# EUROPEAN PATENT SPECIFICATION

(11) **EP 3 185 329 B1**
(45) Date of publication and mention of the grant of the patent: **22.04.2026**
(21) Application number: 16191361.1
(22) Date of filing: 29.09.2016
(51) Int. Cl.: H10K 50/11, H10K 50/15, H10K 50/16, H10K 85/60, C09K 11/02, C09K 11/06, H01G 9/20, H10K 101/00, H10K 101/10, H10K 101/30

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 22.12.2015 KR 20150184084
(43) Date of publication of application: 28.06.2017
(73) Proprietor: Samsung Display Co., Ltd., Gyeonggi-Do (KR)
(72) Inventor: KIM, Seulong, Gyeonggi-do (KR); KIM, Younsun, Gyeonggi-do (KR); SHIN, Dongwoo, Gyeonggi-do (KR); LEE, Jungsub, Gyeonggi-do (KR); ITO, Naoyuki, Gyeonggi-do (KR); LIM, Jino, Gyeonggi-do (KR); JEONG, Hyein, Gyeonggi-do (KR)
(74) Representative: Russell, Tim

(56) References cited:
- WO-A1-2015/093812
- WO-A1-2015/133804
- WO-A2-2015/082046
- XUE-QIN RAN ET AL: "Structural, electronic, and optical properties of doubly ortho-linked quinoxaline/diphenylfluorene hybrids", JOURNAL OF PHYSICAL ORGANIC CHEMISTRY., vol. 24, no. 8, 9 August 2011 (2011-08-09), GB, pages 646 - 656, XP055246302, ISSN: 0894-3230, DOI: 10.1002/poc.1804

## Description

### FIELD OF THE INVENTION

The present invention relates to an organic light-emitting device.

### BACKGROUND OF THE INVENTION

Organic light-emitting devices are self-emission devices that have wide viewing angles, high contrast ratios, short response times, and excellent brightness, driving voltage, and response speed characteristics, compared to devices in the art.

An organic light-emitting device may comprise a first electrode disposed on a substrate, and a hole transport region, an emission layer, an electron transport region, and a second electrode, which are sequentially disposed on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons. These excitons transition from an excited state to a ground state, thereby generating light.

WO2015082046 provides compounds of formula (1) suitable for use in a fluorescent or phosphorescent OLED, for example as matrix material or as hole transport / electron blocking material or exciton blocking material or as electron transport or hole blocking material, and which are used in an OLED lead to good device properties, as well as the provision of the corresponding electronic device.

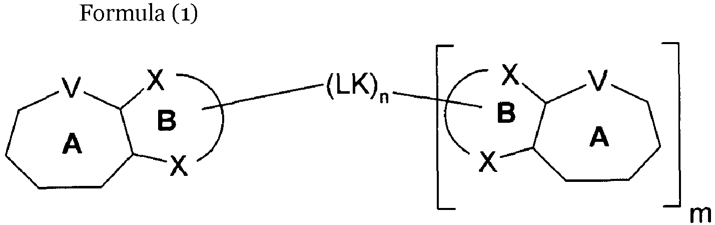

### SUMMARY OF THE INVENTION

The present invention provides an organic light-emitting device having a low driving voltage and high efficiency.

Accordingly, the present invention provides an organic light-emitting device as defined in the claims.

Disclosed is an organic light emitting device comprising:
a first electrode;
a second electrode facing the first electrode;
an emission layer between the first electrode and the second electrode;
a hole transport region between the first electrode and the emission layer; and
an electron transport region between the emission layer and the second electrode,
wherein the emission layer comprises a first compound,
at least one selected from the hole transport region and the electron transport region comprises a second compound,
the first compound is represented by Formula 1A or 1B, and
the second compound is represented by Formula 2A or 2B:

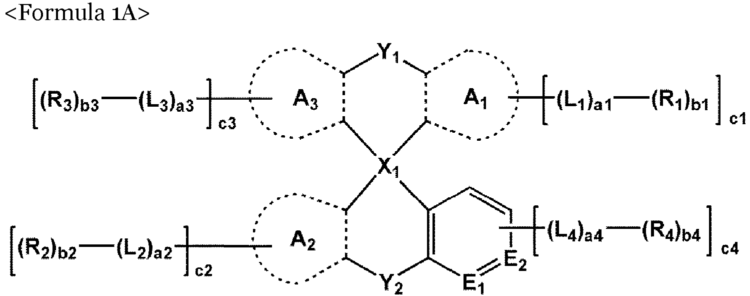

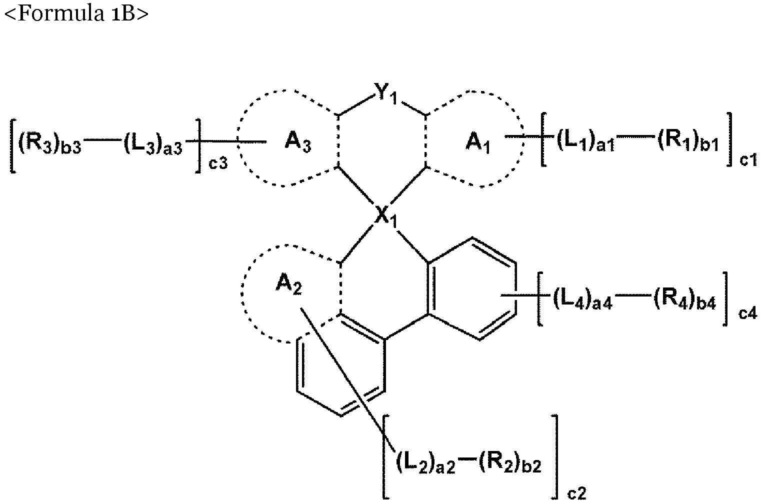

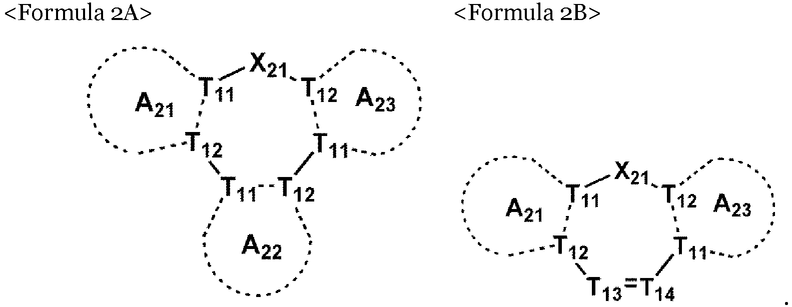

In Formulae 1A, 1B, 2A, and 2B,
rings A₁ to A₃ are each independently selected from a C₅-C₆₀ carbocyclic group and a C₁-C₆₀ heterocyclic group,
rings A₁ to A₃ are each condensed with the spiro-ring in Formulae 1A and 1B,
rings A₂₁, A₂₂, and A₂₃ are each independently a C₃-C₆₀ carbocyclic group or a C₁-C₆₀ heterocyclic group, each substituted with at least one *-[(L₂₂)ₐ₂₂-(R₂₂)b₂₂], in which * is a bonding site to the A₂₁, A₂₂, or A₂₃ ring,
each T₁₁ is independently carbon or nitrogen,
each T₁₂ is independently carbon or nitrogen,
T₁₃ is N or C(R₂₇),
T₁₄ is N or C(R₂₈),
each bond between T₁₁ and T₁₂ represented as a dashed line in formulae 2A and 2B is a single bond or a double bond,
the six atoms represented by the three T₁₁(s) and three T₁₂(s) in Formula 2A are not all nitrogen and the six atoms represented by the two T₁₁(s), two T₁₂(s), T₁₃, and T₁₄ in Formula 2B are not all nitrogen,
rings A₂₁, A₂₂, and A₂₃ are each condensed (e.g., fused) with the central 7-membered ring in Formulae 2A and 2B, such that they each share a T₁₁ and a T₁₂ with the central 7-membered ring,
X₁ is a silicon (Si) atom or a carbon (C) atom,
Y₁ is selected from a single bond, N[(L₁₁)ₐ₁₁-(R₁₁)_{b11}], C(R₁₁)(R₁₃), Si(R₁₁)(R₁₃), O, S, and Se,
Y₂ is selected from a single bond, N[(L₁₂)ₐ₁₂-(R₁₂)_{b12}], C(R₁₂)(R₁₄), Si(R₁₂)(R₁₄), O, S, and Se,
E₁ and E₂ are each independently a nitrogen (N) atom, or may each independently be a carbon (C) atom substituted with *-(L₄)ₐ₄-(R₄)_{b4},
X₂₁ are selected from O, S, Se, C(R₂₃)(R₂₄), Si(R₂₃)(R₂₄), and N[(L₂₁)ₐ₂₁-(R₂₁)_{b21}],
L₁ to L₄, L₁₁, L₁₂, L₂₁, and L₂₂ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
a1 to a4, a11, a12, a21, and a22 are each independently an integer selected from 0 to 5,
R₁ to R₄, R₂₁ to R₂₄, R₂₇, and R₂₈ may each independently be selected from hydrogen, deuterium (-D), -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, - Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂), R₁₁ and R₁₃ are each individually as defined for R₁ or, when R₁₁ and R₁₃ are both present, they may be connected to each other to form a C₅-C₆₀ carbocyclic group or a C₁-C₆₀ heterocyclic group together with the atom to which they are attached,
R₁₂ and R₁₄ are each individually as defined for R₁ or, when R₁₂ and R₁₄ are both present, they may be connected to each other to form a C₅-C₆₀ carbocyclic group or a C₁-C₆₀ heterocyclic group together with the atom to which they are attached,
b1 to b4, b11, b12, b21, and b22 are each independently an integer selected from 1 to 3,
c1 and c2 are each independently an integer selected from 0 to 8, and c3 and c4 are each independently an integer selected from 0 to 4, and
substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed C8-C60 polycyclic group, the substituted divalent non-aromatic condensed 8- to 60-membered heteropolycyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed C8-C60 polycyclic group, and the substituted monovalent non-aromatic condensed 8- to 60-membered heteropolycyclic group are each substituted with one or more substituents selected from
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, - I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₆-C₆₀ aryl group substituted with a C₆-C₆₀ aryl group, a terphenyl group, a C₁-C₆₀ heteroaryl group, a C₁-C₆₀ heteroaryl group substituted with a C₁-C₆₀ alkyl group, a C₁-C₆₀ heteroaryl group substituted with a C₆-C₆₀ aryl group, a monovalent non-aromatic condensed C8-C60 polycyclic group, and a monovalent non-aromatic condensed 8- to 60-membered heteropolycyclic group.

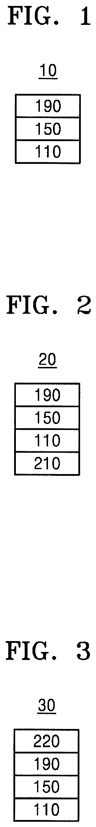

FIGS. 1 to 5 illustrate schematic views of organic light-emitting devices according to various embodiments of the invention.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

The organic light-emitting device of the present invention comprises a first electrode, a second electrode facing the first electrode, an emission layer between the first electrode and the second electrode, a hole transport region between the first electrode and the emission layer, and an electron transport region between the emission layer and the second electrode, wherein the emission layer comprises a first compound and at least one selected from the hole transport region and the electron transport region comprises a second compound.

The first compound is represented by Formula 1A or 1B, and the second compound is represented by Formula 2A or 2B:

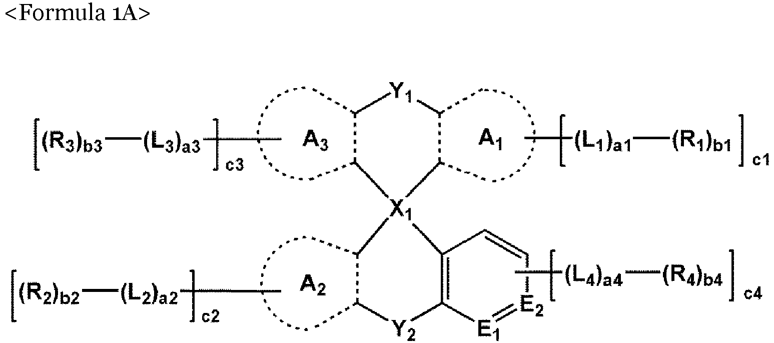

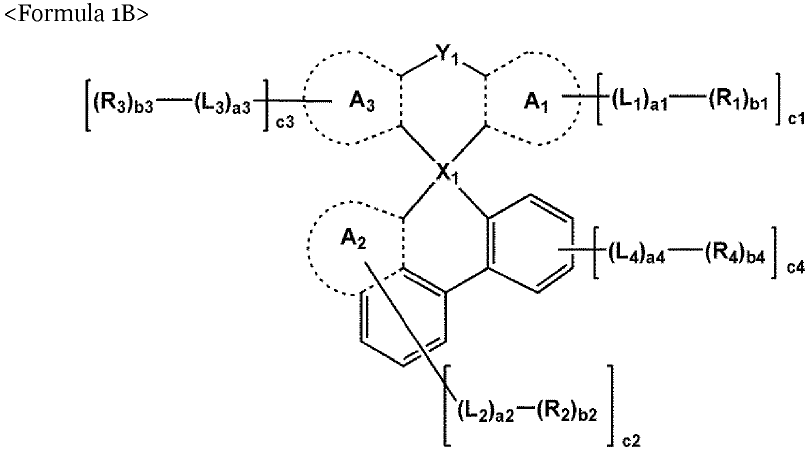

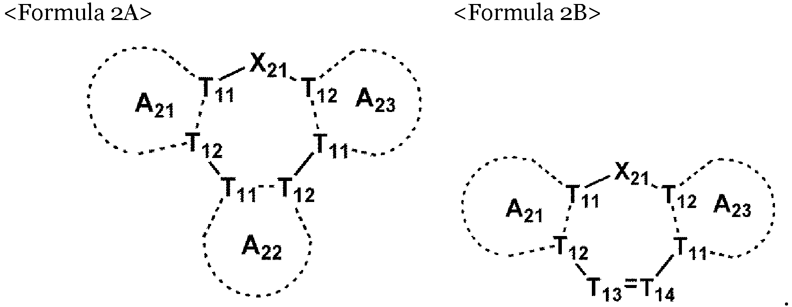

In Formulae 1A and 1B,
rings A₁ to A₃ are each independently selected from a C₃-C₆₀ carbocyclic group and a C₁-C₆₀ heterocyclic group, and
rings A₁ to A₃ are each condensed with the spiro-ring in Formulae 1A and 1B (i.e. the spiro ring comprising X1 in Formulae 1A and 1B).

For example, rings A₁ to A₃ in Formulae 1A and 1B may each independently be selected from a benzene group, a naphthalene group, an anthracene group, a phenanthrene group, an indene group, an indenopyridine group, a fluorene group, a pyridine group, a pyrimidine group, a pyrazine group, a pyrrole group, an imidazole group, a quinoline group, an isoquinoline group, a quinazoline group, a phenanthroline group, a phenanthridine group, a furan group, a thiophene group, an indole group, an indolocarbazole group, a benzofuran group, a benzofurocarbazole group, a benzofuropyrimidine group, a benzothiophene group, a benzoxazole group, a benzothiazole group, a benzoimidazole group, a carbazole group, a dibenzofuran group, a dibenzothiophene group, a pyridoindole group, a dipyridofuran group, a dipyridothiophene group, a pyrimidobenzofuran group, a dipyridopyrrole group, and a pyrimidobenzothiophene group.

Ring A₁ in Formulae 1A and 1B may be selected from a benzene group, a naphthalene group, a pyridine group, a dibenzofuran group, and a pyrimidine group, and

rings A₂ and A₃ may each independently be selected from a benzene group, a naphthalene group, an anthracene group, a phenanthrene group, an indene group, an indenopyridine group, a fluorene group, a pyridine group, a pyrimidine group, a pyrazine group, a pyrrole group, an imidazole group, a quinoline group, an isoquinoline group, a quinazoline group, a phenanthroline group, a phenanthridine group, a furan group, a thiophene group, an indole group, an indolocarbazole group, a benzofuran group, a benzofurocarbazole group, a benzofuropyrimidine group, a benzothiophene group, a benzoxazole group, a benzothiazole group, a benzoimidazole group, a carbazole group, a dibenzofuran group, a dibenzothiophene group, a pyridoindole group, a dipyridofuran group, a dipyridothiophene group, a pyrimidobenzofuran group, a dipyridopyrrole group, and a pyrimidobenzothiophene group.

Rings A₂₁, A₂₂, and A₂₃ in Formulae 2A and 2B may each independently be a C₅-C₆₀ carbocyclic group or a C₁-C₆₀ heterocyclic group, each substituted with at least one *-[(L₂₂)ₐ₂₂-(R₂₂)_{b22}]. L₂₂, a22, R₂₂, and b22 are the same as described below.

T₁₁ and T₁₂ in Formulae 2A and 2B are each independently carbon or nitrogen. Any one of the three T11s in formula 2A may be different from each of the other two T11s, identical to each of the other two T11s, or identical to one of the other two T11s and different from one of the other two T11s. Any one of the three T12s in formula 2A may be different from each of the other two T12s, identical to each of the other two T12s, or identical to one of the other two T12s and different from one of the other two T12s. Any one of the two T11s in Formula 2B may be different from the other T11 or identical to the other T11. Any one of the two T12s in Formula 2B may be different from the other T12 or identical to the other T12. T₁₁ and T₁₂ may be connected to each other via a single bond or a double bond, the six atoms represented by the three T₁₁(s) and three T₁₂(s) in Formula 2A are not all nitrogen and the six atoms represented by the two T₁₁(s), two T₁₂(s), T₁₃, and T₁₄ in Formula 2B are not all nitrogen, and rings A₂₁, A₂₂, and A₂₃ may each be condensed (e.g., fused) with a central 7-membered ring (i.e. the 7-membered ring formed by the three T11s, three T12s and X21 in formula 2A; and the 7-membered ring formed by the two T11s, two T12s, T13, T14 and X21 in formula 2B), such that rings A₂₁, A₂₂, and A₂₃ each share a T₁₁ and a T₁₂ with the central 7-membered ring.

*-[(L₂₂)ₐ₂₂-(R₂₂)_{b22}] substituted in ring A₂₁, *-[(L₂₂)ₐ₂₂-(R₂₂)_{b22}] substituted in ring A₂₂, and *-[(L₂₂)ₐ₂₂-(R₂₂)_{b22}] substituted in ring A₂₃ may be identical to or different from one another.

In addition, when the number of *-[(L₂₂)ₐ₂₂-(R₂₂)_{b22}](s) substituted in ring A₂₁ is two or more, two or more *-[(L₂₂)ₐ₂₂-(R₂₂)_{b22}](s) may be identical to or different from each other, when the number of *-[(L₂₂)ₐ₂₂-(R₂₂)_{b22}](s) substituted in ring A₂₂ is two or more, two or more *-[(L₂₂)ₐ₂₂-(R₂₂)_{b22}](s) may be identical to or different from each other, and when the number of *-[(L₂₂)ₐ₂₂-(R₂₂)_{b22}](s) substituted in ring A₂₃ is two or more, two or more *-[(L₂₂)ₐ₂₂-(R₂₂)_{b22}](s) may be identical to or different from each other.

Rings A₂₁, A₂₂, and A₂₃ in Formulae 2A and 2B may each independently be selected from a benzene group, a naphthalene group, an anthracene group, an indene group, a fluorene group, a pyridine group, a pyrimidine group, a pyrazine group, a pyridazine group, a quinoline group, an isoquinoline group, a pyrrole group, a pyrazole group, an imidazole group, an oxazole group, a thiazole group, a cyclopentadiene group, a silole group, a selenophene group, a furan group, a thiophene group, an indole group, a benzoimidazole group, a benzoxazole group, a benzothiazole group, an indene group, a benzosilole group, a benzoselenophene group, a benzofuran group, a benzothiophene group, a carbazole group, a fluorene group, a dibenzosilole group, a dibenzoselenophene group, a dibenzofuran group, a dibenzothiophene group, a pyrrolopyridine group, a cyclopentapyridine group, a silolopyridine group, a selenophenopyridine group, a furopyridine group, a thienopyridine group, a pyrrolopyrimidine group, a cyclopentapyrimidine group, a silolopyrimidine group, a selenophenopyrimidine group, a furopyrimidine group, a thienopyrimidine group, a pyrrolopyrazine group, a cyclopentapyrazine group, a silolopyrazine group, a selenophenopyrazine group, a furopyrazine group, a thienopyrazine group, a naphthopyrrole group, a cyclopentanaphthalene group, a naphthosilole group, a naphthoselenothiophene group, a naphthofuran group, a naphthothiophene group, a pyrroloquinoline group, a cyclopentaquinoline group, a siloloquinoline group, a selenophenoquinoline group, a furoquinoline group, a thienoquinoline group, a pyrroloisoquinoline group, a cyclopentaisoquinoline group, a siloloisoquinoline group, a selenophenoisoquinoline group, a furoisoquinoline group, a thienoisoquinoline group, an azacarbazole group, an azafluorene group, an azadibenzosilole group, an azadibenzoselenophene group, an azadibenzofuran group, an azadibenzothiophene group, an indenoquinoline group, an indenoisoquinoline group, an indenoquinoxaline group, a phenanthroline group, and a naphthoindole group, each substituted with at least one *-[(L₂₂)ₐ₂₂-(R₂₂)_{b22}].

In the second compound represented by Formulae 2A and 2B, a case where rings A₂₁, A₂₂, and A₂₃ are all a benzene group substituted with at least one *-[(L₂₂)ₐ₂₂-(R₂₂)_{b22}] may be excluded.

Rings A₂₁, A₂₂, and A₂₃ in Formulae 2A and 2B may each independently be selected from groups represented by Formulae 2-1 to 2-36, each substituted with at least one *-[(L₂₂)ₐ₂₂-(R₂₂)_{b22}]:

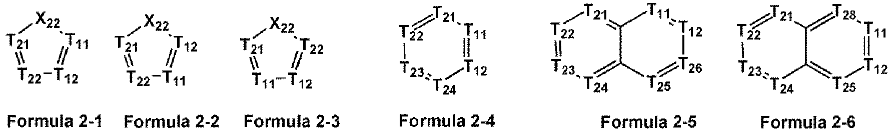

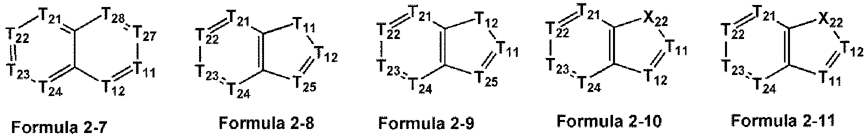

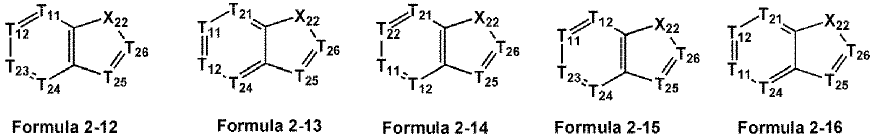

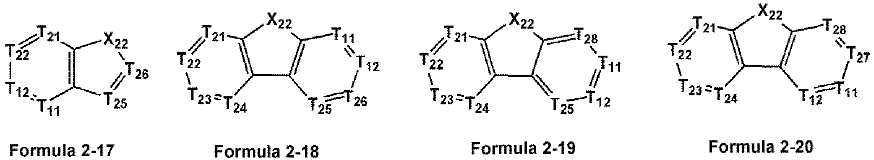

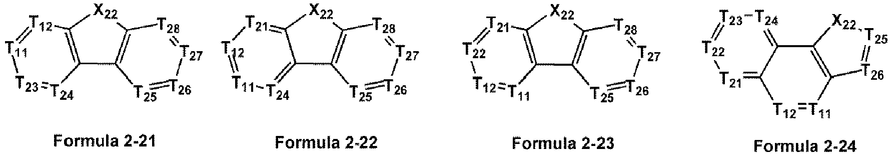

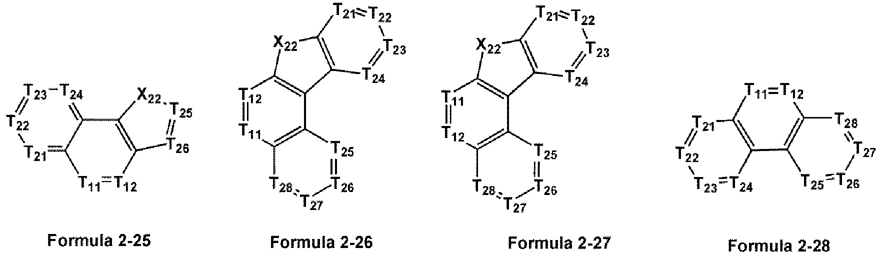

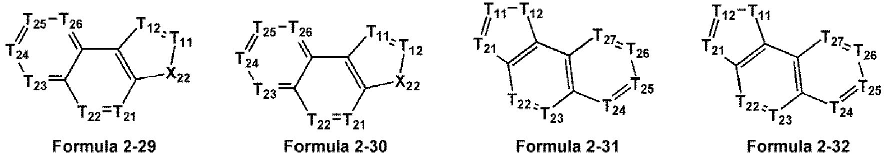

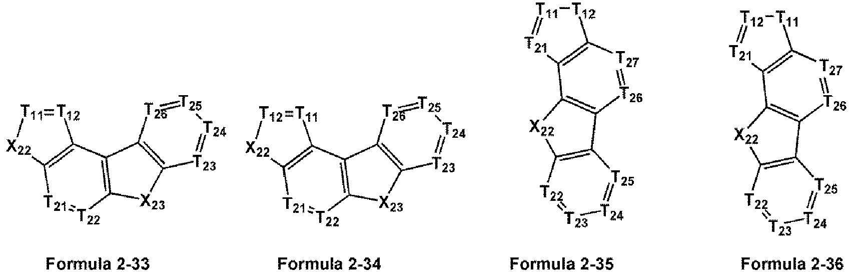

In Formulae 2-1 to 2-36,
T₁₁ and T₁₂ are the same as described above,
X₂₂ and X₂₃ may each independently be selected from O, S, Se, a moiety comprising C, a moiety comprising N, and a moiety comprising Si, and
T₂₁ to T₂₈ may each independently be selected from N and a moiety comprising C.

When both X₂₂ and X₂₃ are comprised in rings A₂₁ to A₂₃, X₂₂ and X₂₃ may be identical to or different from each other.

For example, in Formulae 2-1 to 2-36, X₂₂ and X₂₃ may each independently be O, S, Se, C(R₂₅)(R₂₆), N-[(L₂₂)ₐ₂₂-(R₂₂)_{b22}], or Si(R₂₅)(R₂₆), and T₂₁ to T₂₈ may each independently be N or C-[(L₂₂)ₐ₂₂-(R₂₂)_{b22}]. R₂₅ and R₂₆ may each independently be selected from groups represented by *-[(L₂₂)ₐ₂₂-(R₂₂)_{b22})] as described herein.

Rings A₂₁, A₂₂, and A₂₃ in Formulae 2A and 2B may each independently be selected from groups represented by Formulae 2-101 to 2-229:

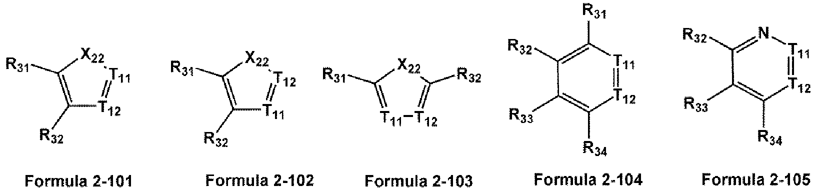

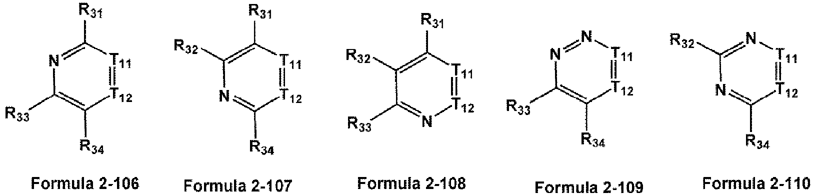

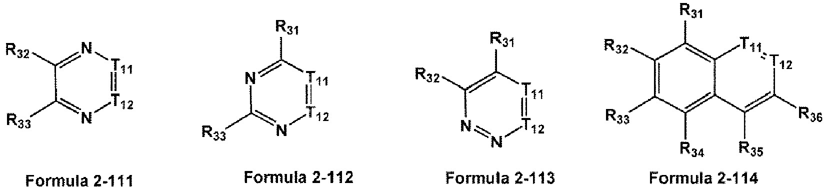

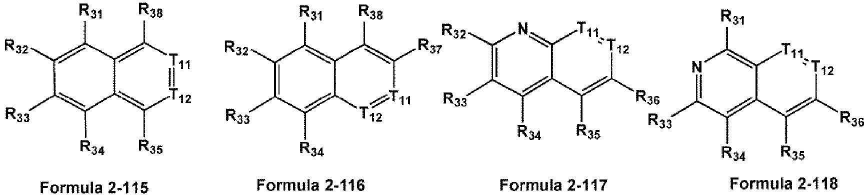

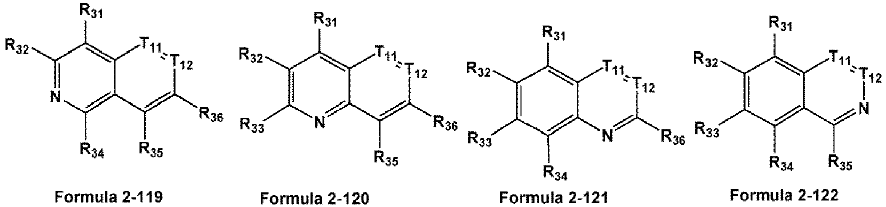

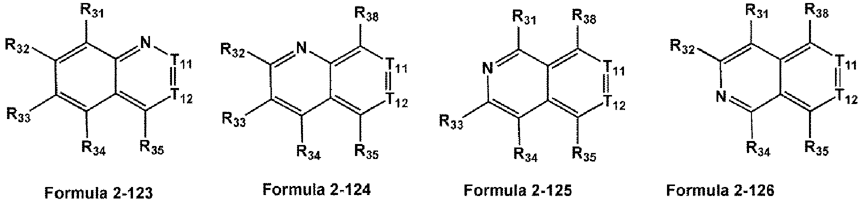

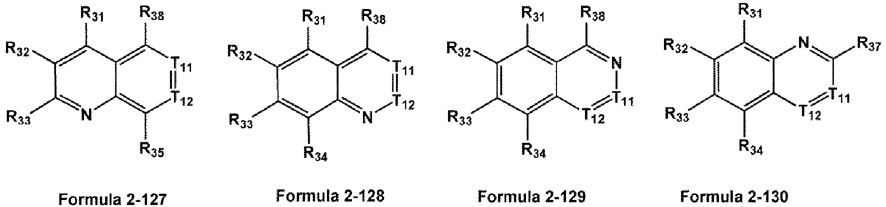

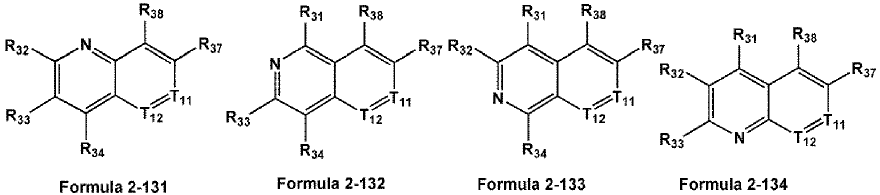

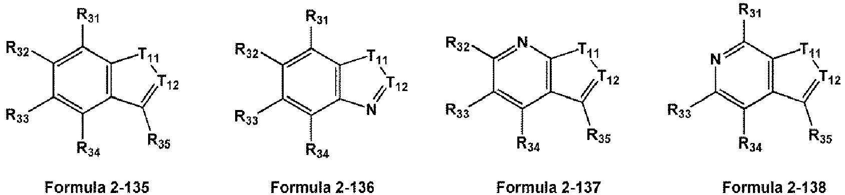

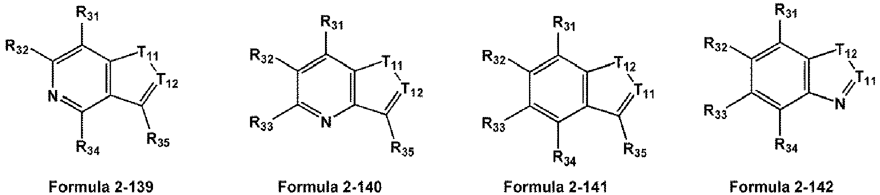

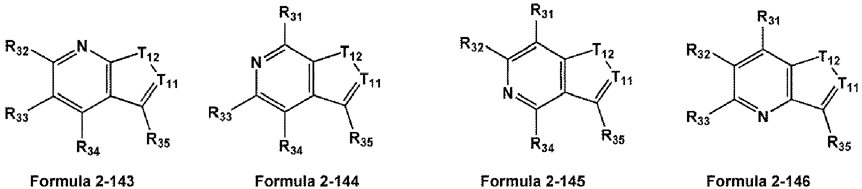

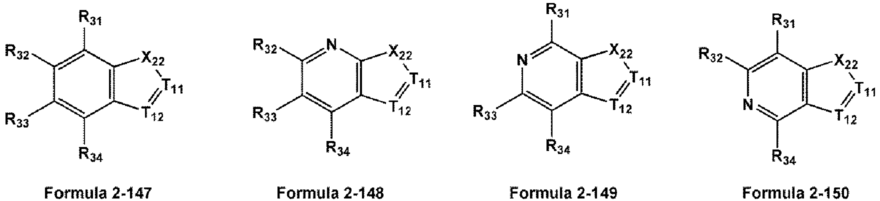

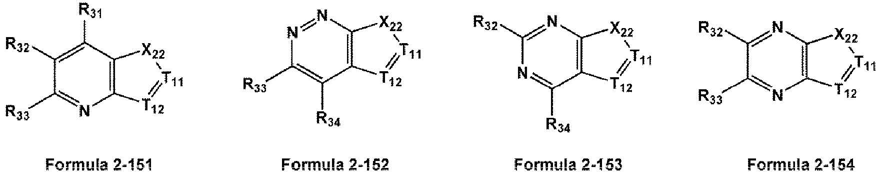

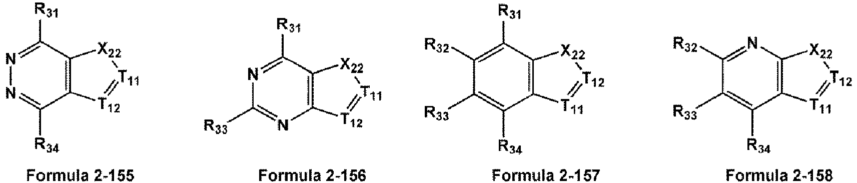

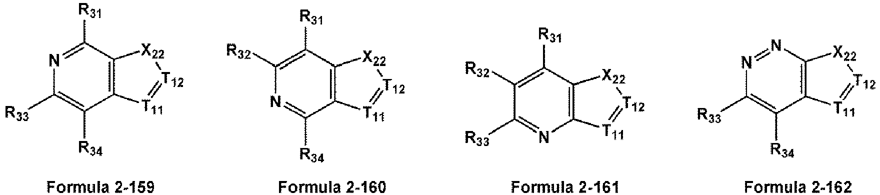

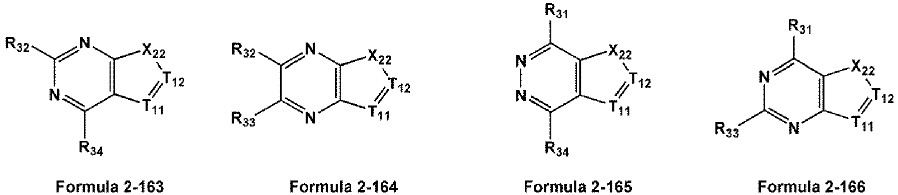

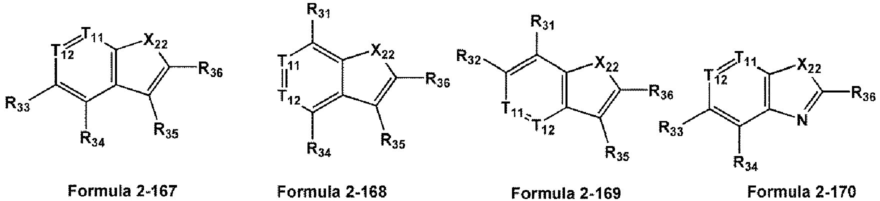

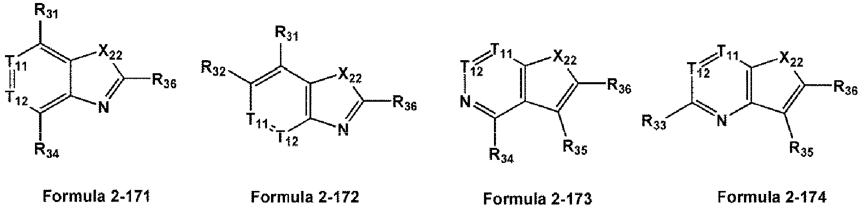

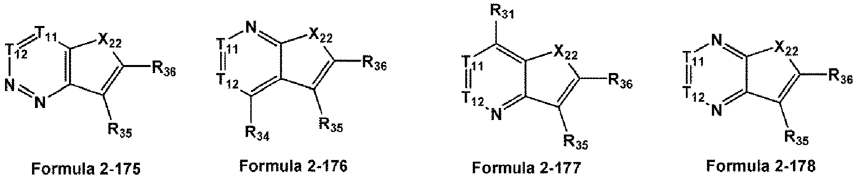

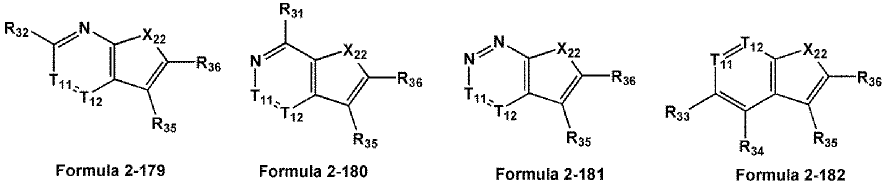

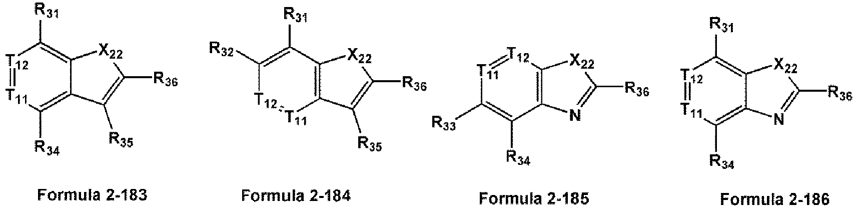

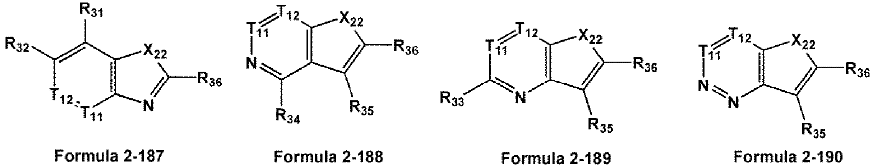

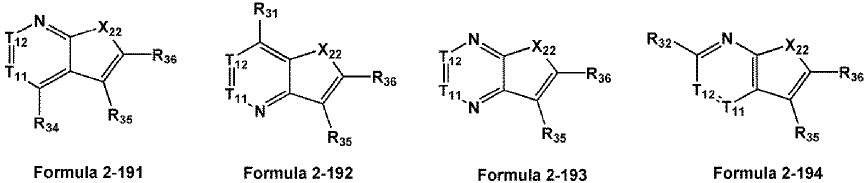

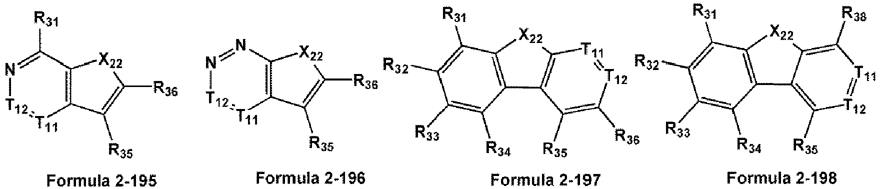

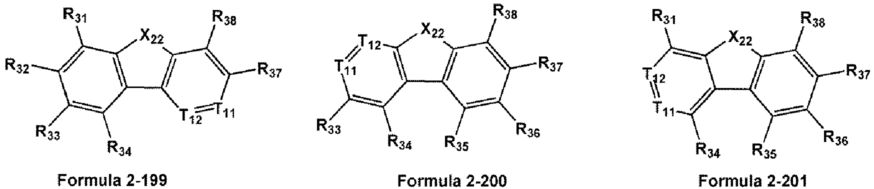

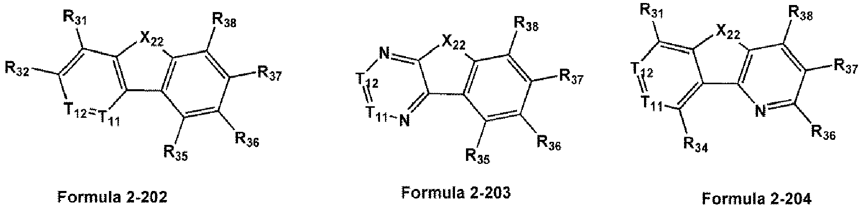

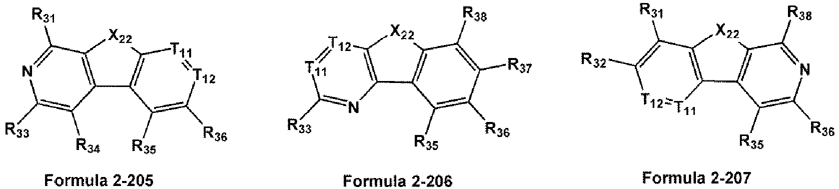

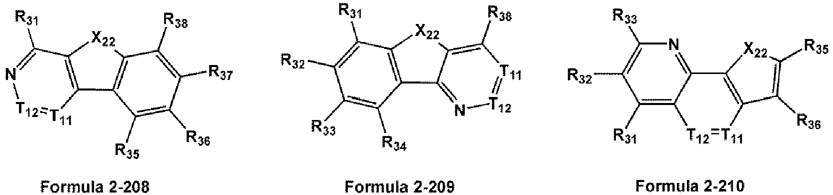

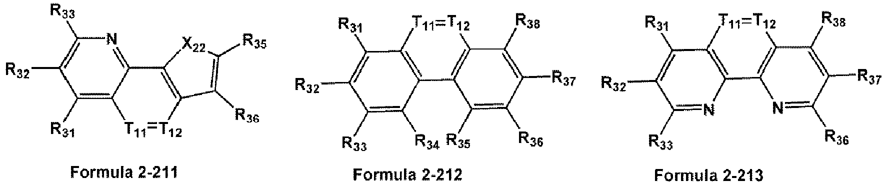

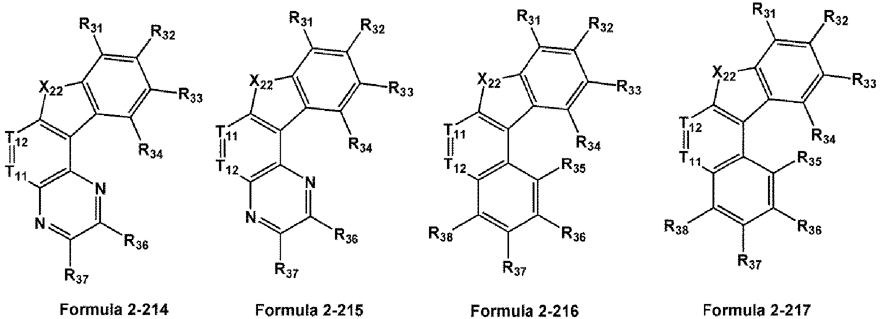

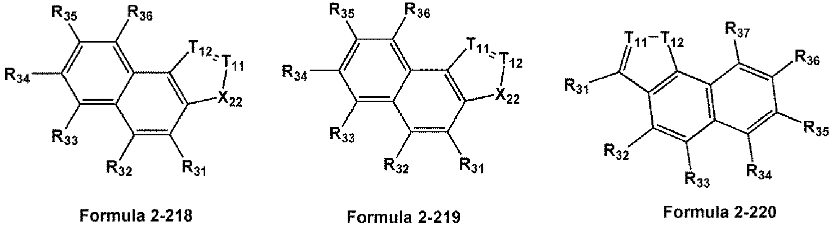

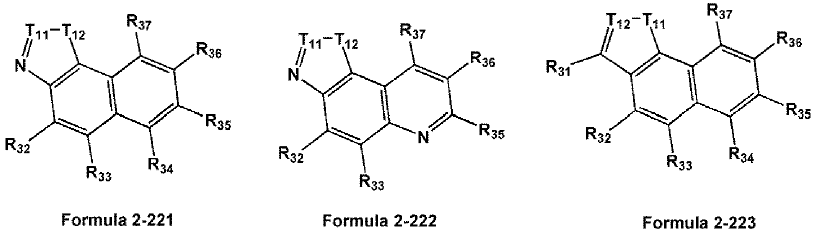

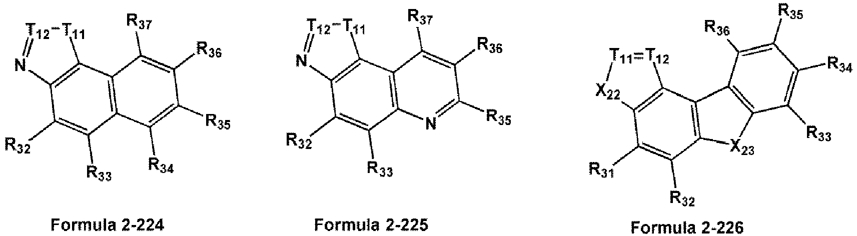

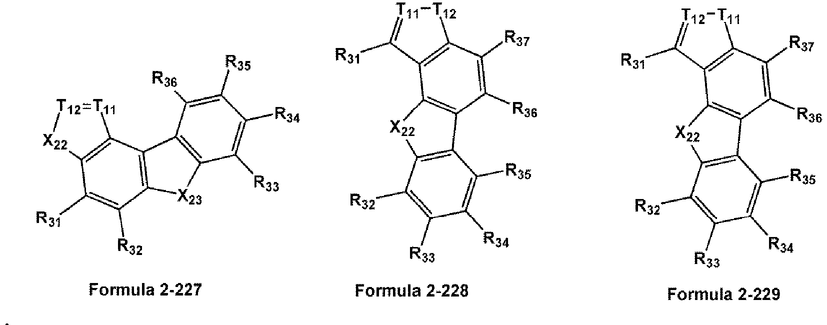

In Formulae 2-101 to 2-229,
T₁₁ and T₁₂ are the same as described above,
X₂₂ and X₂₃ are the same as described above, and
R₃₁ to R₃₈ may each independently be selected from substituents represented by *-[(L₂₂)ₐ₂₂-(R₂₂)_{b22}] as described herein.

In R₃₁ to R₃₈, when the number of *-[(L₂₂)ₐ₂₂-(R₂₂)_{b22}](s) is two or more, two or more *-[(L₂₂)ₐ₂₂-(R₂₂)_{b22}](s) may be identical to or different from each other.

When the number of *-[(L₂₂)ₐ₂₂-(R₂₂)_{b22}](s) in R₃₁ to R₃₈ is 2 or more, no more than 2 *-[(L₂₂)ₐ₂₂-(R₂₂)_{b22}](s) may be a cyclic group or contains a cyclic group. When the number of *-[(L₂₂)ₐ₂₂-(R₂₂)_{b22}](s) in R₃₁ to R₃₈ is 2 or more, no more than 1 *-[(L₂₂)ₐ₂₂-(R₂₂)_{b22}] may be a cyclic group or contains a cyclic group. When the number of *-[(L₂₂)ₐ₂₂-(R₂₂)_{b22}](s) in R₃₁ to R₃₈ is 2 or more, no more than 2 *-[(L₂₂)ₐ₂₂-(R₂₂)_{b22}](s) may be other than hydrogen. When the number of *-[(L₂₂)ₐ₂₂-(R₂₂)_{b22}](s) in R₃₁ to R₃₈ is 2 or more, no more than 1 *-[(L₂₂)ₐ₂₂-(R₂₂)_{b22}] may be other than hydrogen.

In Formulae 2A to 2B, a case where rings A₂₁, A₂₂, and A₂₃ are all represented by Formula 2-104 may be excluded.

The second compound may be represented by one selected from Formulae 2-201A to 2-269A, and rings A₂₁, A₂₂, and A₂₃ in Formulae 2-201A to 2-269A may each be selected from Formulae shown in Table 1.

**[Table 1]**

| Formula No. | Formula No. of ring A₂₁ | Formula No. of ring A₂₂ | Formula No. of ring A₂₃ |
|---|---|---|---|
| 2-201A | 2-2 | 2-4 | 2-4 |
| 2-202A | 2-4 | 2-4 | 2-1 |
| 2-203A | 2-4 | 2-4 | 2-2 |
| 2-204A | 2-4 | 2-4 | 2-3 |
| 2-205A | 2-4 | 2-1 | 2-4 |
| 2-206A | 2-4 | 2-2 | 2-4 |
| 2-207A | 2-4 | 2-4 | 2-10 |
| 2-208A | 2-11 | 2-4 | 2-4 |
| 2-209A | 2-4 | 2-4 | 2-11 |
| 2-210A | 2-4 | 2-10 | 2-4 |
| 2-211A | 2-4 | 2-4 | 2-8 |
| 2-212A | 2-4 | 2-9 | 2-4 |
| 2-213A | 2-4 | 2-4 | 2-14 |
| 2-214A | 2-17 | 2-4 | 2-4 |
| 2-215A | 2-4 | 2-4 | 2-15 |
| 2-216A | 2-13 | 2-4 | 2-4 |
| 2-217A | 2-4 | 2-4 | 2-16 |
| 2-218A | 2-4 | 2-4 | 2-13 |
| 2-219A | 2-16 | 2-4 | 2-4 |
| 2-220A | 2-4 | 2-4 | 2-12 |
| 2-221A | 2-4 | 2-4 | 2-17 |
| 2-222A | 2-4 | 2-16 | 2-4 |
| 2-223A | 2-4 | 2-15 | 2-4 |
| 2-224A | 2-4 | 2-14 | 2-4 |
| 2-225A | 2-4 | 2-17 | 2-4 |
| 2-226A | 2-19 | 2-4 | 2-4 |
| 2-227 A | 2-22 | 2-4 | 2-4 |
| 2-228A | 2-18 | 2-4 | 2-4 |
| 2-229A | 2-²3 | 2-4 | 2-4 |
| 2-230A | 2-21 | 2-4 | 2-4 |
| 2-231A | 2-20 | 2-4 | 2-4 |
| 2-232A | 2-4 | 2-²3 | 2-4 |
| 2-233A | 2-4 | 2-18 | 2-4 |
| 2-234A | 2-4 | 2-21 | 2-4 |
| 2-235A | 2-4 | 2-19 | 2-4 |
| 2-236A | 2-5 | 2-2 | 2-4 |
| 2-237A | 2-5 | 2-1 | 2-4 |
| 2-238A | 2-2 | 2-2 | 2-4 |
| 2-239A | 2-4 | 2-23 | 2-1 |
| 2-240A | 2-6 | 2-10 | 2-4 |
| 2-241A | 2-4 | 2-4 | 2-29 |
| 2-242A | 2-7 | 2-4 | 2-10 |
| 2-243A | 2-11 | 2-4 | 2-10 |
| 2-244A | 2-4 | 2-10 | 2-6 |
| 2-245A | 2-11 | 2-11 | 2-4 |
| 2-246A | 2-11 | 2-11 | 2-5 |
| 2-247A | 2-11 | 2-11 | 2-10 |
| 2-248A | 2-7 | 2-9 | 2-4 |
| 2-249A | 2-4 | 2-4 | 2-25 |
| 2-250A | 2-11 | 2-15 | 2-4 |
| 2-251A | 2-18 | 2-28 | 2-4 |
| 2-252A | 2-23 | 2-10 | 2-4 |
| 2-253A | 2-4 | 2-27 | 2-4 |
| 2-254A | 2-6 | 2-18 | 2-4 |
| 2-255A | 2-4 | 2-²3 | 2-5 |
| 2-256A | 2-²3 | 2-4 | 2-14 |
| 2-257A | 2-17 | 2-4 | 2-14 |
| 2-258A | 2-14 | 2-4 | 2-12 |
| 2-259A | 2-17 | 2-4 | 2-12 |
| 2-260A | 2-14 | 2-16 | 2-2 |
| 2-261A | 2-17 | 2-5 | 2-14 |
| 2-262A | 2-17 | 2-13 | 2-17 |
| 2-263A | 2-17 | 2-14 | 2-12 |
| 2-264A | 2-17 | 2-12 | 2-12 |
| 2-265A | 2-5 | 2-1 | 2-18 |
| 2-266A | 2-4 | 2-29 | 2-4 |
| 2-267A | 2-4 | 2-31 | 2-4 |
| 2-268A | 2-4 | 2-33 | 2-4 |
| 2-269A | 2-4 | 2-35 | 2-4 |

The second compound may be represented by one selected from Formulae 2-201B to 2-215B, and rings A₂₁ and A₂₃ in Formulae 2-201B to 2-215B may each be selected from Formulae shown in Table 2.

**[Table 2]**

| Formula No. | Formula No. of ring A₂₁ | Formula No. of ring A₂₂ | Formula No. of ring A₂₃ |
|---|---|---|---|
| 2-201B | 2-4 | - | 2-19 |
| 2-202B | 2-4 | - | 2-22 |
| 2-203B | 2-4 | - | 2-18 |
| 2-204B | 2-4 | - | 2-²3 |
| 2-205B | 2-4 | - | 2-21 |
| 2-206B | 2-4 | - | 2-20 |
| 2-207B | 2-5 | - | 2-²3 |
| 2-208B | 2-7 | - | 2-²3 |
| 2-209B | 2-4 | - | 2-26 |
| 2-210B | 2-7 | - | 2-22 |
| 2-211B | 2-13 | - | 2-16 |
| 2-212B | 2-5 | - | 2-19 |
| 2-213B | 2-7 | - | 2-20 |
| 2-214B | 2-19 | - | 2-18 |
| 2-215B | 2-18 | - | 2-18 |

The second compound may be represented by one selected from Formulae 2-301A to 2-421A, and rings A₂₁, A₂₂, and A₂₃ in Formulae 2-301A to 2-419A and 2-421A to 2-431A may each be selected from Formulae shown in Table 3.

**[Table 3]**

| Formula No. | Formula No. of ring A₂₁ | Formula No. of ring A₂₂ | Formula No. of ring A₂₃ |
|---|---|---|---|
| 2-301A | 2-104 | 2-147 | 2-104 |
| 2-302A | 2-102 | 2-104 | 2-104 |
| 2-303A | 2-104 | 2-104 | 2-101 |
| 2-304A | 2-104 | 2-104 | 2-102 |
| 2-305A | 2-104 | 2-104 | 2-103 |
| 2-306A | 2-104 | 2-101 | 2-104 |
| 2-307A | 2-104 | 2-102 | 2-104 |
| 2-308A | 2-104 | 2-104 | 2-147 |
| 2-309A | 2-157 | 2-104 | 2-104 |
| 2-310A | 2-104 | 2-104 | 2-157 |
| 2-311A | 2-104 | 2-147 | 2-107 |
| 2-312A | 2-104 | 2-149 | 2-104 |
| 2-313A | 2-104 | 2-156 | 2-104 |
| 2-314A | 2-107 | 2-147 | 2-106 |
| 2-315A | 2-104 | 2-151 | 2-104 |
| 2-316A | 2-104 | 2-147 | 2-106 |
| 2-317A | 2-104 | 2-148 | 2-104 |
| 2-318A | 2-104 | 2-150 | 2-104 |
| 2-319A | 2-106 | 2-147 | 2-104 |
| 2-320A | 2-104 | 2-106 | 2-147 |
| 2-321A | 2-157 | 2-107 | 2-104 |
| 2-322A | 2-106 | 2-104 | 2-147 |
| 2-323A | 2-104 | 2-107 | 2-147 |
| 2-324A | 2-107 | 2-104 | 2-147 |
| 2-325A | 2-104 | 2-104 | 2-160 |
| 2-326A | 2-104 | 2-111 | 2-157 |
| 2-327A | 2-108 | 2-104 | 2-158 |
| 2-328A | 2-111 | 2-104 | 2-157 |
| 2-329A | 2-107 | 2-147 | 2-104 |
| 2-330A | 2-104 | 2-104 | 2-135 |
| 2-331A | 2-104 | 2-141 | 2-104 |
| 2-332A | 2-104 | 2-142 | 2-104 |
| 2-333A | 2-107 | 2-104 | 2-135 |
| 2-334A | 2-104 | 2-111 | 2-135 |
| 2-335A | 2-104 | 2-143 | 2-104 |
| 2-336A | 2-106 | 2-142 | 2-104 |
| 2-337A | 2-107 | 2-142 | 2-106 |
| 2-338A | 2-104 | 2-104 | 2-169 |
| 2-339A | 2-184 | 2-104 | 2-104 |
| 2-340A | 2-104 | 2-104 | 2-182 |
| 2-341A | 2-168 | 2-104 | 2-104 |
| 2-342A | 2-104 | 2-104 | 2-183 |
| 2-343A | 2-104 | 2-104 | 2-168 |
| 2-344A | 2-183 | 2-104 | 2-104 |
| 2-345A | 2-104 | 2-104 | 2-167 |
| 2-346A | 2-104 | 2-104 | 2-184 |
| 2-347A | 2-104 | 2-183 | 2-104 |
| 2-348A | 2-104 | 2-182 | 2-104 |
| 2-349A | 2-104 | 2-169 | 2-104 |
| 2-350A | 2-104 | 2-184 | 2-104 |
| 2-351A | 2-107 | 2-104 | 2-179 |
| 2-352A | 2-111 | 2-104 | 2-169 |
| 2-353A | 2-104 | 2-111 | 2-182 |
| 2-354A | 2-106 | 2-104 | 2-185 |
| 2-355A | 2-171 | 2-104 | 2-104 |
| 2-356A | 2-104 | 2-104 | 2-115 |
| 2-357A | 2-104 | 2-104 | 2-178 |
| 2-358A | 2-104 | 2-106 | 2-167 |
| 2-359A | 2-108 | 2-105 | 2-167 |
| 2-360A | 2-105 | 2-104 | 2-167 |
| 2-361A | 2-112 | 2-104 | 2-184 |
| 2-362A | 2-104 | 2-192 | 2-104 |
| 2-363A | 2-107 | 2-182 | 2-106 |
| 2-364A | 2-104 | 2-169 | 2-105 |
| 2-365A | 2-105 | 2-184 | 2-104 |
| 2-366A | 2-105 | 2-169 | 2-105 |
| 2-367A | 2-198 | 2-104 | 2-104 |
| 2-368A | 2-201 | 2-104 | 2-104 |
| 2-369A | 2-197 | 2-104 | 2-104 |
| 2-370A | 2-202 | 2-104 | 2-104 |
| 2-371A | 2-200 | 2-104 | 2-104 |
| 2-372A | 2-199 | 2-104 | 2-104 |
| 2-373A | 2-104 | 2-202 | 2-104 |
| 2-374A | 2-104 | 2-197 | 2-104 |
| 2-375A | 2-104 | 2-200 | 2-104 |
| 2-376A | 2-104 | 2-198 | 2-104 |
| 2-377A | 2-209 | 2-104 | 2-104 |
| 2-378A | 2-207 | 2-104 | 2-104 |
| 2-379A | 2-200 | 2-106 | 2-104 |
| 2-380A | 2-104 | 2-208 | 2-104 |
| 2-381A | 2-105 | 2-198 | 2-108 |
| 2-382A | 2-202 | 2-102 | 2-104 |
| 2-383A | 2-202 | 2-101 | 2-106 |
| 2-384A | 2-102 | 2-102 | 2-107 |
| 2-385A | 2-104 | 2-202 | 2-101 |
| 2-386A | 2-123 | 2-147 | 2-104 |
| 2-387A | 2-104 | 2-104 | 2-218 |
| 2-388A | 2-116 | 2-104 | 2-147 |
| 2-389A | 2-157 | 2-104 | 2-147 |
| 2-390A | 2-107 | 2-147 | 2-115 |
| 2-391A | 2-157 | 2-157 | 2-104 |
| 2-392A | 2-157 | 2-157 | 2-114 |
| 2-393A | 2-157 | 2-157 | 2-147 |
| 2-394A | 2-116 | 2-147 | 2-104 |
| 2-395A | 2-104 | 2-104 | 2-210 |
| 2-396A | 2-157 | 2-182 | 2-104 |
| 2-397A | 2-197 | 2-213 | 2-104 |
| 2-398A | 2-202 | 2-167 | 2-104 |
| 2-399A | 2-104 | 2-216 | 2-104 |
| 2-400A | 2-124 | 2-197 | 2-104 |
| 2-401A | 2-104 | 2-202 | 2-114 |
| 2-402A | 2-168 | 2-104 | 2-169 |
| 2-403A | 2-184 | 2-104 | 2-169 |
| 2-404A | 2-169 | 2-104 | 2-167 |
| 2-405A | 2-184 | 2-106 | 2-167 |
| 2-406A | 2-169 | 2-183 | 2-102 |
| 2-407A | 2-184 | 2-114 | 2-169 |
| 2-408A | 2-184 | 2-168 | 2-184 |
| 2-409A | 2-184 | 2-104 | 2-167 |
| 2-410A | 2-184 | 2-167 | 2-167 |
| 2-411A | 2-114 | 2-101 | 2-197 |
| 2-412A | 2-104 | 2-149 | 2-104 |
| 2-413A | 2-106 | 2-104 | 2-147 |
| 2-414A | 2-104 | 2-104 | 2-168 |
| 2-415A | 2-200 | 2-106 | 2-104 |
| 2-416A | 2-104 | 2-104 | 2-183 |
| 2-417A | 2-104 | 2-104 | 2-101 |
| 2-418A | 2-105 | 2-169 | 2-105 |
| 2-419A | 2-104 | 2-147 | 2-107 |
| 2-421A | 2-104 | 2-218 | 2-104 |
| 2-422A | 2-104 | 2-226 | 2-104 |
| 2-423A | 2-104 | 2-222 | 2-104 |
| 2-424A | 2-104 | 2-228 | 2-104 |
| 2-425A | 2-104 | 2-151 | 2-104 |
| 2-426A | 2-106 | 2-147 | 2-107 |
| 2-427A | 2-104 | 2-147 | 2-106 |
| 2-428A | 2-107 | 2-150 | 2-104 |
| 2-429A | 2-104 | 2-143 | 2-104 |
| 2-430A | 2-107 | 2-142 | 2-106 |
| 2-431A | 2-104 | 2-142 | 2-104 |

The second compound may be represented by one selected from Formulae 2-301B to 2-320B, and rings A₂₁ and A₂₃ in Formulae 2-301B to 2-320B may each be selected from Formulae shown in Table 4.

**[Table 4]**

| Formula No. | Formula No. of ring A₂₁ | Formula No. of ring A₂₂ | Formula No. of ring A₂₃ |
|---|---|---|---|
| 2-301B | 2-104 | - | 2-198 |
| 2-302B | 2-104 | - | 2-201 |
| 2-303B | 2-104 | - | 2-197 |
| 2-304B | 2-104 | - | 2-202 |
| 2-305B | 2-104 | - | 2-200 |
| 2-306B | 2-104 | - | 2-199 |
| 2-307B | 2-104 | - | 2-203 |
| 2-308B | 2-104 | - | 2-204 |
| 2-309B | 2-106 | - | 2-205 |
| 2-310B | 2-104 | - | 2-206 |
| 2-311B | 2-112 | - | 2-199 |
| 2-312B | 2-114 | - | 2-202 |
| 2-313B | 2-116 | - | 2-202 |
| 2-314B | 2-104 | - | 2-214 |
| 2-315B | 2-130 | - | 2-201 |
| 2-316B | 2-168 | - | 2-183 |
| 2-317B | 2-114 | - | 2-198 |
| 2-318B | 2-116 | - | 2-199 |
| 2-319B | 2-198 | - | 2-197 |
| 2-320B | 2-197 | - | 2-197 |

X₁ in Formulae 1A and 1B is silicon (Si) or carbon (C).

For example, X₁ in Formulae 1A and 1B may be C.

In Formulae 1A and 1B,
Y₁ is selected from a single bond, N[(L₁₁)ₐ₁₁-(R₁₁)_{b11}], C(R₁₁)(R₁₃), Si(R₁₁)(R₁₃), O, S, and Se, and
Y₂ is selected from a single bond, N[(L₁₂)ₐ₁₂-(R₁₂)_{b12}], C(R₁₂)(R₁₄), Si(R₁₂)(R₁₄), O, S, and Se.

For example, in Formulae 1A and 1B,
Y₁ and Y₂ may be a single bond,
Y₁ may be a single bond, and Y₂ may be selected from N[(L₁₂)ₐ₁₂-(R₁₂)_{b12}], C(R₁₂)(R₁₄), Si(R₁₂)(R₁₄), O, S, and Se, or
Y1 may be selected from N[(L₁₁)ₐ₁₁-(R₁₁)_{b11}], C(R₁₁)(R₁₃), Si(R₁₁)(R₁₃), O, S, and Se, and Y₂ may be a single bond.

In Formulae 1A and 1B,
Y₁ and Y₂ may be a single bond,
Y₁ may be a single bond, and Y₂ may be selected from N[(L₁₂)ₐ₁₂-(R₁₂)_{b12}], C(R₁₂)(R₁₄), O, and S, or
Y₁ may be selected from N[(L₁₁)ₐ₁₁-(R₁₁)_{b11}], C(R₁₁)(R₁₃), O, and S, and Y₂ may be a single bond.

For example, in Formula 1B,
Y₁ may be selected from a single bond, N[(L₁₁)ₐ₁₁-(R₁₁)_{b11}], C(R₁₁)(R₁₅), O, and S.

E₁ and E₂ in Formulae 1A and 1B are each independently a nitrogen (N) atom, or a carbon (C) atom substituted with *-(L₄)ₐ₄-(R₄)_{b4}.

When E₁ and E₂ in Formulae 1A and 1B are a carbon (C) atom substituted with *-(L₄)ₐ₄-(R₄)_{b4}, two *-(L₄)ₐ₄-(R₄)_{b4}(s) may be identical to or different from each other.

X₂₁ in Formulae 2A and 2B is selected from O, S, Se, C(R₂₃)(R₂₄), Si(R₂₃)(R₂₄), and N-[(L₂₁)ₐ₂₁-(R₂₁)_{b21}].

X₂₁ in Formulae 2A and 2B may be N[(L₂₁)ₐ₂₁-(R₂₁)_{b21}].

X₂₁ in Formulae 2A and 2B may be O, S, Se, C(R₂₃)(R₂₄), or Si(R₂₃)(R₂₄), and
at least one selected from rings A₂₁, A₂₂, and A₂₃ in Formula 2A and at least one selected from rings A₂₁ and A₂₃ in Formula 2B may each independently be selected from groups represented by Formulae 2-1 to 2-3, 2-10 to 2-27, and 2-33 to 2-36, and X₂₂ or X₂₃ in Formulae 2-1 to 2-3, 2-10 to 2-27, and 2-33 to 2-36 may be N-[(L₂₂)ₐ₂₂-(R₂₂)_{b22}].

X₂₁ in Formulae 2A and 2B may be O, S, Se, C(R₂₃)(R₂₄), or Si(R₂₃)(R₂₄),
at least one selected from rings A₂₁, A₂₂, and A₂₃ in Formula 2A and at least one selected from rings A₂₁ and A₂₃ in Formula 2B may each independently be selected from groups represented by Formulae 2-101 to 2-103, 2-147 to 2-211, 2-214 to 2-219, and 2-226 to 2-229, and X₂₂ or X₂₃ in Formulae 2-101 to 2-103, 2-147 to 2-211, 2-214 to 2-219, and 2-226 to 2-229 may be N-[(L₂₂)ₐ₂₂-(R₂₂)_{b22}].

In Formulae 2A and 2B, X₂₁ may be O, S, Se, C(R₂₃)(R₂₄), Si(R₂₃)(R₂₄), or N-[(L₂₁)ₐ₂₁-(R₂₁)_{b21}], and X₂₂ and X₂₃ may each independently be O, S, Se, C(R₂₅)(R₂₆), Si(R₂₅)(R₂₆), or N-[(L₂₂)ₐ₂₂-(R₂₂)_{b22}]. L₂₁, L₂₂, a21, a22, R₂₁ to R₂₆, b21, and b22 are the same as described below.

L₁ to L₄, L₁₁, L₁₂, L₂₁, and L₂₂ in Formulae 1A, 1B, 2A, and 2B are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group.

For example, in Formulae 1A, 1B, 2A, and 2B,
L₁ to L₄, L₁₁, L₁₂, L₂₁, and L₂₂ may each independently be selected from
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁), and -P(=O)(Q₃₁)(Q₃₂),
wherein Q₃₁ to Q₃₃ may each independently be selected from
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group.

L₁ to L₄, L₁₁, L₁₂, L₂₁, and L₂₂ in Formulae 1A, 1B, 2A, and 2B may each independently be selected from groups represented by Formulae 3-1 to 3-99:

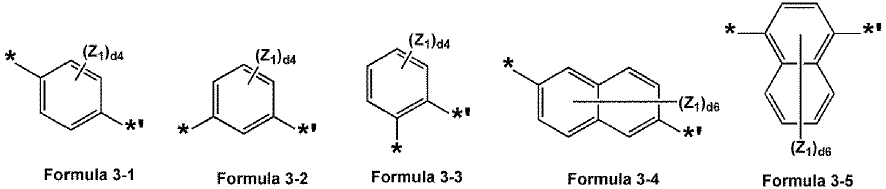

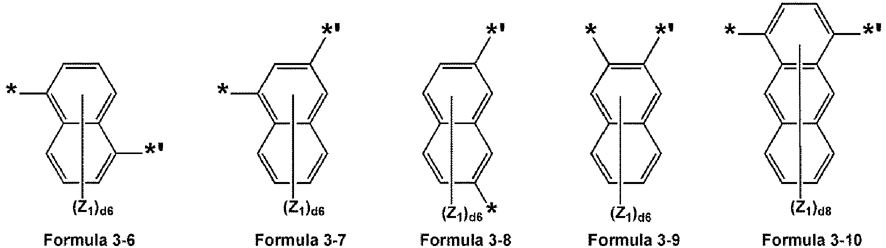

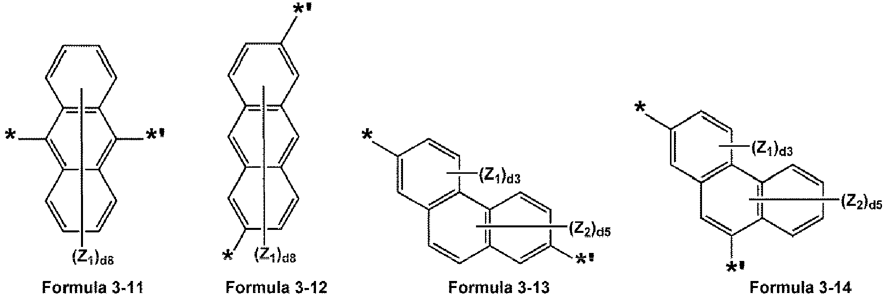

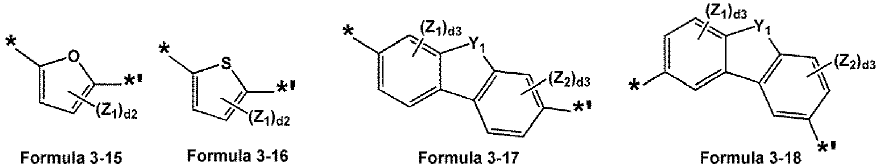

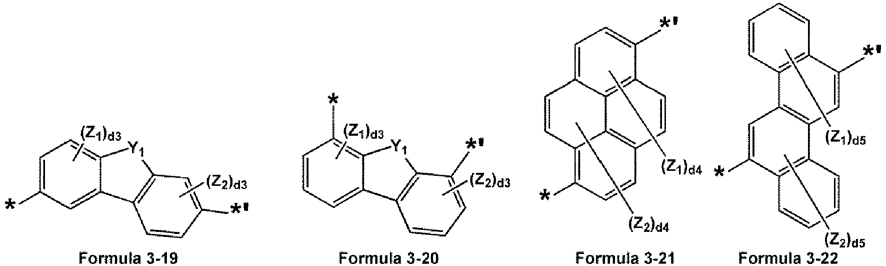

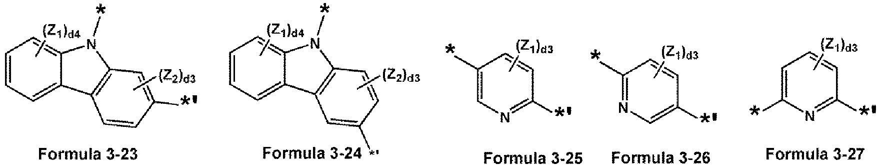

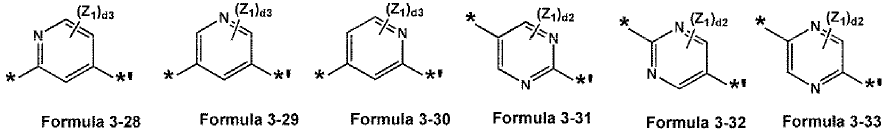

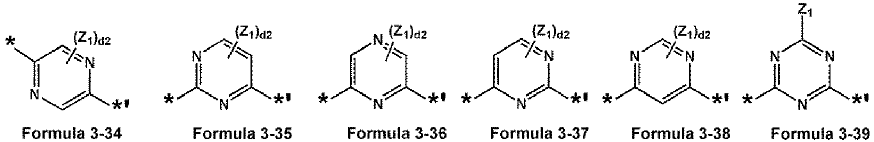

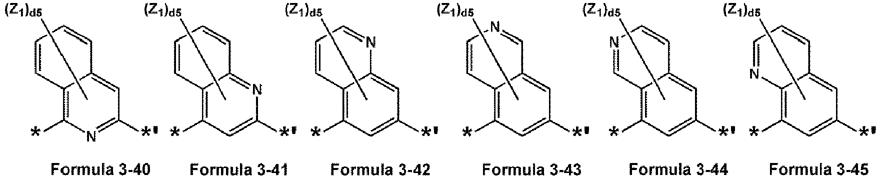

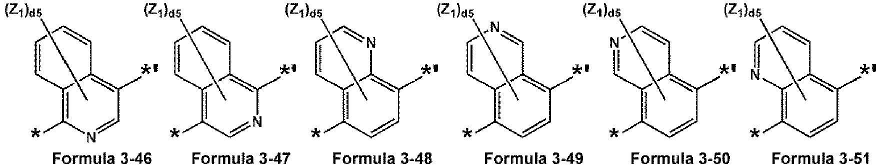

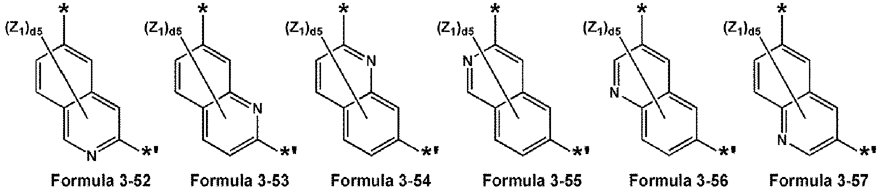

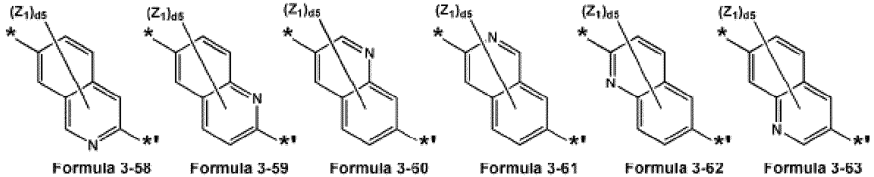

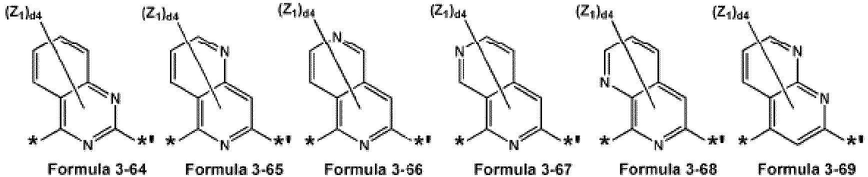

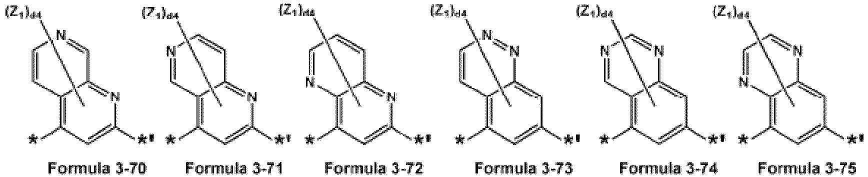

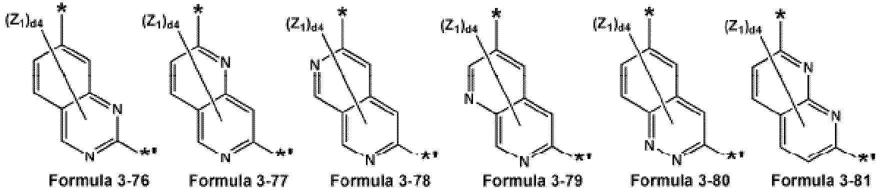

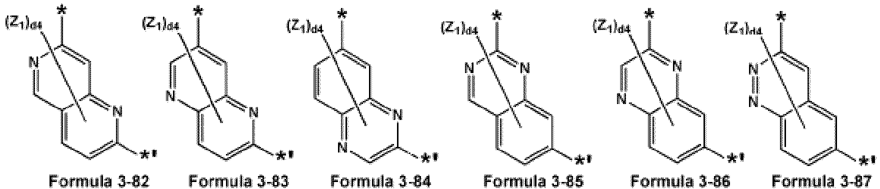

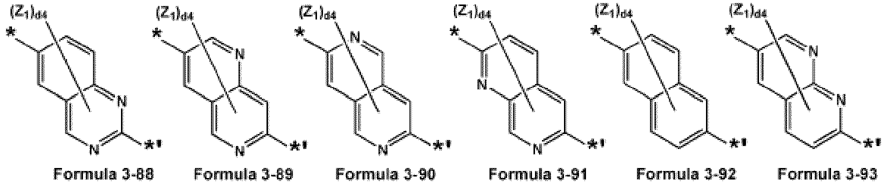

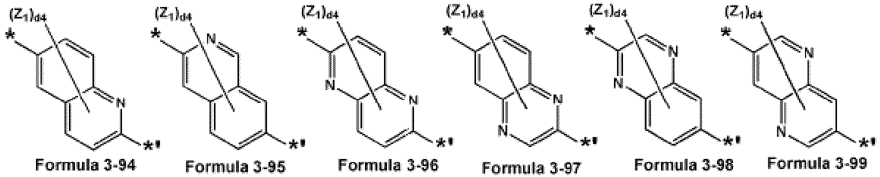

In Formulae 3-1 to 3-99,
Y₁ may be O, S, C(Z₃)(Z₄), N(Z₅), or Si(Z₆)(Z₇),
Z₁ to Z₇ may each independently be selected from hydrogen, deuterium, -F, -Cl, - Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
Q₃₁ to Q₃₃ may each independently be selected from
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group,
d2 may be an integer selected from 0 to 2,
d3 may be an integer selected from 0 to 3,
d4 may be an integer selected from 0 to 4,
d5 may be an integer selected from 0 to 5,
d6 may be an integer selected from 0 to 6,
d8 may be an integer selected from 0 to 8, and
* and *' indicate a binding site to a neighboring atom.

In Formulae 1A, 1B, 2A, and 2B, a1 to a4, a11, a12, a21, and a22 indicate the number of L₁(s), the number of L₂(s), the number of L₃(s), the number of L₄(s), the number of L₁₁(s), the number of L₁₂(s), the number of L₂₁(s), and the number of L₂₂(s), respectively. In Formulae 1A, 1B, 2A, and 2B, a1 to a4, a11, a12, a21, and a22 may each independently be an integer selected from 0 to 5. When a1 is two or more, two or more L₁(s) may be identical to or different from each other, when a2 is two or more, two or more L₂(s) may be identical to or different from each other, when a3 is two or more, two or more L₃(s) may be identical to or different from each other, when a4 is two or more, two or more L₄(s) may be identical to or different from each other, when a11 is two or more, two or more L₁₁(s) may be identical to or different from each other, when a12 is two or more, two or more L₁₂(s) may be identical to or different from each other, when a21 is two or more, two or more L₂₁(s) may be identical to or different from each other, and when a22 is two or more, two or more L₂₂(s) may be identical to or different from each other.

When a1 is zero, *-(L₁)ₐ₁-*' may be a single bond, when a2 is zero, *-(L₂)ₐ₂-*' may be a single bond, when a3 is zero, *-(L₃)ₐ₃-*' may be a single bond, when a4 is zero, *-(L₄)ₐ₄-*' may be a single bond, when a11 is zero, *-(L₁₁)ₐ₁₁-*' may be a single bond, when a12 is zero, *-(L₁₂)ₐ₁₂-*' may be a single bond, when a21 is zero, *-(L₂₁)ₐ₂₁-*' may be a single bond, and when a22 is a zero, *-(L₂₂)ₐ₂₂-*' may be a single bond.

When a1 to a4, a11, a12, a21, or a22 is zero, each respective b1 to b4, b11, b12, b21, and b22 may be 1. Thus, in any single incidence of a group *-[(L₁)ₐ₁-(R₁)_{b1}], when a1 is zero, b1 may be 1. In any single incidence of a group *-[(L₂)ₐ₂-(R₂)_{b2}], when a2 is zero, b2 may be 1. In any single incidence of a group *-(L₃)ₐ₃-(R₃)_{b3}, when a3 is zero, b3 may be 1. In any single incidence of a group *-(L₄)ₐ₄-(R₄)_{b4}, when a4 is zero, b4 may be 1. In any single incidence of a group *-[(L₁₁)ₐ₁₁-(R₁₁)_{b11}], when a11 is zero, b11 may be 1. In any single incidence of a group *-[(L₁₂)ₐ₁₂-(R₁₂)_{b12}], when a12 is zero, b12 may be 1. In any single incidence of a group *-[(L₂₁)ₐ₂₁-(R₂₁)_{b21}], when a21 is zero, b21 may be 1. In any single incidence of a group *-[(L₂₂)ₐ₂₂-(R₂₂)_{b22}], when a22 is zero, b22 may be 1.

a1 to a4, a11, a12, a21, and a22 in Formulae 1A, 1B, 2A, and 2B may each independently be an integer selected from 0 to 3.

In Formulae 1A, 1B, 2A, and 2B,
R₁ to R₄, R₁₁ to R₁₄, R₂₁ to R₂₄, R₂₇, and R₂₈ are each independently selected from hydrogen, deuterium(-D), -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, - Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂).

In addition to the definition provided above, in which R₁₁ and R₁₃ are separate groups, R₁₁ and R₁₃ may alternatively be connected to each other to form, together with the atom to which they are attached, a C₅-C₆₀ carbocyclic group or a C₁-C₆₀ heterocyclic group .

In addition to the definition provided above, in which, R₁₂ and R₁₄ are separate groups, R₁₂ and R₁₄ may alternatively be connected to each other to form, together with the atom to which they are attached, a C₅-C₆₀ carbocyclic group or a C₁-C₆₀ heterocyclic group together with the atom to which they are attached, a C₅-C₆₀ carbocyclic group or a C₁-C₆₀ heterocyclic group.

For example, in Formulae 1A, 1B, 2A, and 2B,
R₁ to R₄, R₁₁ to R₁₄, R₂₁ to R₂₄, R₂₇, and R₂₈ may each independently be selected from
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group; and
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂),
wherein Q₁ to Q₃ and Q₃₁ to Q₃₃ may each independently be selected from
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group.

In Formulae 1A, 1B, 2A, and 2B,
R₁ to R₄, R₁₁ to R₁₄, R₂₁ to R₂₄, R₂₇, and R₂₈ may each independently be selected from
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
groups represented by Formulae 5-1 to 5-45 and Formulae 6-1 to 6-124; and
-Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₁):

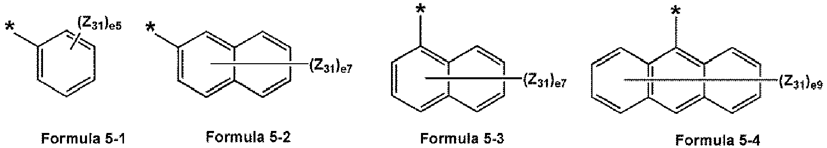

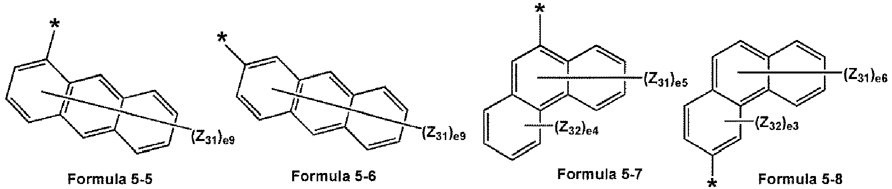

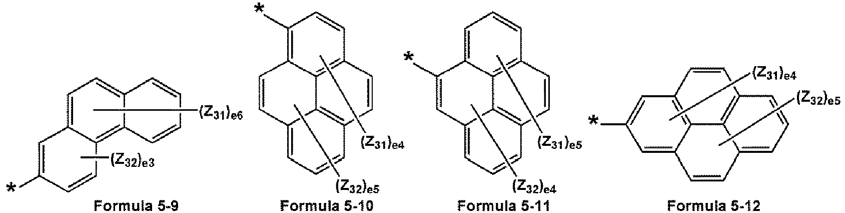

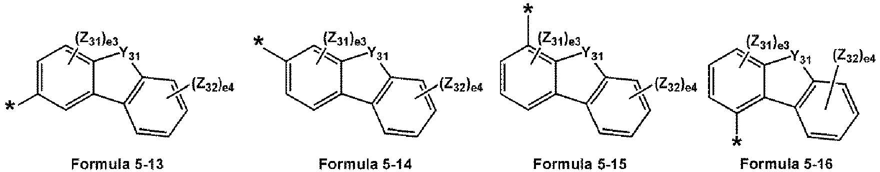

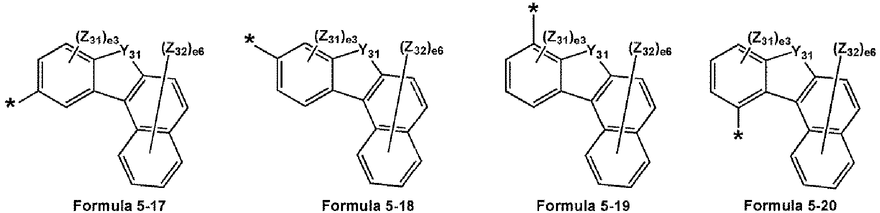

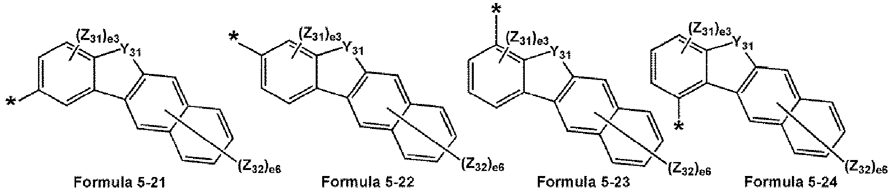

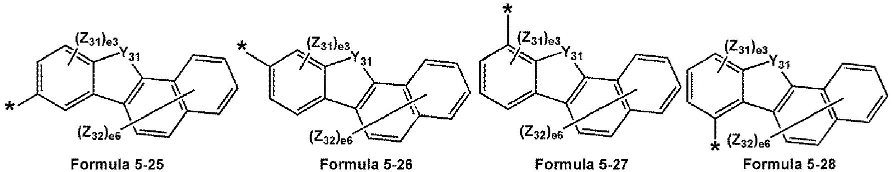

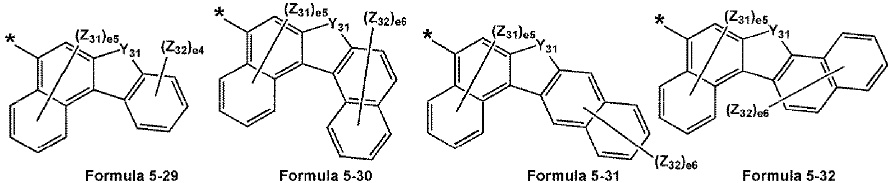

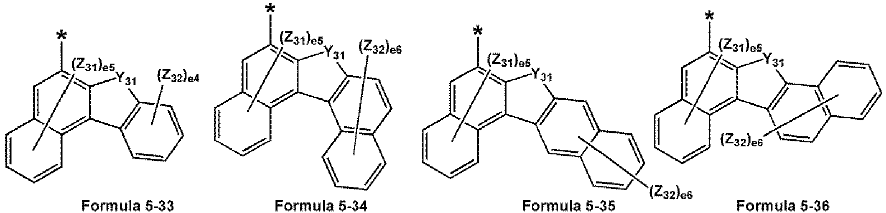

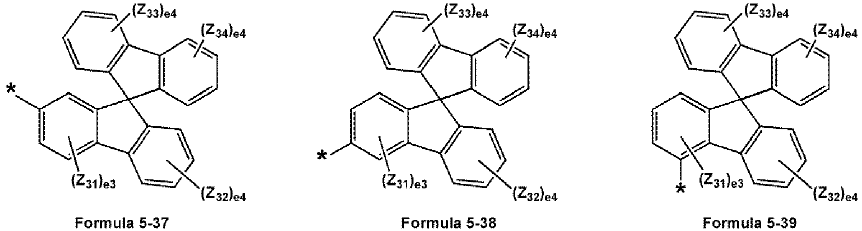

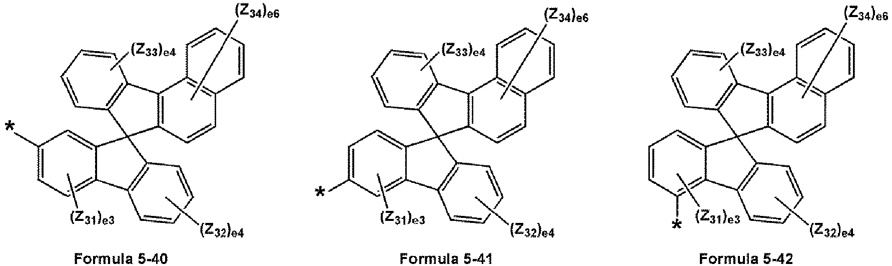

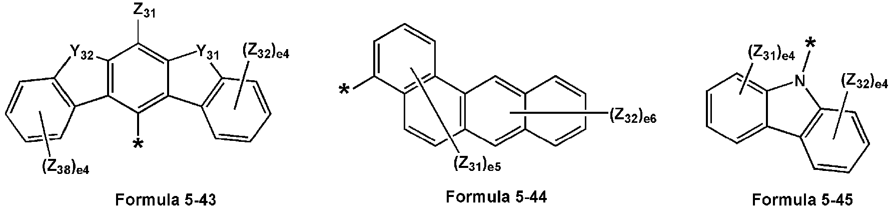

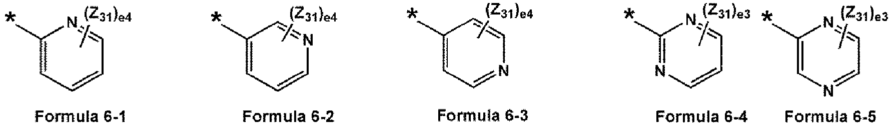

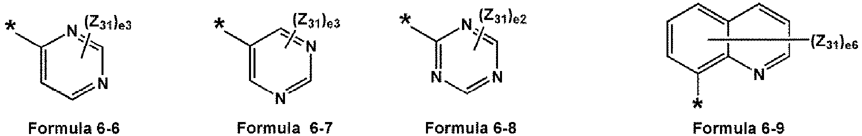

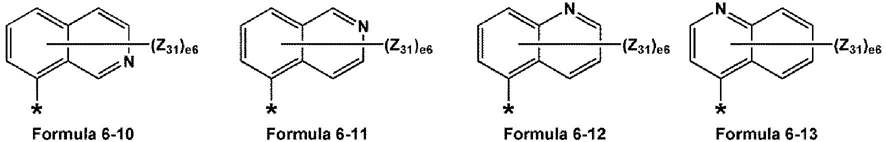

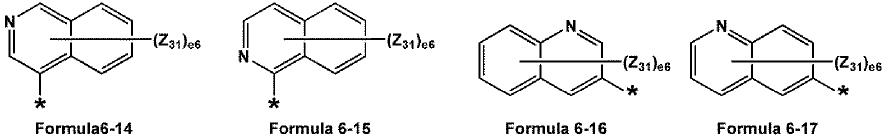

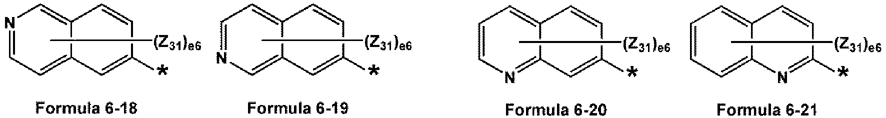

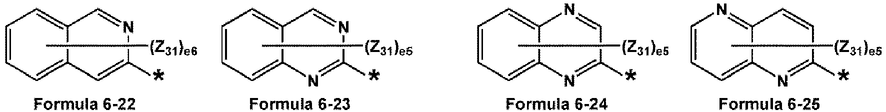

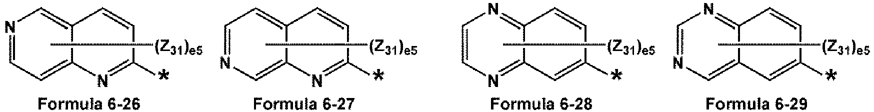

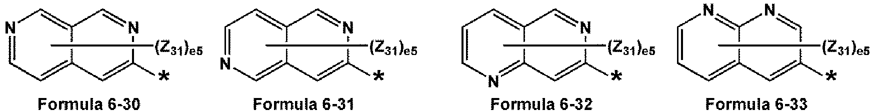

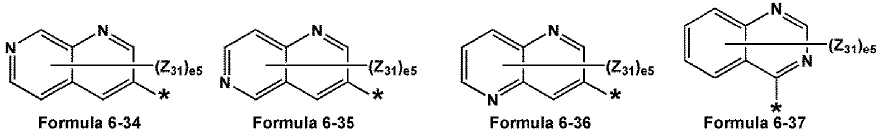

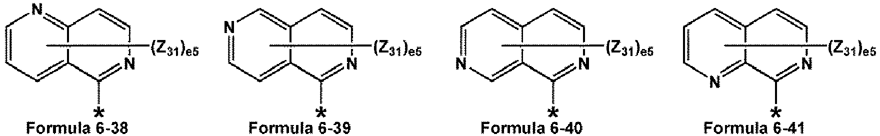

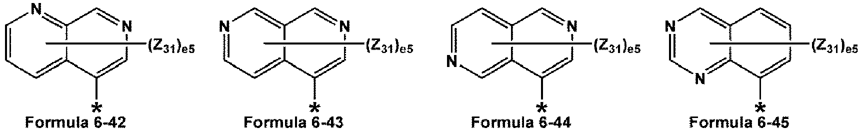

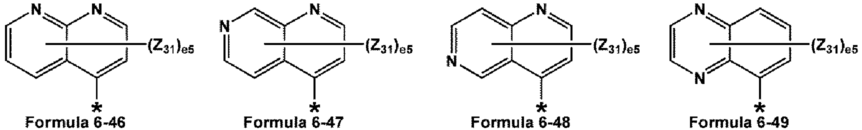

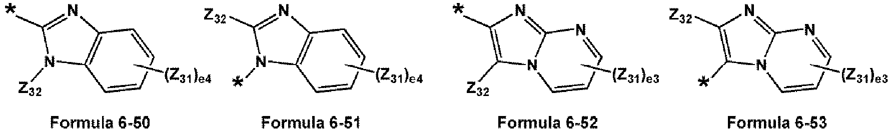

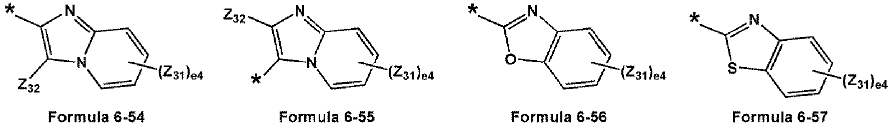

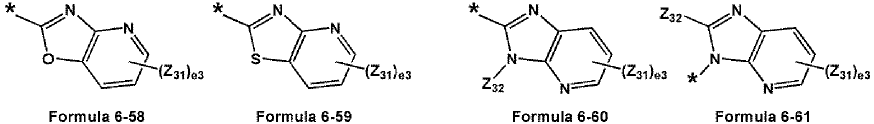

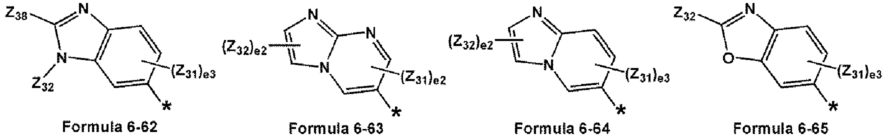

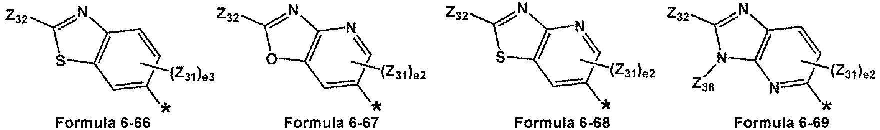

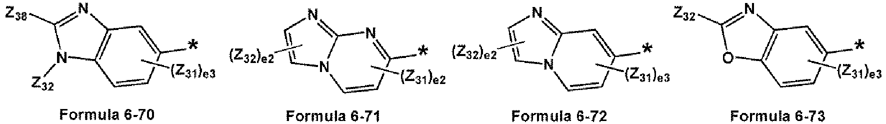

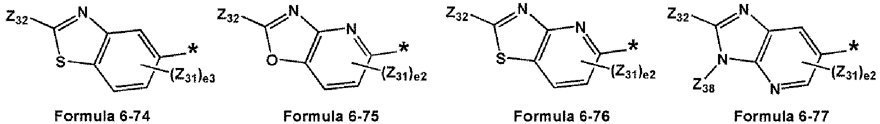

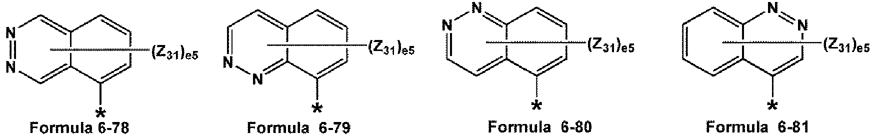

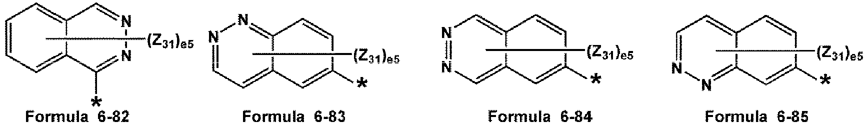

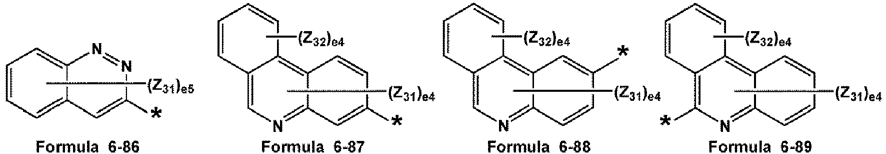

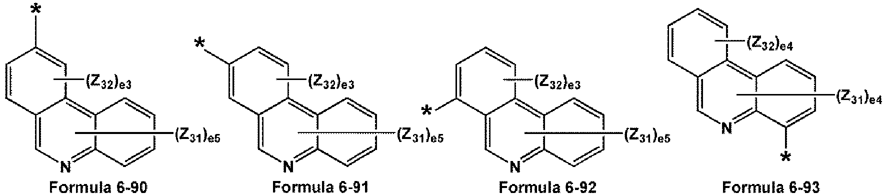

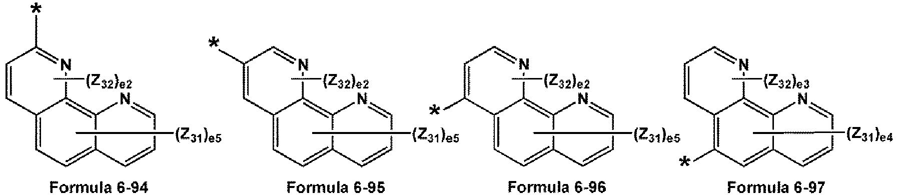

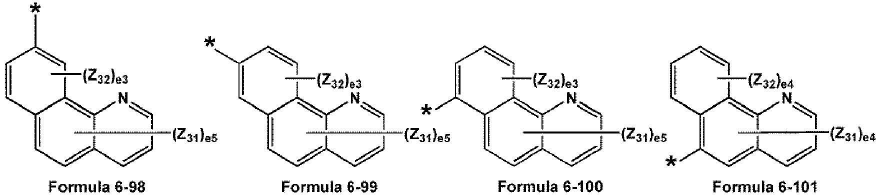

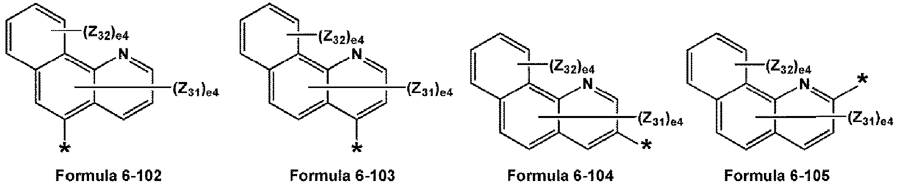

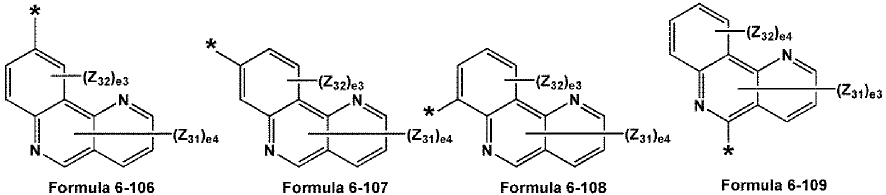

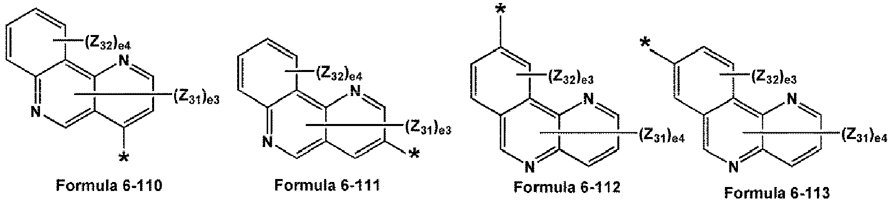

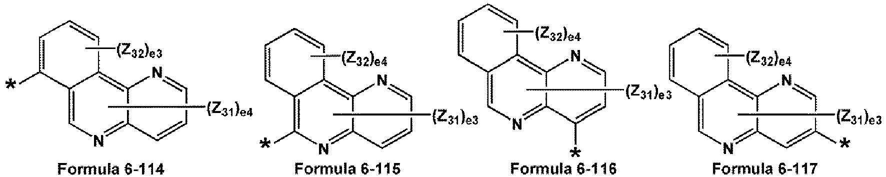

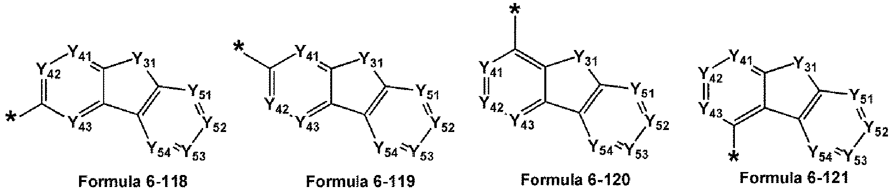

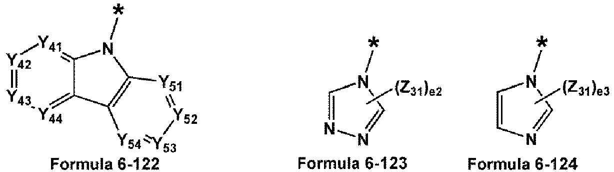

In Formulae 5-1 to 5-45 and 6-1 to 6-124,
Y₃₁ and Y₃₂ may each independently be O, S, C(Z₃₃)(Z₃₄), N(Z₃₅), or Si(Z₃₆)(Z₃₇),
Y₄₁ may be N or C(Z₄₁), Y₄₂ may be N or C(Z₄₂), Y₄₃ may be N or C(Z₄₃), Y₄₄ may be N or C(Z₄₄), Y₅₁ may be N or C(Z₅₁), Y₃₂ may be N or C(Z₅₂), Y₅₃ may be N or C(Z₅₃), Y₅₄ may be N or C(Z₅₄), at least one selected from Y₄₁ to Y₄₃ and Y₅₁ to Y₅₄ in Formulae 5-118 to 5-121 may be N, and at least one selected from Y₄₁ to Y₄₄ and Y₅₁ to Y₅₄ in Formula 5-122 may be N,
Z₃₁ to Z₃₈, Z₄₁ to Z₄₄, and Z₅₁ to Z₅₄ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, and -Si(Q₃₁)(Q₃₂)(Q₃₃),
wherein Q₁ to Q₃ and Q₃₁ to Q₃₃ may each independently be selected from
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group,
e2 may be an integer selected from 0 to 2,
e3 may be an integer selected from 0 to 3,
e4 may be an integer selected from 0 to 4,
e5 may be an integer selected from 0 to 5,
e6 may be an integer selected from 0 to 6,
e7 may be an integer selected from 0 to 7,
e9 may be an integer selected from 0 to 9, and
* indicates a binding site to a neighboring atom.

In Formulae 1A to 1E, 2A, and 2B,
R₁ to R₄, R₂₂ to R₂₄, R₂₇, and R₂₈ may each independently be selected from
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
groups represented by Formulae 9-1 to 9-100 and 10-1 to 10-121; and
-Si(Q₁)(Q₂)(Q₃), -N(Q₁)(Q₂), -B(Q₁)(Q₂), -C(=O)(Q₁), -S(=O)₂(Q₁), and - P(=O)(Q₁)(Q₂), and
R₁₁ to R₁₄ and R₂₁ may each independently be selected from groups represented by Formulae 9-1 to 9-100 and 10-1 to 10-121; and
-Si(Q₁)(Q₂)(Q₃), -N(Q₁)(Q₂), -B(Q₁)(Q₂), -C(=O)(Q₁), -S(=O)₂(Q₁), and - P(=O)(Q₁)(Q₂):

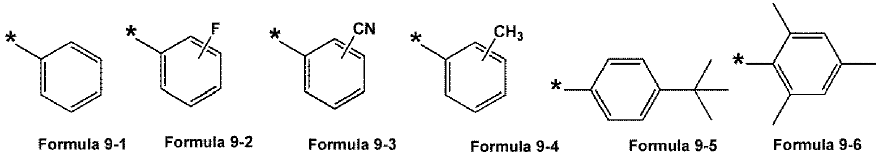

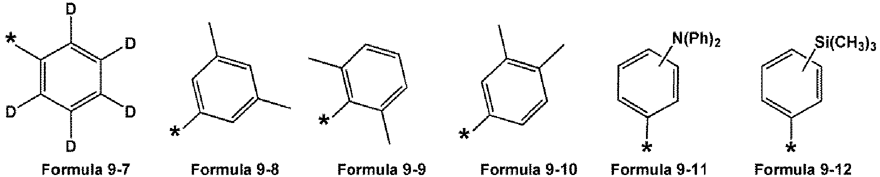

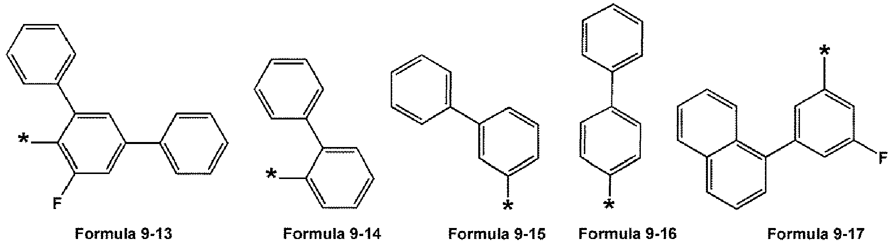

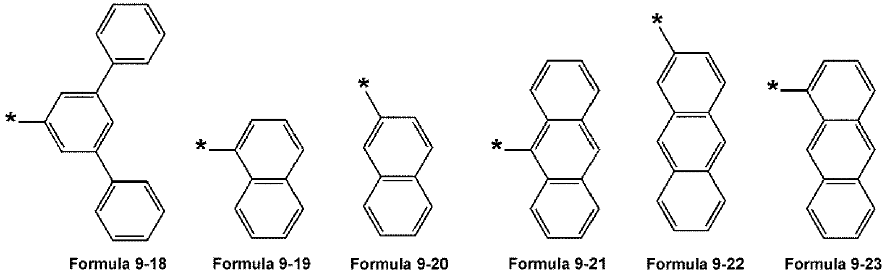

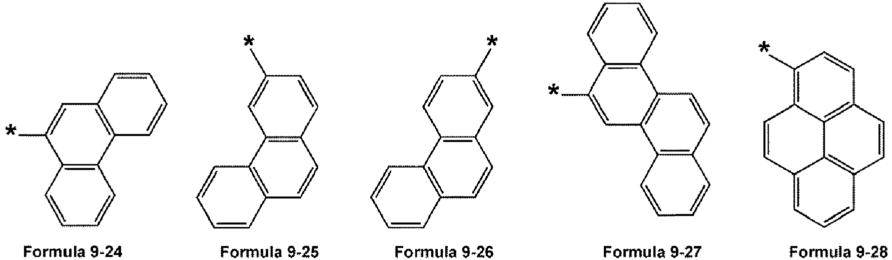

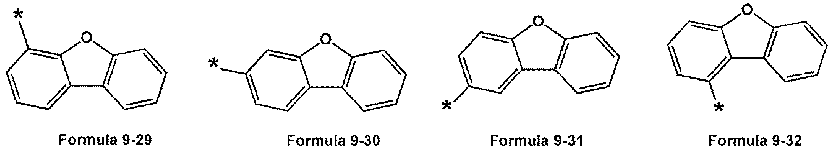

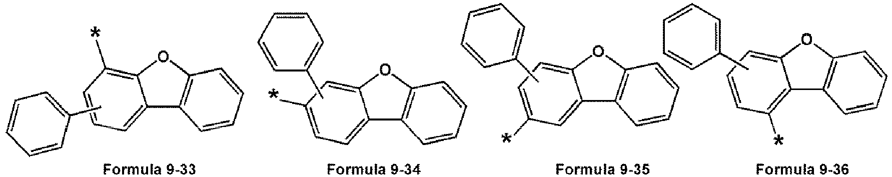

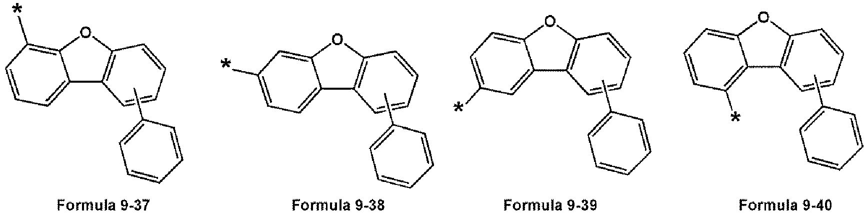

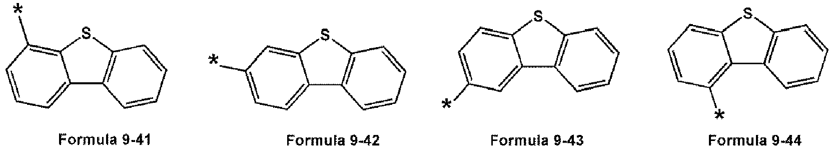

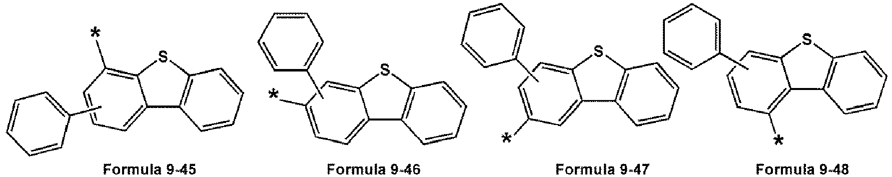

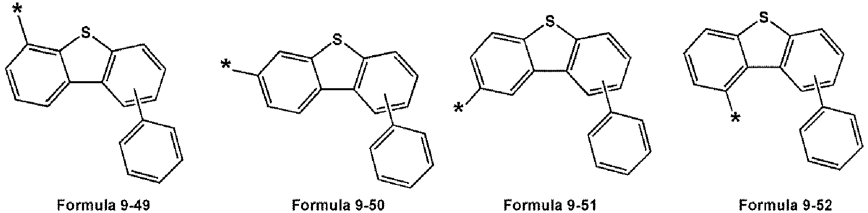

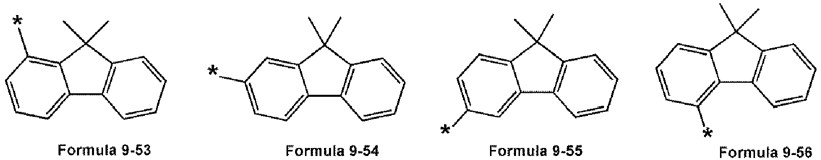

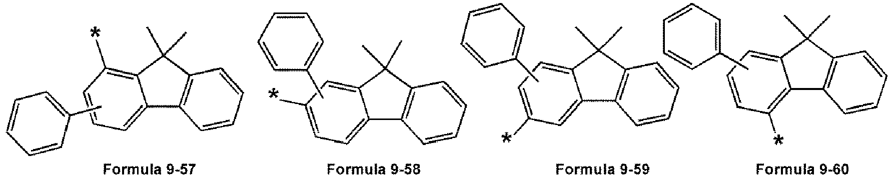

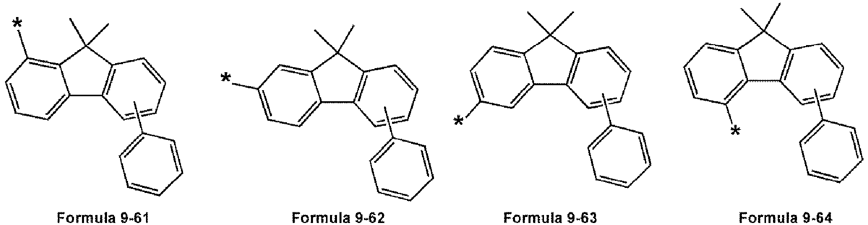

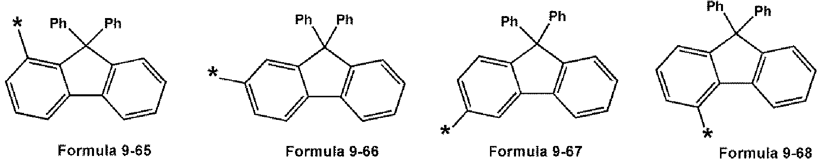

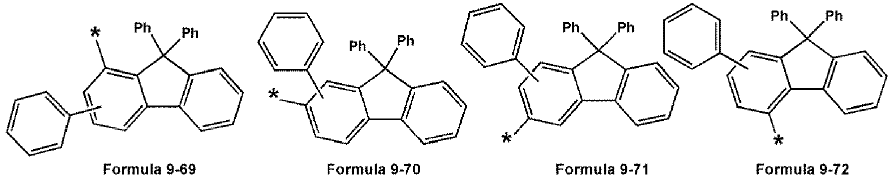

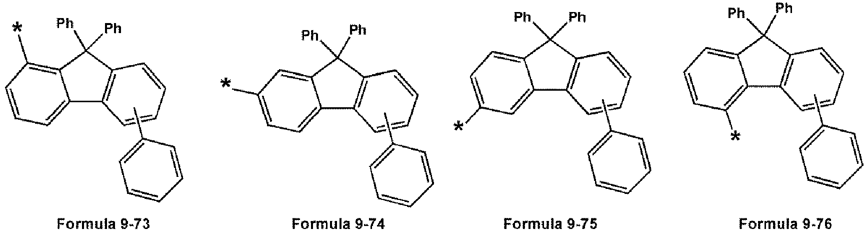

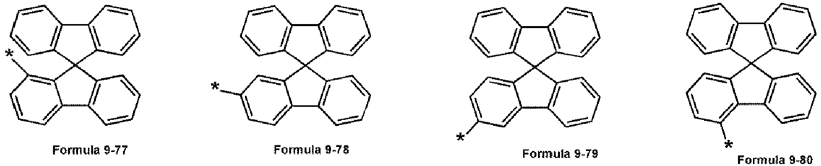

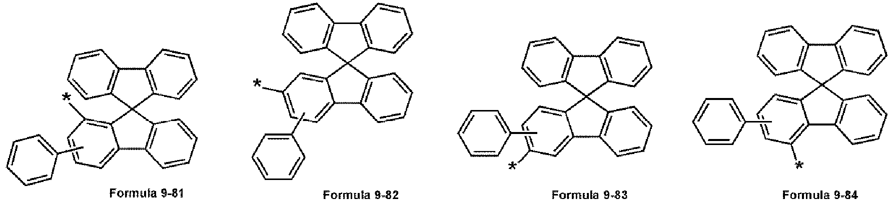

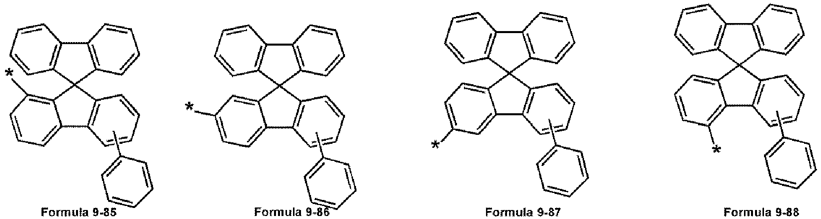

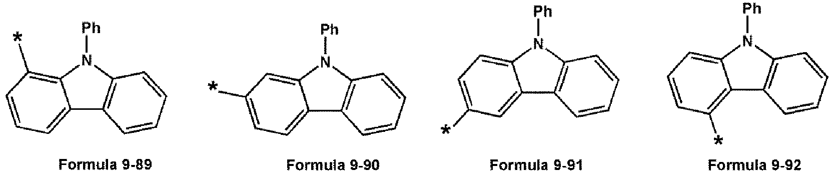

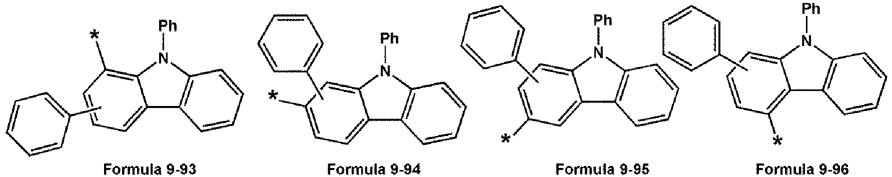

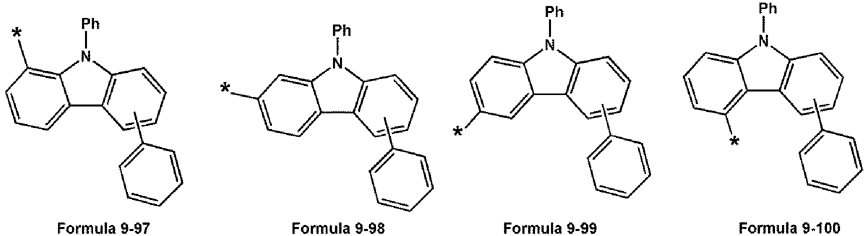

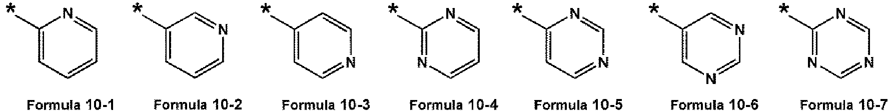

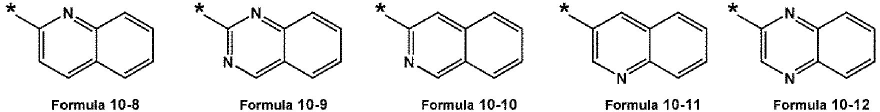

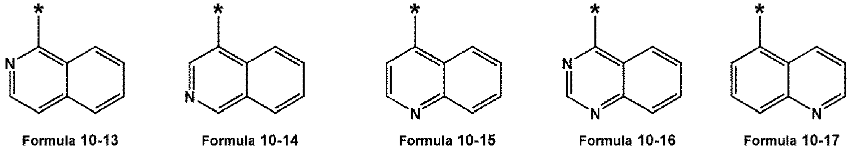

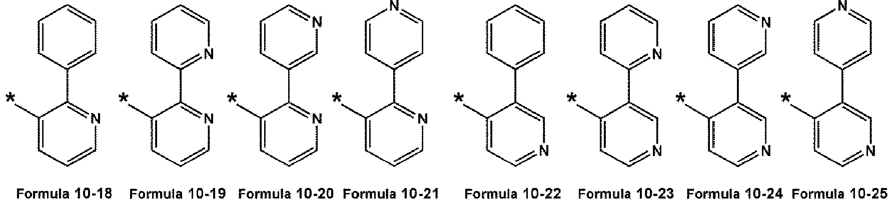

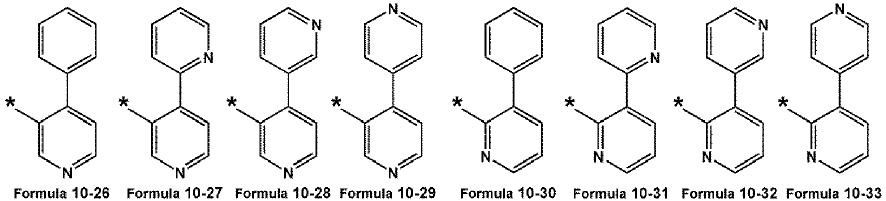

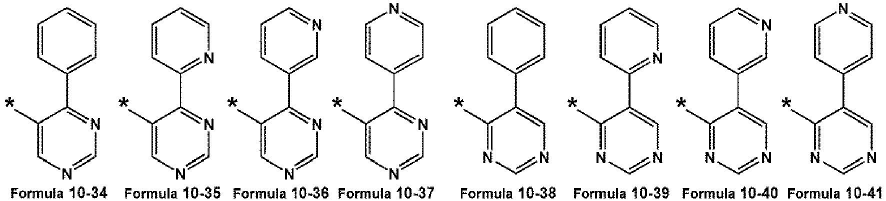

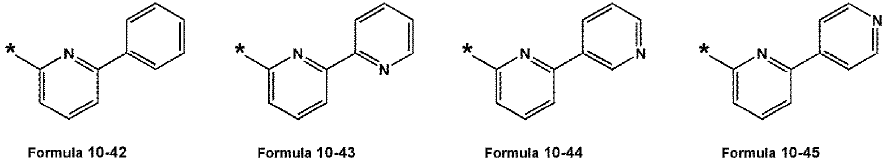

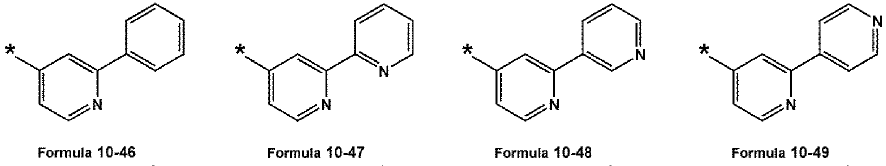

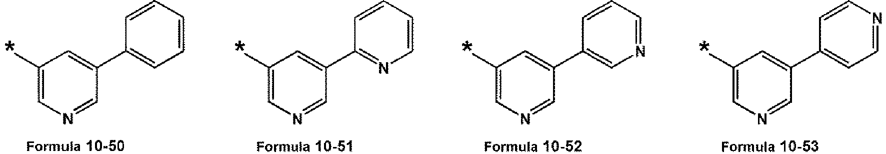

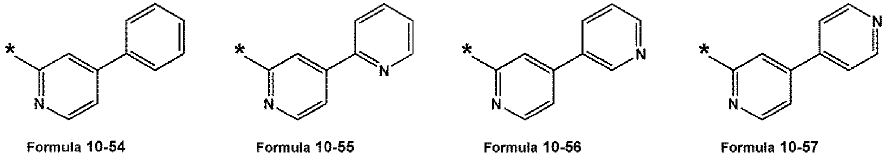

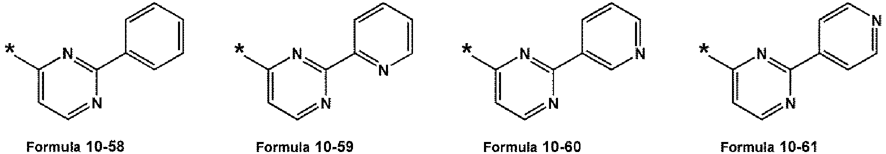

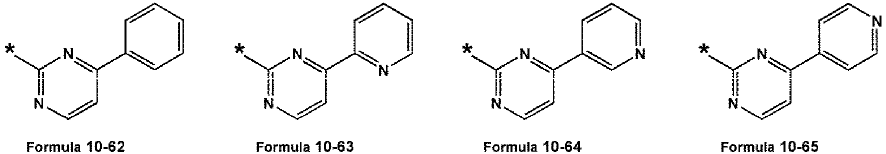

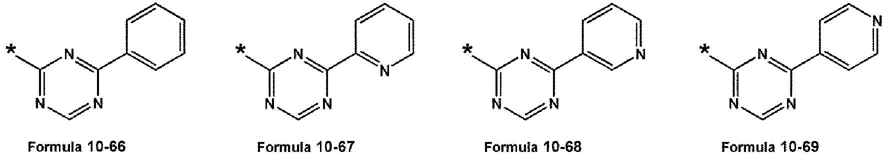

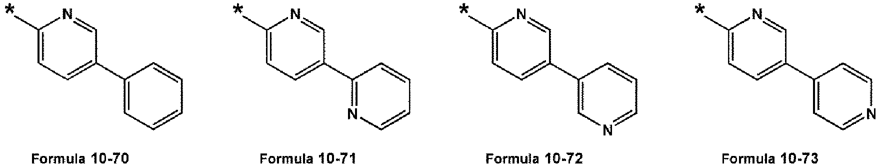

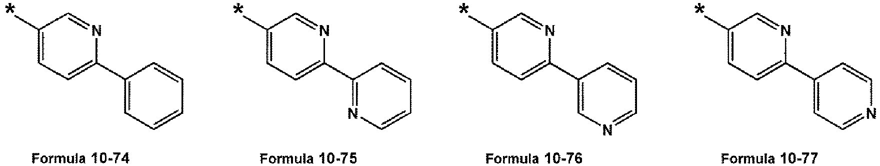

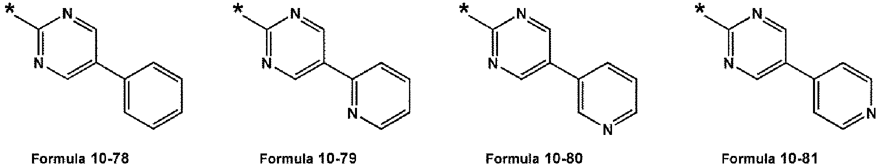

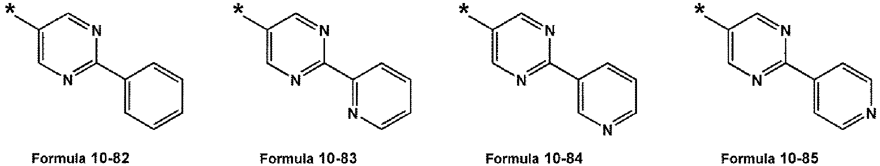

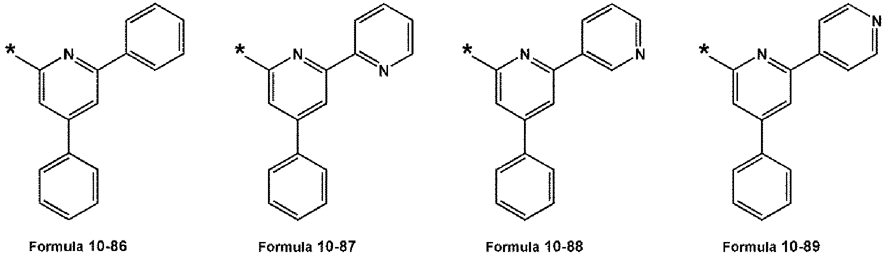

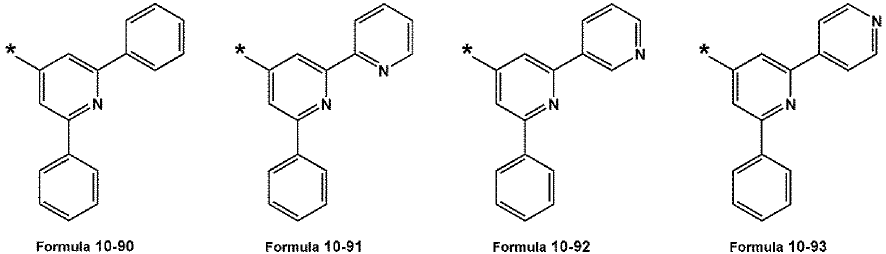

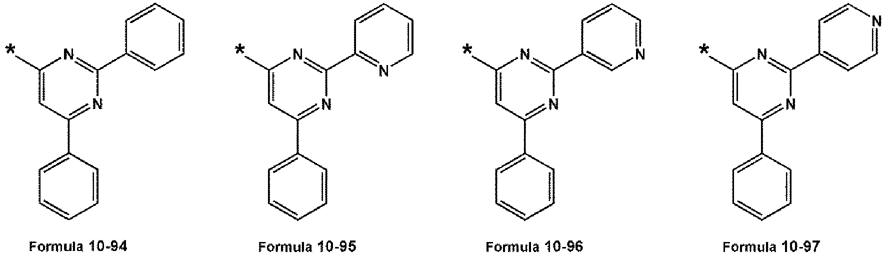

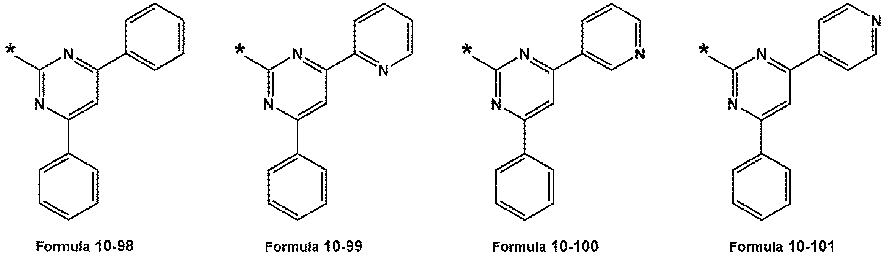

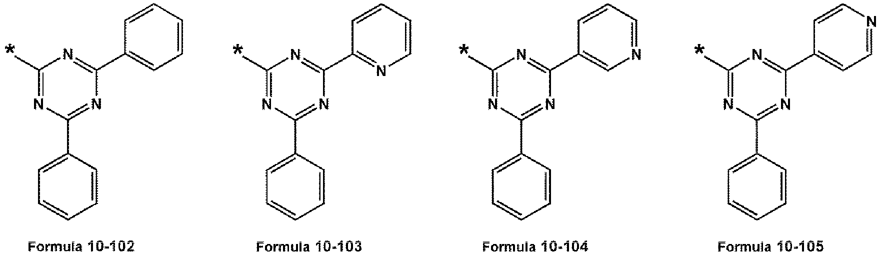

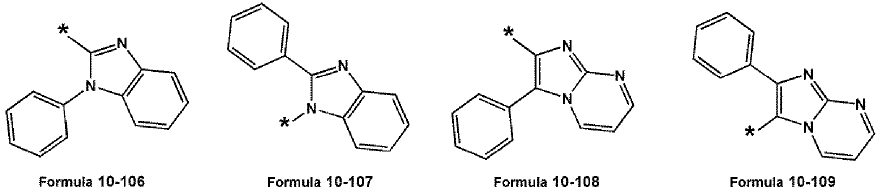

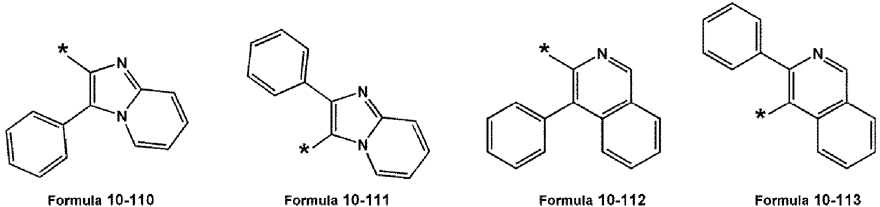

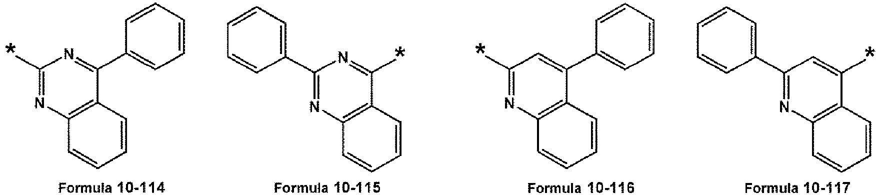

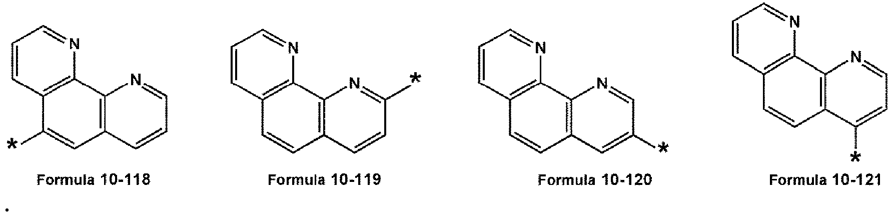

In Formulae 9-1 to 9-100 and 10-1 to 10-121, Ph refers to a phenyl group, and * indicates a binding site to a neighboring atom.

In Formulae 1A, 1B, 2A, and 2B, b1 to b4, b11, b12, b21, and b22 indicate the number of R₁(s), the number of R₂(s), the number of R₃(s), the number of R₄(s), the number of R₁₁(s), the number of R₁₂(s), the number of R₂₁(s), and the number of R₂₂(s), respectively. b1 to b4, b11, b12, b21, and b22 are each independently an integer selected from 1 to 3.

When b1 is two or more, two or more R₁(s) may be identical to or different from each other, when b2 is two or more, two or more R₂(s) may be identical to or different from each other, when b₃ is two or more, two or more R₃(s) may be identical to or different from each other, when b4 is two or more, two or more R₄(s) may be identical to or different from each other, when b11 is two or more, two or more R₁₁(s) may be identical to or different from each other, when b12 is two or more, two or more R₁₂(s) may be identical to or different from each other, when b21 is two or more, two or more R₂₁(s) may be identical to or different from each other, and when b22 is two or more, two or more R₂₂(s) may be identical to or different from each other.

In Formulae 1A, 1B, 2A, and 2B, c1 to c4 indicate the number of *-[(L₁)ₐ₁-(R₁)_{b1}](s), the number of *-[(L₂)ₐ₂-(R₂)_{b2}](s), the number of *-[(L₃)ₐ₃-(R₃)_{b3}](s), and the number of *-[(L₄)ₐ₄-(R₄)_{b4}](s), respectively. c1 and c2 are each independently an integer selected from 0 to 8, and c3 and c4 are each independently an integer selected from 0 to 4.

When c1 is two or more, two or more *-[(L₁)ₐ₁-(R₁)_{b1}](s) may be identical to or different from each other, when c2 is two or more, two or more *-[(L₂)ₐ₂-(R₂)_{b2}](s) may be identical to or different from each other, when c3 is two or more, two or more *-[(L₃)ₐ₃-(R₃)_{b3}](s) may be identical to or different from each other, and when c4 is two or more, two or more *-[(L₄)ₐ₄-(R₄)_{b4}](s) may be identical to or different from each other.

For example, in Formulae 1A, 1B, 2A, and 2B,
the sum of c1 to c4 may be 1, 2, or 3.

The first compound may be represented by one selected from Formulae 1-1 to 1-3:

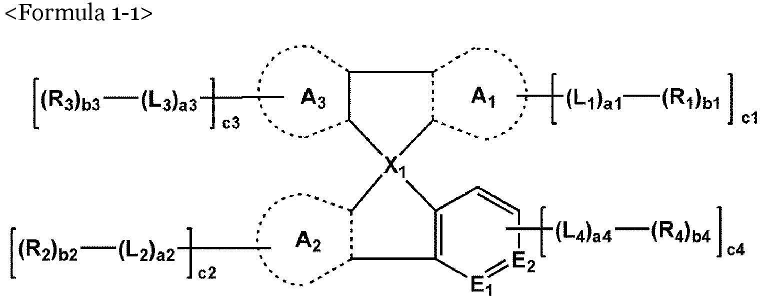

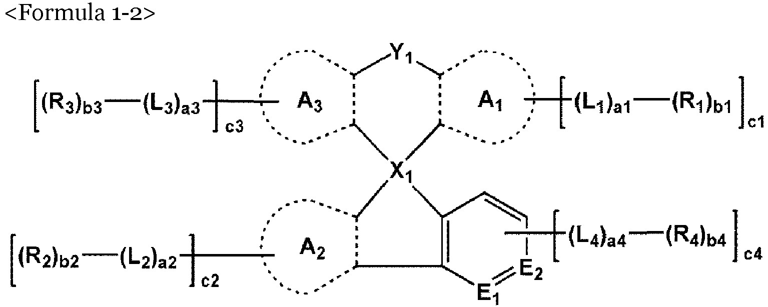

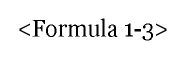

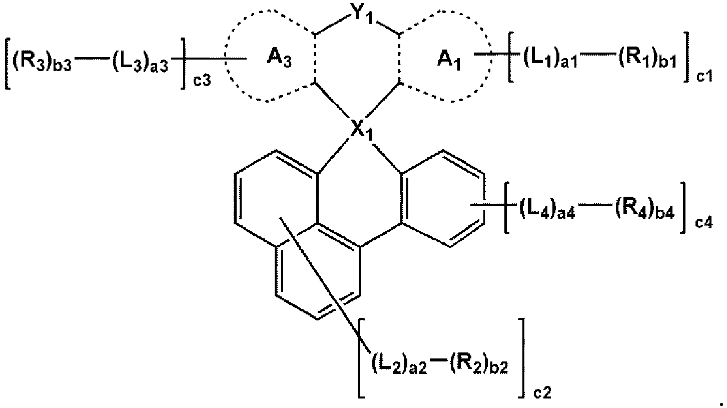

In Formulae 1-1 to 1-3,
rings A₁ to A₃, X₁, E₁, E₂, L₁ to L₄, a1 to a4, R₁ to R₄, b1 to b4, c1, c3, and c4 are the same as described above,
c2 may be an integer selected from 0 to 6,
Y₁ may be selected from N[(L₁₁)ₐ₁₁-(R₁₁)_{b11}], C(R₁₁)(R₁₃), Si(R₁₁)(R₁₃), O, S, and Se, and
L₁₁, a11, R₁₁, R₁₃, and b11 are the same as described above.

For example, in Formulae 1-1 to 1-3,
ring A₁ may be selected from a benzene group, a naphthalene group, a pyridine group, a dibenzofuran group, and a pyrimidine group,
rings A₂ and A₃ may each independently be selected from a benzene group, a naphthalene group, an anthracene group, a phenanthrene group, an indene group, an indenopyridine group, a fluorene group, a pyridine group, a pyrimidine group, a pyrazine group, a pyrrole group, an imidazole group, a quinoline group, an isoquinoline group, a quinazoline group, a phenanthroline group, a phenanthridine group, a furan group, a thiophene group, an indole group, an indolocarbazole group, a benzofuran group, a benzofurocarbazole group, a benzofuropyrimidine group, a benzothiophene group, a benzoxazole group, a benzothiazole group, a benzoimidazole group, a carbazole group, a dibenzofuran group, a dibenzothiophene group, a pyridoindole group, a dipyridofuran group, a dipyridothiophene group, a pyrimidobenzofuran group, a dipyridopyrrole group, and a pyrimidobenzothiophene group, and
R₁ to R₄ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂).

The first compound may be selected from Compounds 1-1 to 1-160:

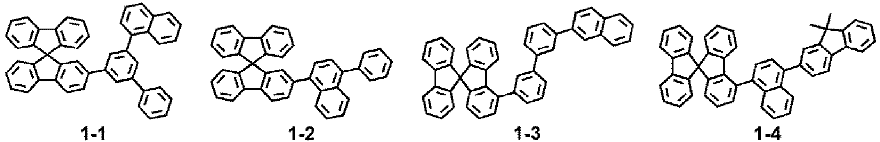

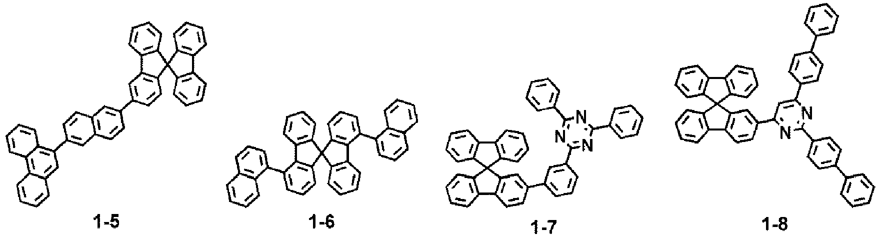

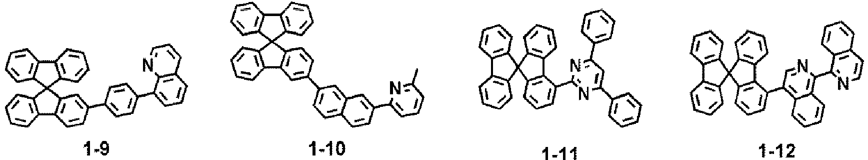

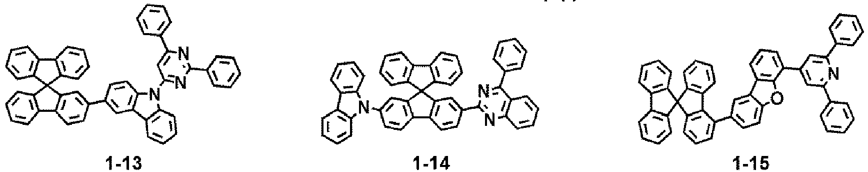

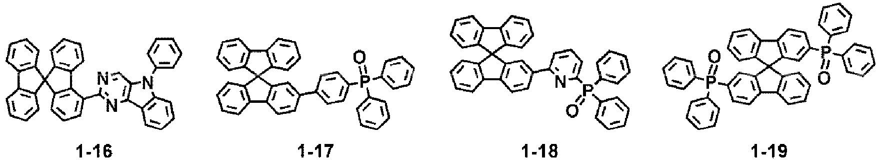

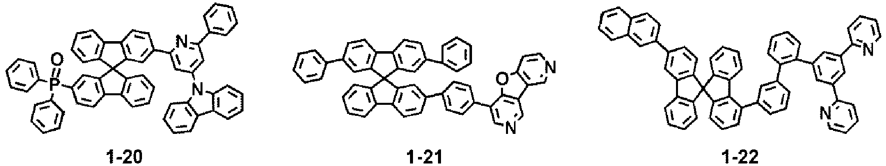

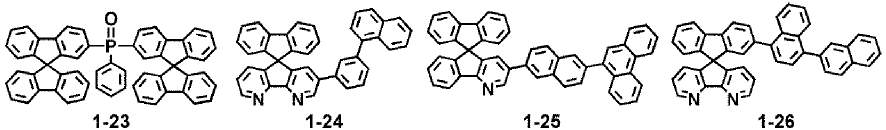

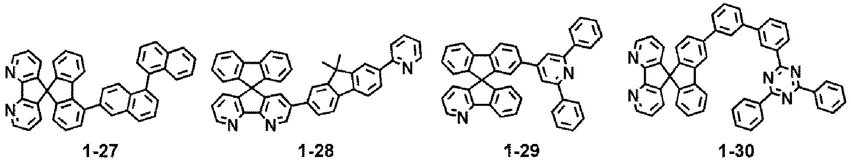

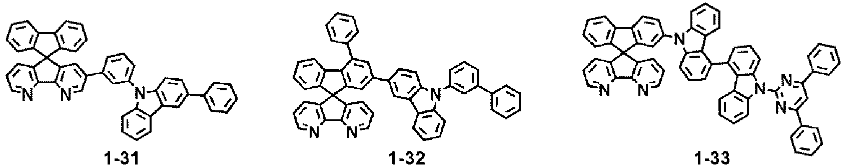

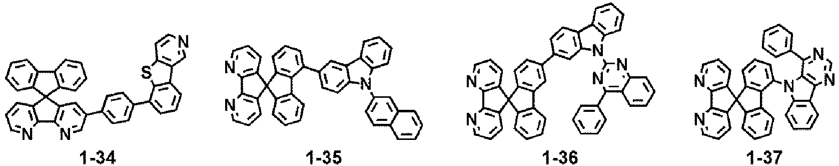

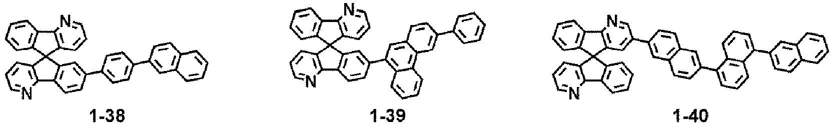

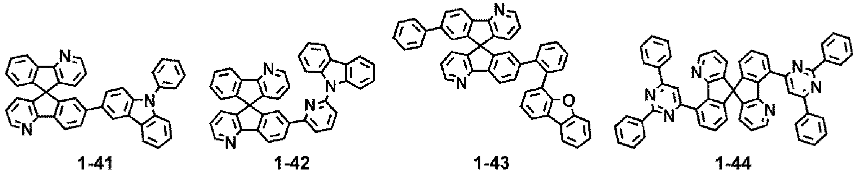

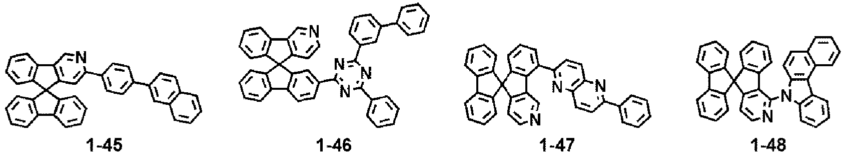

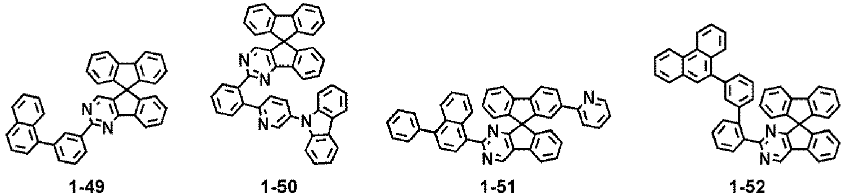

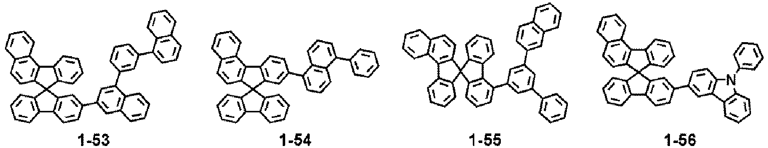

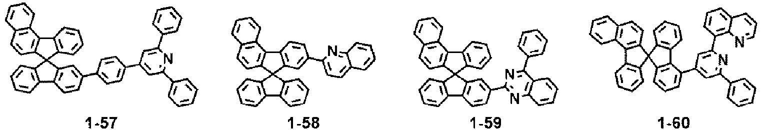

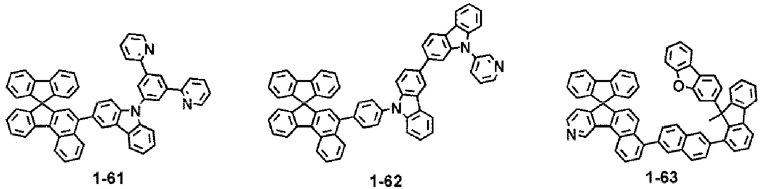

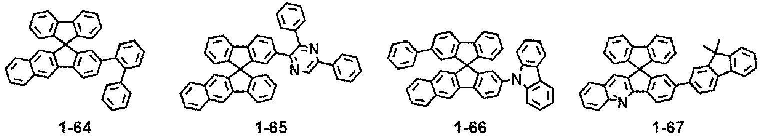

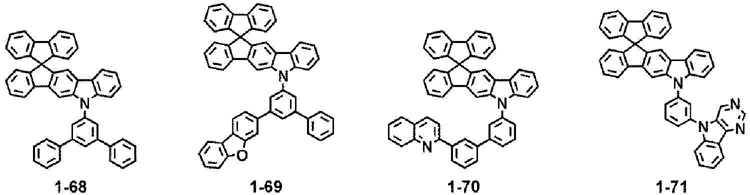

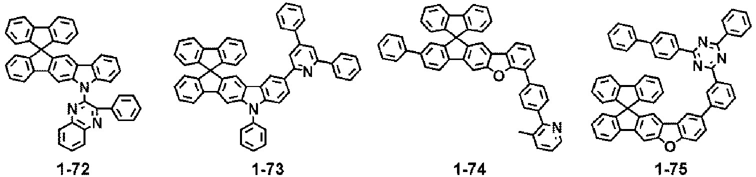

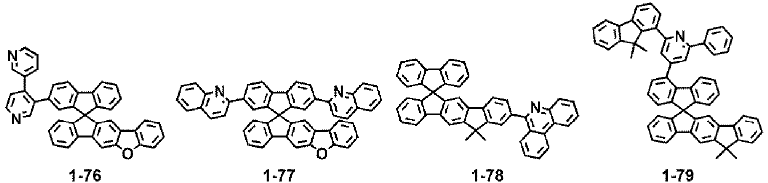

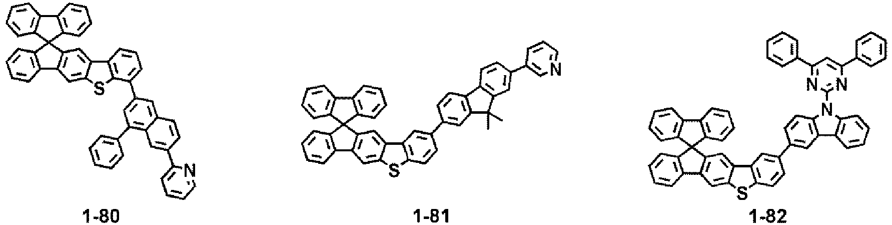

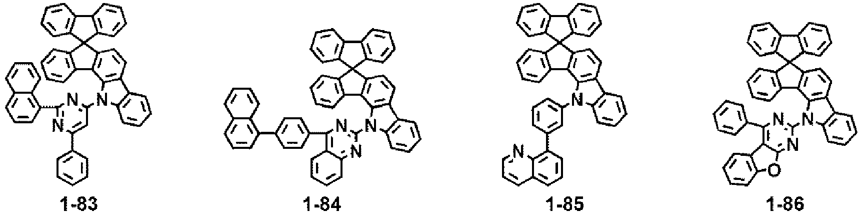

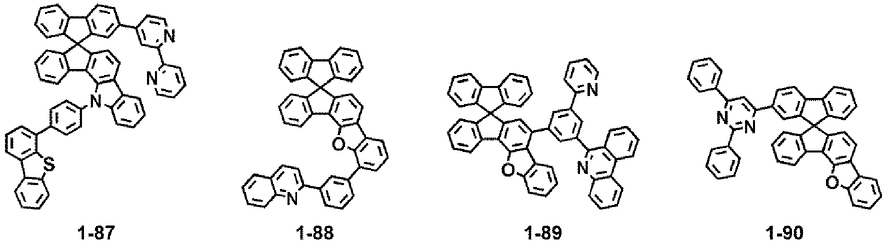

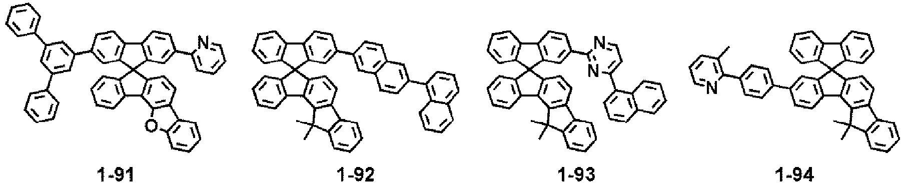

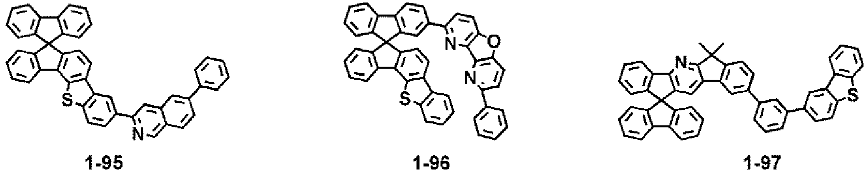

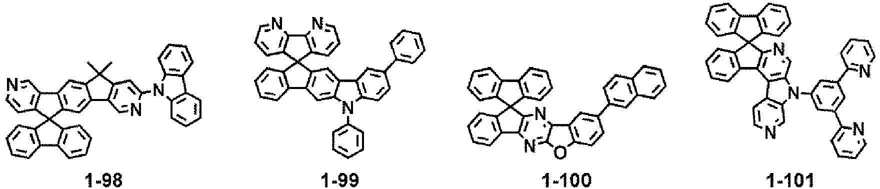

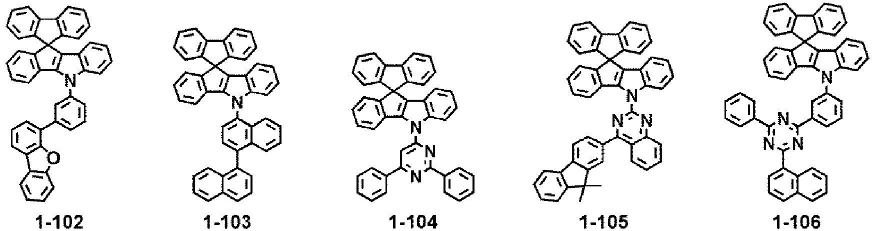

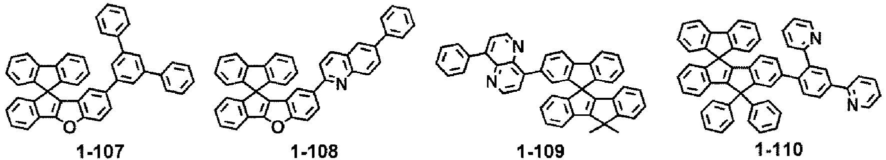

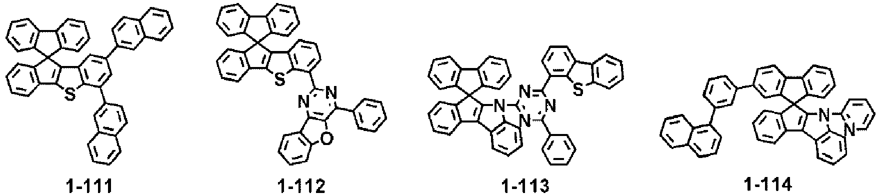

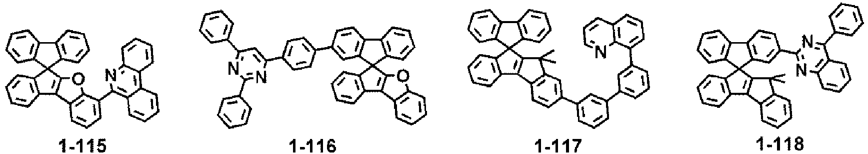

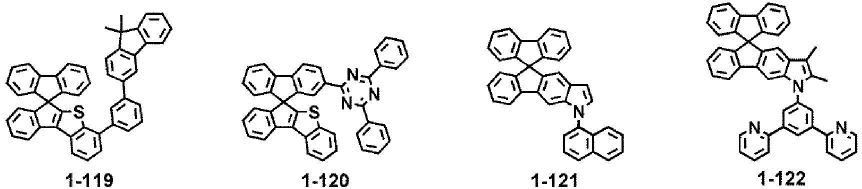

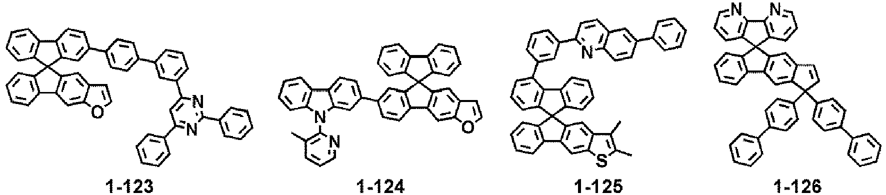

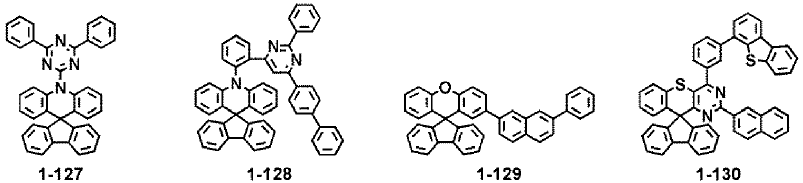

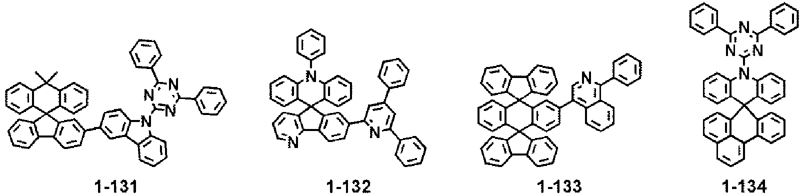

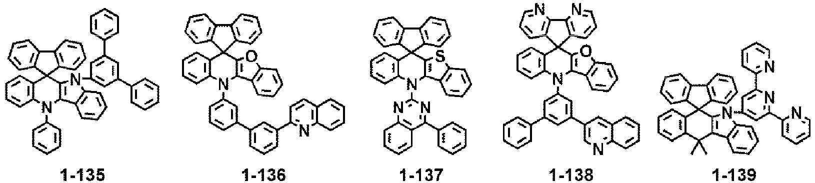

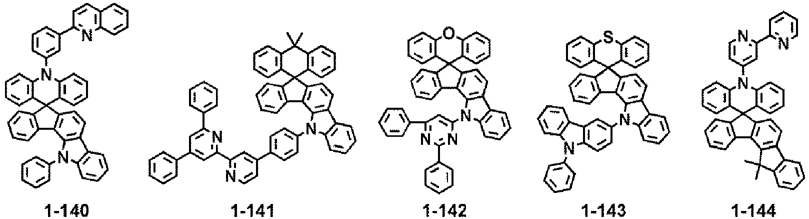

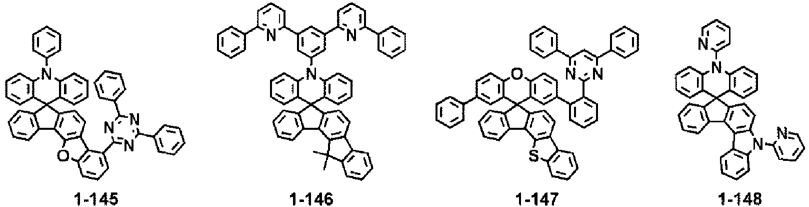

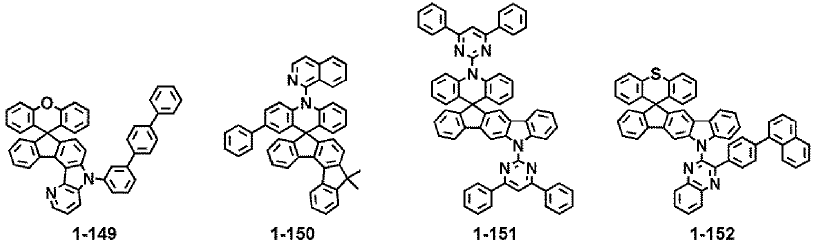

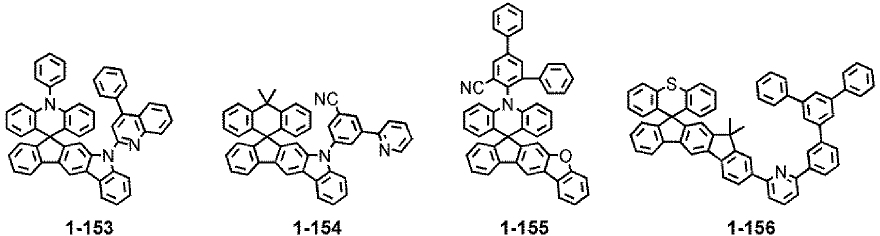

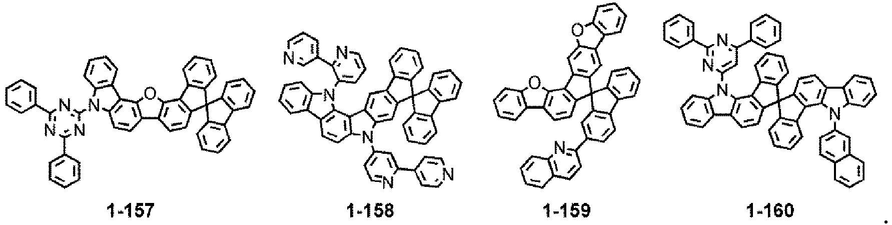

The second compound may be selected from Compounds 2-1a to 2-172a and 2-1 to 2-262:

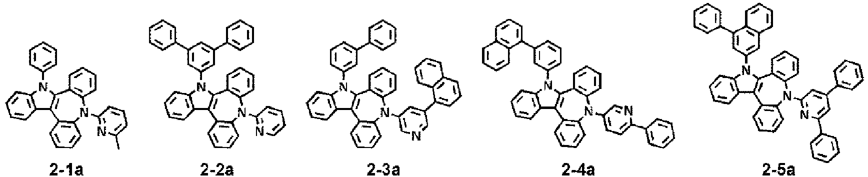

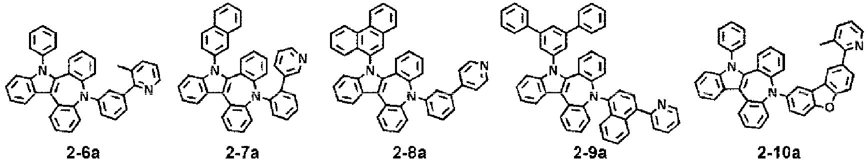

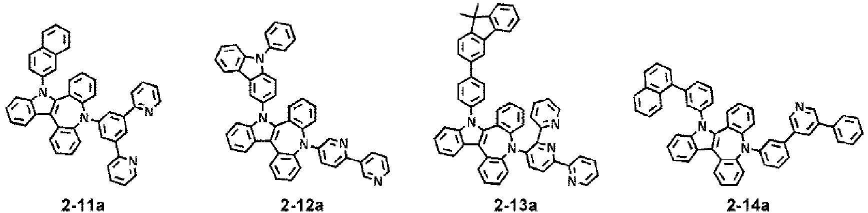

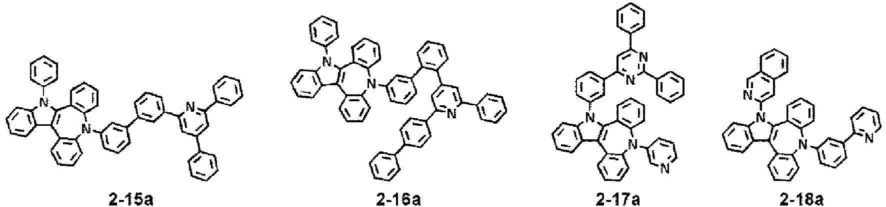

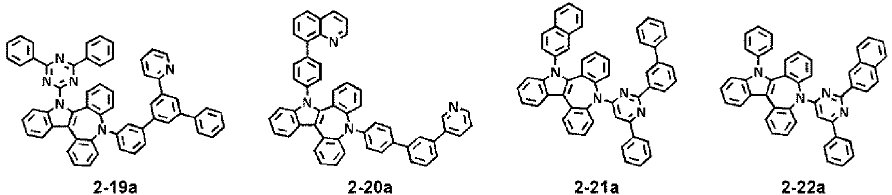

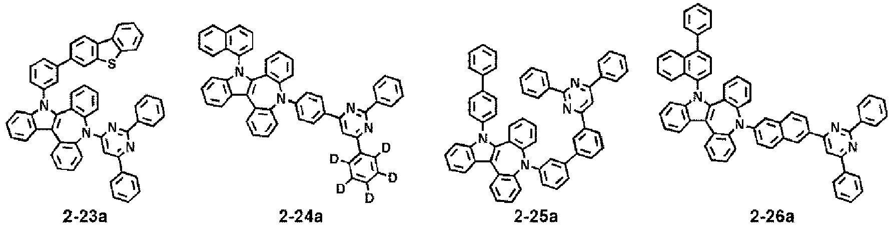

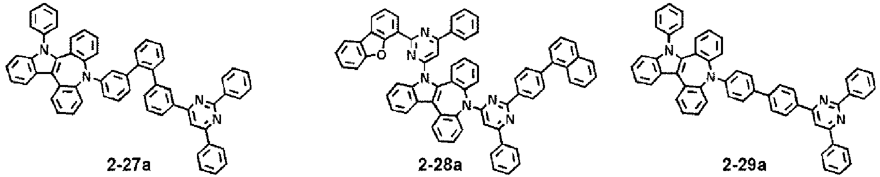

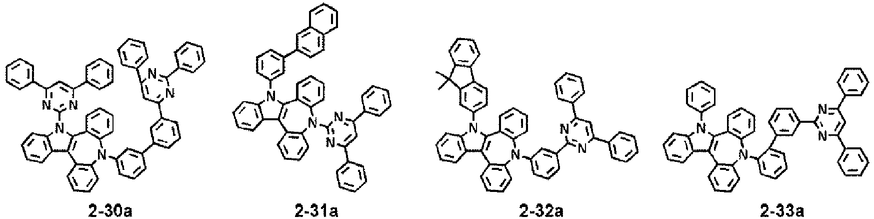

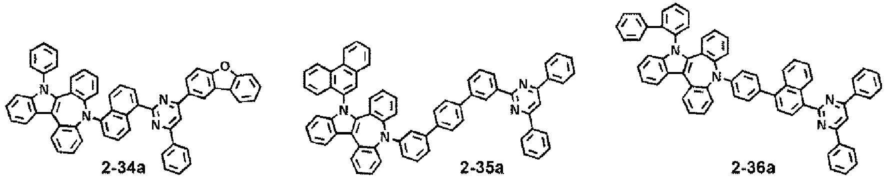

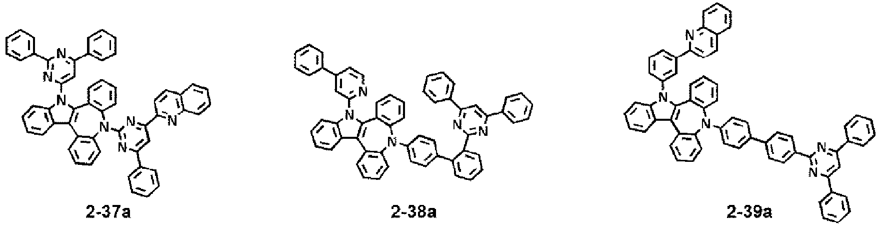

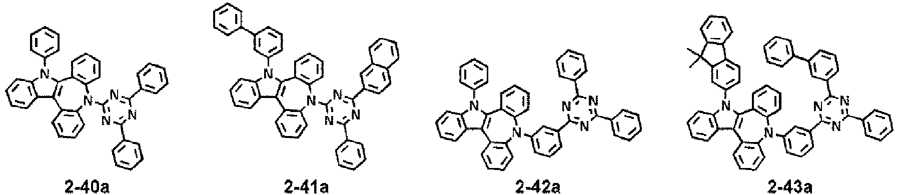

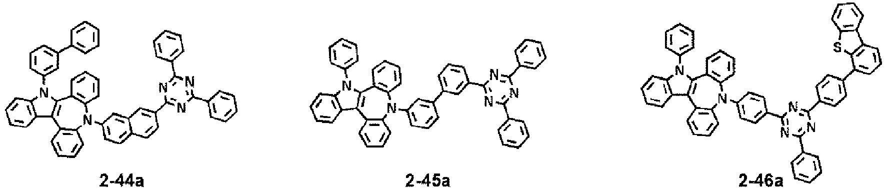

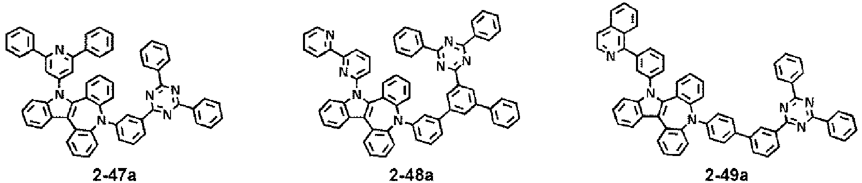

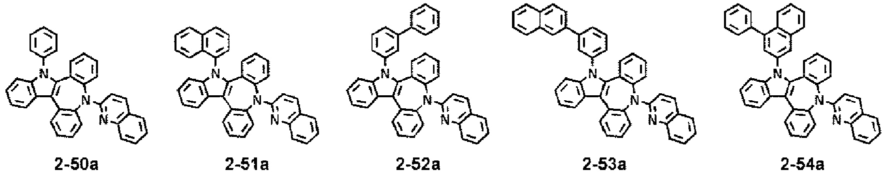

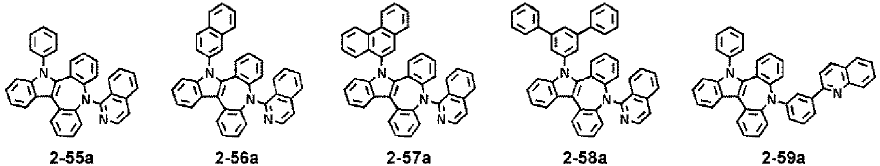

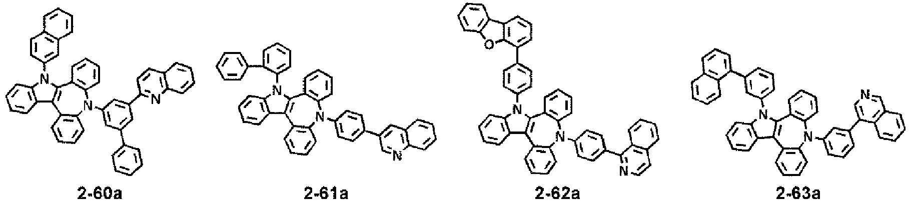

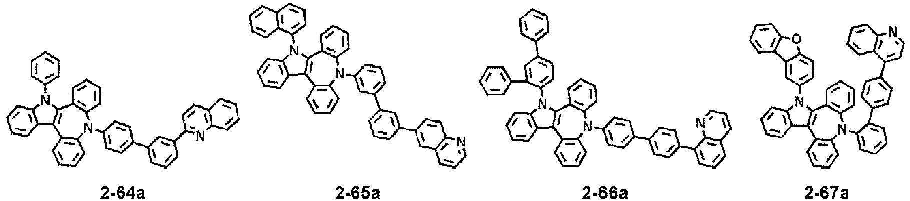

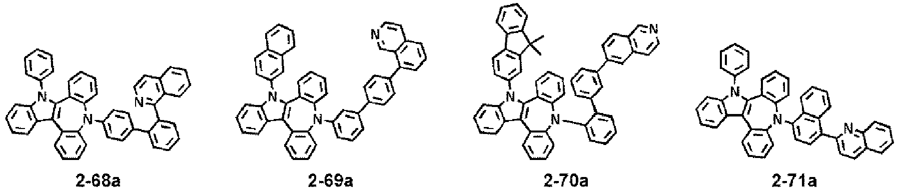

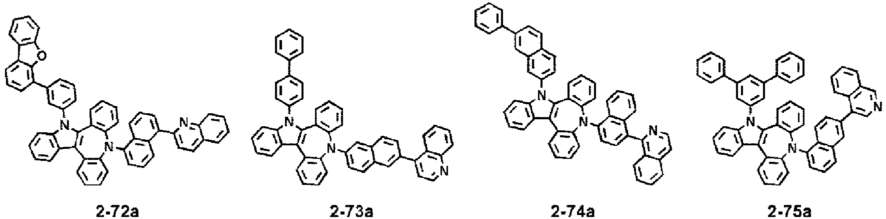

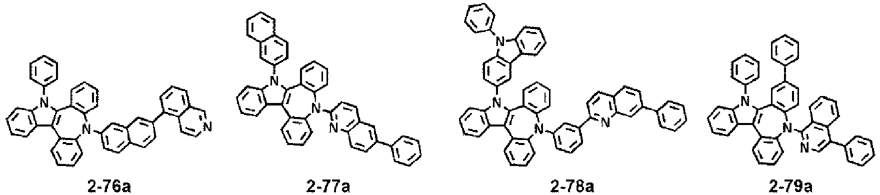

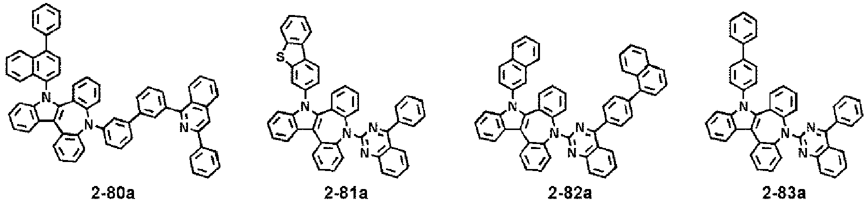

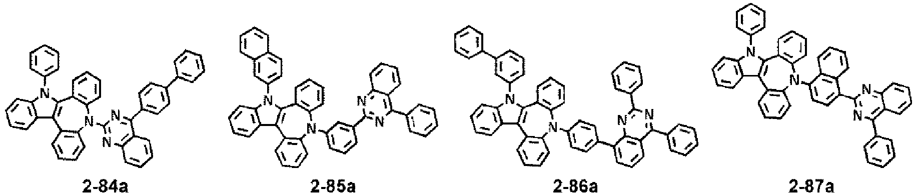

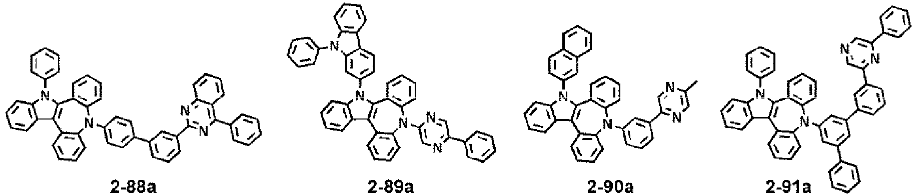

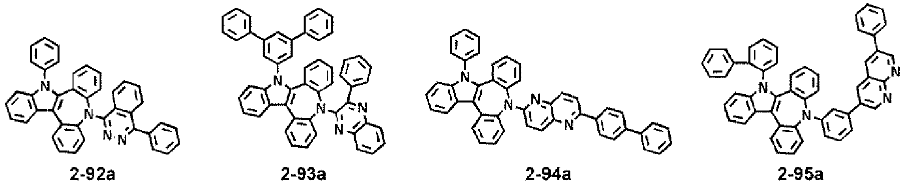

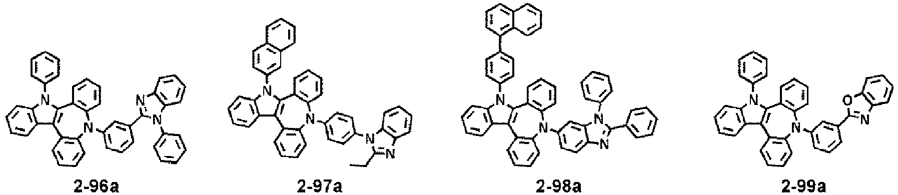

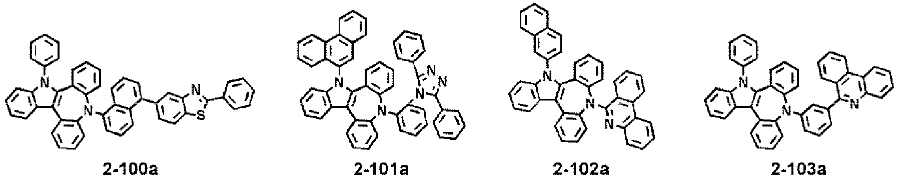

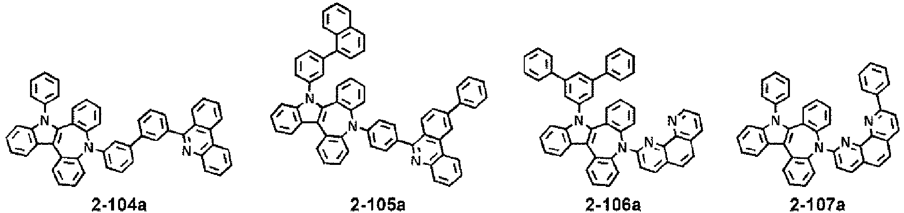

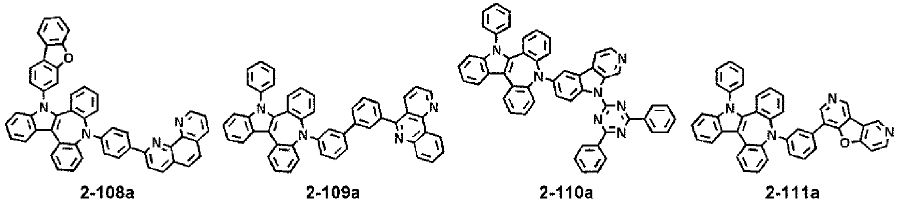

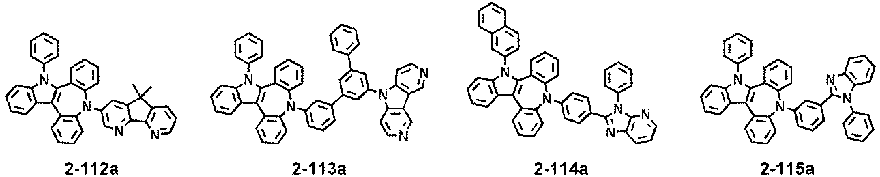

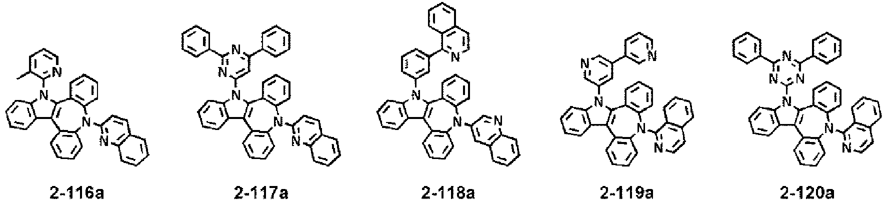

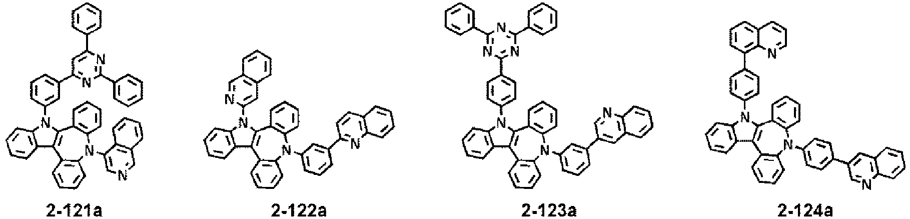

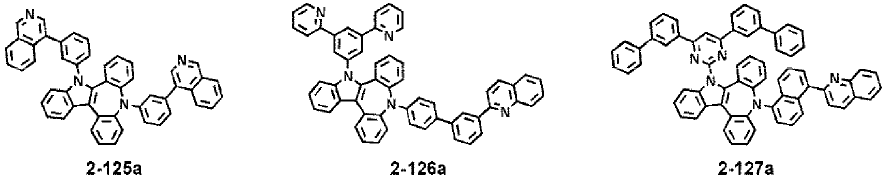

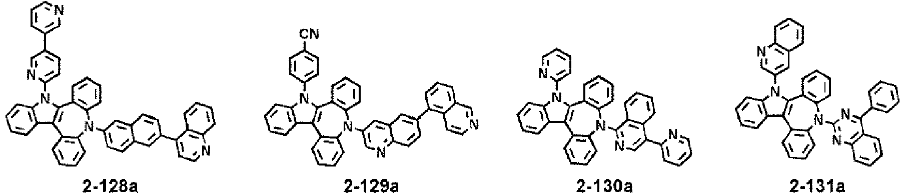

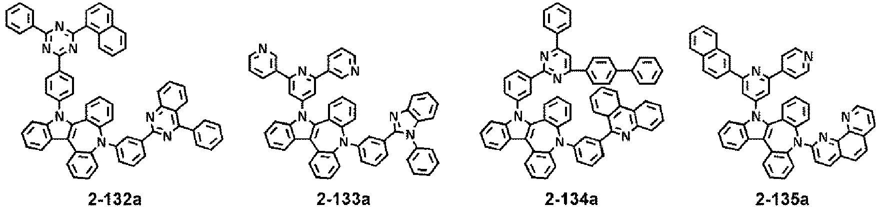

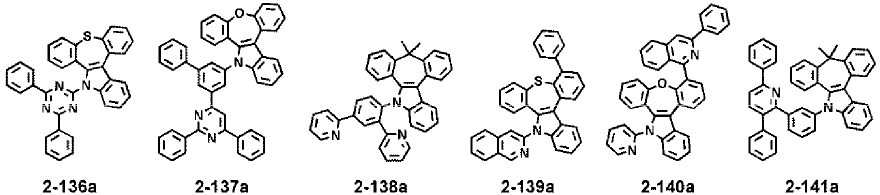

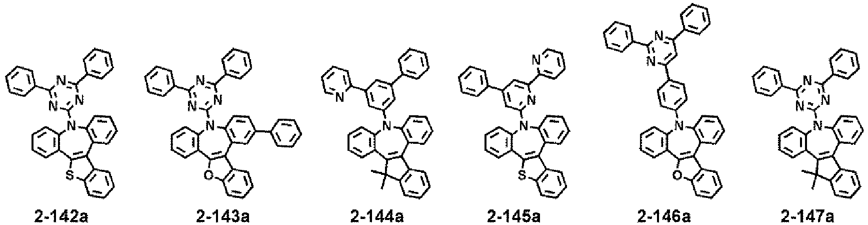

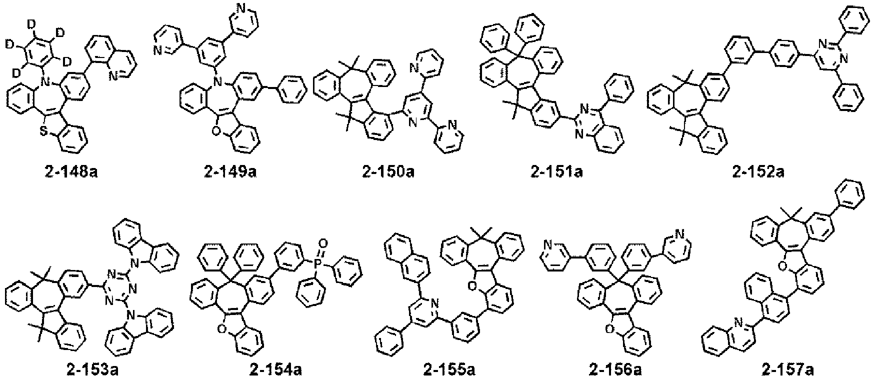

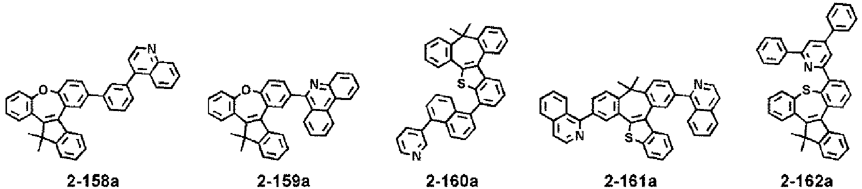

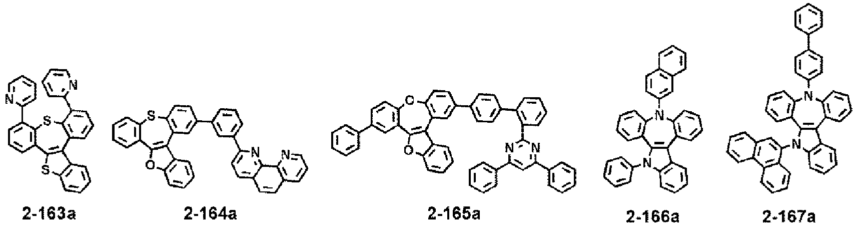

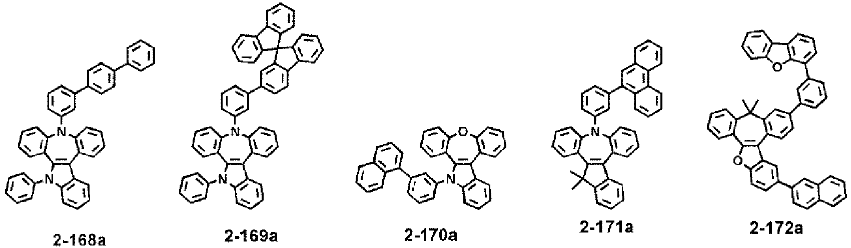

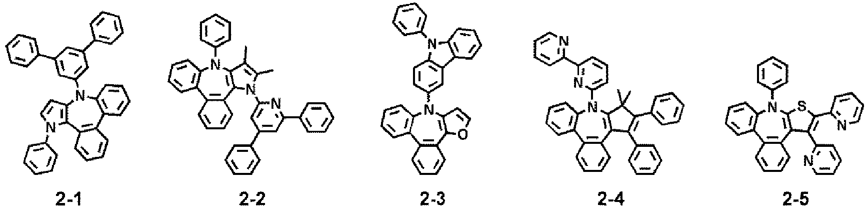

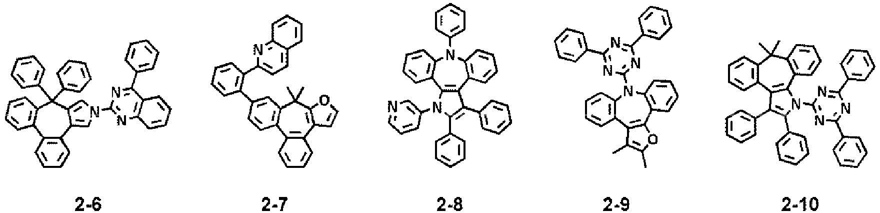

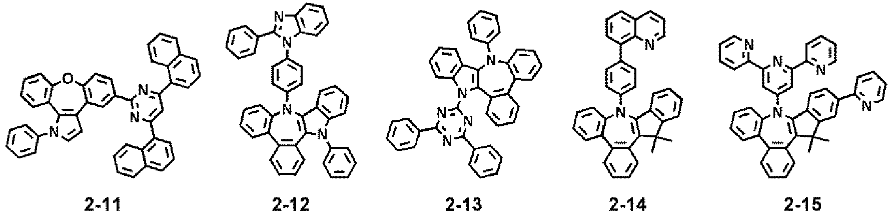

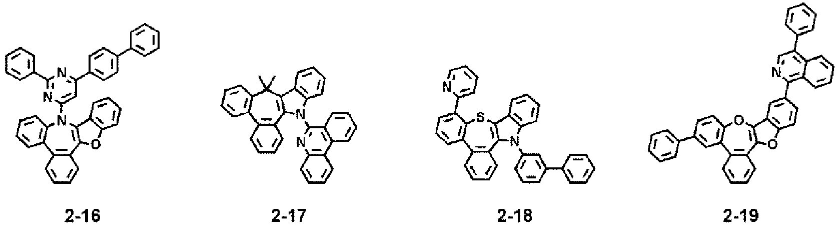

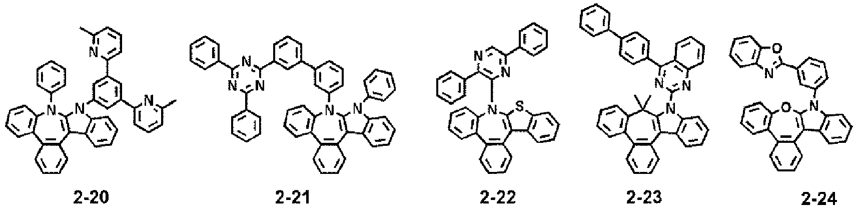

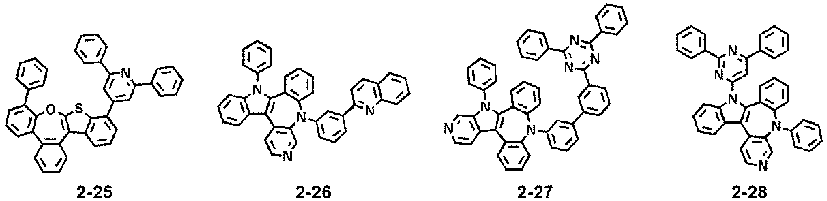

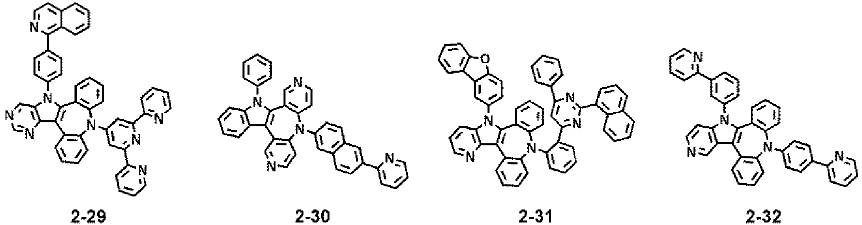

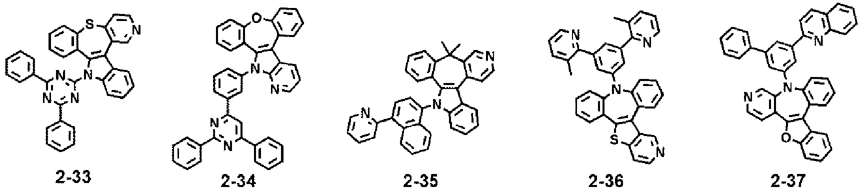

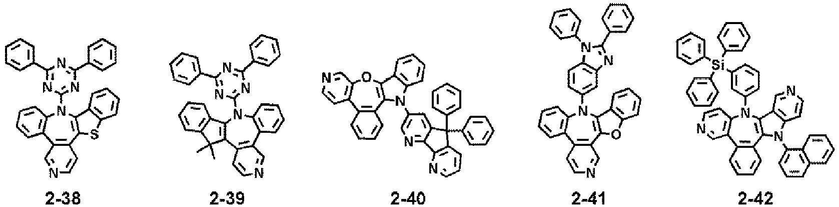

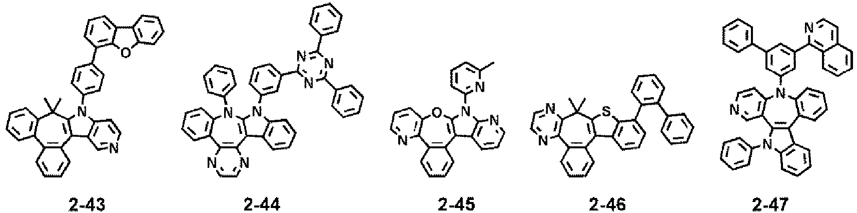

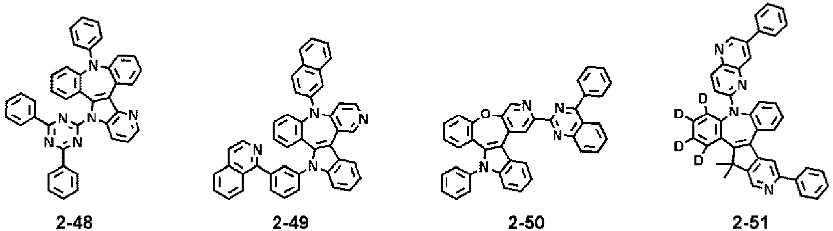

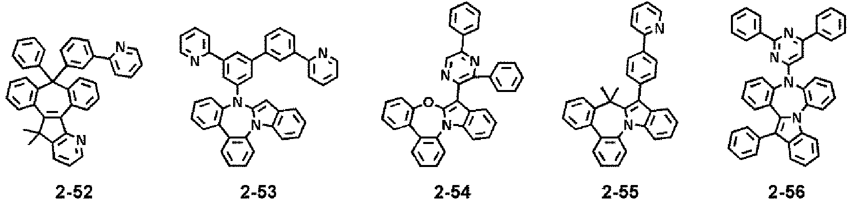

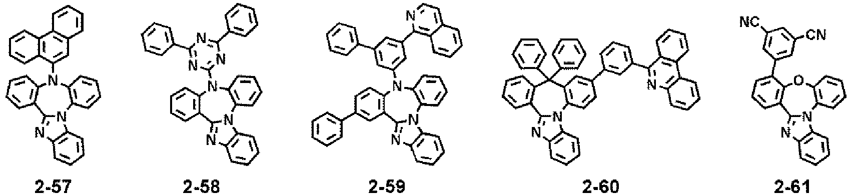

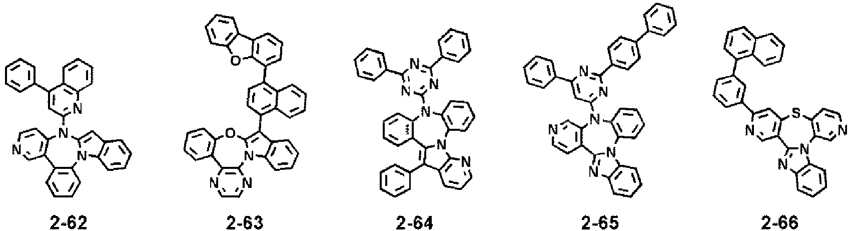

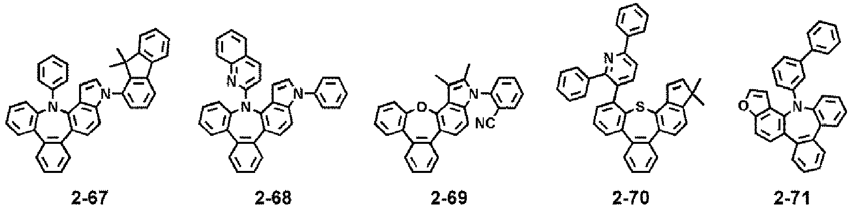

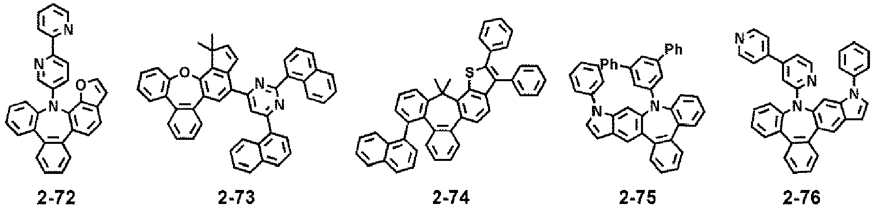

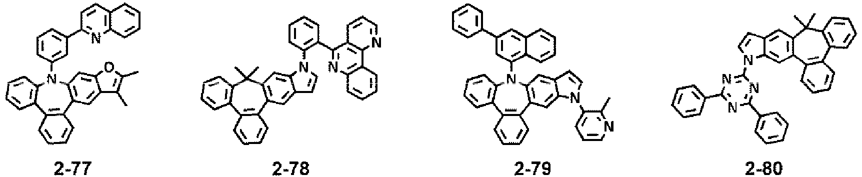

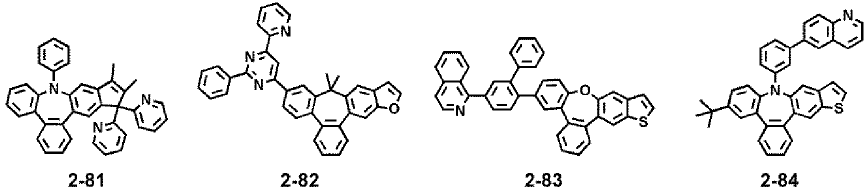

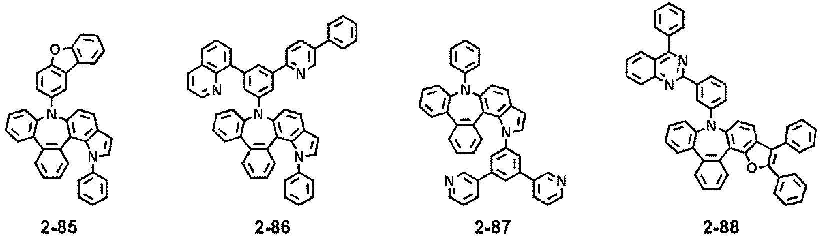

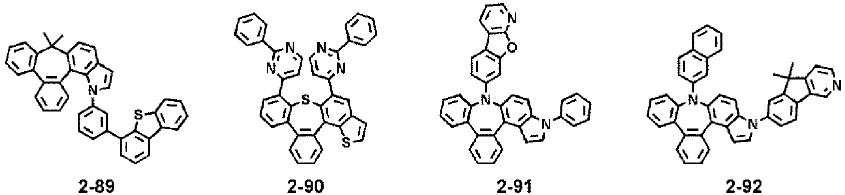

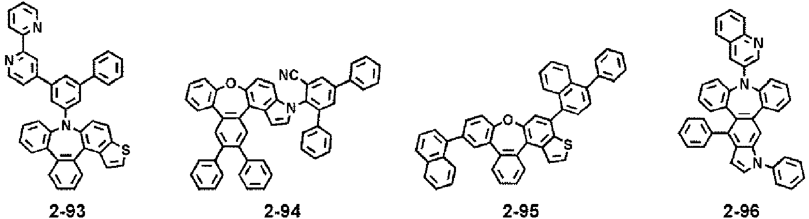

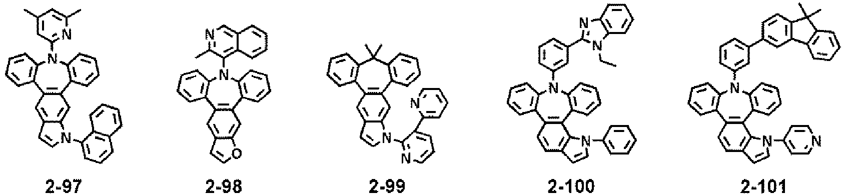

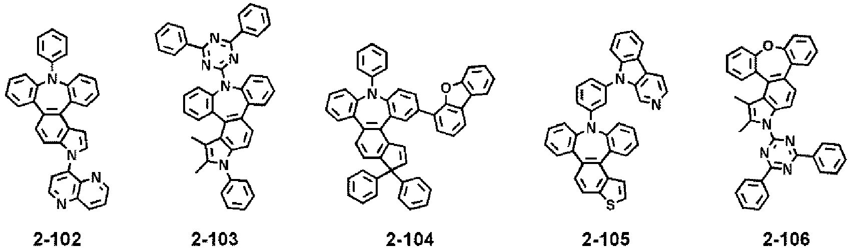

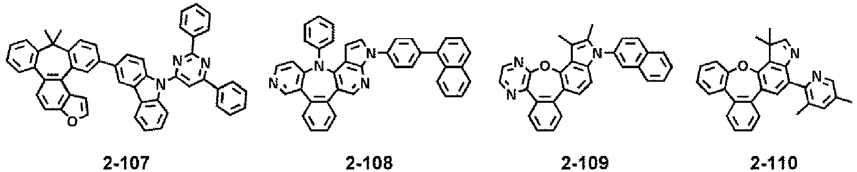

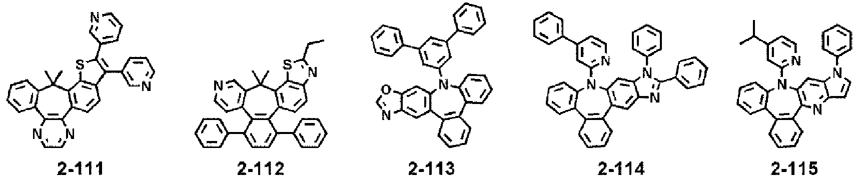

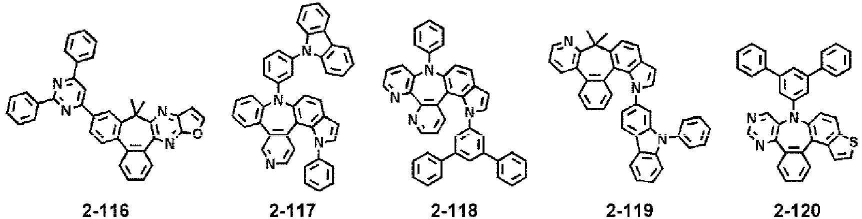

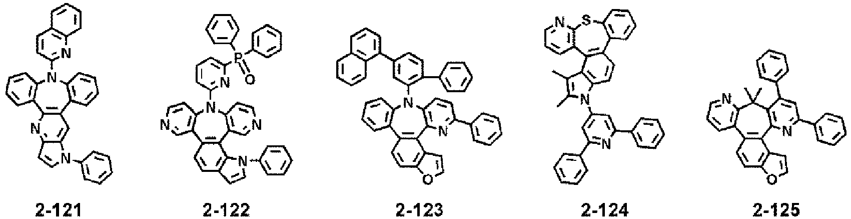

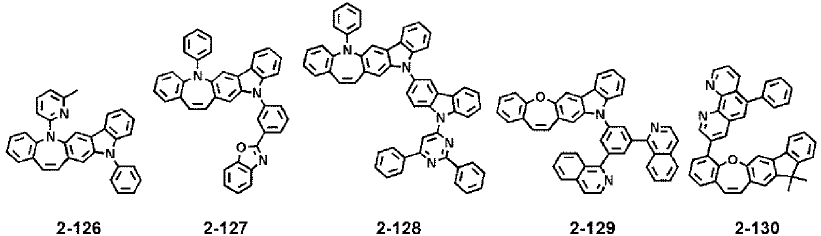

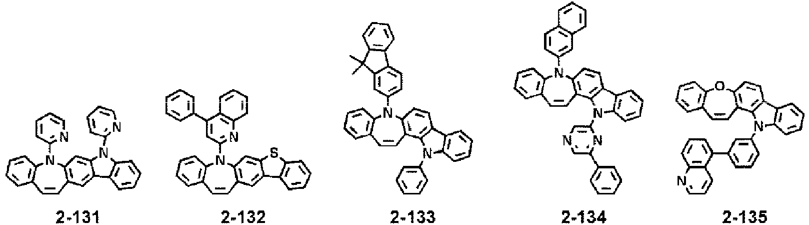

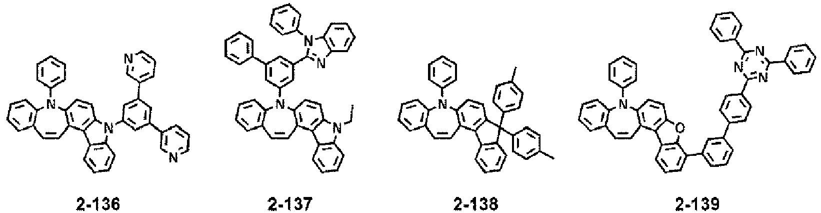

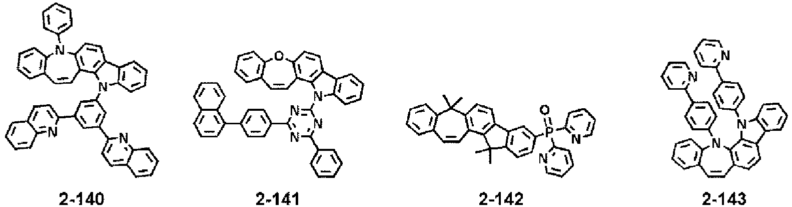

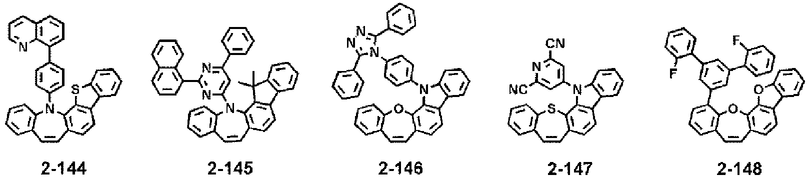

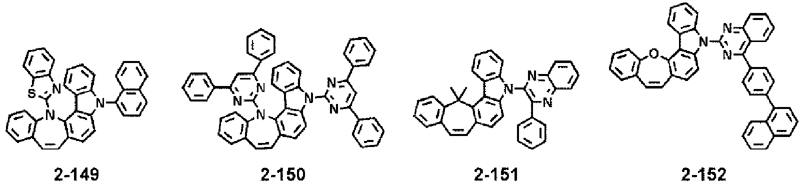

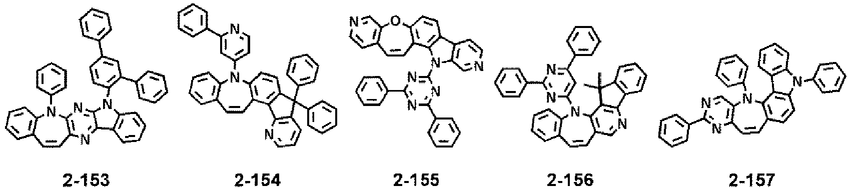

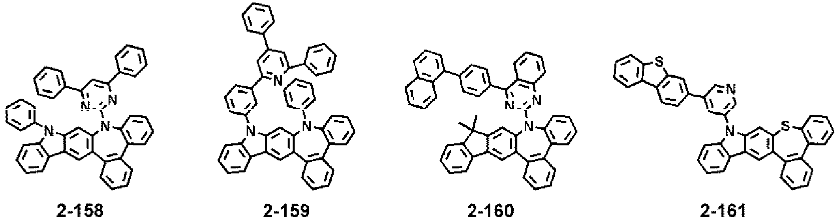

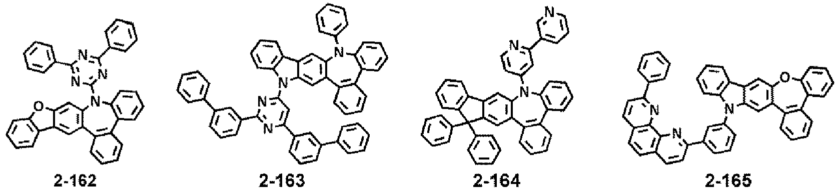

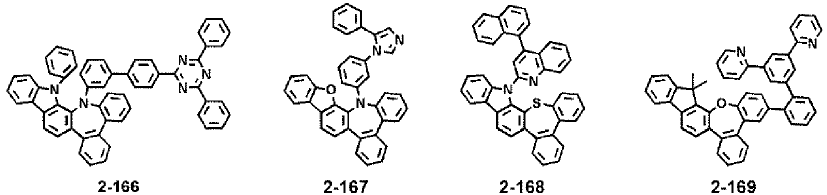

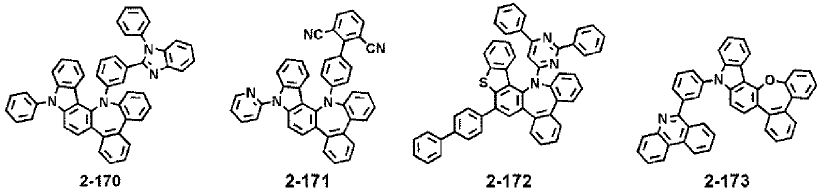

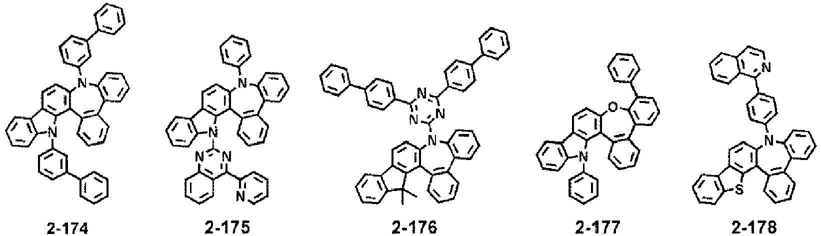

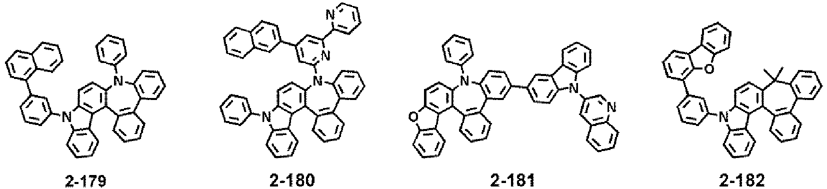

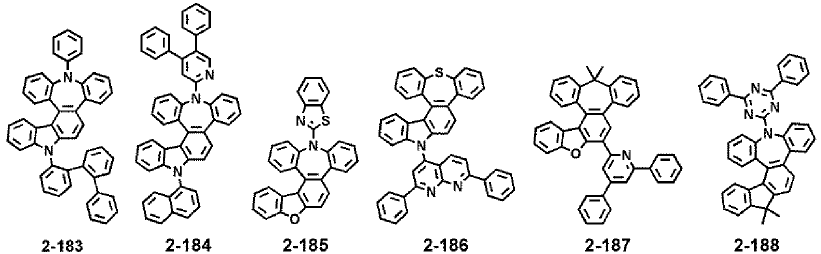

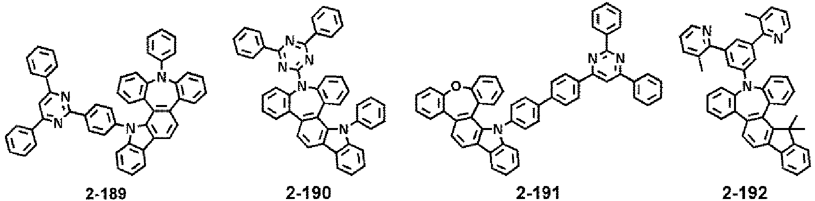

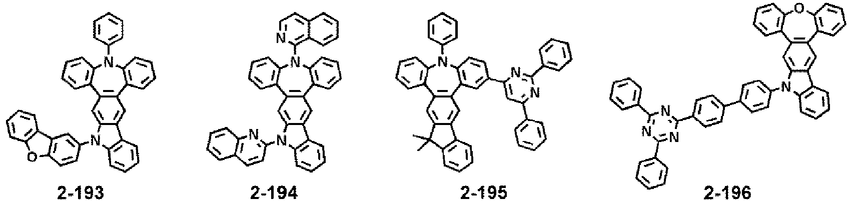

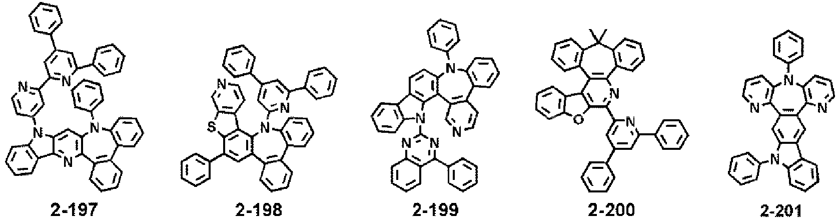

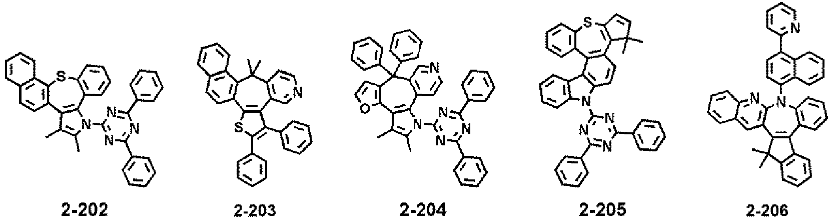

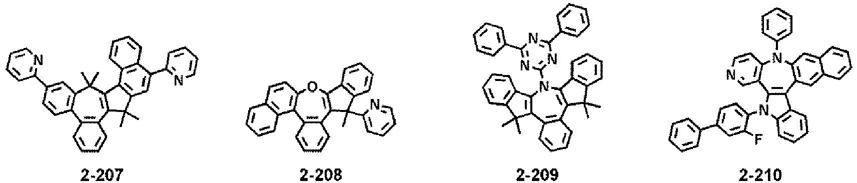

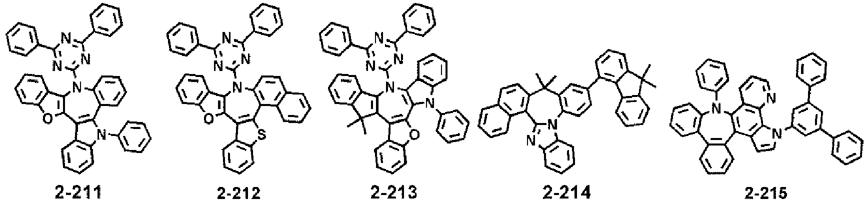

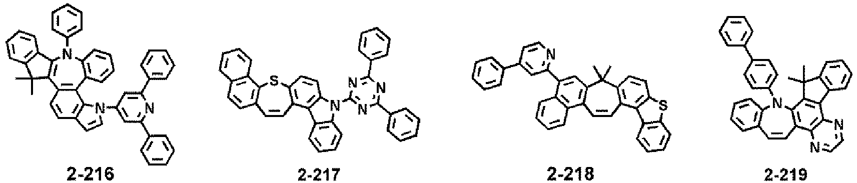

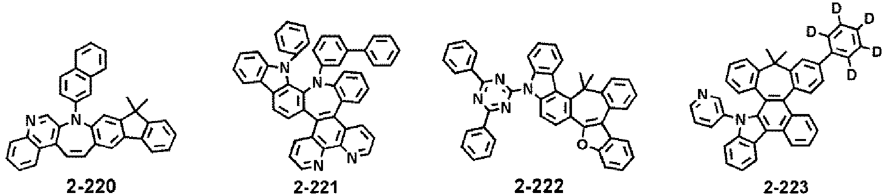

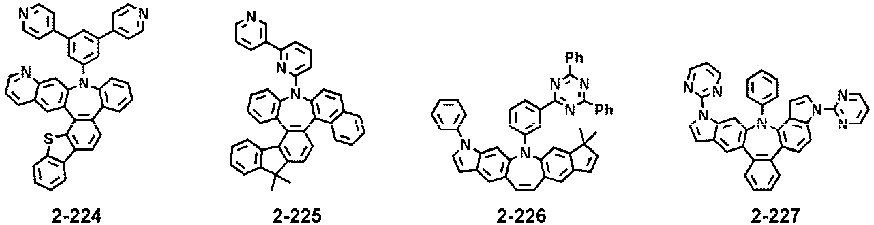

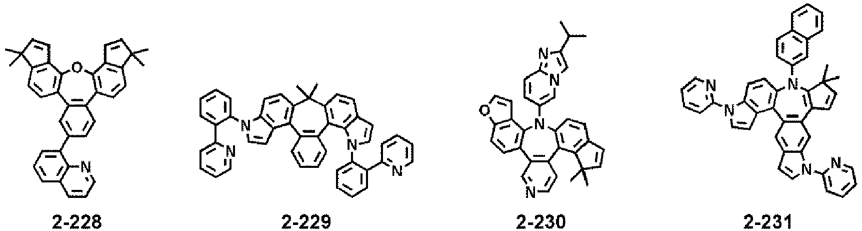

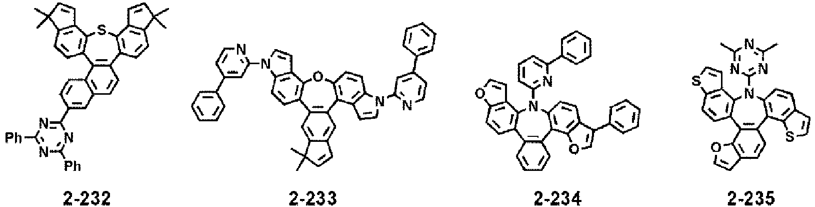

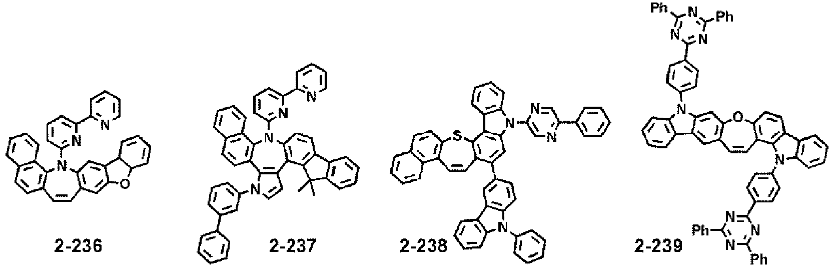

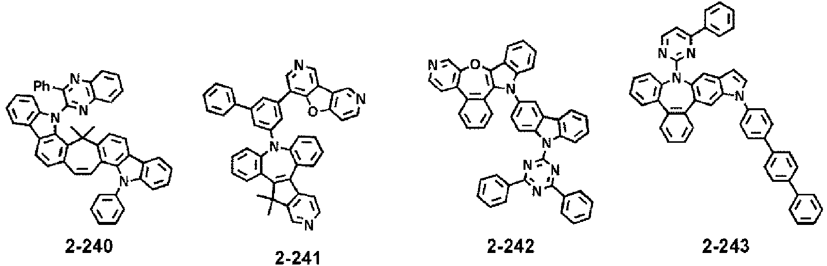

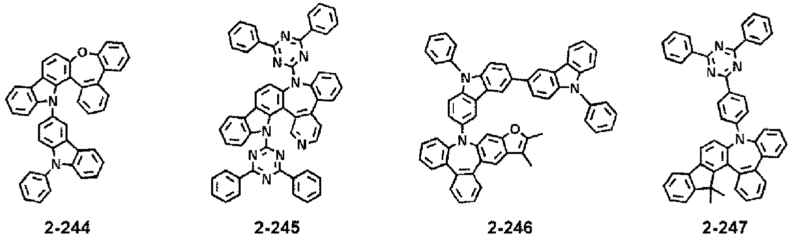

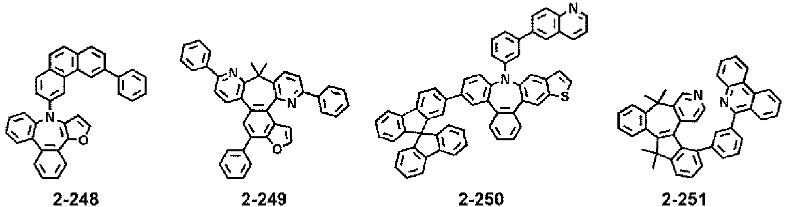

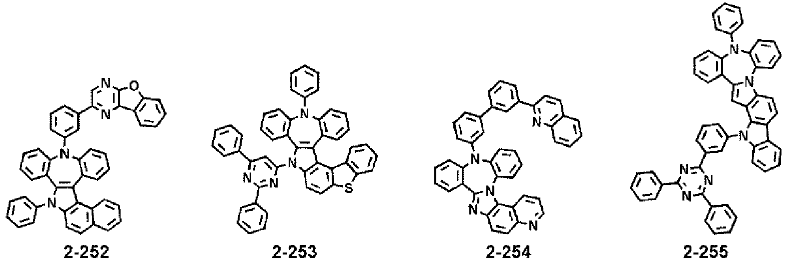

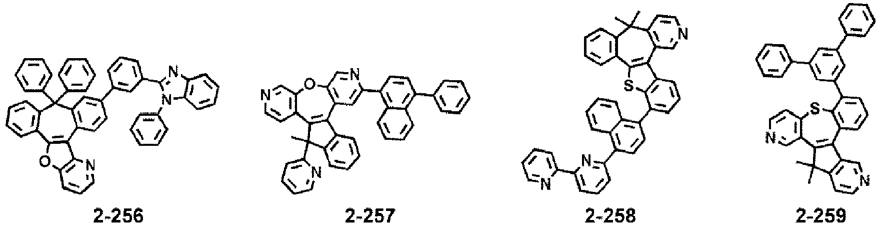

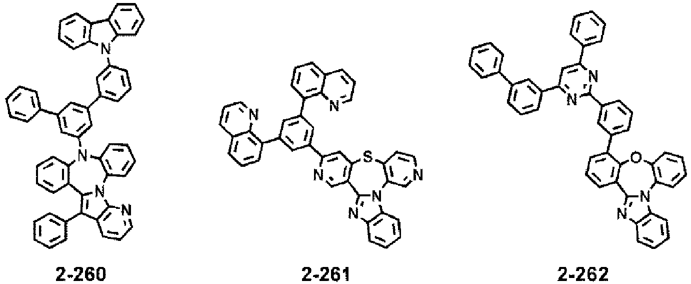

Any combinations of rings A₁ to A₃, X₁, E₁, E₂, Y₁, Y₂, L₁ to L₄, a1 to a4, R₁ to R₄, b1 to b4, and c1 to c4 in Formulae 1A and 1B may be applicable within the scope described herein.

Any combinations of ring A₂₁, ring A₂₂, ring A₂₃, X₂₁, and T₁₁ to T₁₄ in Formulae 2A and 2B may be applicable within the scope described herein.

Any combinations of *-[(L₂₂)ₐ₂₂-(R₂₂)_{b22}], C(R₂₃)(R₂₄), Si(R₂₃)(R₂₄), and N-[(L₂₁)ₐ₂₁-(R₂₁)_{b21}] may be applicable within the scope of L₂₁, L₂₂, a21, a22, R₂₁ to R₂₄, b21, and b₂₂ described herein.

The emission layer of the organic light-emitting device according to an embodiment comprises the first compound, and at least one selected from the hole transport region and the electron transport region comprises the second compound. In this way an adjustment of the balance of electrons and/or holes injected or transported into the emission layer may be facilitated, thereby reducing the possibility of and/or preventing a leakage current from occurring. Accordingly, the organic light-emitting device may have low driving voltage and high efficiency characteristics.

Triplet energy of the second compound may be about 2.2 eV or more. For example, the triplet energy of the second compound may be about 2.3 eV or more, or may be about 2.4 eV or more.

When the triplet energy of the second compound is within these ranges, the emission efficiency of a fluorescent organic light-emitting device may be be improved due to triplet-triplet fusion (TTF). In a phosphorescent organic light-emitting device, it is possible to prevent a reduction in efficiency of an organic light-emitting device by blocking transition of triplet excitons formed in an emission layer.

For example, the emission layer may comprise a first host and a second host, and the first host may comprise the first compound.

The hole transport region may comprise an emission auxiliary layer, the emission auxiliary layer may directly contact the emission layer, and the second compound may be comprised in the emission auxiliary layer.

The electron transport region may comprise a buffer layer, the buffer layer may directly contact the emission layer, and the second compound may be comprised in the buffer layer.

When both the hole transport region and the electron transport region in the organic light-emitting device comprise the second compound described above, the second compound comprised in the hole transport region and the second compound comprised in the electron transport region may be identical to or different from each other.

The emission layer may comprise a dopant, and the dopant may be an organometallic complex.

### [Description of FIG. 1]

FIG. 1 illustrates a schematic view of an organic light-emitting device 10 according to an embodiment. The organic light-emitting device 10 may comprise a first electrode 110, an organic layer 150, and a second electrode 190.

Hereinafter, the structure of the organic light-emitting device 10 according to an embodiment and a method of manufacturing the organic light-emitting device 10 will be described in connection with FIG. 1.

### [First electrode 110]

In FIG. 1, a substrate may be additionally disposed under the first electrode 110 or above the second electrode 190. The substrate may be a glass substrate or a plastic substrate, each having excellent mechanical strength, thermal stability, transparency, surface smoothness, ease of handling, and water-resistance.

The first electrode 110 may be formed by depositing or sputtering a material for forming the first electrode 110 on the substrate. When the first electrode 110 is an anode, the material for forming the first electrode 110 may be selected from materials with a high work function to facilitate hole injection.

The first electrode 110 may be a reflective electrode, a semi-transmissive electrode, or a transmissive electrode. When the first electrode 110 is a transmissible electrode, a material for forming the first electrode 110 may be selected from indium tin oxide (ITO), indium zinc oxide (IZO), tin oxide (SnO₂), zinc oxide (ZnO), and any combinations thereof. When the first electrode 110 is a semi-transmissive electrode or a reflective electrode, as a material for forming the first electrode 110, magnesium (Mg), silver (Ag), aluminum(Al), aluminum-lithium(Al-Li), calcium (Ca), magnesium-indium(Mg-In), magnesium-silver (Mg-Ag), or any combination thereof may be used.

The first electrode 110 may have a single-layered structure, or a multi-layered structure comprising two or more layers. For example, the first electrode 110 may have a three-layered structure of ITO/Ag/ITO.

### [Organic layer 150]

The organic layer 150 is disposed on the first electrode 110. The organic layer 150 may comprise an emission layer.

The organic layer 150 may comprise a hole transport region between the first electrode 110 and the emission layer, and an electron transport region between the emission layer and the second electrode 190.

### [Hole transport region in organic layer 150]

The hole transport region may have, e.g., i) a single-layered structure including a single layer including a single material, ii) a single-layered structure including a single layer comprising a plurality of different materials, or iii) a multi-layered structure having a plurality of layers comprising a plurality of different materials.

The hole transport region may comprise at least one layer selected from a hole injection layer, a hole transport layer, an emission auxiliary layer, and an electron blocking layer.

For example, the hole transport region may have a single-layered structure including a single layer comprising a plurality of different materials, or a multi-layered structure having a structure of hole injection layer/hole transport layer, hole injection layer/hole transport layer/emission auxiliary layer, hole injection layer/emission auxiliary layer, hole transport layer/emission auxiliary layer or hole injection layer/hole transport layer/electron blocking layer, wherein, in each of these structures, constituting layers are sequentially stacked from the first electrode 110 in this stated order.

The hole transport region may comprise the second compound as described above.

The hole transport region may comprise an emission auxiliary layer. The emission auxiliary layer may directly contact the emission layer.

The hole transport region may comprise a hole injection layer and a hole transport layer, which are stacked in this stated order on the first electrode 110, a hole injection layer and an emission auxiliary layer, which are stacked in this stated order on the first electrode 110, or a hole injection layer, a hole transport layer, and an emission auxiliary layer, which are stacked in this stated order on the first electrode 110.

When the hole transport region comprises an emission auxiliary layer, the emission auxiliary layer may comprise the second compound.

The hole transport region may comprise at least one selected from m-MTDATA, TDATA, 2-TNATA, NPB(NPD), β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzenesulfonic acid (Pani/DBSA), PEDOT/PSS (poly(3,4-ethylenedioxythiophene)/poly(4-styrenesulfonate)), polyaniline/camphor sulfonic acid (Pani/CSA), polyaniline/poly(4-styrenesulfonate) (Pani/PSS), a compound represented by Formula 201, and a compound represented by Formula 202:

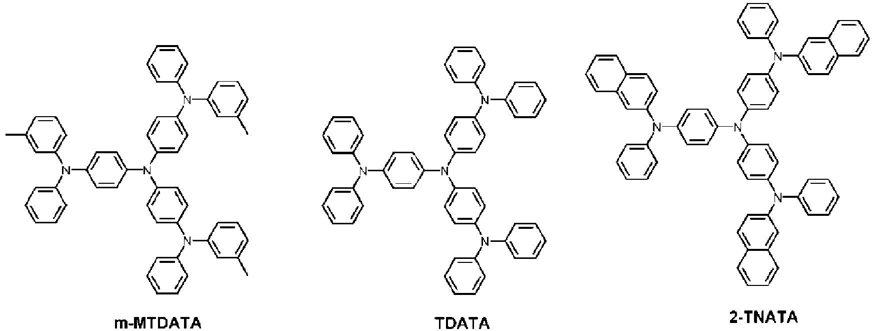

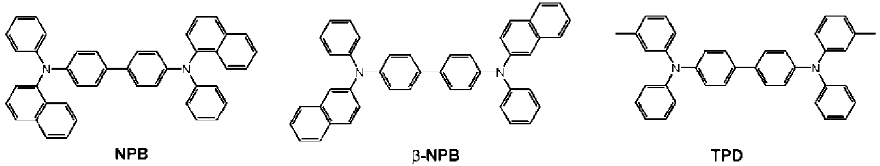

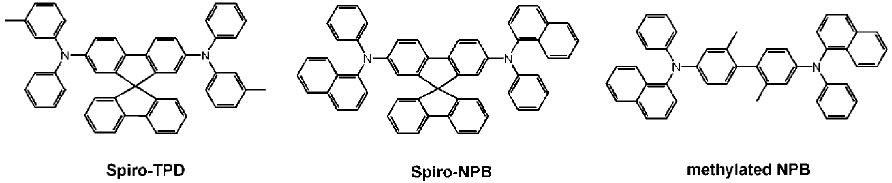

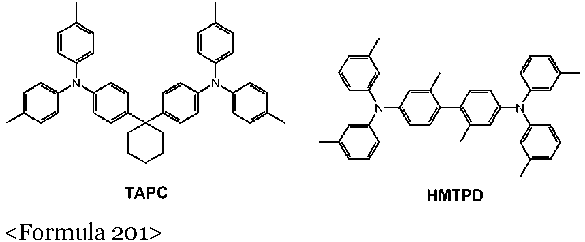

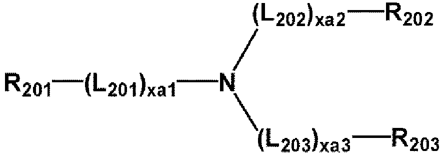

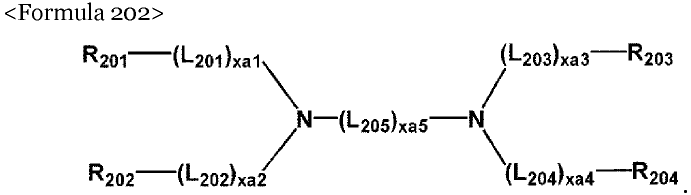

In Formulae 201 and 202,
L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
L₂₀₅ may be selected from *-O-*', *-S-*', *-N(Q₂₀₁)-*', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
xa1 to xa4 may each independently be an integer selected from 0 to 3,
xa5 may be an integer selected from 1 to 10, and
R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group.

For example, in Formula 202, R₂₀₁ and R₂₀₂ may be optionally connected to each other via a single bond, a dimethyl-methylene group, or a diphenyl-methylene group, and R₂₀₃ and R₂₀₄ may be optionally connected to each other via a single bond, a dimethyl-methylene group, or a diphenyl-methylene group.

In Formulae 201 and 202,
L₂₀₁ to L₂₀₅ may each independently be selected from
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I**,** a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.
xa1 to xa4 may each independently be 0, 1, or 2.
xa5 may be 1, 2, 3, or 4.
R₂₀₁ to R₂₀₄ and Q₂₀₁ may each independently be selected from
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ are the same as described above.

At least one selected from R₂₀₁ to R₂₀₃ in Formula 201 may each independently be selected from
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group.

In Formula 202, i) R₂₀₁ and R₂₀₂ may be connected to each other via a single bond, and/or ii) R₂₀₃ and R₂₀₄ may be connected to each other via a single bond.

At least one selected from R₂₀₁ to R₂₀₄ in Formula 202 may be selected from
a carbazolyl group; and
a carbazolyl group substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group.

The compound represented by Formula 201 may be represented by Formula 201A:

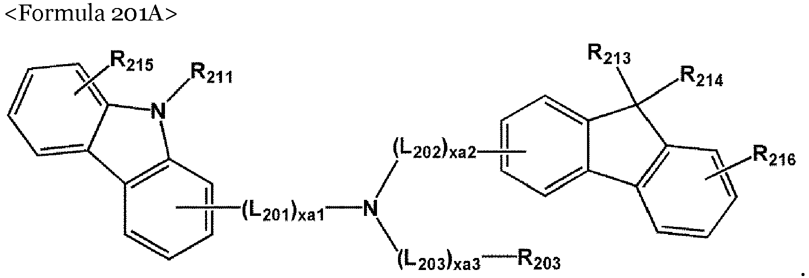

For example, the compound represented by Formula 201 may be represented by Formula 201A(1):

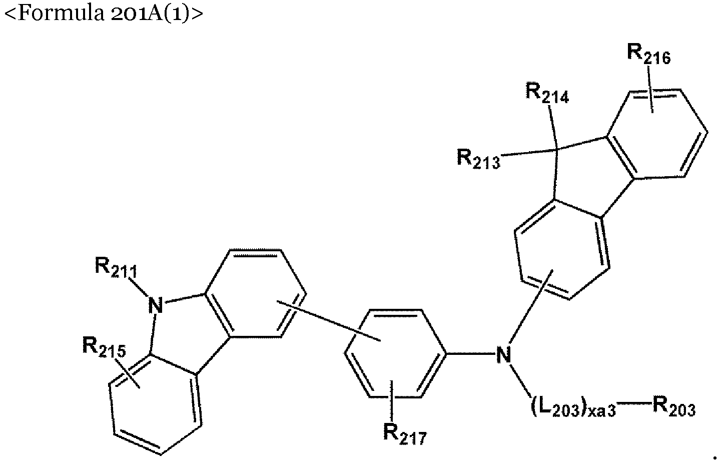

The compound represented by Formula 201 may be represented by Formula 201A-1:

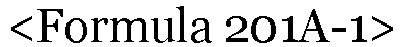

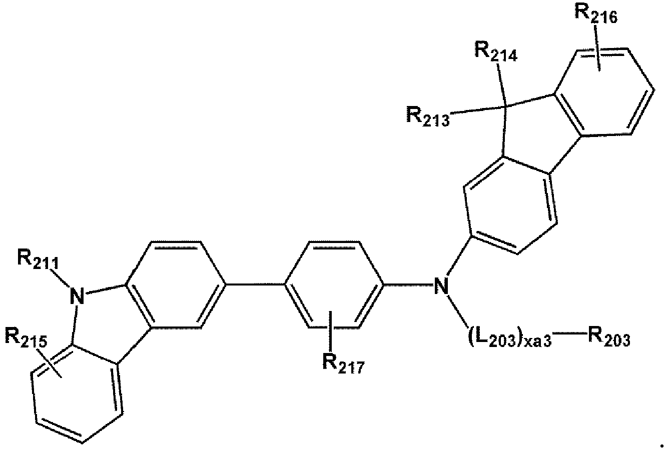

The compound represented by Formula 202 may be represented by Formula 202A:

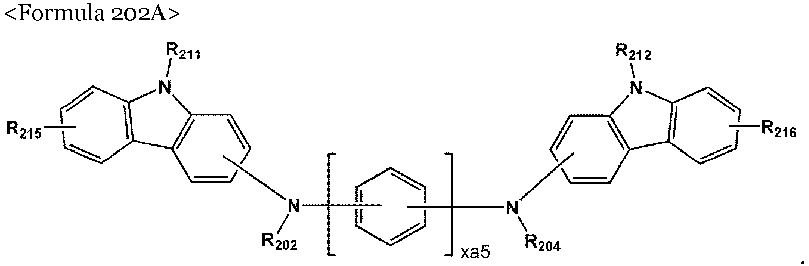

The compound represented by Formula 202 may be represented by Formula 202A-1:

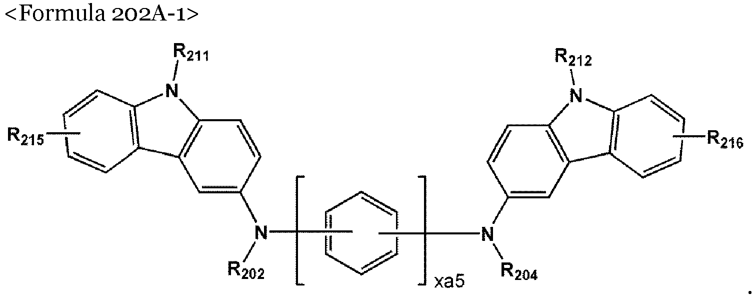

In Formulae 201A, 201A(1), 201A-1, 202A, and 202A-1,
L₂₀₁ to L₂₀₃, xa1 to xa3, xa5, and R₂₀₂ to R₂₀₄ are the same as described above,
R₂₁₁ and R₂₁₂ are the same as described above in connection with R₂₀₃, and
R₂₁₃ to R₂₁₇ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In an implementation, the hole transport region may comprise at least one compound selected from Compounds HT1 to HT39.

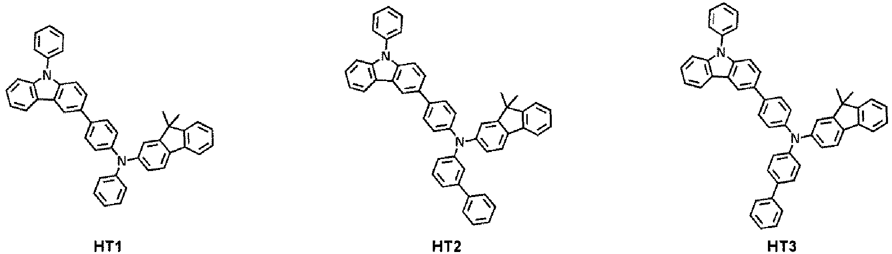

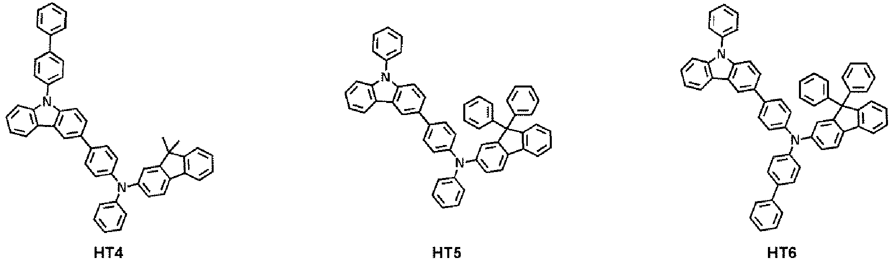

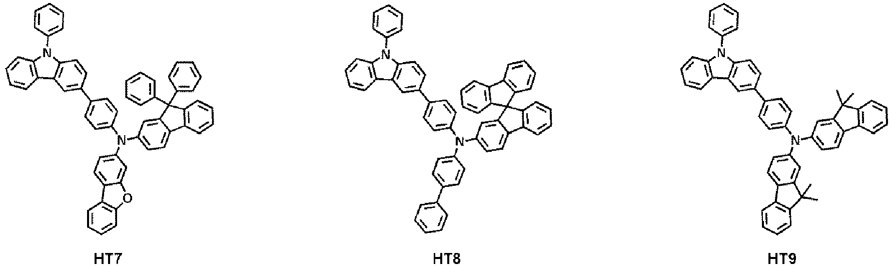

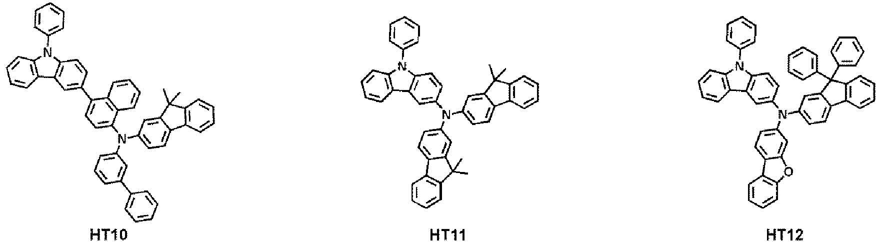

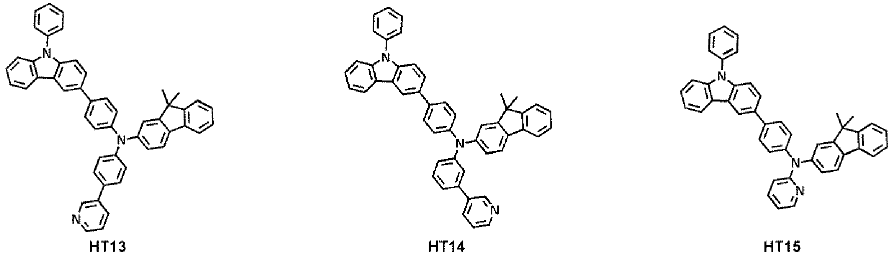

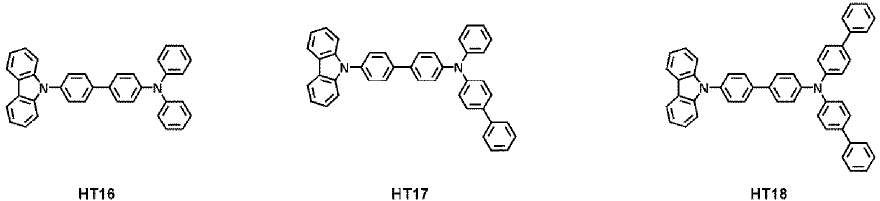

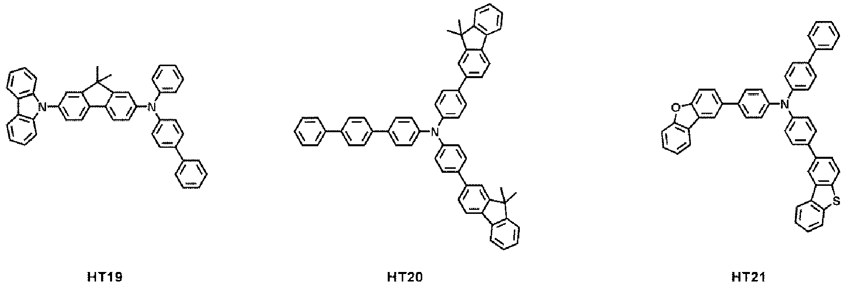

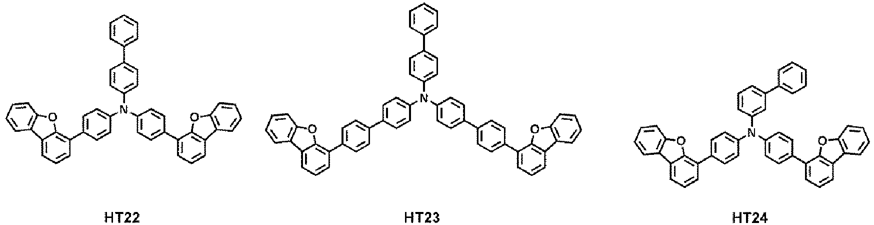

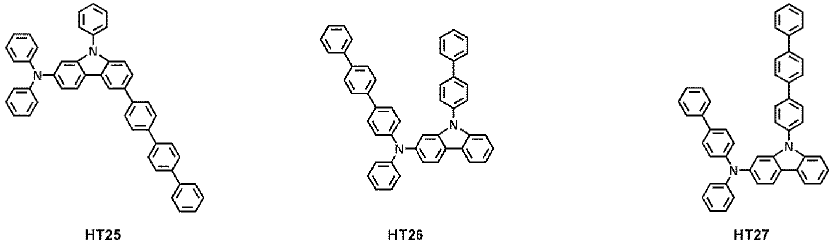

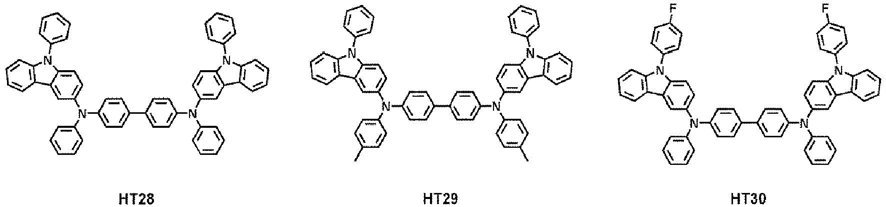

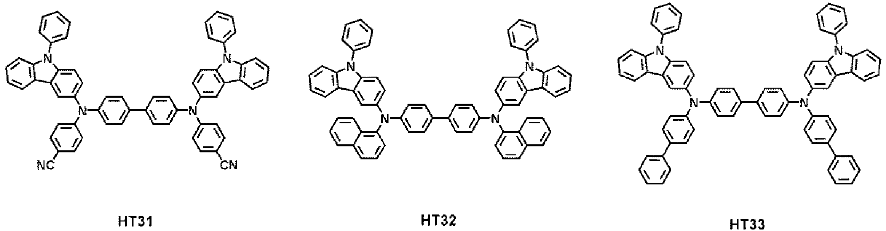

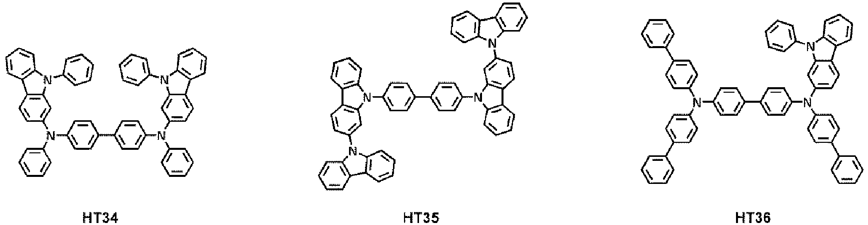

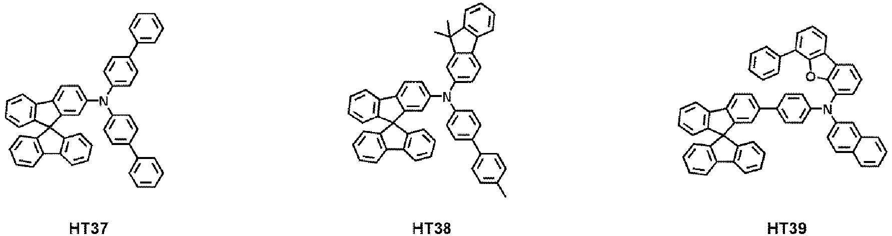

A thickness of the hole transport region may be in a range of about 100 Å to about 10,000 Å, for example, about 100 Å to about 1,000 Å. When the hole transport region comprises at least one selected from a hole injection layer and a hole transport layer, the thickness of the hole injection layer may be in a range of about 100 Å to about 9,000 Å, for example, about 100 Å to about 1,000 Å, and the thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The emission auxiliary layer may help increase light-emission efficiency by compensating for an optical resonance distance according to the wavelength of light emitted by an emission layer, and the electron blocking layer may block the flow of electrons from an electron transport region. The emission auxiliary layer and the electron blocking layer may comprise those materials as described above.

### [p-dopant]

The hole transport region may further comprise, in addition to these materials, a charge-generation material for the improvement of conductive properties. The charge-generation material may be homogeneously or non-homogeneously dispersed in the hole transport region.

The charge-generation material may be, e.g., a p-dopant.

A doping concentration of the p-dopant may be in a range of about 0.1 wt% to about 20 wt%, for example, about 0.5 wt% to about 10 wt%.

A lowest unoccupied molecular orbital (LUMO) of the p-dopant may be about - 3.5 eV or less.

The p-dopant may comprise at least one selected from a quinone derivative, a metal oxide, and a cyano group-containing compound.

For example, the p-dopant may comprise at least one selected from
a quinone derivative, such as tetracyanoquinodimethane (TCNQ) and 2,3,5,6-tetrafluoro-7,7,8,8-tetracyanoquinodimethane (F4-TCNQ);
a metal oxide, such as a tungsten oxide or a molybdenum oxide;
1,4,5,8,9,11-hexaazatriphenylene-hexacarbonitrile (HAT-CN); and
a compound represented by Formula 221 below.

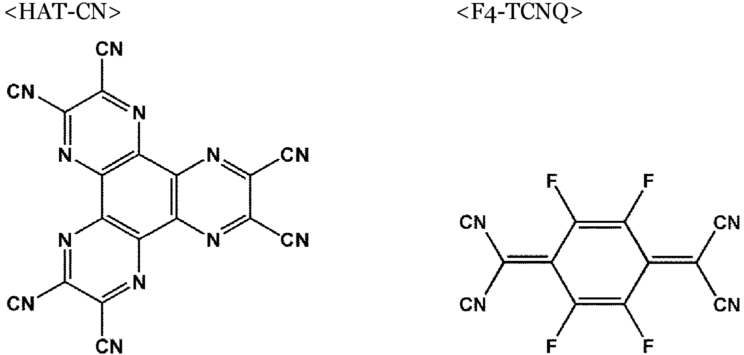

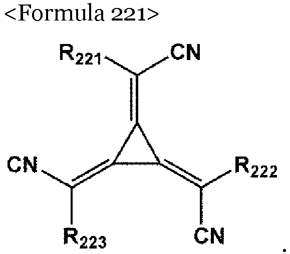

In Formula 221,
R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group, provided that at least one selected from R₂₂₁ to R₂₂₃ has at least one substituent selected from a cyano group, -F, -Cl, -Br, -I, a C₁-C₂₀ alkyl group substituted with -F, a C₁-C₂₀ alkyl group substituted with -Cl, a C₁-C₂₀ alkyl group substituted with -Br, and a C₁-C₂₀ alkyl group substituted with -I.

### [Emission layer in organic layer 150]

When the organic light-emitting device 10 is a full color organic light-emitting device, the emission layer may be patterned into a red emission layer, a green emission layer, or a blue emission layer, according to a sub-pixel. The emission layer may have a stacked structure of two or more layers selected from a red emission layer, a green emission layer, and a blue emission layer, in which the two or more layers contact each other or are separated from each other. The emission layer may comprise two or more materials selected from a red-light emission material, a green-light emission material, and a blue-light emission material, in which the two or more materials are mixed with each other in a single layer to emit white light.

The emission layer of the organic light-emitting device 10 may be a first-color-light emission layer,
the organic light-emitting device 10 may further comprise i) at least one second-color-light emission layer or ii) at least one second-color-light emission layer and at least one third-color-light emission layer, between the first electrode 110 and the second electrode 190,
a maximum emission wavelength of the first-color-light emission layer, a maximum emission wavelength of the second-color-light emission layer, and a maximum emission wavelength of the third-color-light emission layer are identical to or different from each other, and
the organic light-emitting device 10 may emit mixed light comprising first-color-light and second-color-light, or mixed light comprising first-color-light, second-color-light, and third-color-light.

For example, the maximum emission wavelength of the first-color-light emission layer is different from a maximum emission wavelength of the second-color-light emission layer, and the mixed light comprising first-color-light and second-color-light may be white light.

The maximum emission wavelength of the first-color-light emission layer, the maximum emission wavelength of the second-color-light emission layer, and the maximum emission wavelength of the third-color-light emission layer may be different from one another, and the mixed light comprising first-color-light, second-color-light, and third-color-light may be white light.

As used herein the maximum emission wavelength of an emission layer is the wavelength of light emitted by the emission layer with maximum intensity.

The emission layer may comprise a host and a dopant. The dopant may comprise at least one selected from a phosphorescent dopant and a fluorescent dopant.

An amount of the dopant in the emission layer may be, in general, in a range of about 0.01 to about 15 parts by weight based on 100 parts by weight of the host.

A thickness of the emission layer may be in a range of about 100 Å to about 1,000 Å, for example, about 200 Å to about 600 Å. When the thickness of the emission layer is within this range, excellent light-emission characteristics may be obtained without a substantial increase in driving voltage.

### [Host in emission layer]

The emission layer may comprise the first compound as a host. For example, the first compound is the same as described above.

In an implementation, the emission layer may comprise a first host and a second host, and the first host may comprise the first compound.

In an implementation, the second host may be selected from compounds described above as an example of the first compound.

In an implementation, the second host may be selected from 4,4'-bis(N-carbazolyl)-1,1'-biphenyl (CBP), 1,3-di-9-carbazolylbenzene (mCP), and 1,3,5-tri(carbazol-9-yl)benzene (TCP).

A weight ratio of the first host to the second host in the emission layer may be, for example, about 90:10 to about 10:90, for example, about 80:20 to about 20:80, or for example, about 50:50.

### [Phosphorescent dopant included in emission layer in organic layer 150]

The phosphorescent dopant may comprise an organometallic complex represented by Formula 401 below, in which L₄₀₁ may be selected from ligands represented by Formula 402.

<Formula 401> M(L₄₀₁)_{xc1}(L₄₀₂)_{xc2}

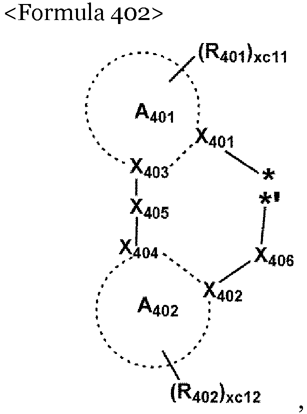

wherein, in Formulae 401 and 402,
M may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
xc1 may be 1, 2, or 3, wherein when xc1 is two or more, two or more L₄₀₁(s) may be identical to or different from each other,
L₄₀₂ may be an organic ligand, and xc2 may be an integer selected from 0 to 4, wherein when xc2 is two or more, two or more L₄₀₂(s) may be identical to or different from each other,
X₄₀₁ to X₄₀₄ may each independently be nitrogen or carbon,
X₄₀₁ and X₄₀₃ may be connected to each other via a single bond or a double bond, and X₄₀₂ and X₄₀₄ may be connected to each other via a single bond or a double bond,
A₄₀₁ and A₄₀₂ may each independently be a C₃-C₆₀ carbocyclic group or a C₁-C₆₀ heterocyclic group,
X₄₀₅ may be a single bond, -O-, -S-, -C(=O)-, -N(Q₄₁₁)-, -C(Q₄₁₁)(Q₄₁₂)-, - C(Q₄₁₁)=C(Q₄₁₂)-, -C(Q₄₁₁)=, or =C(Q₄₁₁)= wherein Q₄₁₁ and Q₄₁₂ may each independently be hydrogen, deuterium, a C₁-C₂₀ alkyl group, a C₁-C₂₀ alkoxy group, a phenyl group, a biphenyl group, a terphenyl group, or a naphthyl group,
X₄₀₆ may be a single bond, O, or S,
R₄₀₁ and R₄₀₂ may each independently be selected from hydrogen, deuterium, - F, -Cl, -Br, -I, -CD₃, -CF₃, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group -Si(Q₄₀₁)(Q₄₀₂)(Q₄₀₃), - N(Q₄₀₁)(Q₄₀₂), -B(Q₄₀₁)(Q₄₀₂), -C(=O)(Q₄₀₁), -S(=O)₂(Q₄₀₁), and -P(=O)(Q₄₀₁)(Q₄₀₂), wherein Q₄₀₁ to Q₄₀₃ may each independently be selected from a C₁-C₁₀ alkyl group, a C₁-C₁₀ alkoxy group, a C₆-C₂₀ aryl group, and a C₁-C₂₀ heteroaryl group,
xc11 and xc12 may each independently be an integer selected from 0 to 10, and
* and *' in Formula 402 indicate a binding site to M in Formula 401.

A₄₀₁ and A₄₀₂ in Formula 402 may each independently be selected from a benzene group, a naphthalene group, a fluorene group, a spiro-bifluorene group, an indene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzoimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In Formula 402, i) X₄₀₁ may be nitrogen, X₄₀₂ may be carbon, or ii) both X₄₀₁ and X₄₀₂ may be nitrogen.

R₄₀₁ and R₄₀₂ in Formula 402 may each independently be selected from
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantanyl group, a norbornanyl group, and a norbornenyl group;
a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;
a cyclopentyl group, a cyclohexyl group, an adamantanyl group, a norbornanyl group, a norbornenyl group a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group; and
-Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), and -P(=O)(Q₄₀₁)(Q₄₀₂),
wherein Q₄₀₁ to Q₄₀₃ may each independently be selected from a C₁-C₁₀ alkyl group, a C₁-C₁₀ alkoxy group, a phenyl group, a biphenyl group, and a naphthyl group.

When xc1 in Formula 401 is two or more, two A₄₀₁(s) selected from two or more L₄₀₁(s) may be optionally connected to each other via a linking group X₄₀₇, or two A₄₀₂(s) may be optionally connected to each other via a linking group X₄₀₈ (see Compounds PD1 to PD4 and PD7 below). X₄₀₇ and X₄₀₈ may each independently be a single bond, *-O-*', *-S-*', *-C(=O)-*', *-N(Q₄₁₃)-*', *-C(Q₄₁₃)(Q₄₁₄)-*', or *-C(Q₄₁₃)=C(Q₄₁₄)-*' (wherein Q₄₁₃ and Q₄₁₄ may each independently be hydrogen, deuterium, a C₁-C₂₀ alkyl group, a C₁-C₂₀ alkoxy group, a phenyl group, a biphenyl group, a terphenyl group, or a naphthyl group).

L₄₀₂ in Formula 401 may be a suitable monovalent, divalent, or trivalent organic ligand. For example, L₄₀₂ may be selected from a halogen, a diketone (for example, an acetylacetonate), a carboxylic acid (for example, a picolinate), -C(=O), an isonitrile, -CN, and phosphorus (for example, a phosphine or a phosphite).

The phosphorescent dopant may be selected from, for example, Compounds PD1 to PD25.

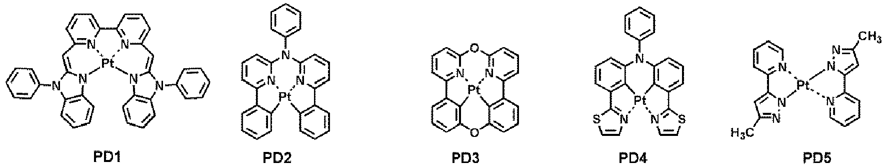

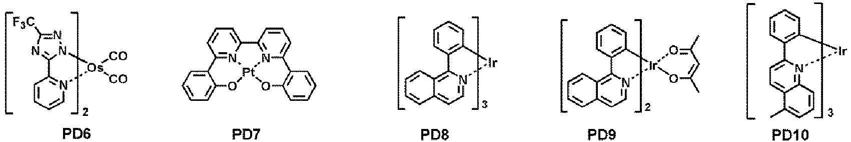

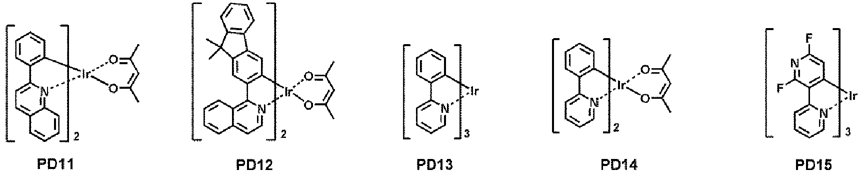

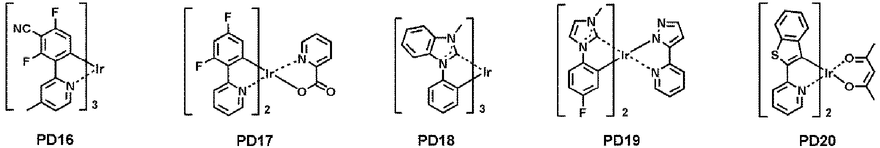

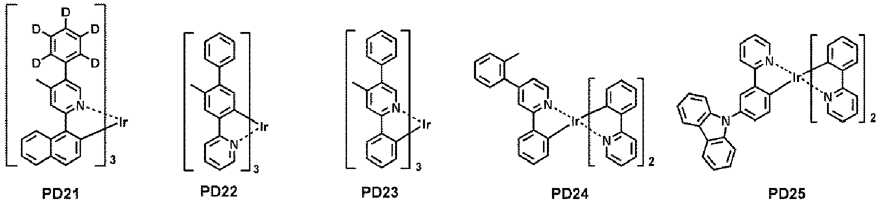

### [Fluorescent dopant in emission layer]

The fluorescent dopant may comprise an arylamine compound or a styrylamine compound.

The fluorescent dopant may comprise a compound represented by Formula 501:

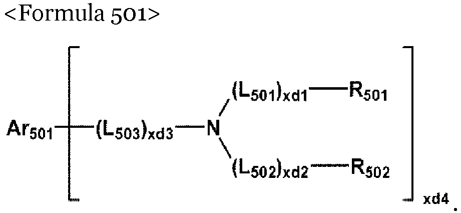

In Formula 501,
Ar₅₀₁ may be a substituted or unsubstituted C₅-C₆₀ carbocyclic group or a substituted or unsubstituted C₁-C₆₀ heterocyclic group,
L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
xd1 to xd3 may each independently be an integer selected from 0 to 3,
R₃₀₁ and R₅₀₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group, and
xd4 may be an integer selected from 1 to 6.

Ar₅₀₁ in Formula 501 may be selected from
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.
L₅₀₁ to L₅₀₃ in Formula 501 may each independently be selected from
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.
R₅₀₁ and R₅₀₂ in Formula 501 may each independently be selected from
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and - Si(Q₃₁)(Q₃₂)(Q₃₃),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.
xd4 in Formula 501 may be two.

For example, the fluorescent dopant may be selected from Compounds FD1 to FD22:

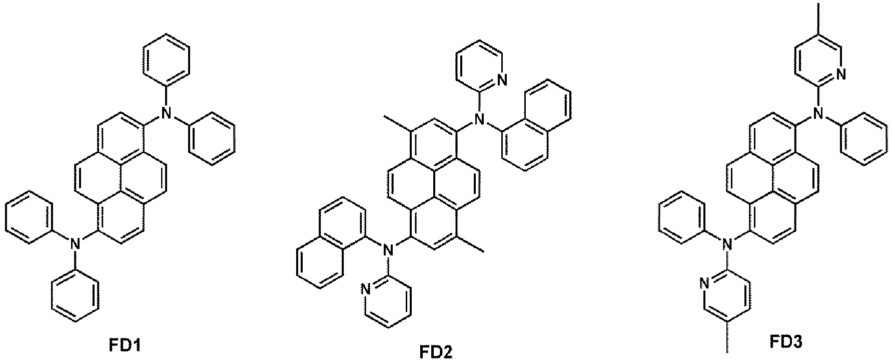

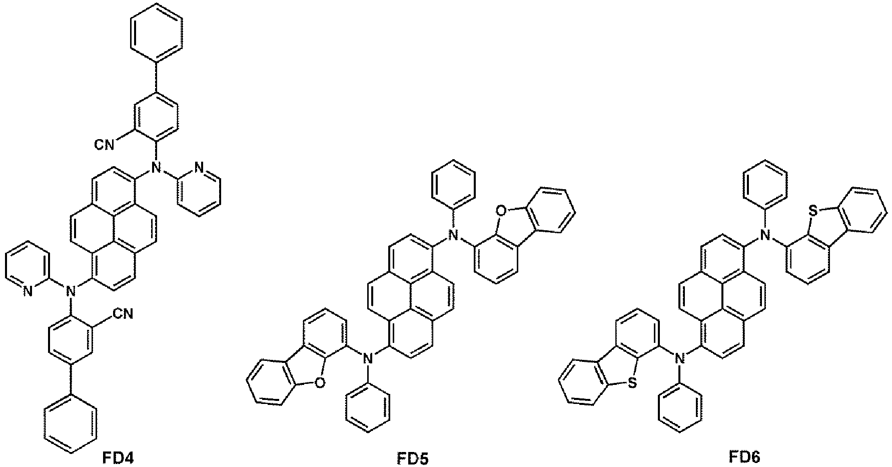

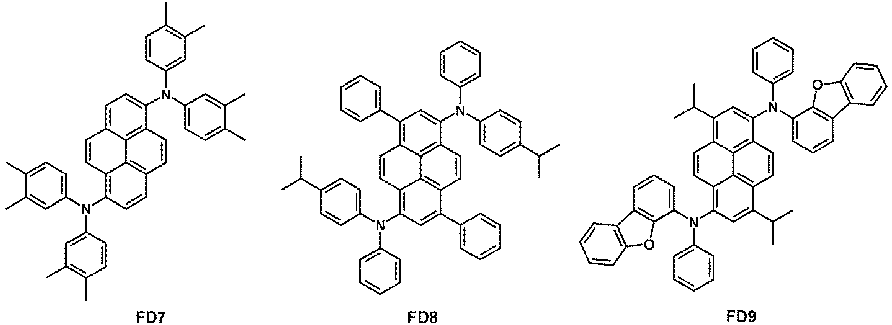

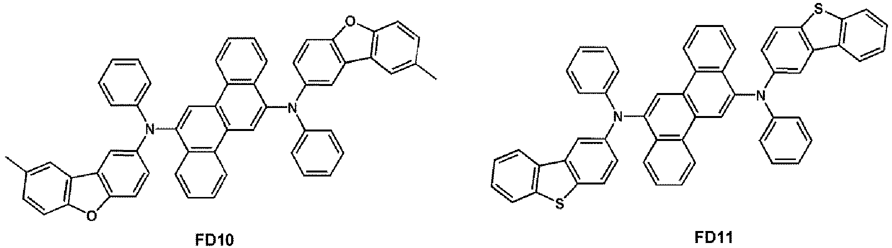

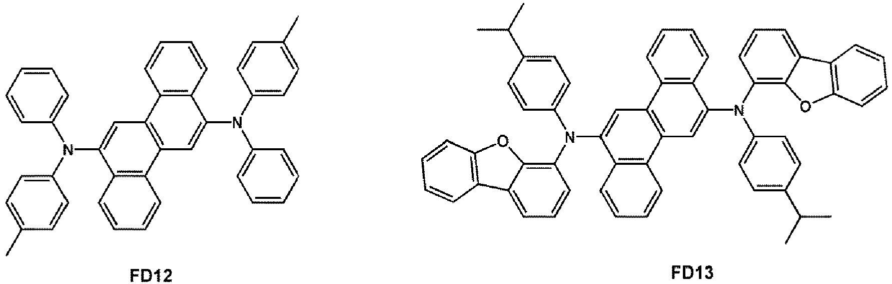

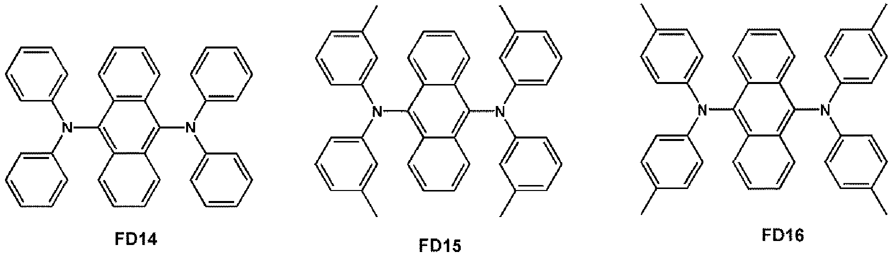

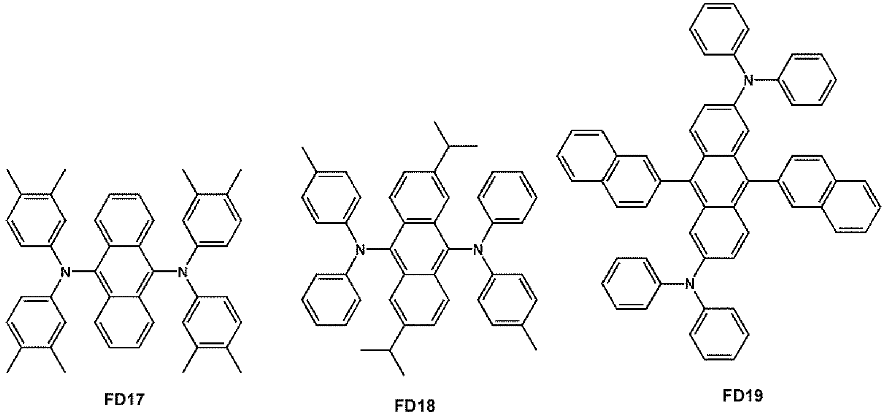

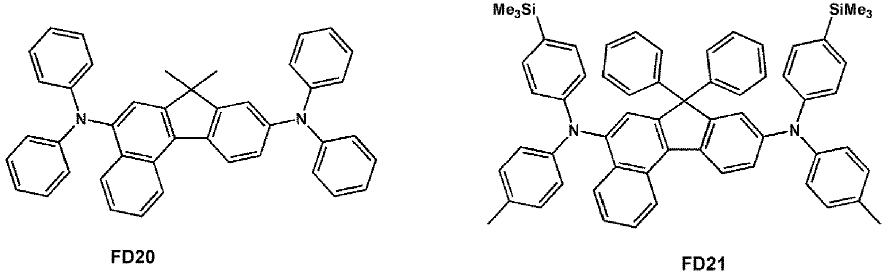

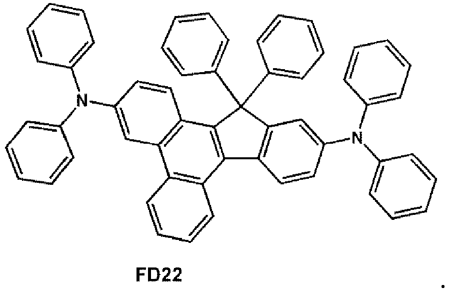

The fluorescent dopant may be selected from compounds illustrated below.

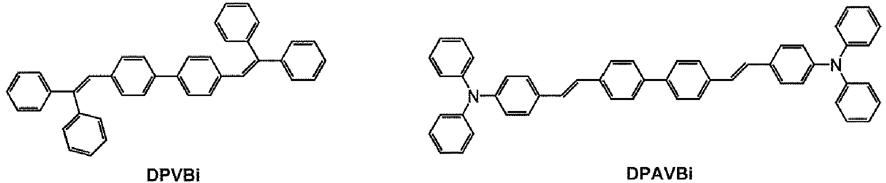

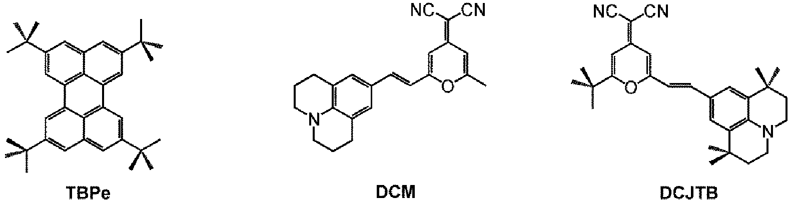

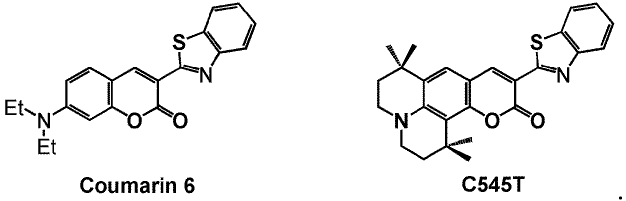

### [Electron transport region in organic layer 150]

The electron transport region may have i) a single-layered structure including a single layer including a single material, ii) a single-layered structure including a single layer comprising a plurality of different materials, or iii) a multi-layered structure having a plurality of layers comprising a plurality of different materials.

The electron transport region may comprise at least one selected from a buffer layer, a hole blocking layer, an electron control layer, an electron transport layer, and an electron injection layer.

For example, the electron transport region may have a structure of electron transport layer/electron injection layer, a structure of hole blocking layer/electron transport layer/electron injection layer, a structure of electron control layer/electron transport layer/electron injection layer, or a structure of buffer layer/electron transport layer/electron injection layer, wherein, in each of these structures, constituting layers are sequentially stacked in this stated order from an emission layer.

The electron transport region may comprise the second compound as described above.

The electron transport region may comprise a buffer layer, and the buffer layer may directly contact the emission layer, and the buffer layer may comprise the second compound as described above.

The electron transport region may comprise a buffer layer, an electron transport layer, and an electron injection layer, which are stacked in this stated order on the emission layer, and the buffer layer may comprise the second compound as described above.

The electron transport region (e.g., a hole blocking layer, an electron control layer, or an electron transport layer in the electron transport region) may comprise a metal-free compound containing at least one π electron-depleted nitrogen-containing ring.

The "π electron-depleted nitrogen-containing ring" indicates a C₁-C₆₀ heterocyclic group having at least one *-N=*' moiety as a ring-forming moiety.

For example, the "π electron-depleted nitrogen-containing ring" may be i) a 5-membered to 7-membered hetero monocyclic group having at least one *-N=*' moiety, ii) a heteropoly cyclic group in which two or more 5-membered to 7-membered hetero monocyclic groups each having at least one *-N=*' moiety are condensed with each other, or iii) a heteropoly cyclic group in which at least one selected from 5-membered to 7-membered hetero monocyclic groups, each having at least one *-N=*' moiety, is condensed with at least one C₅-C₆₀ carbocyclic group.

Examples of the π electron-depleted nitrogen-containing ring are an imidazole, a pyrazole, a thiazole, an isothiazole, an oxazole, an isoxazole, a pyridine, a pyrazine, a pyrimidine, a pyridazine, an indazole, a purine, a quinoline, an isoquinoline, a benzoquinoline, a phthalazine, a naphthyridine, a quinoxaline, a quinazoline, a cinnoline, a phenanthridine, an acridine, a phenanthroline, a phenazine, a benzoimidazole, an isobenzothiazole, a benzoxazole, an isobenzoxazole, a triazole, a tetrazole, an oxadiazole, a triazine, thiadiazol, an imidazopyridine, an imidazopyrimidine, and an azacarbazole.

For example, the electron transport region may comprise a compound represented by Formula 601:

<Formula 601> [Ar₆₀₁]ₓₑ₁₁-[(L₆₀₁)ₓₑ₁-R₆₀₁]ₓₑ₂₁.

In Formula 601,
Ar₆₀₁ may be a substituted or unsubstituted C₅-C₆₀ carbocyclic group or a substituted or unsubstituted C₁-C₆₀ heterocyclic group,
xe11 may be 1, 2, or 3,
L₆₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
xe1 may be an integer selected from 0 to 5,
R₆₀₁ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₆₀₁)(Q₆₀₂)(Q₆₀₃), -C(=O)(Q₆₀₁), -S(=O)₂(Q₆₀₁), and - P(=O)(Q₆₀₁)(Q₆₀₂),
Q₆₀₁ to Q₆₀₃ may each independently be a C₁-C₁₀ alkyl group, a C₁-C₁₀ alkoxy group, a phenyl group, a biphenyl group, a terphenyl group, or a naphthyl group, and
xe21 may be an integer selected from 1 to 5.

At least one selected from Ar₆₀₁(s) in the number of xe11 and/or at least one selected from R₆₀₁(s) in the number of xe21 may comprise the π electron-depleted nitrogen-containing ring.

Ring Ar₆₀₁ in Formula 601 may be selected from
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, naphthyridine group, a quinoxaline group, a quinazoline group, a cinnoline group, a phenanthridine group, an acridine group, a phenanthroline group, a phenazine group, a benzoimidazole group, an iso-benzothiazole group, a benzoxazole group, an isobenzoxazole group, a triazole group, a tetrazole group, an oxadiazole group, a triazine group, a thiadiazol group, an imidazopyridine group, an imidazopyrimidine group, and an azacarbazole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, naphthyridine group, a quinoxaline group, a quinazoline group, a cinnoline group, a phenanthridine group, an acridine group, a phenanthroline group, a phenazine group, a benzoimidazole group, an iso-benzothiazole group, a benzoxazole group, an isobenzoxazole group, a triazole group, a tetrazole group, an oxadiazole group, a triazine group, a thiadiazol group, an imidazopyridine group, an imidazopyrimidine group, and an azacarbazole group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -S(=O)₂(Q₃₁), and -PC(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

When xe11 in Formula 601 is two or more, two or more Ar₆₀₁(s) may be linked to each other via a single bond.

Ar₆₀₁ in Formula 601 may be an anthracene group.

A compound represented by Formula 601 may be represented by Formula 601-1:

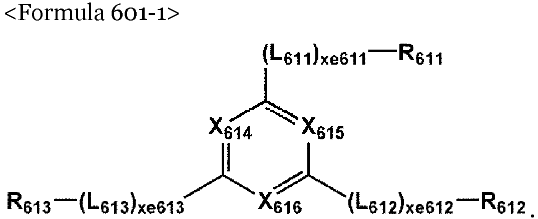

In Formula 601-1,
X₆₁₄ may be N or C(R₆₁₄), X₆₁₅ may be N or C(R₆₁₅), X₆₁₆ may be N or C(R₆₁₆), and at least one selected from X₆₁₄ to X₆₁₆ may be N,
L₆₁₁ to L₆₁₃ may each independently be substantially the same as described in connection with L₆₀₁,
xe611 to xe613 may each independently be substantially the same as described in connection with xe1,
R₆₁₁ to R₆₁₃ may each independently be substantially the same as described in connection with R₆₀₁,
R₆₁₄ to R₆₁₆ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

L₆₀₁ and L₆₁₁ to L₆₁₃ in Formulae 601 and 601-1 may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I**,** a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group.

xe1 and xe611 to xe613 in Formulae 601 and 601-1 may each independently be 0, 1, or 2.

R₆₀₁ and R₆₁₁ to R₆₁₃ in Formulae 601 and 601-1 may each independently be selected from
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I**,** a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
-S(=O)₂(Q₆₀₁) and -P(=O)(Q₆₀₁)(Q₆₀₂),
wherein Q₆₀₁ and Q₆₀₂ are substantially the same as described above.

The electron transport region may comprise at least one compound selected from Compounds ET1 to ET36.

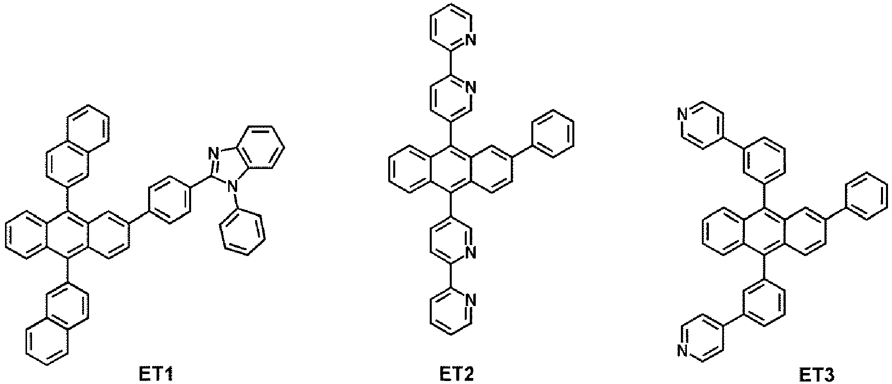

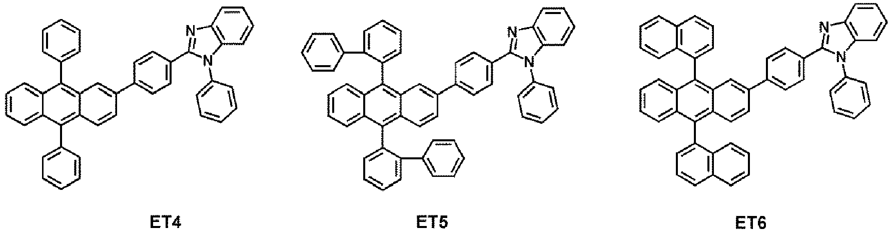

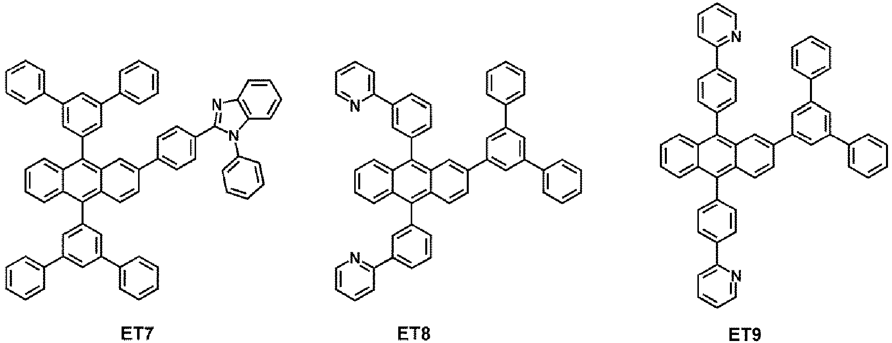

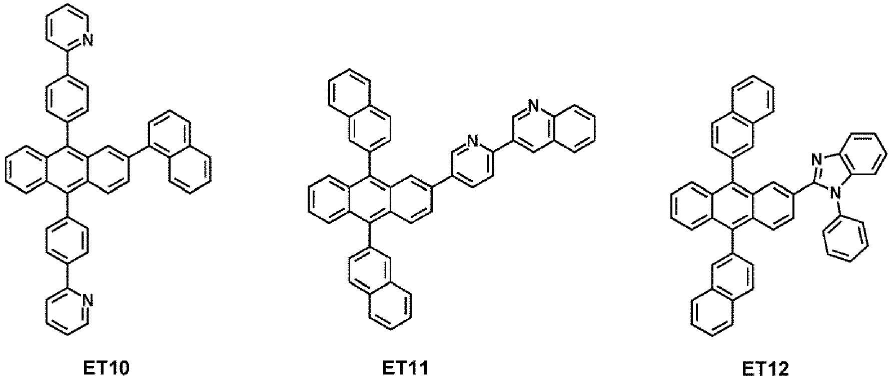

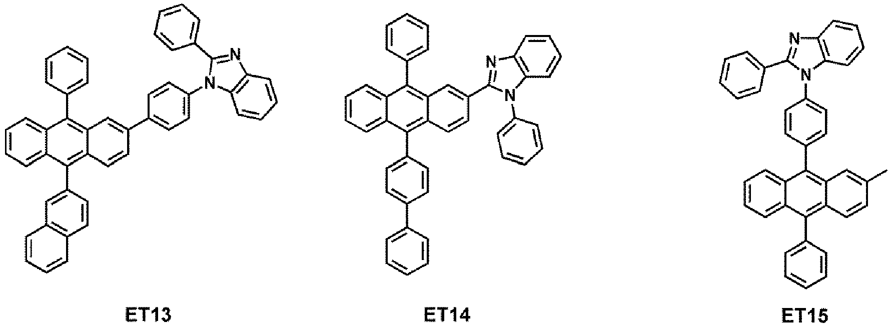

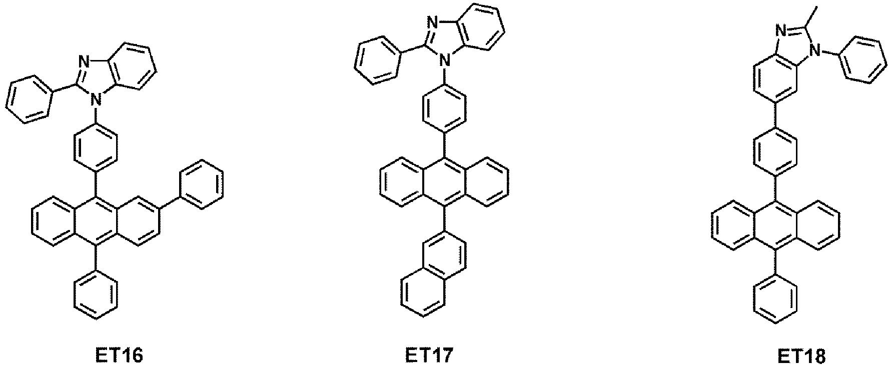

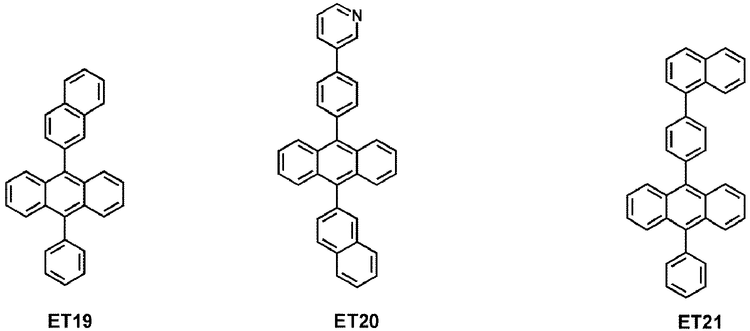

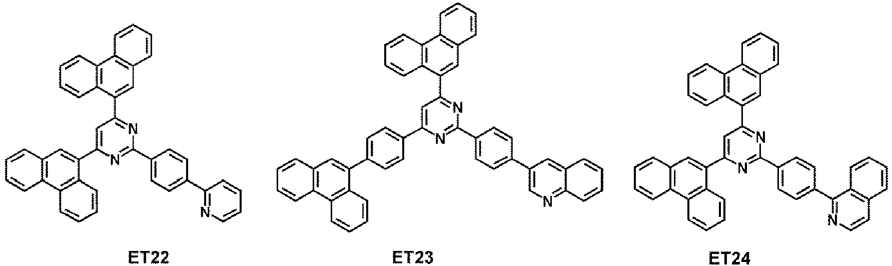

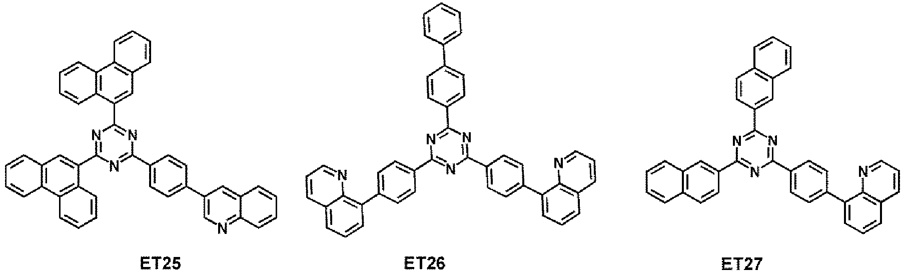

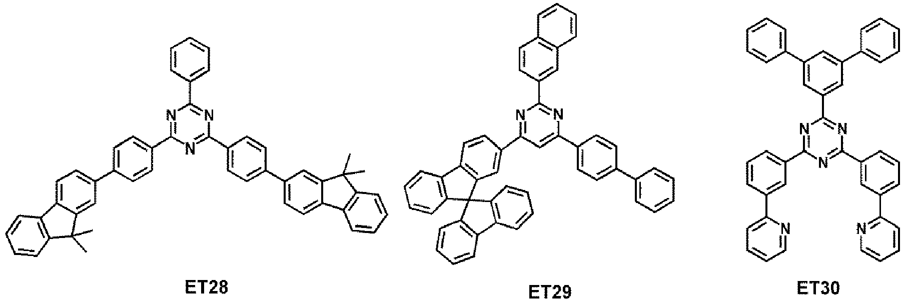

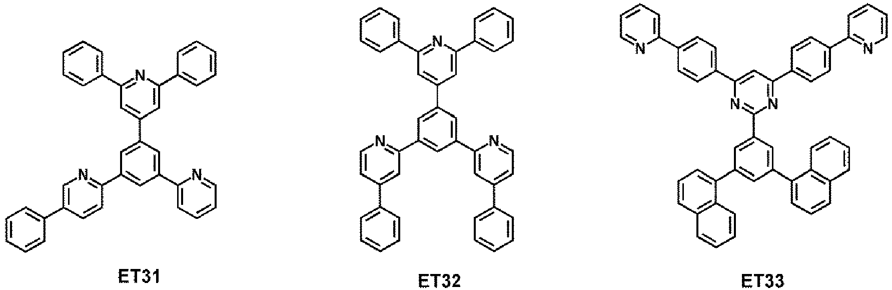

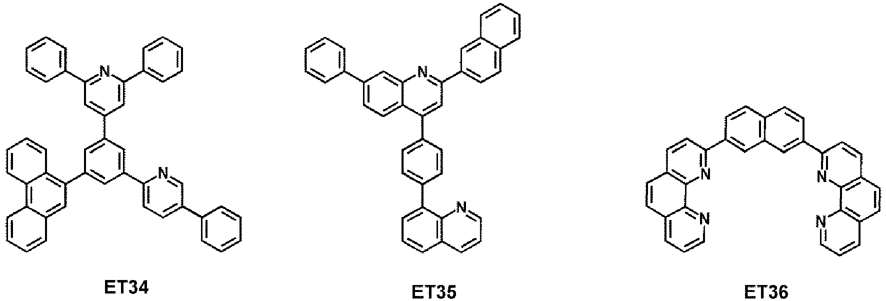

The electron transport region may comprise at least one selected from 2,9-dimethyl-4,7-diphenyl-1,10-phenanthroline (BCP), 4,7-dphenyl-1,10-phenanthroline (Bphen), Alq₃, BAlq, 3-(biphenyl-4-yl)-5-(4-tert-butylphenyl)-4-phenyl-4H-1,2,4-triazole (TAZ), and NTAZ.

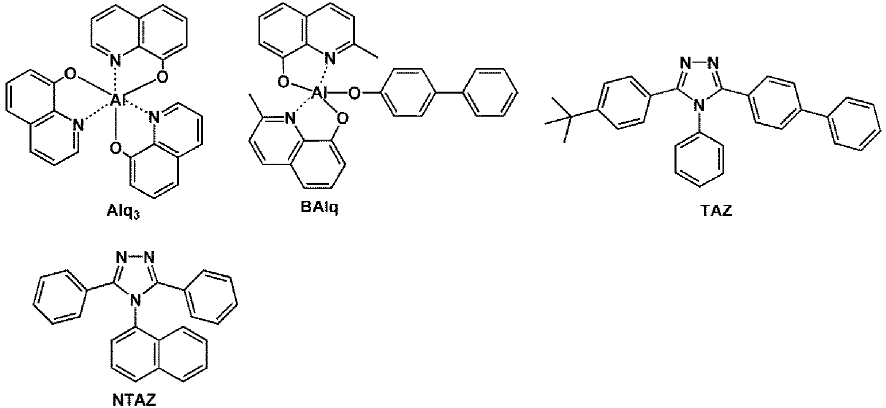

The thickness of the buffer layer, the hole blocking layer, or the electron control layer may each independently be in a range of about 20 Å to about 1,000 Å, for example, about 30 Å to about 300 Å. When the thicknesses of the buffer layer, the hole blocking layer, and the electron control layer are within these ranges, the electron blocking layer may have excellent electron blocking characteristics or electron control characteristics without a substantial increase in driving voltage.

A thickness of the electron transport layer may be in a range of about 100 Å to about 1,000 Å, for example, about 150 Å to about 500 Å. When the thickness of the electron transport layer is within the range described above, the electron transport layer may have satisfactory electron transport characteristics without a substantial increase in driving voltage.

The electron transport region (e.g., the electron transport layer in the electron transport region) may further comprise, in addition to the materials described above, a metal-containing material.

The metal-containing material may comprise at least one selected from an alkaline metal complex and an alkaline earth-metal complex. The alkaline metal complex may comprise a metal ion selected from an Li ion, a Na ion, a K ion, a Rb ion, and a Cs ion, and the alkaline earth-metal complex may comprise a metal ion selected from a Be ion, a Mg ion, a Ca ion, a Sr ion, and a Ba ion. A ligand coordinated with the metal ion of the alkaline metal complex or the alkaline earth-metal complex may be selected from a hydroxy quinoline, a hydroxy isoquinoline, a hydroxy benzoquinoline, a hydroxy acridine, a hydroxy phenanthridine, a hydroxy phenylan oxazole, a hydroxy phenylthiazole, a hydroxy diphenylan oxadiazole, a hydroxy diphenylthiadiazol, a hydroxy phenylpyridine, a hydroxy phenylbenzoimidazole, a hydroxy phenylbenzothiazole, a bipyridine, a phenanthroline, and a cyclopentadiene.

For example, the metal-containing material may comprise a Li complex. The Li complex may comprise, for example, Compound ET-D1 (lithium quinolate, LiQ) or ET-D2.

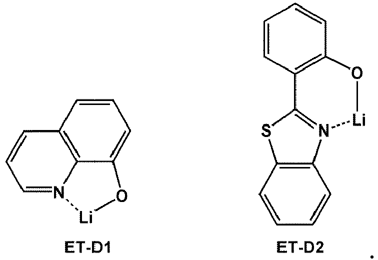

The electron transport region may comprise an electron injection layer that facilitates injection of electrons from the second electrode 190. The electron injection layer may directly contact the second electrode 190.

The electron injection layer may have i) a single-layered structure including a single layer including a single material, ii) a single-layered structure including a single layer comprising a plurality of different materials, or iii) a multi-layered structure having a plurality of layers comprising a plurality of different materials.

The electron injection layer may comprise an alkaline metal, an alkaline earth metal, a rare-earth metal, an alkaline metal compound, an alkaline earth-metal compound, a rare-earth metal compound, an alkaline metal complex, an alkaline earth-metal complex, a rare-earth metal complex, or any combinations thereof.

The electron injection layer may comprise Li, Na, K, Rb, Cs, Mg, Ca, Er, Tm, Yb, or any combination thereof.

The alkaline metal may be selected from Li, Na, K, Rb, and Cs. The alkaline metal may be Li, Na, or Cs. The alkaline metal may be Li or Cs.

The alkaline earth metal may be selected from Mg, Ca, Sr, and Ba.

The rare-earth metal may be selected from Sc, Y, Ce, Yb, Gd, and Tb.

The alkaline metal compound, the alkaline earth-metal compound, and the rare-earth metal compound may be selected from oxides and halides (for example, fluorides, chlorides, bromides, or iodines) of the alkaline metal, the alkaline earth-metal and the rare-earth metal.

The alkaline metal compound may be selected from alkaline metal oxides, such as Li₂O, Cs₂O, or K₂O, and alkaline metal halides, such as LiF, NaF, CsF, KF, LiI, NaI, CsI, RbI, or KI. The alkaline metal compound may be selected from LiF, Li₂O, NaF, LiI, NaI, CsI, and KI.

The alkaline earth-metal compound may be selected from alkaline earth-metal compounds, such as BaO, SrO, CaO, BaₓSr₁₋ₓO (0<x<1), or BaₓCa₁₋ₓO (0<x<1). The alkaline earth-metal compound may be selected from BaO, SrO, and CaO.

The rare-earth metal compound may be selected from YbF₃, ScF₃, ScO₃, Y₂O₃, Ce₂O₃, GdF₃, and TbF₃. The rare-earth metal compound may be selected from YbF₃, ScF₃, ThF₃, YbI₃, ScI₃, and ThI₃.

The alkaline metal complex, the alkaline earth-metal complex, and the rare-earth metal complex may comprise an ion of alkaline metal, an alkaline earth-metal, and a rare-earth metal as described above, and a ligand coordinated with a metal ion of the alkaline metal complex, the alkaline earth-metal complex, and the rare-earth metal complex may each independently be selected from a hydroxy quinoline, a hydroxy isoquinoline, a hydroxy benzoquinoline, a hydroxy acridine, a hydroxy phenanthridine, a hydroxy phenylan oxazole, a hydroxy phenylthiazole, a hydroxy diphenylan oxadiazole, a hydroxy diphenylthiadiazol, a hydroxy a phenylpyridine, a hydroxy phenylbenzoimidazole, a hydroxy phenylbenzothiazole, a bipyridine, a phenanthroline, and a cyclopentadiene.

The electron injection layer may consist of an alkaline metal, an alkaline earth metal, a rare-earth-metal, an alkaline metal compound, an alkaline earth-metal compound, a rare-earth metal compound, an alkaline metal complex, an alkaline earth-metal complex, a rare-earth metal complex, or any combinations thereof, as described above. The electron injection layer may further comprise an organic material. When the electron injection layer further comprises an organic material, alkaline metal, alkaline earth metal, rare-earth-metal, alkaline metal compound, an alkaline earth-metal compound, a rare-earth metal compound, an alkaline metal complex, an alkaline earth-metal complex, a rare-earth metal complex, or any combinations thereof may be homogeneously or non-homogeneously dispersed in a matrix comprising the organic material.

A thickness of the electron injection layer may be in a range of about 1 Å to about 100 Å, for example, about 3 Å to about 90 Å. When the thickness of the electron injection layer is within the range described above, the electron injection layer may have satisfactory electron injection characteristics without a substantial increase in driving voltage.

At least one layer selected from the electron transport layer and the electron injection layer may comprise an alkaline metal, an alkaline earth metal, a rare-earth-metal, an alkaline metal compound, an alkaline earth-metal compound, a rare-earth metal compound, an alkaline metal complex, an alkaline earth-metal complex, a rare-earth metal complex, or any combinations thereof.

### [Second electrode 190]

The second electrode 190 may be disposed on the organic layer 150 having such a structure. The second electrode 190 may be a cathode that is an electron injection electrode, and in this regard, a material for forming the second electrode 190 may be a material having a low work function, and such a material may be metal, alloy, an electrically conductive compound, or a combination thereof.

The second electrode 190 may comprise at least one selected from lithium (Li), silver (Ag), magnesium (Mg), aluminum (Al), aluminum-lithium (Al-Li), calcium (Ca), magnesium-indium (Mg-In), magnesium-silver (Mg-Ag), ITO, and IZO. The second electrode 190 may be a transmissive electrode, a semi-transmissive electrode, or a reflective electrode.

The second electrode 190 may have a single-layered structure, or a multi-layered structure comprising two or more layers.

### [Description of FIGS. 2 to 5]

An organic light-emitting device 20 of FIG. 2 may comprise a first capping layer 210, a first electrode 110, an organic layer 150, and a second electrode 190 which are sequentially stacked in this stated order, an organic light-emitting device 30 of FIG. 3 may comprise a first electrode 110, an organic layer 150, a second electrode 190, and a second capping layer 220 which are sequentially stacked in this stated order, and an organic light-emitting device 40 of FIG. 4 may comprise a first capping layer 210, a first electrode 110, an organic layer 150, a second electrode 190, and a second capping layer 220.

Regarding FIGS. 2 to 4, the first electrode 110, the organic layer 150, and the second electrode 190 may be understood by referring to the description presented in connection with FIG. 1.

In the organic layer 150 of each of the organic light-emitting devices 20 and 40, light generated in an emission layer may pass through the first electrode 110, which is a semi-transmissive electrode or a transmissive electrode, and the first capping layer 210 toward the outside, and in the organic layer 150 of each of the organic light-emitting devices 30 and 40, light generated in an emission layer may pass through the second electrode 190, which is a semi-transmissive electrode or a transmissive electrode, and the second capping layer 220 toward the outside.

The first capping layer 210 and the second capping layer 220 may increase external luminescent efficiency according to the principle of constructive interference.

The first capping layer 210 and the second capping layer 220 may each independently be a capping layer comprising an organic material, an inorganic capping layer comprising an inorganic material, or a composite capping layer comprising an organic material and an inorganic material.

At least one selected from the first capping layer 210 and the second capping layer 220 may each independently comprise at least one material selected from carbocyclic compounds, heterocyclic compounds, amine-based compounds, porphine derivatives, phthalocyanine derivatives, naphthalocyanine derivatives, alkaline metal complexes, and alkaline earth-based complexes. The carbocyclic compound, the heterocyclic compound, and the amine-based compound may be optionally substituted with a substituent containing at least one element selected from O, N, S, Se, Si, F, Cl, Br, and I. At least one selected from the first capping layer 210 and the second capping layer 220 may each independently comprise an amine-based compound.

At least one selected from the first capping layer 210 and the second capping layer 220 may each independently comprise the compound represented by Formula 201 or the compound represented by Formula 202.

At least one selected from the first capping layer 210 and the second capping layer 220 may each independently comprise a compound selected from Compounds HT28 to HT33 and Compounds CP1 to CP5.

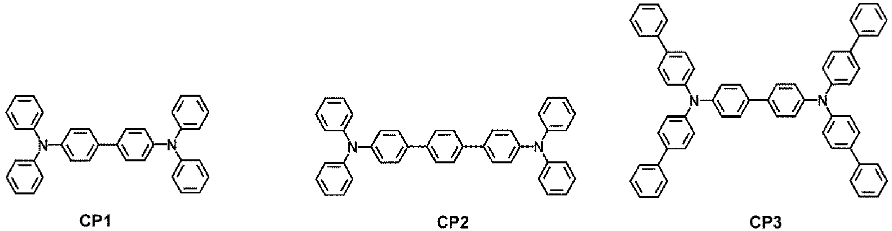

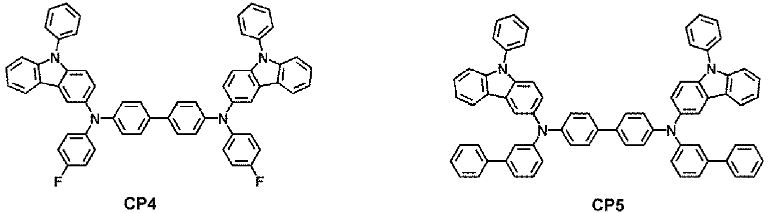

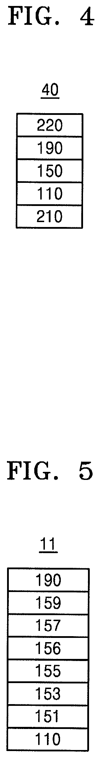

FIG. 5 illustrates a schematic view of an organic light-emitting device 11 according to an embodiment. The organic light-emitting device 11 may comprise a first electrode 110, a hole transport layer 151, an emission auxiliary layer 153, an emission layer 155, a buffer layer 156, an electron transport layer 157, an electron injection layer 159, and a second electrode 190, which are sequentially stacked in this stated order.

Respective layers constituting the organic light-emitting device 11 of FIG. 5 may be understood by referring to corresponding descriptions above.

Hereinbefore, the organic light-emitting device according to an embodiment has been described in connection with FIGS. 1 to 5.

Layers constituting the hole transport region, an emission layer, and layers constituting the electron transport region may be formed in a certain region by using one or more suitable methods selected from vacuum deposition, spin coating, casting, Langmuir-Blodgett (LB) deposition, ink-jet printing, laser-printing, and laser-induced thermal imaging.

When the respective layers of the hole transport region, the emission layer, and the respective layers of the electron transport region are formed by deposition, the deposition may be performed at a deposition temperature of about 100 °C to about 500 °C, at a vacuum degree of about 1.33 x 10 ⁻⁶ Pa (10⁻⁸ torr) to about 0.133 Pa (10⁻³ torr), and at a deposition rate of about 0.01 Å/sec to about 100 Å/sec by taking into account a material for forming a layer to be deposited and the structure of a layer to be formed.

When layers constituting the hole transport region, an emission layer, and layers constituting the electron transport region are formed by spin coating, the spin coating may be performed at a coating speed of about 2,000 rpm to about 5,000 rpm and at a heat treatment temperature of about 80°C to about 200°C by taking into account a material to be comprised in a layer to be formed and the structure of a layer to be formed.

### [General definition of substituents]

The term "C₁-C₆₀ alkyl group," as used herein, refers to a linear or branched aliphatic hydrocarbon monovalent group having 1 to 60 carbon atoms, e.g. 1 to 30 carbon atoms, 1 to 20 carbon atoms, 1 to 10 carbon atoms, 1 to 6 carbon atoms or 1 to 4 carbon atoms. Non-limiting examples thereof include a methyl group, an ethyl group, a propyl group, an isobutyl group, a sec-butyl group, a tert-butyl group, a pentyl group, an iso-amyl group, and a hexyl group. The term "C₁-C₆₀ alkylene group," as used herein, refers to a divalent group having the same structure as the C₁-C₆₀ alkyl group.

The term "C₂-C₆₀ alkenyl group," as used herein, refers to a hydrocarbon group formed by substituting at least one carbon-carbon double bond in the middle or at the terminal of the C₂-C₆₀ alkyl group, and non-limiting examples thereof include an ethenyl group, a propenyl group, and a butenyl group. The term "C₂-C₆₀ alkylene group," as used herein, refers to a divalent group having the same structure as the C₂-C₆₀ alkyl group.

The term "C₂-C₆₀ alkynyl group," as used herein, refers to a hydrocarbon group formed by substituting at least one carbon trip bond in the middle or at the terminal of the C₂-C₆₀ alkyl group, and non-limiting examples thereof include an ethynyl group and a propynyl group. The term "C₂-C₆₀ alkylene group," as used herein, refers to a divalent group having the same structure as the C₂-C₆₀ alkyl group.

The term "C₁-C₆₀ alkoxy group," as used herein, refers to a monovalent group represented by -OA₁₀₁ (wherein A₁₀₁ is the C₁-C₆₀ alkyl group), and non-limiting examples thereof include a methoxy group, an ethoxy group, and an isopropyloxy group.

The term "C₃-C₁₀ cycloalkyl group," as used herein, refers to a monovalent hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "C₃-C₁₀ cycloalkylene group," as used herein, refers to a divalent group having the same structure as the C₃-C₁₀ cycloalkyl group.

The term "C₁-C₁₀ heterocycloalkyl group," as used herein, refers to a monovalent saturated monocyclic group having at least one heteroatom selected from N, O, Si, P, and S (e.g. 1, 2, 3, 4 or 5 heteroatoms) as a ring-forming atom and 1 to 10 carbon atoms, e.g. 1, 2, 3, 4 or 5 ring carbon atoms. Non-limiting examples thereof include a 1,2,3,4-oxatriazolidinyl group, a tetrahydrofuranyl group, and a tetrahydrothiophenyl group. The term "C₁-C₁₀ heterocycloalkylene group," as used herein, refers to a divalent group having the same structure as the C₁-C₁₀ heterocycloalkyl group.

The term "C₃-C₁₀ cycloalkenyl group," as used herein, refers to a monovalent monocyclic group that has 3 to 10 carbon atoms and at least one double bond in the ring thereof and does not have aromaticity, and non-limiting examples thereof include a cyclopentenyl group, a cyclohexenyl group, and a cycloheptenyl group. The term "C₃-C₁₀ cycloalkenylene group," as used herein, refers to a divalent group having the same structure as the C₃-C₁₀ cycloalkenyl group.

The term "C₁-C₁₀ heterocycloalkenyl group," as used herein, refers to a monovalent monocyclic group that has at least one heteroatom (e.g. 1, 2, 3, 4 or 5 heteroatoms) selected from N, O, Si, P, and S as a ring-forming atom, 1 to 10 carbon atoms, e.g. 1, 2, 3, 4 or 5 ring carbon atoms, and at least one double bond in its ring. Non-limiting examples of the C₁-C₁₀ heterocycloalkenyl group are a 4,5-dihydro-1,2,3,4-oxatriazolyl group, a 2,3-dihydrofuranyl group, and a 2,3-dihydrothiophenyl group. The term "C₁-C₁₀ heterocycloalkenylene group," as used herein, refers to a divalent group having the same structure as the C₁-C₁₀ heterocycloalkenyl group.

The term "C₆-C₆₀ aryl group," as used herein, refers to a monovalent group having a carbocyclic aromatic system having 6 to 60 carbon atoms, e.g. 6 to 20 ring carbon atoms, 6 to 14 ring carbon atoms or 6 to 10 ring carbon atoms. The term "C₆-C₆₀ arylene group," as used herein, refers to a divalent group having a carbocyclic aromatic system having 6 to 60 carbon atoms. Non-limiting examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each comprise two or more rings, the rings may be fused to each other.

The term "C₁-C₆₀ heteroaryl group," as used herein, refers to a monovalent group having a heterocyclic aromatic system that has at least one heteroatom (e.g. 1, 2, 3, 4 or 5 heteroatoms) selected from N, O, Si, P, and S as a ring-forming atom, and 1 to 60 carbon atoms e.g. 1 to 19 ring carbon atoms, 1 to 13 ring carbon atoms or 1 to 9 ring carbon atoms. The term "C₁-C₆₀ heteroarylene group," as used herein, refers to a divalent group having a heterocyclic aromatic system that has at least one heteroatom selected from N, O, Si, P, and S as a ring-forming atom, and 1 to 60 carbon atoms. Non-limiting examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each comprise two or more rings, the rings may be fused to each other.

The term "C₆-C₆₀ aryloxy group," as used herein, refers to -OA₁₀₂ (wherein A₁₀₂ is the C₆-C₆₀ aryl group), and a C₆-C₆₀ arylthio group used herein indicates -SA₁₀₃ (wherein A₁₀₃ is the C₆-C₆₀ aryl group).

The term "monovalent non-aromatic condensed C8-C60 polycyclic group," as used herein, refers to a monovalent group having 8 to 60 ring carbon atoms (for example, 8 to 20, 8 to 14 or 8 to 10 ring carbon atoms) that has two or more rings condensed with each other, only carbon atoms as a ring-forming atom, and non-aromaticity in the entire molecular structure. Examples of the monovalent non-aromatic condensed C8-C60 polycyclic group include a fluorenyl group and a spiro-bifluorenyl group. The term "divalent non-aromatic condensed C8-C60 polycyclic group," used herein, refers to a divalent group having the same structure as the monovalent non-aromatic condensed C8-C60 polycyclic group.

The term "monovalent non-aromatic condensed 8- to 60-membered heteropolycyclic group," as used herein, refers to a monovalent group having 8- to 60-ring-forming atoms (for example, having 1 to 59, 2 to 59, 2 to 19, 2 to 13 or 2 to 9 ring carbon atoms) that has two or more rings condensed to each other, has at least one heteroatom (e.g. 1, 2, 3, 4 or 5 heteroatoms) selected from N, O, Si, P, and S, other than carbon atoms, as a ring-forming atom, and has non-aromaticity in the entire molecular structure. An example of the monovalent non-aromatic condensed 8- to 60-membered heteropolycyclic group is a carbazolyl group. The term "divalent non-aromatic condensed 8- to 60-membered heteropolycyclic group," used herein, refers to a divalent group having the same structure as the monovalent non-aromatic condensed 8- to 60-membered heteropolycyclic group.

The term "C₅-C₆₀ carbocyclic group," as used herein, refers to a monocyclic or polycyclic group having 5 to 60 carbon atoms, e.g. 5 to 20 ring carbon atoms, 5 to 14 ring carbon atoms or 5 to 10 ring carbon atoms in which the only ring-forming atoms are carbon atoms. The term "C₅-C₆₀ carbocyclic group," as used herein refers to an aromatic carbocyclic group or a non-aromatic carbocyclic group. The term "C₅-C₆₀ carbocyclic group," as used herein, refers to a ring, such as a benzene, a monovalent group, such as a phenyl group, or a divalent group, such as a phenylene group. Depending on the number of substituents connected to the C₅-C₆₀ carbocyclic group, the C₅-C₆₀ carbocyclic group may be a trivalent group or a quadrivalent group.

The term "C₁-C₆₀ heterocyclic group," as used herein, refers to a group having the same structure as the C₁-C₆₀ carbocyclic group, except that as a ring-forming atom, at least one heteroatom (e.g. 1, 2, 3, 4 or 5 heteroatoms) selected from N, O, Si, P, S, and Se is used in addition to carbon (the number of carbon atoms may be in a range of 1 to 60, e.g. 1 to 20 ring carbon atoms, 1 to 14 ring carbon atoms or 1 to 10 ring carbon atoms).

Certain groups are specified herein as being substituted or unsubstituted. Unless otherwise specified, when a group is substituted it is typically substituted with 1, 2, 3 or 4 substituents. For example, when a group is substituted it may substituted with 1, 2 or 3 substituents; 1 or 2 substituents; or 1 substituent. Groups which are not specified as being substituted or unsubstituted are typically unsubstituted.

Unless otherwise specified, when a group is substituted it is typically substituted with at least one substituent (e.g. 1, 2, 3 or 4 substituents) selected from
deuterium (-D), -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, - I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, and a monovalent non-aromatic condensed 8- to 60-membered heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₁ to Q₃, Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₆-C₆₀ aryl group substituted with a C₆-C₆₀ aryl group, a terphenyl group, a C₁-C₆₀ heteroaryl group, a C₁-C₆₀ heteroaryl group substituted with a C₁-C₆₀ alkyl group, a C₁-C₆₀ heteroaryl group substituted with a C₆-C₆₀ aryl group, a monovalent non-aromatic condensed C8-C60 polycyclic group, and a monovalent non-aromatic condensed 8- to 60-membered heteropolycyclic group.

The term "Ph", as used herein, may refer to a phenyl group; the term "Me", as used herein, may refer to a methyl group; the term "Et", as used herein, may refer to an ethyl group; the terms "ter-Bu" or "But", as used herein, may refer to a tert-butyl group; and the term "OMe," as used herein refers to a methoxy group.

The "biphenyl group" used therein refers to "a phenyl group substituted with a phenyl group." The "biphenyl group" belongs to "a substituted phenyl group" having "a C₆-C₆₀ aryl group" as a substituent.

The "terphenyl group" used herein refers to "a phenyl group substituted with a biphenyl group." The "terphenyl group" belongs to "a substituted phenyl group" having "a C₆-C₆₀ aryl group substituted with a C₆-C₆₀ aryl group."

Symbols * and *' used herein, unless defined otherwise, refer to a binding site to a neighboring atom in a corresponding formula.

Hereinafter, a compound according to embodiments and an organic light-emitting device according to embodiments will be described in detail with reference to Synthesis Examples and Examples. The wording "B was used instead of A" used in describing Synthesis Examples means that a molar equivalent of A was identical to a molar equivalent of B.

### [Example]

The following Examples and Comparative Examples are provided in order to highlight characteristics of one or more embodiments, but it will be understood that the Examples and Comparative Examples are not to be construed as limiting the scope of the embodiments, nor are the Comparative Examples to be construed as being outside the scope of the embodiments. Further, it will be understood that the embodiments are not limited to the particular details described in the Examples and Comparative Examples.

### Example 1-1: Manufacture of red organic light-emitting device

An anode was prepared by cutting an ITO glass substrate (manufactured by Corning), having a thickness of 1,200 Å and sheet resistance of 15 Ω/cm², to a size of 50 mm x 50 mm x 0.5 mm, ultrasonically cleaning the ITO glass substrate using isopropyl alcohol and pure water each for 15 minutes, and then, exposing the ITO glass substrate to UV light irradiation for 30 minutes and ozone to clean the ITO glass substrate. Then, the ITO glass substrate was loaded into a vacuum deposition apparatus.

m-MTDATA was vacuum-deposited on the ITO glass substrate (anode) to a thickness of 700 Å to form a hole transport layer. Then, TCTA was vacuum deposited on the hole transport layer to a thickness of 100 Å to form an emission auxiliary layer.

Compound 1-1 (as a host) and PD11 (as a dopant) were co-deposited on the emission auxiliary layer at a weight ratio of 98:2 to form an emission layer having a thickness of 300 Å.

Compound 2-9 was deposited on the emission layer to form a buffer layer having a thickness of 100 Å, and then, Alq₃ was vacuum deposited on the buffer layer to form an electron transport layer having a thickness of 200 Å. LiF was deposited on the electron transport layer to form an electron injection layer having a thickness of 10 Å.

Al was deposited on the electron injection layer to form a cathode having a thickness of 2,000 Å, thereby completing the manufacture of an organic light-emitting device.

### Examples 1-2 to 1-10 and Comparative Examples 1-1 to 1-3

Organic light-emitting devices were manufactured in the same manner as in Example 1-1, except that compounds shown in Table 5 were used in forming an emission layer and a buffer layer.

### Evaluation Example 1

The driving voltage and efficiency of the organic light-emitting devices of Examples 1-1 to 1-10 and Comparative Examples 1-1 to 1-3 were evaluated at 5 mA/cm² by using a Keithley SMU 236 meter. Results thereof are shown in Table 5.

**[Table 5]**

| | Emission layer (host) | Buffer layer | Driving voltage(V) | Efficiency (cd/A) |
|---|---|---|---|---|
| Example 1-1 | Compound 1-1 | Compound 2-9 | 5.3 | 23.9 |
| Example 1-2 | Compound 1-6 | Compound 2-48 | 5.4 | 24.5 |
| Example 1-3 | Compound 1-124 | Compound 2-147a | 5.2 | 23.7 |
| Example 1-4 | Compound 1-97 | Compound 2-143a | 5.3 | 24.1 |
| Example 1-5 | Compound 1-41 | Compound 2-48 | 5.5 | 23.8 |
| Example 1-6 | Compound 1-19 | Compound 2-93 | 5.5 | 24.5 |
| Example 1-7 | Compound 1-57 | Compound 2-153 | 5.3 | 25.3 |
| Example 1-8 | Compound 1-64 | Compound 2-165 | 5.3 | 25.1 |
| Example 1-9 | Compound 1-126 | Compound 2-189 | 5.4 | 24.0 |
| Example 1-10 | Compound 1-137 | Compound 2-211 | 5.2 | 24.7 |
| Comparative Example 1-1 | CBP | Compound 2-9 | 5.9 | 22.3 |
| Comparative Example 1-2 | Compound 1-1 | BAlq | 5.8 | 22.7 |
| Comparative Example 1-3 | CBP | BAlq | 6.2 | 21.6 |

Referring to Table 5, it may be seen that the organic light-emitting devices of Examples 1-1 to 1-10 had a low driving voltage and high efficiency, compared to those of the organic light-emitting devices of Comparative Examples 1-1 to 1-3.

### Example 2-1: Manufacture of green (phosphorescent) organic light-emitting device

An anode was prepared by cutting an ITO glass substrate (manufactured by Corning), having a thickness of 1,200 Å and sheet resistance of 15 Ω/cm², to a size of 50 mm x 50 mm x 0.5 mm, ultrasonically cleaning the ITO glass substrate using isopropyl alcohol and pure water each for 15 minutes, and then, exposing to irradiation of UV light for 30 minutes and ozone to clean. Then, the ITO glass substrate was loaded into a vacuum deposition apparatus.

m-MTDATA was vacuum deposited on the ITO glass substrate (anode) to a thickness of 700 Å to form a hole transport layer. Then, TCTA was vacuum deposited on the hole transport layer to a thickness of 100 Å to form an emission auxiliary layer.

Compound 1-1 (as a host) and PD13 (as a dopant) were co-deposited on the emission auxiliary layer at a weight ratio of 90:10 to form an emission layer having a thickness of 300 Å.

Compound 2-9 was deposited on the emission layer to form a buffer layer having a thickness of 100 Å, and then, Alq₃ was vacuum deposited on the buffer layer to form an electron transport layer having a thickness of 200 Å. LiF was deposited on the electron transport layer to form an electron injection layer having a thickness of 10 Å.

Al was deposited on the electron injection layer to form a cathode having a thickness of 2,000 Å, thereby completing the manufacture of an organic light-emitting device.

### Examples 2-2 to 2-5 and Comparative Examples 2-1 to 2-3

Organic light-emitting devices were manufactured in the same manner as in Example 2-1, except that compounds shown in Table 6 were used in forming an emission layer and a buffer layer.

### Example 2-6

An organic light-emitting device was manufactured in the same manner as in Example 2-1, except that Compound 1-1 (as a first host), CBP (as a second host), and PD13 (as a dopant) were co-deposited at a weight ratio of 50:50:10 in forming an emission layer.

### Examples 2-7 to 2-10

Organic light-emitting devices were manufactured in the same manner as in Example 2-6, except that compounds shown in Table 7 were used in forming an emission layer and a buffer layer.

### Example 2-11: Manufacture of green (fluorescent) organic light-emitting device

An anode was prepared by cutting an ITO glass substrate (manufactured by Corning), having a thickness of 1,200 Å and sheet resistance of 15 Ω/cm², to a size of 50 mm x 50 mm x 0.5 mm, ultrasonically cleaning the ITO glass substrate using isopropyl alcohol and pure water each for 15 minutes, and then, exposing to irradiation of UV light for 30 minutes and ozone to clean. Then, the ITO glass substrate was loaded into a vacuum deposition apparatus.

m-MTDATA was vacuum deposited on the ITO glass substrate (anode) to a thickness of 700 Å to form a hole transport layer. Then, NPB was vacuum deposited on the hole transport layer to a thickness of 100 Å to form an emission auxiliary layer.

Compound 1-166 (as a host) and FD19 (as a dopant) were co-deposited on the emission auxiliary layer at a weight ratio of 95:5 to form an emission layer having a thickness of 300 Å.

Compound 2-9 was deposited on the emission layer to form a buffer layer having a thickness of 100 Å, and then, Alq₃ was vacuum deposited on the buffer layer to form an electron transport layer having a thickness of 200 Å. LiF was deposited on the electron transport layer to form an electron injection layer having a thickness of 10 Å.

Al was deposited on the electron injection layer to form a cathode having a thickness of 2,000 Å, thereby completing the manufacture of an organic light-emitting device.

### Examples 2-12 to 2-15 and Comparative Examples 2-4 to 2-6

Organic light-emitting devices were manufactured in the same manner as in Example 2-11, except that compounds shown in Table 6 were used in forming an emission layer and a buffer layer.

### Evaluation Example 2

The driving voltage and efficiency of the organic light-emitting devices of Examples 2-1 to 2-15 and Comparative Examples 2-1 to 2-6 were evaluated at 5 mA/cm² (phosphorescence) and 10 mA/cm² (fluorescence) by using a Keithley SMU 236 meter. Results thereof are shown in Tables 6 and 7.

**[Table 6]**

| | Emission layer (host) | Emission layer (dopant) | Buffer layer | Weight ratio (host: dopant) | Driving voltage (V) | Efficiency (cd/A) |
|---|---|---|---|---|---|---|
| Example 2-1 | Compound 1-1 | PD13 | Compound 2-9 | 90:10 | 5.5 | 41.5 |
| Example 2-2 | Compound 1-20 | PD13 | Compound 2-48 | 90:10 | 5.2 | 43.6 |
| Example 2-3 | Compound 1-46 | PD13 | Compound 2-136a | 90:10 | 5.4 | 42.8 |
| Example 2-4 | Compound 1-59 | PD13 | Compound 2-103 | 90:10 | 5.4 | 43.1 |
| Example 2-5 | Compound 1-104 | PD13 | Compound 2-162 | 90:10 | 5.3 | 42.6 |
| Comparative Example 2-1 | CBP | PD13 | Compound 2-9 | 90:10 | 5.9 | 38.7 |
| Comparative Example 2-2 | Compound 1-1 | PD13 | BAlq | 90:10 | 5.9 | 38.3 |
| Comparative Example 2-3 | CBP | PD13 | BAlq | 90:10 | 6.1 | 36.1 |
| Example 2-11 | Compound 1-1 | FD19 | Compound 2-9 | 95:5 | 4.5 | 19.1 |
| Example 2-12 | Compound 1-20 | FD19 | Compound 2-48 | 95:5 | 4.7 | 19.9 |
| Example 2-13 | Compound 1-46 | FD19 | Compound 2-136a | 95:5 | 4.4 | 20.1 |
| Example 2-14 | Compound 1-59 | FD19 | Compound 2-103 | 95:5 | 4.3 | 19.8 |
| Example 2-15 | Compound 1-104 | FD19 | Compound 2-162 | 95:5 | 4.5 | 20.3 |
| Comparative Example 2-4 | AND | FD19 | Compound 2-9 | 95:5 | 4.8 | 18.3 |
| Comparative Example 2-5 | Compound 1-166 | FD19 | Alq₃ | 95:5 | 4.6 | 17.8 |
| Comparative Example 2-6 | ADN | FD19 | Alq₃ | 95:5 | 5.0 | 16.2 |

**[Table 7]**

| | Emission layer (first host: second host) | Emission layer (dopant) | Buffer layer | Weight ratio (first host:second host:dopant) | Driving voltage (V) | Efficiency (cd/A) |
|---|---|---|---|---|---|---|
| Example 2-6 | Compound 1-1: CPB | PD13 | Compound 2-9 | 50:50:10 | 5.5 | 41.1 |
| Example 2-7 | Compound 1-1: Compound 1-39 | PD13 | Compound 2-48 | 50:50:10 | 5.3 | 42.3 |
| Example 2-8 | Compound 1-20: Compound 1-41 | PD13 | Compound 2-136a | 50:50:10 | 5.2 | 42.7 |
| Example 2-9 | Compound 1-113: Compound 1-60 | PD13 | Compound 2-103 | 50:50:10 | 5.4 | 42.0 |
| Example 2-10 | Compound 1-46: Compound 1-16 | PD13 | Compound 2-162 | 50:50:10 | 5.3 | 43.2 |

Referring to Tables 6 and 7, it may be seen that the organic light-emitting devices of Examples 2-1 to 2-10 had a low driving voltage and high efficiency, compared to those of the organic light-emitting devices of Comparative Examples 2-1 to 2-3, and the organic light-emitting devices of the Examples 2-11 to 2-15 had a low driving voltage and high efficiency, compared to those of the organic light-emitting devices of Comparative Examples 2-4 to 2-6.

### Example 3-1: Manufacture of blue organic light-emitting device

An anode was prepared by cutting an ITO glass substrate (manufactured by Corning), having a thickness of 1,200 Å and sheet resistance of 15 Ω/cm², to a size of 50 mm x 50 mm x 0.5 mm, ultrasonically cleaning the ITO glass substrate using isopropyl alcohol and pure water each for 15 minutes, and then, exposing to irradiation of UV light for 30 minutes and ozone to clean. Then, the ITO glass substrate was loaded into a vacuum deposition apparatus.

m-MTDATA was vacuum deposited on the ITO glass substrate (anode) to a thickness of 700 Å to form a hole transport layer. Then, NPB was vacuum deposited on the hole transport layer to a thickness of 100 Å to form an emission auxiliary layer.

Compound 1-166 (as a host) and FD1 (as a dopant) were co-deposited on the emission auxiliary layer at a weight ratio of 95:5 to form an emission layer having a thickness of 300 Å.

Compound 2-9 was deposited on the emission layer to form a buffer layer having a thickness of 100 Å, and then, Alq₃ was vacuum deposited on the buffer layer to form an electron transport layer having a thickness of 200 Å. LiF was deposited on the electron transport layer to form an electron injection layer having a thickness of 10 Å.

Al was deposited on the electron injection layer to form a cathode having a thickness of 2,000 Å, thereby completing the manufacture of an organic light-emitting device.

### Examples 3-2 to 3-5 and Comparative Examples 3-1 to 3-3

Organic light-emitting devices were manufactured in the same manner as in Example 3-1, except that compounds shown in Table 8 were used in forming an emission layer and a buffer layer.

### Example 3-6 to 3-10

Organic light-emitting devices were manufactured in the same manner as in Example 3-1, except that 1 wt% of F4-TCNQ was doped in forming a hole transport layer and that compounds shown in Table 8 were used in forming an emission layer and a buffer layer.

**[Table 8]**

| | Emission layer (host) | Buffer layer | Driving voltage (V) | Efficiency (cd/A) |
|---|---|---|---|---|
| Example 3-1 | Compound 1-166 | Compound 2-9 | 4.5 | 5.1 |
| Example 3-2 | Compound 1-164 | Compound 2-48 | 4.5 | 5.3 |
| Example 3-3 | Compound 1-178 | Compound 2-136a | 4.6 | 5.0 |
| Example 3-4 | Compound 1-164 | Compound 2-103 | 4.4 | 4.9 |
| Example 3-5 | Compound 1-178 | Compound 2-162 | 4.4 | 5.2 |
| Example 3-6 | Compound 1-165 | Compound 2-131 | 4.2 | 5.2 |
| Example 3-7 | Compound 1-171 | Compound 2-121a | 4.1 | 5.0 |
| Example 3-8 | Compound 1-171 | Compound 2-180 | 4.2 | 5.0 |
| Example 3-9 | Compound 1-176 | Compound 2-13a | 4.2 | 5.2 |
| Example 3-10 | Compound 1-176 | Compound 2-242 | 4.3 | 5.1 |
| Comparative Example 3-1 | AND | Compound 2-9 | 4.7 | 4.6 |
| Comparative Example 3-2 | Compound 1-166 | Alq₃ | 4.6 | 4.8 |
| Comparative Example 3-3 | ADN | Alq₃ | 4.9 | 4.4 |

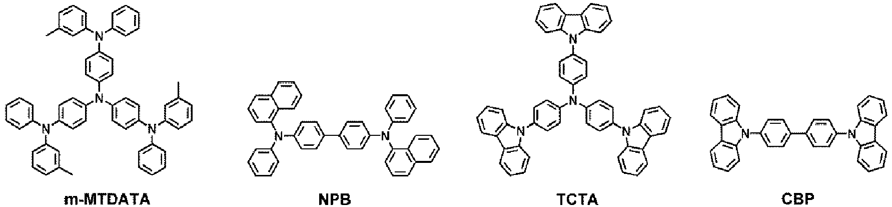

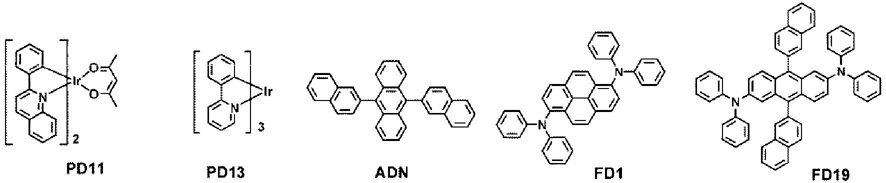

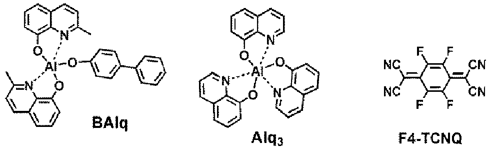

Referring to Table 8, it may be seen that the organic light-emitting devices of Examples 3-1 to 3-10 had a low driving voltage and high efficiency, compared to those of the organic light-emitting devices of Comparative Examples 3-1 to 3-3.

According to one or more embodiments, an organic light-emitting device may have a low driving voltage and high efficiency.

Exemplary embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. An organic light-emitting device, comprising:
a first electrode;
a second electrode facing the first electrode;
an emission layer between the first electrode and the second electrode;
a hole transport region between the first electrode and the emission layer; and
an electron transport region between the emission layer and the second electrode,
wherein:
the emission layer comprises a first compound,
at least one of the hole transport region and the electron transport region comprises a second compound,
the first compound is represented by Formula 1A or 1B, and
the second compound is represented by Formula 2A or 2B: 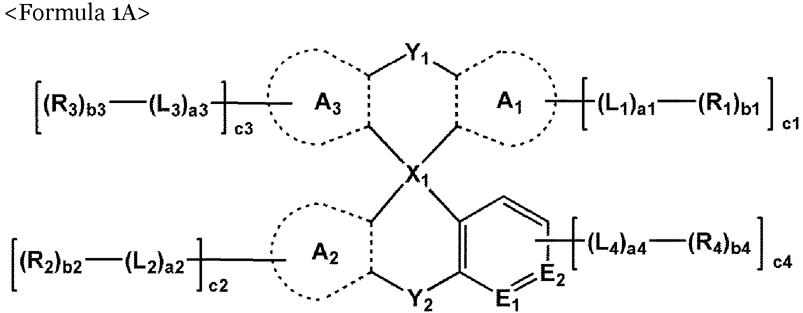 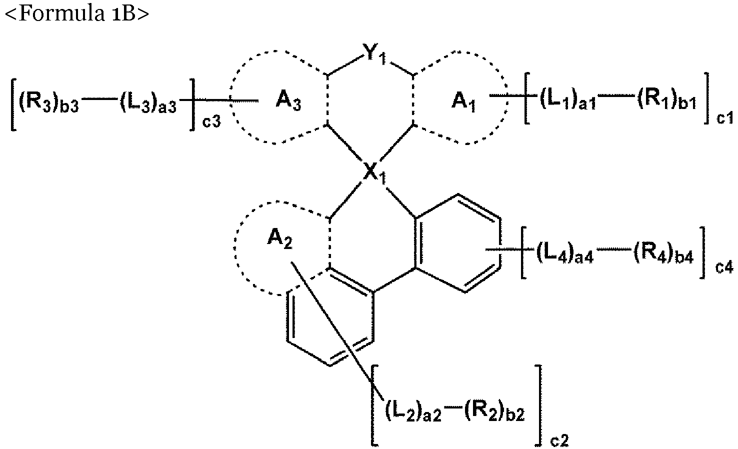 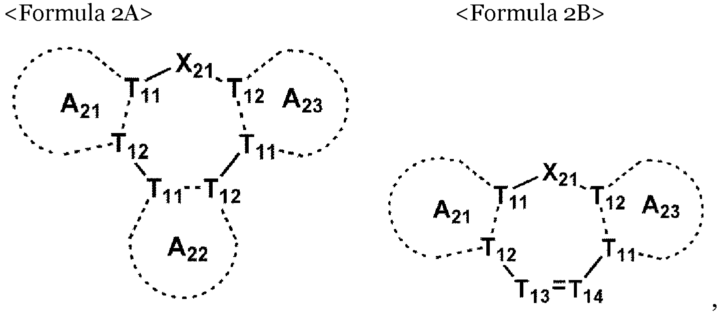
wherein, in Formulae 1A, 1B, 2A, and 2B,
rings A₁ to A₃ are each independently selected from a C₃-C₆₀ carbocyclic group and a C₁-C₆₀ heterocyclic group,
rings A₁ to A₃ are each condensed with the spiro-ring in Formulae 1A and 1B,
rings A₂₁, A₂₂, and A₂₃ are each independently a C₃-C₆₀ carbocyclic group or C₁-C₆₀ heterocyclic group, each substituted with at least one *-[(L₂₂)ₐ₂₂-(R₂₂)_{b22}], in which * is a bonding site to the A₂₁, A₂₂, or A₂₃ ring,
each T₁₁ is independently carbon or nitrogen,
each T₁₂ is independently carbon or nitrogen,
T₁₃ is N or C(R₂₇),
T₁₄ is N or C(R₂₈),
each bond between T₁₁ and T₁₂ represented as a dashed line in formulae 2A and 2B is a single bond or a double bond,
the six atoms represented by the three T₁₁ and three T₁₂ in Formula 2A are not all nitrogen, and the six atoms represented by the two T₁₁, two T₁₂, T₁₃, and T₁₄ in Formula 2B are not all nitrogen,
rings A₂₁, A₂₂, and A₂₃ are each condensed with the 7-membered ring in Formulae 2A and 2B, while sharing T₁₁ and T₁₂ therewith,
X₁ is a silicon (Si) atom or a carbon (C) atom,
Y₁ is selected from a single bond, N[(L₁₁)ₐ₁₁-(R₁₁)_{b11}], C(R₁₁)(R₁₃), Si(R₁₁)(R₁₃), O, S, and Se,
Y₂ is selected from a single bond, N[(L₁₂)ₐ₁₂-(R₁₂)_{b12}], C(R₁₂)(R₁₄), Si(R₁₂)(R₁₄), O, S, and Se,
E₁ and E₂ are each independently a nitrogen (N) atom, or a carbon (C) atom substituted with *-(L₄)ₐ₄-(R₄)_{b4},
X₂₁ is N[(L₂₁)ₐ₂₁-(R₂₁)_{b21}], or
X₂₁ is O, S, Se, C(R₂₃)(R₂₄), or Si(R₂₃)(R₂₄), and at least one of rings A₂₁, A₂₂, and A₂₃ in Formula 2A and at least one of rings A₂₁ and A₂₃ in Formula 2B are each independently a group represented by one of Formulae 2-1 to 2-3, 2-10 to 2-27, and 2-33 to 2-36 in which at least one of X₂₂ and X₂₃ is N-[(L₂₂)ₐ₂₂-(R₂₂)_{b22}]: 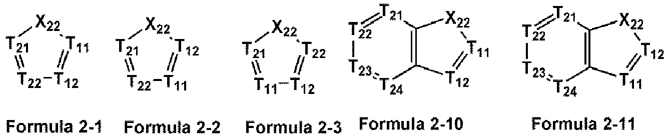 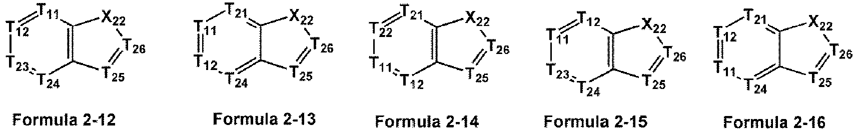 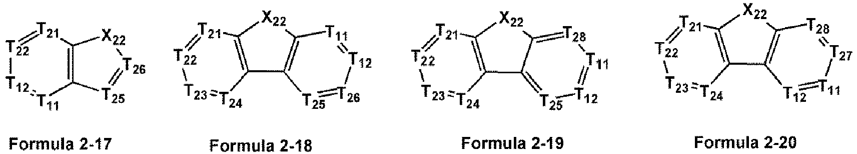 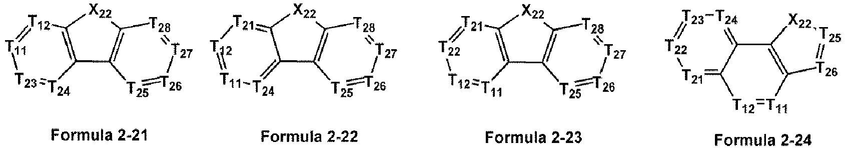 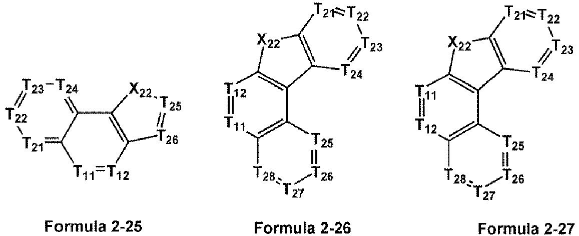 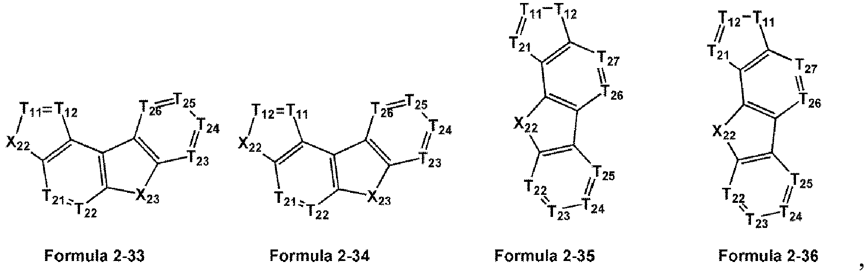
wherein, in Formulae 2-1 to 2-3, 2-10 to 2-27, and 2-33 to 2-36,
X₂₂ and X₂₃ are each independently selected from O, S, Se, a carbon-containing moiety, a nitrogen-containing moiety, and a silicon-containing moiety, and
T₂₁ to T₂₈ are each independently selected from N and a carbon-containing moiety,
L₁ to L₄, L₁₁, L₁₂, and L₂₁ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
wherein, in Formulae 2-1 to 2-3, 2-10 to 2-19, 2-21 to 2-27, and 2-33 to 2-36,
L₂₂ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
wherein, in Formulae 2-20,
L₂₂ are each independently selected from a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group; and
a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, a terphenyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂), wherein Q₃₁ to Q₃₃ are each independently selected from:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group.
a1 to a4, a11, a12, a21, and a22 are each independently an integer of 0 to 5,
R₁ to R₄, R₂₁, R₂₃, R₂₄, R₂₇, and R₂₈ are each independently selected from hydrogen, deuterium (-D), -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, - Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂),
wherein, in Formulae 2-1 to 2-3, 2-10 to 2-19, 2-21, 2-23 to 2-27, and 2-33 to 2-36,
R₂₂ is selected from hydrogen, deuterium (-D), -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₁)(Q₂)(Q₃), - N(Q₁)(Q₂), -B(Q₁)(Q₂), -C(=O)(Q₁), -S(=O)₂(Q₁), and -P(=O)(Q₁)(Q₂),
wherein, in Formulae 2-20,
R₂₂ is selected from hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, -Si(Q₁)(Q₂)(Q₃), - N(Q₁)(Q₂), -B(Q₁)(Q₂), -C(=O)(Q₁), -S(=O)₂(Q₁), and -P(=O)(Q₁)(Q₂); and
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁), and -P(=O)(Q₃₁)(Q₃₂), wherein Q₁ to Q₃ and Q₃₁ to Q₃₃ are each independently selected from:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group,
wherein, in Formulae 2-22,
R₂₂ is hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, -Si(Q₁)(Q₂)(Q₃), - N(Q₁)(Q₂), -B(Q₁)(Q₂), -C(=O)(Q₁), -S(=O)₂(Q₁), and -P(=O)(Q₁)(Q₂);
a cyclopentyl group, a cyclohexyl group, a cycloheptyl group, a cyclopentenyl group, a cyclohexenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, a terphenyl group, - Si(Q₃₁)(Q₃₂)(Q₃₃), -N(Q₅₁)(Q₃₂), -B(Q₃₁)(Q₃₂), -C(=O)(Q₃₁), -S(=O)₂(Q₃₁), and - P(=O)(Q₃₁)(Q₃₂), wherein Q₁ to Q₃ and Q₃₁ to Q₃₃ are each independently selected from:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group,
R₁₁ and R₁₃ are each individually as defined for R₁ or, when R₁₁ and R₁₃ are both present, they may be connected to each other to form a C₅-C₆₀ carbocyclic group or a C₁-C₆₀ heterocyclic group together with the atom to which they are attached,
R₁₂ and R₁₄ are each individually as defined for R₁ or, when R₁₂ and R₁₄ are both present, they may be connected to each other to form a C₅-C₆₀ carbocyclic group or a C₁-C₆₀ heterocyclic group together with the atom to which they are attached,
b1 to b4, b11, b12, b21, and b22 are each independently an integer of 1 to 3,
c1 and c2 are each independently an integer of 0 to 8, and c3 and c4 are each independently an integer of 0 to 4, and
the substituted C₃-C₁₁ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed C8-C60 polycyclic group, the substituted divalent non-aromatic condensed 8- to 60-membered heteropolycyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed C8-C60 polycyclic group, and the substituted monovalent non-aromatic condensed 8- to 60-membered heteropolycyclic group are each substituted with one or more substituents selected from:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, - I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and - P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
wherein Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₆-C₆₀ aryl group substituted with a C₆-C₆₀ aryl group, a terphenyl group, a C₁-C₆₀ heteroaryl group, a C₁-C₆₀ heteroaryl group substituted with a C₁-C₆₀ alkyl group, a C₁-C₆₀ heteroaryl group substituted with a C₆-C₆₀ aryl group, a monovalent non-aromatic condensed C8-C60 polycyclic group, and a monovalent non-aromatic condensed 8- to 60-membered heteropolycyclic group.

2. The organic light-emitting device as claimed in claim 1, wherein rings A₁ to A₃ in Formulae 1A and 1B are each independently selected from a benzene group, a naphthalene group, an anthracene group, a phenanthrene group, an indene group, an indenopyridine group, a fluorene group, a pyridine group, a pyrimidine group, a pyrazine group, a pyrrole group, an imidazole group, a quinoline group, an isoquinoline group, a quinazoline group, a phenanthroline group, a phenanthridine group, a furan group, a thiophene group, an indole group, an indolocarbazole group, a benzofuran group, a benzofurocarbazole group, a benzofuropyrimidine group, a benzothiophene group, a benzoxazole group, a benzothiazole group, a benzoimidazole group, a carbazole group, a dibenzofuran group, a dibenzothiophene group, a pyridoindole group, a dipyridofuran group, a dipyridothiophene group, a pyrimidobenzofuran group, a dipyridopyrrole group, and a pyrimidobenzothiophene group.

3. The organic light-emitting device as claimed in claim 1 or claim 2, wherein rings A₂₁, A₂₂, and A₂₃ in Formulae 2A and 2B are each independently selected from a benzene group, a naphthalene group, an anthracene group, an indene group, a fluorene group, a pyridine group, a pyrimidine group, a pyrazine group, a pyridazine group, a quinoline group, an isoquinoline group, a pyrrole group, a pyrazole group, an imidazole group, an oxazole group, a thiazole group, a cyclopentadiene group, a silole group, a selenophene group, a furan group, a thiophene group, an indole group, a benzoimidazole group, a benzoxazole group, a benzothiazole group, an indene group, a benzosilole group, a benzoselenophene group, a benzofuran group, a benzothiophene group, a carbazole group, a fluorene group, a dibenzosilole group, a dibenzoselenophene group, a dibenzofuran group, a dibenzothiophene group, a pyrrolopyridine group, a cyclopentapyridine group, a silolopyridine group, a selenophenopyridine group, a furopyridine group, a thienopyridine group, a pyrrolopyrimidine group, a cyclopentapyrimidine group, a silolopyrimidine group, a selenophenopyrimidine group, a furopyrimidine group, a thienopyrimidine group, a pyrrolopyrazine group, a cyclopentapyrazine group, a silolopyrazine group, a selenophenopyrazine group, a furopyrazine group, a thienopyrazine group, a naphthopyrrole group, a cyclopentanaphthalene group, a naphthosilole group, a naphthoselenothiophene group, a naphthofuran group, a naphthothiophene group, a pyrroloquinoline group, a cyclopentaquinoline group, a siloloquinoline group, a selenophenoquinoline group, a furoquinoline group, a thienoquinoline group, a pyrroloisoquinoline group, a cyclopentaisoquinoline group, a siloloisoquinoline group, a selenophenoisoquinoline group, a furoisoquinoline group, a thienoisoquinoline group, an azacarbazole group, an azafluorene group, an azadibenzosilole group, an azadibenzoselenophene group, an azadibenzofuran group, an azadibenzothiophene group, an indenoquinoline group, an indenoisoquinoline group, an indenoquinoxaline group, a phenanthroline group, and a naphthoindole group, each substituted with at least one *-[(L₂₂)ₐ₂₂-(R₂₂)_{b22}], in which * is a bonding site to a neighboring atom.

4. The organic light-emitting device as claimed in claim 1 or claim 2, wherein:
rings A₂₁ A₂₂, and A₂₃ in Formulae 2A and 2B are each independently a group represented by one of the following Formulae 2-1 to 2-36, each substituted with at least one *-[(L₂₂)ₐ₂₂-(R₂₂)_{b22})], in which * is a bonding site to the A₂₁, A₂₂, or A₂₃ ring, 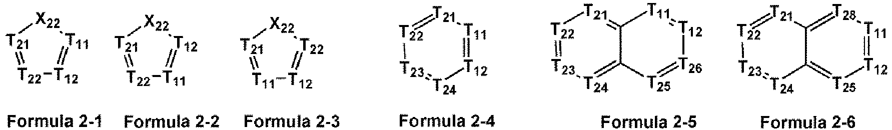 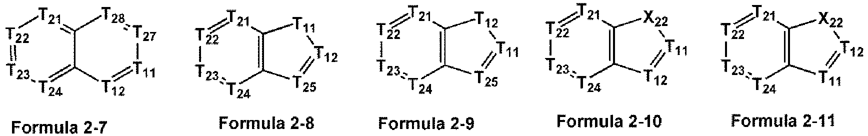 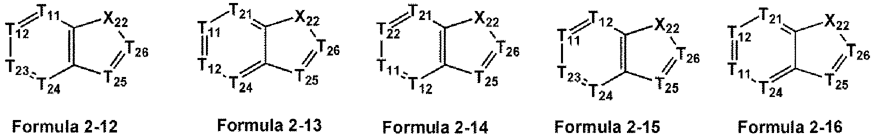 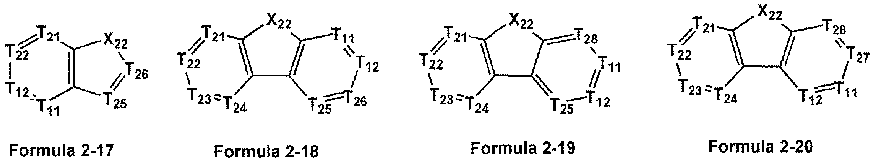 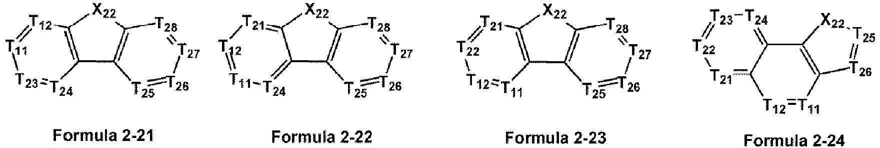 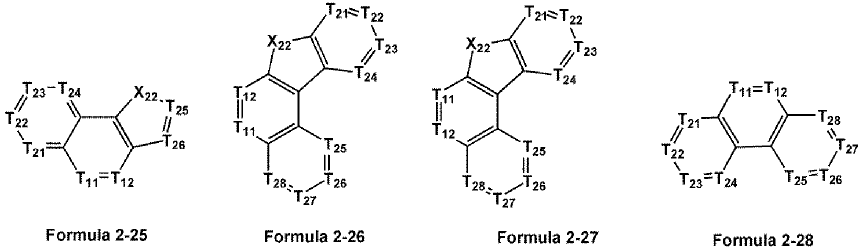 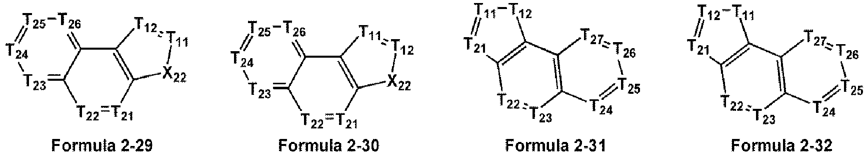 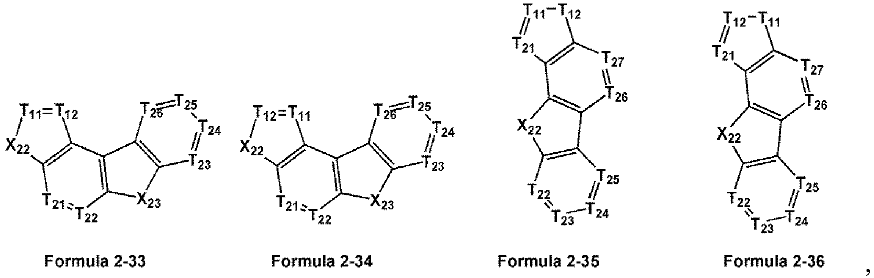
wherein, in Formulae 2-1 to 2-36,
T₁₁ and T₁₂ are as defined in claim 1,
X₂₂ and X₂₃ are each independently selected from O, S, Se, a carbon-containing moiety, a nitrogen-containing moiety, and a silicon-containing moiety, and
T₂₁ to T₂₈ are each independently selected from N and a a carbon-containing moiety.

5. The organic light-emitting device as claimed in any one of the preceding claims, wherein, in Formulae 1A and 1B:
Y₁ and Y₂ are both a single bond,
Y₁ is a single bond and Y₂ is selected from N[(L₁₂)ₐ₁₂-(R₁₂)_{b12}], C(R₁₂)(R₁₄), Si(R₁₂)(R₁₄), O, S, and Se, or
Y₁ is selected from N[(L₁₁)ₐ₁₁-(R₁₁)_{b11}], C(R₁₁)(R₁₃), Si(R₁₁)(R₁₃), O, S, and Se, and Y₂ is a single bond.

6. The organic light-emitting device as claimed in any one of the preceding claims, wherein, in Formulae 1A, 1B, 2A, 2B, Formulae 2-1 to 2-3, 2-10 to 2-27, and 2-33 to 2-36, L₁ to L₄, L₁₁, L₁₂, and L₂₁ are each independently selected from:
a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group; and
a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂),
wherein, in Formulae 2-1 to 2-3, 2-10 to 2-19, 2-21 to 2-27, and 2-33 to 2-36, L₂₂ is selected from:
a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group; and
a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzoimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂).

7. The organic light-emitting device as claimed in any one of the preceding claims, wherein, in Formulae 1A, 1B, 2A, and 2B, R₁ to R₄, R₁₁ to R₁₄, R₂₁, R₂₃, R₂₄, R₂₇, and R₂₈ are each independently selected from:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, -Si(Q₁)(Q₂)(Q₃), - N(Q₁)(Q₂), -B(Q₁)(Q₂), -C(=O)(Q₁), -S(=O)₂(Q₁), and -P(=O)(Q₁)(Q₂); and
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzoimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁), and -P(=O)(Q₃₁)(Q₃₂), wherein Q₁ to Q₃ and Q₃₁ to Q₃₃ are each independently selected from:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group.

8. The organic light-emitting device as claimed in any one of the preceding claims, wherein the first compound is represented by one of the following Formulae 1-1 to 1-3: 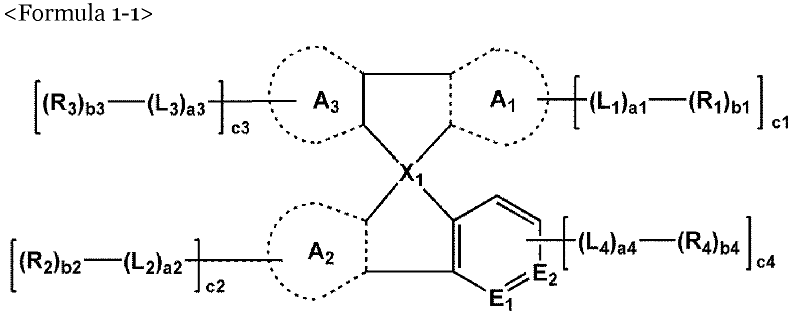 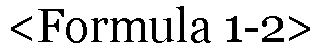 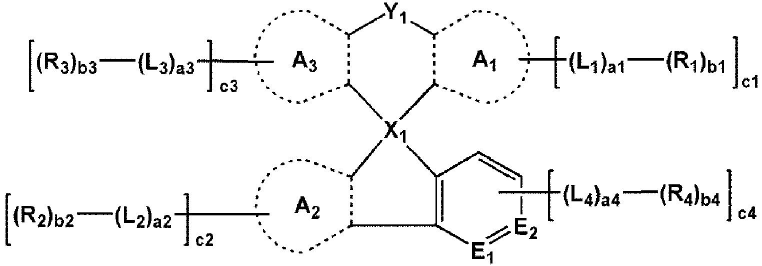 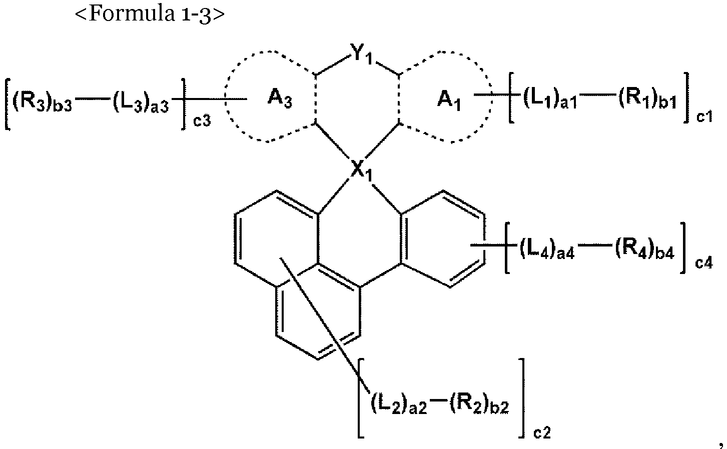 wherein, in Formulae 1-1 to 1-3,
c2 is an integer of 0 to 6,
Y₁ is selected from N[(L₁₁)ₐ₁₁-(R₁₁)_{b11}], C(R₁₁)(R₁₃), Si(R₁₁)(R₁₃), O, S, and Se, and
rings A₁ to A₃, X₁, E₁, E₂, L₁ to L₄, a1 to a4, R₁ to R₄, b1 to b4, c1, c3, c4, L₁₁, a11, R₁₁, R₁₃, and b11 are as defined in any of claims 1, 2, 8 and 9,
preferably wherein:
ring A₁ is selected from a benzene group, a naphthalene group, a pyridine group, a dibenzofuran group, and a pyrimidine group,
rings A₂ and A₃ are each independently selected from a benzene group, a naphthalene group, an anthracene group, a phenanthrene group, an indene group, an indenopyridine group, a fluorene group, a pyridine group, a pyrimidine group, a pyrazine group, a pyrrole group, an imidazole group, a quinoline group, an isoquinoline group, a quinazoline group, a phenanthroline group, a phenanthridine group, a furan group, a thiophene group, an indole group, an indolocarbazole group, a benzofuran group, a benzofurocarbazole group, a benzofuropyrimidine group, a benzothiophene group, a benzoxazole group, a benzothiazole group, a benzoimidazole group, a carbazole group, a dibenzofuran group, a dibenzothiophene group, a pyridoindole group, a dipyridofuran group, a dipyridothiophene group, a pyrimidobenzofuran group, a dipyridopyrrole group, and a pyrimidobenzothiophene group, and
R₁ to R₄ are each independently selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, a terphenyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂)-

9. The organic light-emitting device as claimed in any one of the preceding claims, wherein
(a) a triplet energy of the second compound is about 2.2 eV or more; and/or
(b) the emission layer comprises a first host and a second host, the first host comprising the first compound; and/or
(c) the electron transport region comprises a buffer layer, the buffer layer directly contacts the emission layer, and the buffer layer comprises the second compound.

10. The organic light-emitting device as claimed in any one of the preceding claims, wherein:
the emission layer comprises a dopant, and
the dopant comprises an organometallic complex;
preferably wherein the organometallic complex is represented by Formula 401, in which L₄₀₁ is selected from a ligand represented by Formula 402,
<Formula 401> M(L₄₀₁)_{xc1}(L₄₀₂)_{xc2} 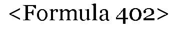 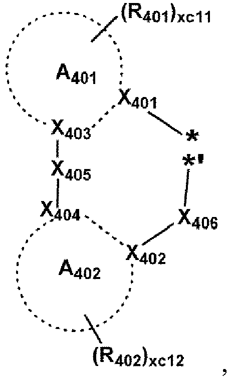
wherein, in Formulae 401 and 402,
M is selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
xc1 is 1, 2, or 3, wherein when xc1 is 2 or 3, 2 or 3 L₄₀₁ are identical to or different from each other,
L₄₀₂ is an organic ligand, and xc2 is an integer of 0 to 4, wherein when xc2 is 2, 3, or 4, 2, 3, or 4 L₄₀₂ are identical to or different from each other,
X₄₀₁ to X₄₀₄ are each independently nitrogen or carbon,
X₄₀₁ and X₄₀₃ are connected to each other via a single bond or a double bond, and X₄₀₂ and X₄₀₄ are connected to each other via a single bond or a double bond,
A₄₀₁ and A₄₀₂ are each independently a C₅-C₆₀ carbocyclic group or a C₁-C₆₀ heterocyclic group,
X₄₀₅ is a single bond, -O-, -S-, -C(=O)-, -N(Q₄₁₁)-, -C(Q₄₁₁)(Q₄₁₂)-, - C(Q₄₁₁)=C(Q₄₁₂)-, -C(Q₄₁₁)=, or =C(Q₄₁₁)=, wherein Q₄₁₁ and Q₄₁₂ are each independently hydrogen, deuterium, a C₁-C₂₀ alkyl group, a C₁-C₂₀ alkoxy group, a phenyl group, a biphenyl group, a terphenyl group, or a naphthyl group,
X₄₀₆ is a single bond, O, or S,
R₄₀₁ and R₄₀₂ are each independently selected from hydrogen, deuterium, - F, -Cl, -Br, -I, -CD₃, -CF₃, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group -Si(Q₄₀₁)(Q₄₀₂)(Q₄₀₃), - N(Q₄₀₁)(Q₄₀₂), -B(Q₄₀₁)(Q₄₀₂), -C(=O)(Q₄₀₁), -S(=O)₂(Q₄₀₁), and -P(=O)(Q₄₀₁)(Q₄₀₂), wherein Q₄₀₁ to Q₄₀₃ are each independently selected from a C₁-C₁₀ alkyl group, a C₁-C₁₀ alkoxy group, a C₆-C₂₀ aryl group, and a C₁-C₂₀ heteroaryl group,
xc11 and xc12 are each independently an integer of 0 to 10, and
* and *' in Formula 402 indicate a binding site to M in Formula 401.

11. The organic light-emitting device as claimed in any one of the preceding claims, wherein:
the electron transport region comprises a buffer layer, an electron transport layer, and an electron injection layer, and
at least one layer of the electron transport layer and the electron injection layer comprises an alkaline metal, an alkaline earth metal, a rare-earth metal, an alkaline metal compound, an alkaline earth-metal compound, a rare-earth metal compound, an alkaline metal complex, an alkaline earth-metal complex, a rare-earth metal complex, or a combination thereof.

12. The organic light-emitting device as claimed in any one of the preceding claims, wherein:
the hole transport region comprises a p-dopant, and
a lowest unoccupied molecular orbital (LUMO) of the p-dopant is about -3.5 eV or less;
preferably wherein the p-dopant comprises a cyano group-containing compound.

13. The organic light-emitting device as claimed in any one of the preceding claims, wherein
The emission layer is a first-color-light emission layer,
the organic light-emitting device further comprises at least one second-color-light emission layer or at least one second-color-light emission layer and at least one third-color-light emission layer, between the first electrode and the second electrode,
a maximum emission wavelength of the first-color-light emission layer, a maximum emission wavelength of the second-color-light emission layer, and a maximum emission wavelength of the third-color-light emission layer are identical to or different from one another, and
mixed light comprising first-color-light and second-color-light, or mixed light comprising first-color-light, second-color-light, and third-color-light is emitted.

## Patentansprüche

1. Organische lichtemittierende Vorrichtung, umfassend:
eine erste Elektrode;
eine zweite Elektrode, die der ersten Elektrode gegenüberliegt;
eine Emissionsschicht zwischen der ersten Elektrode und der zweiten Elektrode;
einen Lochtransportbereich zwischen der ersten Elektrode und der Emissionsschicht; und
einen Elektronentransportbereich zwischen der Emissionsschicht und der zweiten Elektrode,
wobei:
die Emissionsschicht eine erste Verbindung umfasst,
wobei mindestens einer von dem Lochtransportbereich und dem Elektronentransportbereich eine zweite Verbindung umfasst,
die erste Verbindung durch Formel 1A oder 1B dargestellt ist, und
die zweite Verbindung durch Formel 2A oder 2B dargestellt ist: 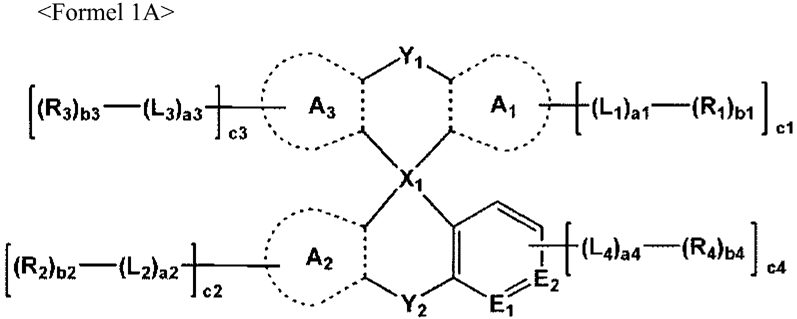 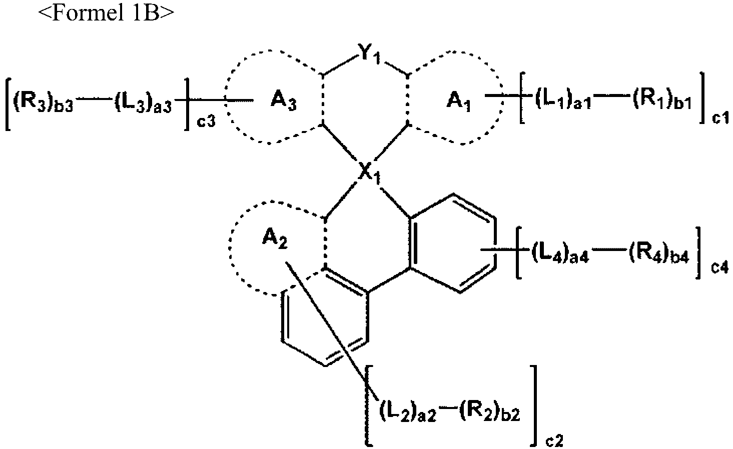 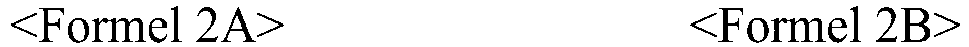 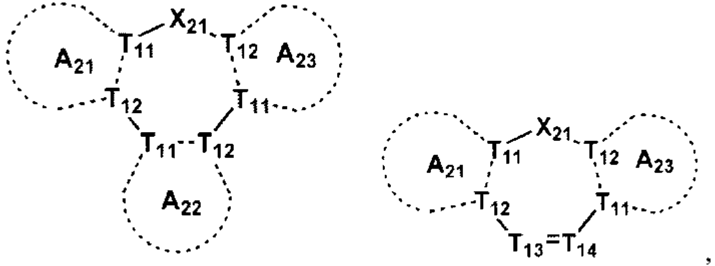
wobei in Formeln 1A, 1B, 2A und 2B
Ringe A₁ bis A₃ jeweils unabhängig ausgewählt sind aus einer carbocyclischen C₅-C₆₀-Gruppe und einer heterocyclischen C₁-C₆₀-Gruppe,
die Ringe A₁ bis A₃ jeweils mit dem Spiro-Ring in Formeln 1A und 1B kondensiert sind,
Ringe A₂₁, A₂₂ und A₂₃ jeweils unabhängig eine carbocyclische C₅-C₆₀-Gruppe oder heterocyclische C₁-C₆₀-Gruppe sind, jeweils substituiert mit mindestens einem *-[(L₂₂)ₐ₂₂-(R₂₂)_{b22}], wobei * eine Bindungsstelle zum A₂₁-, A₂₂- oder A₂₃-Ring ist,
jedes T₁₁ unabhängig Kohlenstoff oder Stickstoff ist,
jedes T₁₂ unabhängig Kohlenstoff oder Stickstoff ist,
T₁₃ N oder C(R₂₇) ist,
T₁₄ N oder C(R₂₈) ist,
jede Bindung zwischen T₁₁ und T₁₂, die in Formeln 2A und 2B als gestrichelte Linie dargestellt ist, eine Einfachbindung oder eine Doppelbindung ist;
die sechs Atome, die durch die drei T₁₁ und drei T₁₂ in Formel 2A dargestellt sind, nicht alle Stickstoff sind, und die sechs Atome, die durch die zwei T₁₁, zwei T₁₂, T₁₃ und T₁₄ in Formel 2B dargestellt sind, nicht alle Stickstoff sind,
die Ringe A₂₁, A₂₂ und A₂₃ jeweils mit dem 7-gliedrigen Ring in Formeln 2A und 2B kondensiert sind, während sie sich T₁₁ und T₁₂ damit teilen,
X₁ ein Silicium (Si) -Atom oder ein Kohlenstoff (C) -Atom ist,
Y₁ ausgewählt ist aus einer Einzelbindung, N[(L₁₁)ₐ₁₁-(R₁₁)_{b11}], C(R₁₁)(R₁₃), Si(R₁₁)(R₁₃), O, S und Se,
Y₂ ausgewählt ist aus einer Einfachbindung, N[(L₁₂)ₐ₁₂-(R₁₂)_{b12}], C(R₁₂)(R₁₄), Si(R₁₂)(R₁₄), O, S und Se,
E₁ und E₂ jeweils unabhängig ein Stickstoff- (N) -Atom oder ein Kohlenstoff- (C) -Atom sind, das mit *-(L₄)ₐ₄-(R₄)_{b4} substituiert ist,
X₂₁ N[(L₂₁)ₐ₂₁-(R₂₁)_{b21}] ist, oder
X₂₁ O, S, Se, C(R₂₃)(R₂₄) oder Si(R₂₃)(R₂₄) ist und mindestens einer der Ringe A₂₁, A₂₂ und A₂₃ in Formel 2A und mindestens einer der Ringe A₂₁ und A₂₃ in Formel 2B jeweils unabhängig eine Gruppe sind, die durch eine der Formeln 2-1 bis 2-3, 2-10 bis 2-27 und 2-33 bis 2-36 dargestellt ist, in denen mindestens einer von X₂₂ und X₂₃ N-[(L₂₂)ₐ₂₂-(R₂₂)b₂₂] ist: 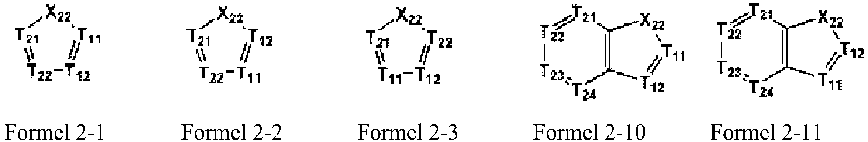 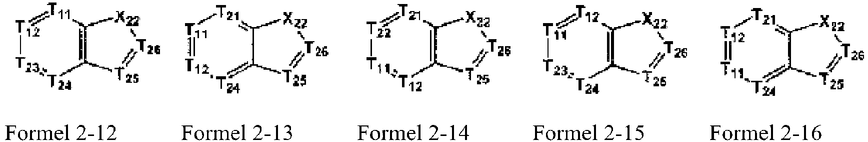 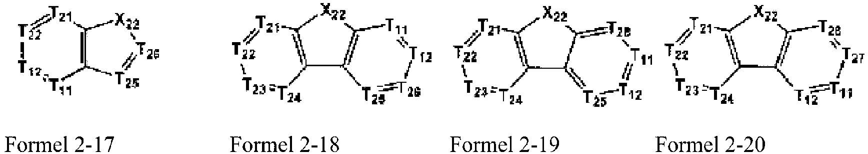 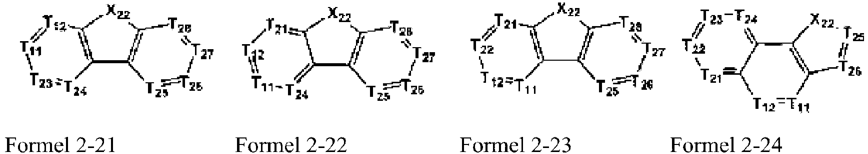 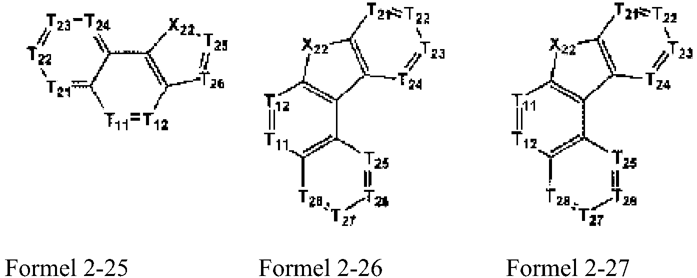 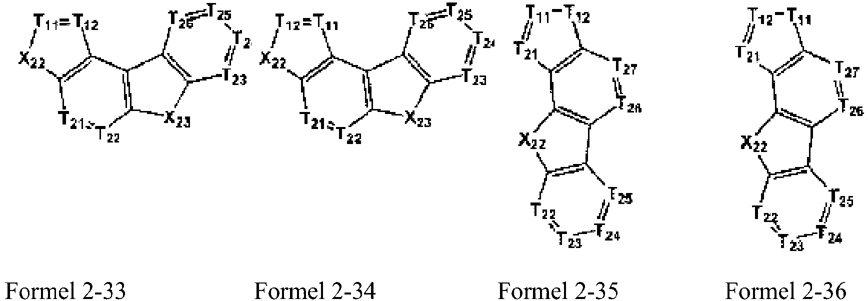
wobei in Formeln 2-1 bis 2-3, 2-10 bis 2-27 und 2-33 bis 2-36 X₂₂ und X₂₃ jeweils unabhängig ausgewählt sind aus O, S, Se, einer kohlenstoffhaltigen Einheit, einer stickstoffhaltigen Einheit und einer siliziumhaltigen Einheit, und
T₂₁ bis T₂₈ jeweils unabhängig ausgewählt sind aus N und einer kohlenstoffhaltigen Einheit,
L₁ bis L₄, L₁₁, L₁₂ und L₂₁ jeweils unabhängig ausgewählt sind aus einer substituierten oder unsubstituierten C₃-C₁₀-Cycloalkylengruppe, einer substituierten oder unsubstituierten C₁-C₁₀-Heterocycloalkylengruppe, einer substituierten oder unsubstituierten C₃-C₁₀-Cycloalkenylengruppe, einer substituierten oder unsubstituierten C₁-C₁₀-Heterocycloalkenylengruppe, einer substituierten oder unsubstituierten C₆-C₆₀-Arylengruppe, einer substituierten oder unsubstituierten C₁-C₆₀-Heteroarylengruppe, einer substituierten oder unsubstituierten divalenten nicht-aromatischen kondensierten polycyclischen C8-C60-Gruppe und einer substituierten oder unsubstituierten divalenten nicht-aromatischen kondensierten 8- bis 60-gliedrigen heteropolycyclischen Gruppe,
wobei in Formeln 2-1 bis 2-3, 2-10 bis 2-19, 2-21 bis 2-27 und 2-33 bis 2-36
L₂₂ jeweils unabhängig ausgewählt ist aus einer substituierten oder unsubstituierten C₃-C₁₀-Cycloalkylengruppe, einer substituierten oder unsubstituierten C₁-C₁₀-Heterocycloalkylengruppe, einer substituierten oder unsubstituierten C₃-C₁₀-Cycloalkenylengruppe, einer substituierten oder unsubstituierten C₁-C₁₀-Heterocycloalkenylengruppe, einer substituierten oder unsubstituierten C₆-C₆₀-Arylengruppe, einer substituierten oder unsubstituierten C₁-C₆₀-Heteroarylengruppe, einer substituierten oder unsubstituierten divalenten nicht-aromatischen kondensierten polycyclischen C8-C60-Gruppe und einer substituierten oder unsubstituierten divalenten nicht-aromatischen kondensierten 8- bis 60-gliedrigen heteropolycyclischen Gruppe,
wobei in Formel 2-20,
L₂₂ jeweils unabhängig ausgewählt ist aus einer Phenylengruppe, einer Pentalenylengruppe, einer Indenylengruppe, einer Naphthylengruppe, einer Azulenylengruppe, einer Indacenylengruppe, einer Acenaphthylengruppe, einer Fluorenylengruppe, einer Spiro-bifluorenylengruppe, einer Spiro-benzofluoren-fluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Perylenylengruppe, einer Pentaphenylengruppe, einer Pyrrolylengruppe, einer Thiophenylengruppe, einer Furanylengruppe, einer Silolylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyridazinylengruppe, einer Indolylengruppe, einer Isoindolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Phenanthridinylengruppe, einer Acridinylengruppe, einer Phenanthrolinylengruppe, einer Phenazinylengruppe, einer Benzoimidazolylengruppe, einer Benzofuranylengruppe, einer Benzothiophenylengruppe, einer Benzosilolylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Dibenzosilolylengruppe, einer Carbazolylengruppe, einer Benzocarbazolylengruppe, einer Dibenzocarbazolylengruppe, einer Thiadiazolylengruppe, einer Imidazopyridinylengruppe, einer Imidazopyrimidinylengruppe, einer Oxazolopyridinylengruppe, einer Thiazolopyridinylengruppe, einer Benzonaphthyridinylengruppe, einer Azafluorenylengruppe, einer Azaspiro-bifluorenylengruppe, einer Azacarbazolylengruppe, einer Azadibenzofuranylengruppe, einer Azadibenzothiophenylengruppe und einer Azadibenzosilolylengruppe; und
einer Phenylengruppe, einer Pentalenylengruppe, einer Indenylengruppe, einer Naphthylengruppe, einer Azulenylengruppe, einer Indacenylengruppe, einer Acenaphthylengruppe, einer Fluorenylengruppe, einer Spiro-bifluorenylengruppe, einer Spiro-benzofluoren-fluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Perylenylengruppe, einer Pentaphenylengruppe, einer Pyrrolylengruppe, einer Thiophenylengruppe, einer Furanylengruppe, einer Silolylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyridazinylengruppe, einer Indolylengruppe, einer Isoindolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Benzosilolylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Dibenzosilolylengruppe, einer Carbazolylengruppe, einer Benzocarbazolylengruppe, einer Dibenzocarbazolylengruppe, einer Thiadiazolylengruppe, einer Imidazopyridinylengruppe, einer Imidazopyrimidinylengruppe, einer Oxazolopyridinylengruppe, einer Thiazolopyridinylengruppe, einer Benzonaphthyridinylengruppe, einer Azafluorenylengruppe, einer Azaspiro-bifluorenylengruppe, einer Azacarbazolylengruppe, einer Azadibenzofuranylengruppe, einer Azadibenzothiophenylengruppe und einer Azadibenzosilolylengruppe, jeweils substituiert mit mindestens einem, ausgewählt aus Deuterium, -F, -Cl, -Br, -I, einer Hydroxygruppe, einer Cyanogruppe, einer Nitrogruppe, einer Amidingruppe, einer Hydrazingruppe, einer Hydrazongruppe, einer C₁-C₂₀-Alkylgruppe, einer C₁-C₂₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer monovalenten nicht-aromatischen kondensierten polycyclischen C₈-C₆₀-Gruppe, einer monovalenten nicht-aromatischen kondensierten 8- bis 60-gliedrigen heteropolycyclischen Gruppe, einer Biphenylgruppe, einer Terphenylgruppe, - Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁) und -P(=O)(Q₃₁)(Q₃₂), wobei Q₃₁ bis Q₃₃ jeweils unabhängig ausgewählt sind aus:
einer C₁-C₁₀-Alkylgruppe, einer C₁-C₁₀-Alkoxygruppe, einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe; und
einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, jeweils substituiert mit mindestens einer, ausgewählt aus einer C₁-C₁₀-Alkylgruppe, einer C₁-C₁₀-Alkoxygruppe und einer Phenylgruppe,
a1 bis a4, a11, a12, a21 und a22 jeweils unabhängig eine ganze Zahl von 0 bis 5 sind,
R₁ bis R₄, R₂₁, R₂₃, R₂₄, R₂₇ und R₂₈ jeweils unabhängig ausgewählt sind aus Wasserstoff, Deuterium (-D), -F, -Cl, -Br, -I, einer Hydroxygruppe, einer Cyanogruppe, einer Nitrogruppe, einer Amidingruppe, einer Hydrazingruppe, einer Hydrazongruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten monovalenten nicht-aromatischen kondensierten polycyclischen C8-C60-Gruppe, einer substituierten oder unsubstituierten monovalenten nicht-aromatischen kondensierten 8- bis 60-gliedrigen heteropolycyclischen Gruppe, -Si(Q₁)(Q₂)(Q₃), -N(Q₁)(Q₂), - B(Q₁)(Q₂), -C(=O)(Q₁), -S(=O)₂(Q₁) und -P(=O)(Q₁)(Q₂),
wobei in Formeln 2-1 bis 2-3, 2-10 bis 2-19, 2-21, 2-23 bis 2-27 und 2-33 bis 2-36,
R₂₂ ausgewählt ist aus Wasserstoff, Deuterium (-D), -F, -Cl, -Br, -I, einer Hydroxygruppe, einer Cyanogruppe, einer Nitrogruppe, einer Amidingruppe, einer Hydrazingruppe, einer Hydrazongruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten monovalenten nicht-aromatischen kondensierten polycyclischen C8-C60-Gruppe, einer substituierten oder unsubstituierten monovalenten nicht-aromatischen kondensierten 8- bis 60-gliedrigen heteropolycyclischen Gruppe, -Si(Q₁)(Q₂)(Q₃), -N(Q₁)(Q₂), -B(Q₁)(Q₂), -C(=O)(Q₁), -S(=O)₂(Q₁) und -P(=O)(Q₁)(Q₂),
wobei in Formel 2-20,
R₂₂ ausgewählt ist aus Wasserstoff, Deuterium, -F, -Cl, -Br, -I, einer Hydroxygruppe, einer Cyanogruppe, einer Nitrogruppe, einer Amidingruppe, einer Hydrazingruppe, einer Hydrazongruppe, einer C₁-C₂₀ -Alkylgruppe und einer C₁-C₂₀ -Alkoxygruppe;
einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-bifluorenylgruppe, einer Spiro-benzofluoren-fluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Pyrrolylgruppe, einer Thiophenylgruppe, einer Furanylgruppe, einer Silolylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyridazinylgruppe, einer Indolylgruppe, einer Isoindolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Phenanthridinylgruppe, einer Acridinylgruppe, einer Phenanthrolinylgruppe, einer Phenazinylgruppe, einer Benzoimidazolylgruppe, einer Benzofuranylgruppe, einer Benzothiophenylgruppe, einer Benzosilolylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Carbazolylgruppe, einer Benzocarbazolylgruppe, einer Dibenzocarbazolylgruppe, einer Thiadiazolylgruppe, einer Imidazopyridinylgruppe, einer Imidazopyrimidinylgruppe, einer Oxazolopyridinylgruppe, einer Thiazolopyridinylgruppe, einer Benzonaphthyridinylgruppe, einer Azafluorenylgruppe, einer Azaspiro-bifluorenylgruppe, einer Azacarbazolylgruppe, einer Azadibenzofuranylgruppe, einer Azadibenzothiophenylgruppe, einer Azadibenzosilolylgruppe, - Si(Q₁)(Q₂)(Q₃), -N(Q₁)(Q₂), -B(Q₁)(Q₂), -C(=O)(Q₁), -S(=O)₂(Q₁) und -P(=O)(Q₁)(Q₂); und
einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-bifluorenylgruppe, einer Spiro-benzofluoren-fluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Pyrrolylgruppe, einer Thiophenylgruppe, einer Furanylgruppe, einer Silolylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyridazinylgruppe, einer Indolylgruppe, einer Isoindolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Phenanthridinylgruppe, einer Acridinylgruppe, einer Phenanthrolinylgruppe, einer Phenazinylgruppe, einer Benzoimidazolylgruppe, einer Benzofuranylgruppe, einer Benzothiophenylgruppe, einer Benzosilolylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Carbazolylgruppe, einer Benzocarbazolylgruppe, einer Dibenzocarbazolylgruppe, einer Thiadiazolylgruppe, einer Imidazopyridinylgruppe, einer Imidazopyrimidinylgruppe, einer Oxazolopyridinylgruppe, einer Thiazolopyridinylgruppe, einer Benzonaphthyridinylgruppe, einer Azafluorenylgruppe, einer Azaspiro-bifluorenylgruppe, einer Azacarbazolylgruppe, einer Azadibenzofuranylgruppe, einer Azadibenzothiophenylgruppe und einer Azadibenzosilolylgruppe, jeweils substituiert mit mindestens einem, ausgewählt aus Deuterium, - F, -Cl, -Br, -I, einer Hydroxygruppe, einer Cyanogruppe, einer Nitrogruppe, einer Amidingruppe, einer Hydrazingruppe, einer Hydrazongruppe, einer C₁-C₂₀-Alkylgruppe, einer C₁-C₂₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer monovalenten nicht-aromatischen kondensierten polycyclischen C8-C60-Gruppe, einer monovalenten nicht-aromatischen kondensierten 8- bis 60-gliedrigen heteropolycyclischen Gruppe, einer Biphenylgruppe, einer Terphenylgruppe, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂), wobei Q₁ bis Q₃ und Q₃₁ bis Q₃₃ jeweils unabhängig ausgewählt sind aus:
einer C₁-C₁₀-Alkylgruppe, einer C₁-C₁₀-Alkoxygruppe, einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe; und
einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, jeweils substituiert mit mindestens einer, ausgewählt aus einer C₁-C₁₀-Alkylgruppe, einer C₁-C₁₀-Alkoxygruppe und einer Phenylgruppe,
wobei in Formel 2-22
R₂₂ Wasserstoff, Deuterium, -F, -Cl, -Br, -I, eine Hydroxygruppe, eine Cyanogruppe, eine Nitrogruppe, eine Amidingruppe, eine Hydrazingruppe, eine Hydrazongruppe, eine C₁-C₂₀-Alkylgruppe und eine C₁-C₂₀-Alkoxygruppe,
eine Cyclopentylgruppe, eine Cyclohexylgruppe, eine Cycloheptylgruppe, eine Cyclopentenylgruppe, eine Cyclohexenylgruppe, eine Phenylgruppe, eine Biphenylgruppe, eine Terphenylgruppe, eine Pentalenylgruppe, eine Indenylgruppe, eine Naphthylgruppe, eine Azulenylgruppe, eine Indacenylgruppe, eine Acenaphthylgruppe, eine Fluorenylgruppe, eine Spiro-Bifluorenylgruppe, eine Spiro-Benzofluoren-Fluorenylgruppe, eine Benzofluorenylgruppe, eine Dibenzofluorenylgruppe, eine Phenalenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Perylenylgruppe, eine Pentaphenylgruppe, eine Pyrrolylgruppe, eine Thiophenylgruppe, eine Furanylgruppe, eine Silolylgruppe, eine Imidazolylgruppe, eine Pyrazolylgruppe, eine Thiazolylgruppe, eine Isothiazolylgruppe, eine Oxazolylgruppe, eine Isoxazolylgruppe, eine Pyridinylgruppe, eine Pyrazinylgruppe, eine Pyrimidinylgruppe, eine Pyridazinylgruppe, eine Indolylgruppe, eine Isoindolylgruppe, eine Indazolylgruppe, eine Purinylgruppe, eine Chinolinylgruppe, eine Isochinolinylgruppe, eine Benzochinolinylgruppe, eine Phthalazinylgruppe, eine Naphthyridinylgruppe, eine Chinoxalinylgruppe, eine Chinazolinylgruppe, eine Cinnolinylgruppe, eine Phenanthridinylgruppe, eine Acridinylgruppe, eine Phenanthrolinylgruppe, eine Phenazinylgruppe, eine Benzoimidazolylgruppe, eine Benzofuranylgruppe, eine Benzothiophenylgruppe, eine Benzosilolylgruppe, eine Isobenzothiazolylgruppe, eine Benzoxazolylgruppe, eine Isobenzoxazolylgruppe, eine Triazolylgruppe, eine Tetrazolylgruppe, eine Oxadiazolylgruppe, eine Triazinylgruppe, eine Dibenzothiophenylgruppe, eine Dibenzosilolylgruppe, eine Carbazolylgruppe, eine Benzocarbazolylgruppe, eine Dibenzocarbazolylgruppe, eine Thiadiazolylgruppe, eine Imidazopyridinylgruppe, eine Imidazopyrimidinylgruppe, eine Oxazolopyridinylgruppe, eine Thiazolopyridinylgruppe, eine Benzonaphthyridinylgruppe, eine Azafluorenylgruppe, eine Azaspiro-Bifluorenylgruppe, eine Azacarbazolylgruppe, eine Azadibenzofuranylgruppe, eine Azadibenzothiophenylgruppe, eine Azadibenzosilolylgruppe, -Si(Q₁)(Q₂)(Q₃), -N(Q₁)(Q₂), - B(Q₁)(Q₂), -C(=O)(Q₁), -S(=O)₂(Q₁) und -P(=O)(Q₁)(Q₂);
eine Cyclopentylgruppe, eine Cyclohexylgruppe, eine Cycloheptylgruppe, eine Cyclopentenylgruppe, eine Cyclohexenylgruppe, eine Biphenylgruppe, eine Terphenylgruppe, eine Pentalenylgruppe, eine Indenylgruppe, eine Naphthylgruppe, eine Azulenylgruppe, eine Indacenylgruppe, eine Acenaphthylgruppe, eine Fluorenylgruppe, eine Spiro-bifluorenylgruppe, eine Spiro-benzofluoren-fluorenylgruppe, eine Benzofluorenylgruppe, eine Dibenzofluorenylgruppe, eine Phenalenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Perylenylgruppe, eine Pentaphenylgruppe, eine Pyrrolylgruppe, eine Thiophenylgruppe, eine Furanylgruppe, eine Silolylgruppe, eine Imidazolylgruppe, eine Pyrazolylgruppe, eine Thiazolylgruppe, eine Isothiazolylgruppe, eine Oxazolylgruppe, eine Isoxazolylgruppe, eine Pyridinylgruppe, eine Pyrazinylgruppe, eine Pyrimidinylgruppe, eine Pyridazinylgruppe, eine Indolylgruppe, eine Isoindolylgruppe, eine Indazolylgruppe, eine Purinylgruppe, eine Chinolinylgruppe, eine Isochinolinylgruppe, eine Benzochinolinylgruppe, eine Phthalazinylgruppe, eine Naphthyridinylgruppe, eine Chinoxalinylgruppe, eine Chinazolinylgruppe, eine Cinnolinylgruppe, eine Phenanthridinylgruppe, eine Acridinylgruppe, eine Phenanthrolinylgruppe, eine Phenazinylgruppe, eine Benzoimidazolylgruppe, eine Benzothiophenylgruppe, eine Benzosilolylgruppe, eine Isobenzothiazolylgruppe, eine Benzoxazolylgruppe, eine Isobenzoxazolylgruppe, eine Triazolylgruppe, eine Tetrazolylgruppe, eine Oxadiazolylgruppe, eine Triazinylgruppe, eine Dibenzofuranylgruppe, eine Dibenzothiophenylgruppe, eine Dibenzosilolylgruppe, eine Carbazolylgruppe, eine Benzocarbazolylgruppe, eine Dibenzocarbazolylgruppe, eine Thiadiazolylgruppe, eine Imidazopyridinylgruppe, eine Imidazopyrimidinylgruppe, eine Oxazolopyridinylgruppe, eine Thiazolopyridinylgruppe, eine Benzonaphthyridinylgruppe, eine Azafluorenylgruppe, eine Azaspiro-bifluorenylgruppe, eine Azacarbazolylgruppe, eine Azadibenzofuranylgruppe, eine Azadibenzothiophenylgruppe und eine Azadibenzosilolylgruppe ist, wobei jede dieser Gruppen mit mindestens einem Substituenten substituiert ist, ausgewählt aus: Deuterium, -F, -Cl, -Br, -I, einer Hydroxygruppe, einer Cyanogruppe, einer Nitrogruppe, einer Amidingruppe, einer Hydrazingruppe, einer Hydrazongruppe, einer C₁-C₂₀-Alkylgruppe, einer C₁-C₂₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer monovalenten nicht-aromatischen kondensierten polycyclischen C8-C60-Gruppe, einer monovalenten nicht-aromatischen kondensierten 8- bis 60-gliedrigen heteropolycyclischen Gruppe, einer Biphenylgruppe, einer Terphenylgruppe, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂), wobei Q₁ bis Q₃ und Q₃₁ bis Q₃₃ jeweils unabhängig ausgewählt sind aus:
einer C₁-C₁₀-Alkylgruppe, einer C₁-C₁₀-Alkoxygruppe, einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe; und
einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, jeweils substituiert mit mindestens einer, ausgewählt aus einer C₁-C₁₀-Alkylgruppe, einer C₁-C₁₀-Alkoxygruppe und einer Phenylgruppe,
R₁₁ und R₁₃ jeweils einzeln wie für R₁ definiert sind oder, wenn R₁₁ und R₁₃ beide vorhanden sind, miteinander verbunden sein können, um zusammen mit dem Atom, an das sie gebunden sind, eine carbocyclische C₅-C₆₀-Gruppe oder eine heterocyclische C₁-C₆₀-Gruppe zu bilden,
R₁₂ und R₁₄ jeweils einzeln wie für R₁ definiert sind oder, wenn R₁₂ und R₁₄ beide vorhanden sind, miteinander verbunden sein können, um zusammen mit dem Atom, an das sie gebunden sind, eine carbocyclische C₅-C₆₀-Gruppe oder eine heterocyclische C₁-C₆₀-Gruppe zu bilden,
b1 bis b4, b11, b12, b21 und b22 jeweils unabhängig eine ganze Zahl von 1 bis 3 sind,
c1 und c2 jeweils unabhängig eine Ganzzahl von 0 bis 8 sind und c3 und c4 jeweils unabhängig eine Ganzzahl von 0 bis 4 sind, und
die substituierte C₃-C₁₀-Cycloalkylengruppe, die substituierte C₁-C₁₀-Heterocycloalkylengruppe, die substituierte C₃-C₁₀-Cycloalkenylengruppe, die substituierte C₁-C₁₀-Heterocycloalkenylengruppe, die substituierte C₆-C₆₀-Arylengruppe, die substituierte C₁-C₆₀-Heteroarylengruppe, die substituierte divalente nicht-aromatische kondensierte polycyclische C8-C60-Gruppe, die substituierte divalente nicht-aromatische kondensierte 8- bis 60-gliedrige heteropolycyclische Gruppe, die substituierte C₁-C₆₀-Alkylgruppe, die substituierte C₂-C₆₀-Alkenylgruppe, die substituierte C₂-C₆₀-Alkinylgruppe, die substituierte C₁-C₆₀-Alkoxygruppe, die substituierte C₃-C₁₀-Cycloalkylgruppe, die substituierte C₁-C₁₀-Heterocycloalkylgruppe, die substituierte C₃-C₁₀-Cycloalkenylgruppe, die substituierte C₁-C₁₀-Heterocycloalkenylgruppe, die substituierte C₆-C₆₀-Arylgruppe, die substituierte C₆-C₆₀-Aryloxygruppe, die substituierte C₆-C₆₀-Arylthiogruppe, die substituierte C₁-C₆₀-Heteroarylgruppe, die substituierte monovalente nicht-aromatische kondensierte polycyclische C8-C60-Gruppe und die substituierte monovalente nicht-aromatische kondensierte 8- bis 60-gliedrige heteropolycyclische Gruppe jeweils mit einem oder mehreren Substituenten substituiert sind, ausgewählt aus:
Deuterium, -F, -Cl, -Br, -I, einer Hydroxygruppe, einer Cyanogruppe, einer Nitrogruppe, einer Amidingruppe, einer Hydrazingruppe, einer Hydrazongruppe, einer C₁-C₆₀-Alkylgruppe, einer C₂-C₆₀-Alkenylgruppe, einer C₂-C₆₀-Alkinylgruppe und einer C₁-C₆₀-Alkoxygruppe;
einer C₁-C₆₀-Alkylgruppe, einer C₂-C₆₀-Alkenylgruppe, einer C₂-C₆₀-Alkinylgruppe und einer C₁-C₆₀-Alkoxygruppe, die jeweils mit mindestens einem der folgenden Substituenten substituiert sind: Deuterium, -F, -Cl, -Br, -I, einer Hydroxygruppe, einer Cyanogruppe, einer Nitrogruppe, einer Amidingruppe, einer Hydrazingruppe, einer Hydrazongruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatische kondensierte C8-C60-polycyclische Gruppe, eine monovalente nicht-aromatischen kondensierten 8- bis 60-gliedrigen heteropolycyclischen Gruppe, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁) und -P(=O)(Q₁₁)(Q₁₂);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen C8-C60-Gruppe, einer monovalenten nicht-aromatischen kondensierten 8- bis 60-gliedrigen heteropolycyclischen Gruppe, einer Biphenylgruppe und einer Terphenylgruppe;
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen C8-C60-Gruppe und einer monovalenten nicht-aromatischen kondensierten 8- bis 60-gliedrigen heteropolycyclischen Gruppe, jeweils substituiert mit mindestens einem, ausgewählt aus Deuterium, -F, -Cl, -Br, -I, einer Hydroxygruppe, einer Cyanogruppe, einer Nitrogruppe, einer Amidingruppe, einer Hydrazingruppe, einer Hydrazongruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht-aromatischen kondensierten polycyclischen C8-C60-Gruppe, einer monovalenten nicht-aromatischen kondensierten 8- bis 60-gliedrigen heteropolycyclischen Gruppe, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁) und -P(=O)(Q₂₁)(Q₂₂); und
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und - P(=O)(Q₃₁)(Q₃₂),
wobei Q₁ bis Q₃, Q₁₁ bis Q₁₃, Q₂₁ bis Q₂₃ und Q₃₁ bis Q₃₃ jeweils unabhängig ausgewählt sind aus Wasserstoff, Deuterium, -F, -Cl, -Br, -I, einer Hydroxylgruppe, einer Cyanogruppe, einer Nitrogruppe, einer Amidingruppe, einer Hydrazingruppe, einer Hydrazongruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Arylgruppe substituiert mit einer C₁-C₆₀-Alkylgruppe, einer C₆-C₆₀-Arylgruppe substituiert mit einer C₆-C₆₀-Arylgruppe, einer Terphenylgruppe, einer C₁-C₆₀-Heteroarylgruppe, einer C₁-C₆₀-Heteroarylgruppe substitutiert mit einer C₁-C₆₀-Alkylgruppe, einer C₁-C₆₀-Heteroarylgruppe substituiert mit einer C₆-C₆₀-Arylgruppe, einer monovalenten nicht-aromatischen kondensierten polycyclischen C8-C60-Gruppe und einer einwertigen nicht-aromatischen kondensierten 8- bis 60-gliedrigen heteropolycyclischen Gruppe.

2. Organische lichtemittierende Vorrichtung nach Anspruch 1, wobei die Ringe A₁ bis A₃ in Formeln 1A und 1B jeweils unabhängig ausgewählt sind aus einer Benzolgruppe, einer Naphthalingruppe, einer Anthracengruppe, einer Phenanthrengruppe, einer Indengruppe, einer Indenopyridingruppe, einer Fluorengruppe, einer Pyridingruppe, einer Pyrimidingruppe, einer Pyrazingruppe, einer Pyrrolgruppe, einer Imidazolgruppe, einer Chinolingruppe, einer Isochinolingruppe, einer Chinazolingruppe, einer Phenanthrolingruppe, einer Phenanthridingruppe, einer Furangruppe, einer Thiophengruppe, einer Indolgruppe, einer Indolocarbazolgruppe, einer Benzofurangruppe, einer Benzofurocarbazolgruppe, einer Benzofuropyrimidingruppe, einer Benzothiophengruppe, einer Benzoxazolgruppe, einer Benzothiazolgruppe, einer Benzoimidazolgruppe, einer Carbazolgruppe, einer Dibenzofurangruppe, einer Dibenzothiophengruppe, einer Pyridoindolgruppe, einer Dipyridofurangruppe, einer Dipyridothiophengruppe, einer Pyrimidozofurangruppe, einer Dipyrrolgruppe und einer Pyrimidobenzothiophengruppe.

3. Organische lichtemittierende Vorrichtung nach Anspruch 1 oder Anspruch 2, wobei die Ringe A₂₁, A₂₂ und A₂₃ in Formeln 2A und 2B jeweils unabhängig ausgewählt sind aus einer Benzolgruppe, einer Naphthalingruppe, einer Anthracengruppe, einer Indengruppe, einer Fluorengruppe, einer Pyridingruppe, einer Pyrimidingruppe, einer Pyrazingruppe, einer Pyridazingruppe, einer Chinolingruppe, einer Isochinolingruppe, einer Pyrrolgruppe, einer Pyrazolgruppe, einer Imidazolgruppe, einer Oxazolgruppe, einer Thiazolgruppe, einer Cyclopentadiengruppe, einer Silolgruppe, einer Selenophengruppe, einer Furangruppe, einer Thiophengruppe, einer Indolgruppe, einer Benzoimidazolgruppe, einer Benzoxazolgruppe, einer Benzothiazolgruppe, einer Indengruppe, einer Benzosilolgruppe, einer Benzoselenophengruppe, einer Benzofurangruppe, einer Benzothiophengruppe, einer Carbazolgruppe, einer Fluorengruppe, einer Dibenzosilolgruppe, einer Dibenzoselenophengruppe, einer Dibenzofurangruppe, einer Dibenzothiophengruppe, einer Pyrrolopyridingruppe, einer Cyclopentapyridingruppe, einer Silolopyridingruppe, einer Selenophenopyridingruppe, einer Furopyridingruppe, einer Thienopyridingruppe, einer Pyrrolopyrimidingruppe, einer Cyclopentapyrimidingruppe, einer Silolopyrimidingruppe, einer Selenophenopyrimidingruppe, einer Furopyrimidingruppe, einer Thienopyrimidingruppe, einer Pyrrolopyrazingruppe, einer Cyclopentapyrazingruppe, einer Silolopyrazingruppe, einer Selenophenopyrazingruppe, einer Furopyrazingruppe, einer Thienopyrazingruppe, einer Naphthopyrrolgruppe, einer Cyclopentanaphthalingruppe, einer Naphthosilolgruppe, einer Naphthoselenothiophengruppe, einer Naphthofurangruppe, einer Naphthothiophengruppe, einer Pyrrolochinolingruppe, einer Cyclopentachinolingruppe, einer Silolochinolingruppe, einer Selenophenochinolingruppe, einer Furochinolingruppe, einer Thienochinolingruppe, einer Pyrroloisochinolingruppe, einer Cyclopentaisochinolingruppe, einer Siloloisochinolingruppe, einer Selenophenoisochinolingruppe, einer Furoisochinolingruppe, einer Thienoisochinolingruppe, einer Azacarbazolgruppe, einer Azafluorengruppe, einer Azadibenzosilolgruppe, einer Azadibenzoselenophengruppe, einer Azadibenzofurangruppe, einer Azadibenzothiophengruppe, einer Indenochinolingruppe, einer Indenoisochinolingruppe, einer Indenochinoxalingruppe, einer Phenanthrolingruppe und einer Naphthoindolgruppe, jeweils substituiert mit mindestens einem *-[(L₂₂)ₐ₂₂-(R₂₂)_{b22}], wobei * eine Bindungsstelle zu einem benachbarten Atom ist.

4. Organische lichtemittierende Vorrichtung nach Anspruch 1 oder Anspruch 2, wobei:
die Ringe A₂₁ A₂₂ und A₂₃ in Formeln 2A und 2B jeweils unabhängig eine Gruppe sind, die durch eine der folgenden Formeln 2-1 bis 2-36 dargestellt wird, die jeweils mit mindestens einem *-[(L₂₂)ₐ₂₂-(R₂₂)_{b22})] substituiert sind, wobei * eine Bindungsstelle zum A₂₁-, A₂₂- oder A₂₃-Ring ist, 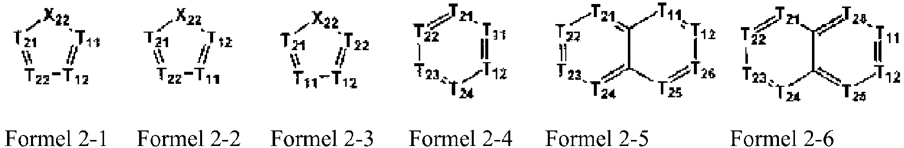 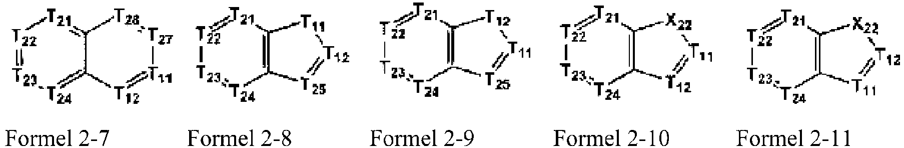 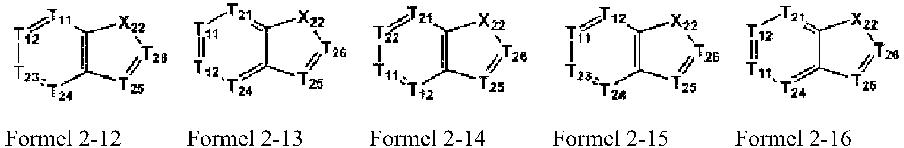 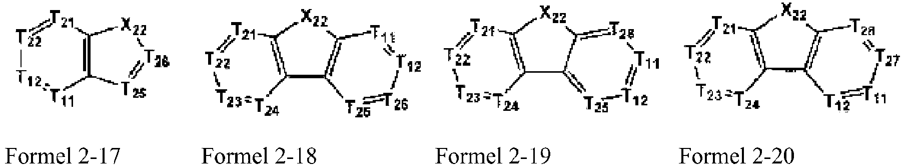 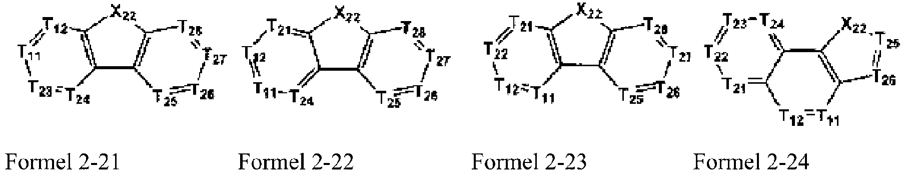 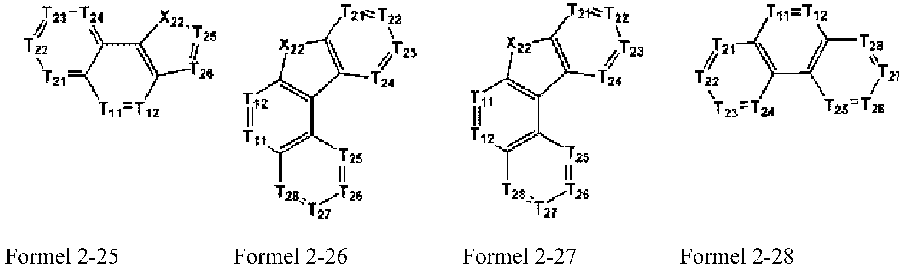 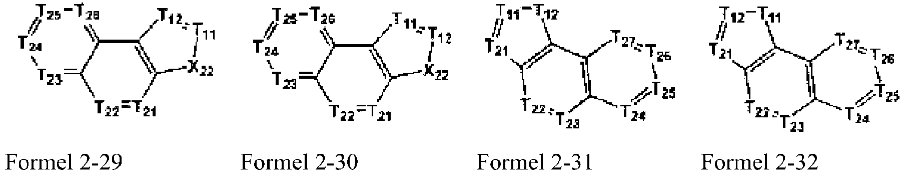 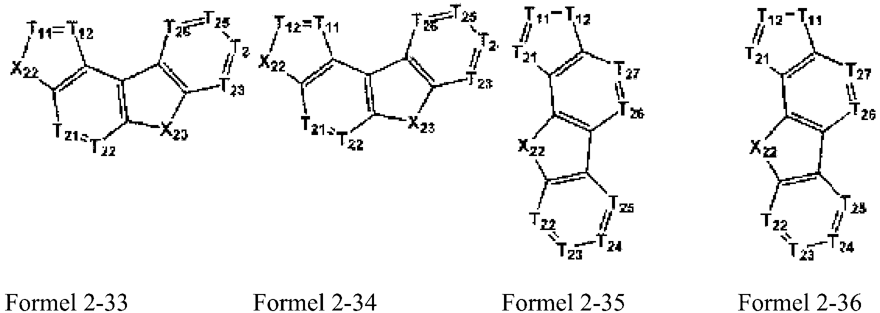
wobei in Formeln 2-1 bis 2-36
T₁₁ und T₁₂ wie in Anspruch 1 definiert sind,
X₂₂ und X₂₃ jeweils unabhängig ausgewählt sind aus O, S, Se, einer kohlenstoffhaltigen Einheit, einer stickstoffhaltigen Einheit und einer siliziumhaltigen Einheit, und
T₂₁ bis T₂₈ jeweils unabhängig ausgewählt sind aus N und einer kohlenstoffhaltigen Einheit.

5. Organische lichtemittierende Vorrichtung nach einem der vorhergehenden Ansprüche, wobei, in Formeln 1A und 1B:
Y₁ und Y₂ beide eine Einfachbindung sind,
Y₁ eine Einfachbindung ist und Y₂ ausgewählt ist aus N[(L₁₂)ₐ₁₂-(R₁₂)_{b12}], C(R₁₂)(R₁₄), Si(R₁₂)(R₁₄), O, S und Se, oder
Y₁ ausgewählt ist aus N[(L₁₁)ₐ₁₁-(R₁₁)_{b11}], C(R₁₁)(R₁₃), Si(R₁₁)(R₁₃), O, S und Se, und Y₂ eine Einzelbindung ist.

6. Organische lichtemittierende Vorrichtung nach einem der vorhergehenden Ansprüche, wobei in Formeln 1A, 1B, 2A, 2B, Formeln 2-1 bis 2-3, 2-10 bis 2-27 und 2- 33 bis 2-36, L₁ to L₄, L₁₁, L₁₂ und L₂₁ jeweils unabhängig ausgewählt sind aus:
einer Phenylengruppe, einer Pentalenylengruppe, einer Indenylengruppe, einer Naphthylengruppe, einer Azulenylengruppe, einer Indacenylengruppe, einer Acenaphthylengruppe, einer Fluorenylengruppe, einer Spiro-bifluorenylengruppe, einer Spiro-benzofluoren-fluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Perylenylengruppe, einer Pentaphenylengruppe, einer Pyrrolylengruppe, einer Thiophenylengruppe, einer Furanylengruppe, einer Silolylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Indolylengruppe, einer Isoindolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Benzosilolylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Dibenzosilolylengruppe, einer Carbazolylengruppe, einer Benzocarbazolylengruppe, einer Dibenzocarbazolylengruppe, einer Thiadiazolylengruppe, einer Imidazopyridinylengruppe, einer Imidazopyrimidinylengruppe, einer Oxazolopyridinylengruppe, einer Thiazolopyridinylengruppe, einer Benzonaphthyridinylengruppe, einer Azafluorenylengruppe, einer Azaspirobifluorenylengruppe, einer Azacarbazolylengruppe, einer Azadibenzofuranylengruppe, einer Azadibenzothiophenylengruppe und einer Azadibenzosilolylengruppe; und
einer Phenylengruppe, einer Pentalenylengruppe, einer Indenylengruppe, einer Naphthylengruppe, einer Azulenylengruppe, einer Indacenylengruppe, einer Acenaphthylengruppe, einer Fluorenylengruppe, einer Spiro-bifluorenylengruppe, einer Spiro-benzofluoren-fluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Perylenylengruppe, einer Pentaphenylengruppe, einer Pyrrolylengruppe, einer Thiophenylengruppe, einer Furanylengruppe, einer Silolylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Indolylengruppe, einer Isoindolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Benzosilolylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Dibenzosilolylengruppe, einer Carbazolylengruppe, einer Benzocarbazolylengruppe, einer Dibenzocarbazolylengruppe, einer Thiadiazolylengruppe, einer Imidazopyridinylengruppe, einer Imidazopyrimidinylengruppe, einer Oxazolopyridinylengruppe, einer Thiazolopyridinylengruppe, einer Benzonaphthyridinylengruppe, einer Azafluorenylengruppe, einer Azaspirobifluorenylengruppe, einer Azacarbazolylengruppe, einer Azadibenzofuranylengruppe, einer Azadibenzothiophenylengruppe und einer Azadibenzosilolylengruppe, jeweils substituiert mit mindestens einem, ausgewählt aus Deuterium, -F, -Cl, -Br, -I, einer Hydroxygruppe, einer Cyanogruppe, einer Nitrogruppe, einer Amidingruppe, einer Hydrazingruppe, einer Hydrazongruppe, einer C₁-C₂₀-Alkylgruppe, einer C₁-C₂₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer monovalenten nicht-aromatischen kondensierten polycyclischen C8-C60-Gruppe, einer monovalenten nicht-aromatischen kondensierten 8- bis 60-gliedrigen heteropolycyclischen Gruppe, einer Biphenylgruppe, einer Terphenylgruppe, -Si(Q₃₁)(Q₃₂)(Q₃₃), -N(Q₃₁)(Q₃₂), - B(Q₃₁)(Q₃₂),-C(=O)(Q₃₁), -S(=O)₂(Q₃₁) und -P(=O)(Q₃₁)(Q₃₂),
wobei in Formeln 2-1 bis 2-3, 2-10 bis 2-19, 2-21 bis 2-27 und 2-33 bis 2-36, L₂₂ ausgewählt ist aus:
einer Phenylengruppe, einer Pentalenylengruppe, einer Indenylengruppe, einer Naphthylengruppe, einer Azulenylengruppe, einer Indacenylengruppe, einer Acenaphthylengruppe, einer Fluorenylengruppe, einer Spiro-bifluorenylengruppe, einer Spiro-benzofluoren-fluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Perylenylengruppe, einer Pentaphenylengruppe, einer Pyrrolylengruppe, einer Thiophenylengruppe, einer Furanylengruppe, einer Silolylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Indolylengruppe, einer Isoindolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Benzosilolylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Dibenzosilolylengruppe, einer Carbazolylengruppe, einer Benzocarbazolylengruppe, einer Dibenzocarbazolylengruppe, einer Thiadiazolylengruppe, einer Imidazopyridinylengruppe, einer Imidazopyrimidinylengruppe, einer Oxazolopyridinylengruppe, einer Thiazolopyridinylengruppe, einer Benzonaphthyridinylengruppe, einer Azafluorenylengruppe, einer Azaspirobifluorenylengruppe, einer Azacarbazolylengruppe, einer Azadibenzofuranylengruppe, einer Azadibenzothiophenylengruppe und einer Azadibenzosilolylengruppe; und
einer Phenylengruppe, einer Pentalenylengruppe, einer Indenylengruppe, einer Naphthylengruppe, einer Azulenylengruppe, einer Indacenylengruppe, einer Acenaphthylengruppe, einer Fluorenylengruppe, einer Spiro-bifluorenylengruppe, einer Spiro-benzofluoren-fluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Perylenylengruppe, einer Pentaphenylengruppe, einer Pyrrolylengruppe, einer Thiophenylengruppe, einer Furanylengruppe, einer Silolylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Indolylengruppe, einer Isoindolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Benzosilolylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Dibenzosilolylengruppe, einer Carbazolylengruppe, einer Benzocarbazolylengruppe, einer Dibenzocarbazolylengruppe, einer Thiadiazolylengruppe, einer Imidazopyridinylengruppe, einer Imidazopyrimidinylengruppe, einer Oxazolopyridinylengruppe, einer Thiazolopyridinylengruppe, einer Benzonaphthyridinylengruppe, einer Azafluorenylengruppe, einer Azaspirobifluorenylengruppe, einer Azacarbazolylengruppe, einer Azadibenzofuranylengruppe, einer Azadibenzothiophenylengruppe und einer Azadibenzosilolylengruppe, jeweils substituiert mit mindestens einem, ausgewählt aus Deuterium, -F, -Cl, -Br, -I, einer Hydroxygruppe, einer Cyanogruppe, einer Nitrogruppe, einer Amidingruppe, einer Hydrazingruppe, einer Hydrazongruppe, einer C₁-C₂₀-Alkylgruppe, einer C₁-C₂₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer monovalenten nicht-aromatischen kondensierten polycyclischen C8-C60-Gruppe, einer monovalenten nicht-aromatischen kondensierten 8- bis 60-gliedrigen heteropolycyclischen Gruppe, einer Biphenylgruppe, einer Terphenylgruppe, -Si(Q₃₁)(Q₃₂)(Q₃₃), -N(Q₃₁)(Q₃₂), - B(Q₃₁)(Q₃₂),-C(=O)(Q₃₁), -S(=O)₂(Q₃₁) und -P(=O)(Q₃₁)(Q₃₂).

7. Organische lichtemittierende Vorrichtung nach einem der vorhergehenden Ansprüche, wobei in Formeln 1A, 1B, 2A und 2B, R₁ bis R₄, R₁₁ bis R₁₄, R₂₁, R₂₃, R₂₄, R₂₇ und R₂₈ jeweils unabhängig ausgewählt sind aus:
Wasserstoff, Deuterium, -F, -Cl, -Br, -I, einer Hydroxygruppe, einer Cyanogruppe, einer Nitrogruppe, einer Amidingruppe, einer Hydrazingruppe, einer Hydrazongruppe, einer C₁-C₂₀-Alkylgruppe und einer C₁-C₂₀-Alkoxygruppe;
einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-Bifluorenylgruppe, einer Spiro-Benzofluoren-Fluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Pyrrolylgruppe, einer Thiophenylgruppe, einer Furanylgruppe, einer Silolylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Isoindolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Phenanthridinylgruppe, einer Acridinylgruppe, einer Phenanthrolinylgruppe einer Phenazinylgruppe, einer Benzoimidazolylgruppe, einer Benzofuranylgruppe, einer Benzothiophenylgruppe, einer Benzosilolylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Carbazolylgruppe, einer Benzocarbazolylgruppe, einer Dibenzocarbazolylgruppe, einer Thiadiazolylgruppe, einer Imidazopyridinylgruppe, einer Imidazopyrimidinylgruppe, einer Oxazolopyridinylgruppe, einer Thiazolopyridinylgruppe, einer Benzonaphthyridinylgruppe, einer Azafluorenylgruppe, einer Azaspiro-bifluorenylgruppe, einer Azacarbazolylgruppe, einer Azadibenzofuranylgruppe, einer Azadibenzothiophenylgruppe, einer Azadibenzosilolylgruppe, - Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂); und
einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-bifluorenylgruppe, einer Spiro-benzofluoren-fluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Pyrrolylgruppe, einer Thiophenylgruppe, einer Furanylgruppe, einer Silolylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Isoindolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzosilolylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Carbazolylgruppe, einer Benzocarbazolylgruppe, einer Dibenzocarbazolylgruppe, einer Thiadiazolylgruppe, einer Imidazopyridinylgruppe, einer Imidazopyrimidinylgruppe, einer Oxazolopyridinylgruppe, einerThiazolopyridinylgruppe, einer Benzonaphthyridinylgruppe, einer Azafluorenylgruppe, einer Azaspiro-bifluorenylgruppe, einer Azacarbazolylgruppe, einer Azadibenzofuranylgruppe, einer Azadibenzothiophenylgruppe und einer Azadibenzosilolylgruppe, jeweils substituiert mit mindestens einem, ausgewählt aus Deuterium, - F, -Cl, -Br, -I, einer Hydroxygruppe, einer Cyanogruppe, einer Nitrogruppe, einer Amidingruppe, einer Hydrazingruppe, einer Hydrazongruppe, einer C₁-C₂₀-Alkylgruppe, einer C₁-C₂₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer monovalenten nicht-aromatischen kondensierten polycyclischen C8-C60-Gruppe, einer monovalenten nicht-aromatischen kondensierten 8- bis 60-gliedrigen heteropolycyclischen Gruppe, einer Biphenylgruppe, einer Terphenylgruppe, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂), wobei Q₁ bis Q₃ und Q₃₁ bis Q₃₃ jeweils unabhängig ausgewählt sind aus:
einer C₁-C₁₀-Alkylgruppe, einer C₁-C₁₀-Alkoxygruppe, einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe; und
einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, jeweils substituiert mit mindestens einer, ausgewählt aus einer C₁-C₁₀-Alkylgruppe, einer C₁-C₁₀-Alkoxygruppe und einer Phenylgruppe.

8. Organische lichtemittierende Vorrichtung nach einem der vorhergehenden Ansprüche, wobei die erste Verbindung durch eine der folgenden Formeln 1-1 bis 1-3 dargestellt ist: 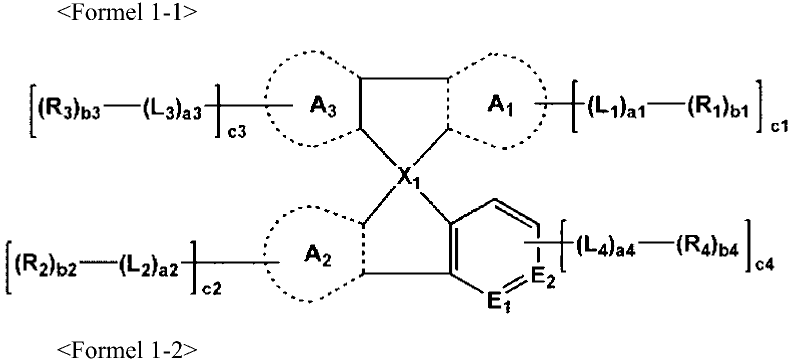 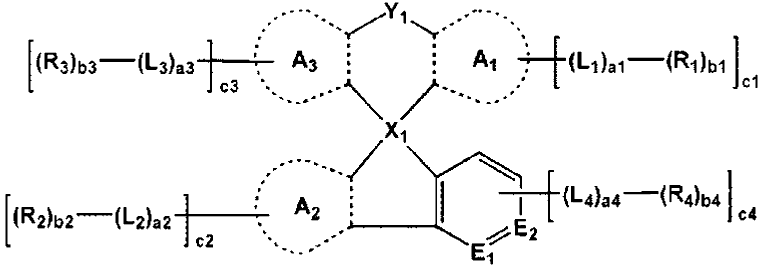 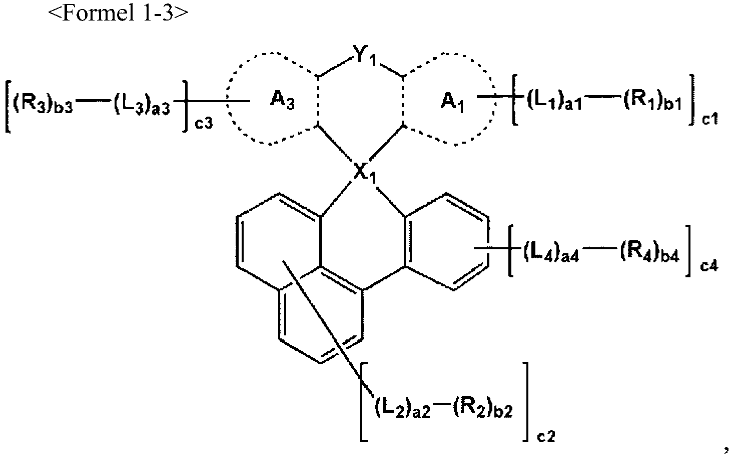 wobei in Formeln 1-1 bis 1-3
c2 eine ganze Zahl von 0 bis 6 ist,
Y₁ ausgewählt ist aus N[(L₁₁)ₐ₁₁-(R₁₁)_{b11}], C(R₁₁)(R₁₃), Si(R₁₁)(R₁₃), O, S und Se, und
Ringe A₁ bis A₃, X₁, E₁, E₂, L₁ bis L₄, a1 bis a4, R₁ bis R₄, b1 bis b4, c1, c3, c4, L₁₁, a11, R₁₁, R₁₃ und b11 wie in einem der Ansprüche 1, 2, 8 und 9 definiert sind,
wobei vorzugsweise:
Ring A₁ ausgewählt ist aus einer Benzolgruppe, einer Naphthalingruppe, einer Pyridingruppe, einer Dibenzofurangruppe und einer Pyrimidingruppe,
die Ringe A₂ und A₃ jeweils unabhängig ausgewählt sind aus einer Benzolgruppe, einer Naphthalingruppe, einer Anthracengruppe, einer Phenanthrengruppe, einer Indengruppe, einer Indenopyridingruppe, einer Fluorengruppe, einer Pyridingruppe, einer Pyrimidingruppe, einer Pyrazingruppe, einer Pyrrolgruppe, einer Imidazolgruppe, einer Chinolingruppe, einer Isochinolingruppe, einer Chinazolingruppe, einer Phenanthrolingruppe, einer Phenanthridingruppe, einer Furangruppe, einer Thiophengruppe, einer Indolgruppe, einer Indolocarbazolgruppe, einer Benzofurangruppe, einer Benzofurocarbazolgruppe, einer Benzofuropyrimidingruppe, einer Benzothiophengruppe, einer Benzoxazolgruppe, einer Benzothiazolgruppe, einer Benzoimidazolgruppe, einer Carbazolgruppe, einer Dibenzofurangruppe, einer Dibenzothiophengruppe, einer Pyridoindolgruppe, einer Dipyridofurangruppe, einer Dipyridothiophengruppe, einer Pyrimidobenzofurangruppe, einer Dipyridopyrrolgruppe und einer Pyrimidobenzothiophengruppe, und
R₁ bis R₄ jeweils unabhängig voneinander ausgewählt sind aus Wasserstoff, Deuterium, - F, -Cl, -Br, -I, einer Hydroxygruppe, einer Cyanogruppe, einer Nitrogruppe, einer Amidingruppe, einer Hydrazingruppe, einer Hydrazongruppe, einer C₁-C₂₀ -Alkylgruppe, einer C₁-C₂₀ - Alkoxygruppe, einer C₃-C₁₀ -Cycloalkylgruppe, einer C₁-C₁₀ -Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₁-C₆₀ Heteroarylgruppe, einer monovalenten nicht-aromatischen kondensierten polycyclischen C8-C60-Gruppe, einer monovalenten nicht-aromatischen kondensierten 8- bis 60-gliedrigen heteropolycyclischen Gruppe, einer Biphenylgruppe, einer Terphenylgruppe, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂).

9. Organische lichtemittierende Vorrichtung nach einem der vorhergehenden Ansprüche, wobei
(a) eine Triplettenergie der zweiten Verbindung etwa 2,2 eV oder mehr beträgt; und/oder
(b) die Emissionsschicht einen ersten Wirt und einen zweiten Wirt umfasst, wobei der erste Wirt die erste Verbindung umfasst; und/oder
(c) der Elektronentransportbereich eine Pufferschicht umfasst, die Pufferschicht die Emissionsschicht direkt berührt und die Pufferschicht die zweite Verbindung umfasst.

10. Organische lichtemittierende Vorrichtung nach einem der vorhergehenden Ansprüche, wobei:
die Emissionsschicht einen Dotierstoff umfasst, und
der Dotierstoff einen metallorganischen Komplex umfasst;
vorzugsweise wobei der organometallische Komplex dargestellt ist durch Formel 401, wobei L₄₀₁ ausgewählt ist aus einem Liganden, dargestellt durch Formel 402,
<Formel 401> M(L₄₀₁)xc1(L₄₀₂)xc2 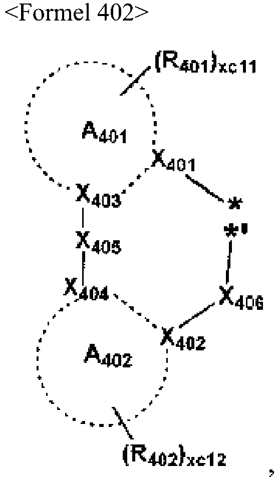
wobei in Formeln 401 und 402
M ausgewählt ist aus Iridium (Ir), Platin (Pt), Palladium (Pd), Osmium (Os), Titan (Ti), Zirkonium (Zr), Hafnium (Hf), Europium (Eu), Terbium (Tb), Rhodium (Rh) und Thulium (Tm),
xc1 1, 2 oder 3 ist, wobei, wenn xc1 2 oder 3 ist, 2 oder 3 L₄₀₁ zueinander identisch oder voneinander verschieden sind,
L₄₀₂ ein organischer Ligand ist und xc2 eine ganze Zahl von 0 bis 4 ist, wobei, wenn xc2 2, 3 oder 4, 2, 3 oder 4 ist, L₄₀₂ miteinander identisch oder voneinander verschieden sind,
X₄₀₁ bis X₄₀₄ jeweils unabhängig Stickstoff oder Kohlenstoff sind,
X₄₀₁ und X₄₀₃ über eine Einzelbindung oder eine Doppelbindung miteinander verbunden sind und X₄₀₂ und X₄₀₄ über eine Einzelbindung oder eine Doppelbindung miteinander verbunden sind,
A₄₀₁ und A₄₀₂ jeweils unabhängig eine carbocyclische C₅-C₆₀-Gruppe oder eine heterocyclische C₁-C₆₀-Gruppe sind,
X₄₀₅ eine Einfachbindung, -O-, -S-, -C(=O)-, -N(Q₄₁₁)-, -C(Q₄₁₁)(Q₄₁₂)-, -C(Q₄₁₁)=C(Q₄₁₂)-, -C(Q₄₁₁)= oder =C(Q₄₁₁)= ist, wobei Q₄₁₁ und Q₄₁₂ jeweils unabhängig Wasserstoff, Deuterium, eine C₁-C₂₀-Alkylgruppe, eine C₁-C₂₀-Alkoxygruppe, eine Phenylgruppe, eine Biphenylgruppe, eine Terphenylgruppe oder eine Naphthylgruppe sind,
X₄₀₆ eine Einfachbindung, O oder S ist,
R₄₀₁ und R₄₀₂ jeweils unabhängig ausgewählt sind aus Wasserstoff, Deuterium, -F, -Cl, - Br, -I, -CD₃, -CF₃, einer Hydroxygruppe, einer Cyanogruppe, einer Nitrogruppe, einer Amidingruppe, einer Hydrazingruppe, einer Hydrazongruppe, einer substituierten oder unsubstituierten C₁-C₂₀-Alkylgruppe, einer substituierten oder unsubstituierten C₁-C₂₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe einer substituierten oder unsubstituierten C₁-C₆₀-Heteroarylgruppe, einer substituierten oder unsubstituierten monovalenten nicht-aromatischen kondensierten polycyclischen C8-C60-Gruppe, einer substituierten oder unsubstituierten monovalenten nicht-aromatischen kondensierten 8- bis 60-gliedrigen heteropolycyclischen Gruppe, Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁) und - P(=O)(Q₄₀₁)(Q₄₀₂), wobei Q₄₀₁ to Q₄₀₃ jeweils unabhängig ausgewählt sind aus einer C₁-C₁₀-Alkylgruppe, einer C₁-C₁₀-Alkoxygruppe, einer C₆-C₂₀-Arylgruppe und einer C₁-C₂₀-Heteroarylgruppe,
xc11 und xc12 jeweils unabhängig eine ganze Zahl von 0 bis 10 sind, und
* und *' in Formel 402 eine Bindungsstelle an M in Formel 401 anzeigen.

11. Organische lichtemittierende Vorrichtung nach einem der vorhergehenden Ansprüche, wobei:
die Elektronentransportbereich eine Pufferschicht, eine Elektronentransportschicht und eine Elektroneninjektionsschicht umfasst, und
wobei mindestens eine Schicht der Elektronentransportschicht und der Elektroneninjektionsschicht ein Alkalimetall, ein Erdalkalimetall, ein Seltenerdmetall, eine Alkalimetallverbindung, eine Erdalkalimetallverbindung, eine Seltenerdmetallverbindung, einen Alkalimetallkomplex, einen Erdalkalimetallkomplex, einen Seltenerdmetallkomplex oder eine Kombination davon umfasst.

12. Organische lichtemittierende Vorrichtung nach einem der vorhergehenden Ansprüche, wobei:
der Lochtransportbereich einen p-Dotierstoff umfasst und
ein niedrigstes unbesetztes Molekülorbital (LUMO) des p-Dotierstoffs etwa -3,5 eV oder weniger beträgt;
bevorzugt, wobei der p-Dotierstoff eine Cyanogruppen-haltige Verbindung umfasst.

13. Organische lichtemittierende Vorrichtung nach einem der vorhergehenden Ansprüche, wobei
die Emissionsschicht eine Emissionsschicht von Licht mit einer ersten Farbe ist,
die organische lichtemittierende Vorrichtung ferner mindestens eine Emissionsschicht von Licht mit einer zweiten Farbe oder mindestens eine Emissionsschicht von Licht mit einer zweiten Farbe und mindestens eine Emissionsschicht von Licht mit einer dritten Farbe zwischen der ersten Elektrode und der zweiten Elektrode umfasst,
eine maximale Emissionswellenlänge der Emissionsschicht von Licht mit einer ersten Farbe, eine maximale Emissionswellenlänge der Emissionsschicht von Licht mit einer zweiten Farbe und eine maximale Emissionswellenlänge der Emissionsschicht von Licht mit einer dritten Farbe miteinander identisch oder voneinander unterschiedlich sind, und
gemischtes Licht, das Licht mit einer ersten Farbe und Licht mit einer zweiten Farbe umfasst, oder gemischtes Licht, das Licht mit einer ersten Farbe, Licht mit einer zweiten Farbe und Licht mit einer dritten Farbe umfasst, emittiert wird.

## Revendications

1. Dispositif électroluminescent organique, comprenant :
une première électrode ;
une seconde électrode faisant face à la première électrode ;
une couche d'émission entre la première électrode et la seconde électrode ;
une région de transport de trou entre la première électrode et la couche d'émission ; et
une région de transport d'électrons entre la couche d'émission et la seconde électrode,
dans lequel :
la couche d'émission comprend un premier composé,
au moins l'une de la région de transport de trou et de la région de transport d'électrons comprend un deuxième composé,
le premier composé est représenté par la Formule 1A ou 1B, et
le deuxième composé est représenté par la Formule 2A ou 2B : 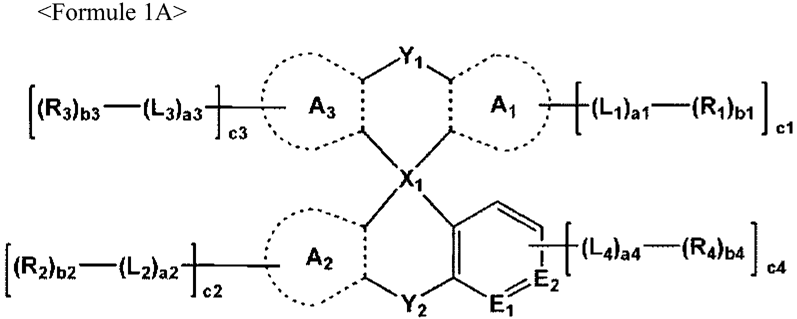 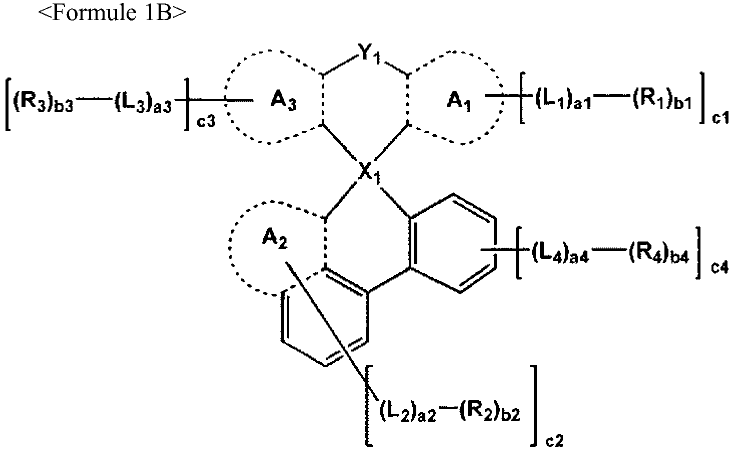 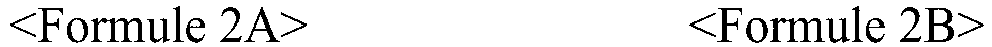 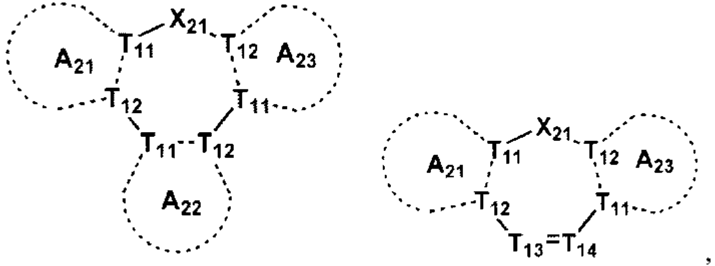
dans lequel, dans les formules 1A, 1B, 2A et 2B,
les cycles A₁ à A₃ sont chacun indépendamment sélectionnés parmi un groupe carbocyclique en C₅ à C₆₀ et un groupe hétérocyclique en C₁ à C₆₀,
les cycles A₁ à A₃ sont chacun condensés avec le cycle spiro dans les Formules 1A et 1B,
les cycles A₂₁, A₂₂ et A₂₃ sont chacun indépendamment un groupe carbocyclique en C₅ à C₆₀ ou un groupe hétérocyclique en C₁ à C₆₀, chacun substitué par au moins un *-[(L₂₂)ₐ₂₂-(R₂₂)_{b22}], dans lequel * est un site de liaison au cycle A₂₁, A₂₂ ou A₂₃,
chaque T₁₁ est indépendamment du carbone ou de l'azote,
chaque T₁₂ est indépendamment du carbone ou de l'azote,
T₁₃ est N ou C(R₂₇),
T₁₄ est N ou C(R₂₈),
chaque liaison entre T₁₁ et T₁₂ représentée sous forme de ligne pointillée dans les formules 2A et 2B est une liaison simple ou une liaison double ;
les six atomes représentés par les trois T₁₁ et trois T₁₂ dans la Formule 2A ne sont pas tous de l'azote, et les six atomes représentés par les deux T₁₁, deux T₁₂, T₁₃ et T₁₄ dans la Formule 2B ne sont pas tous de l'azote,
les cycles A₂₁, A₂₂ et A₂₃ sont chacun condensés avec le cycle à 7 chaînons dans les formules 2A et 2B, tout en partageant T₁₁ et T₁₂ avec celui-ci,
X₁ est un atome de silicium (Si) ou un atome de carbone (C),
Y₁ est choisi parmi une liaison simple, N[(L₁₁)ₐ₁₁-(R₁₁)_{b11}], C(R₁₁)(R₁₃), Si(R₁₁)(R₁₃), O, S et Se,
Y₂ est choisi parmi une liaison simple, N[(L₁₂)ₐ₁₂-(R₁₂)_{b12}], C(R₁₂)(R₁₄), Si(R₁₂)(R₁₄), O, S et Se,
E₁ et E₂ sont chacun indépendamment un atome d'azote (N) ou un atome de carbone (C) substitué par *-(L₄)ₐ₄-(R₄)_{b4},
X₂₁ est N[(L₂₁)ₐ₂₁-(R₂₁)_{b21}], ou
X₂₁ est O, S, Se, C(R₂₃)(R₂₄), ou Si(R₂₃)(R₂₄), et au moins l'un des cycles A₂₁, A₂₂, et A₂₃ dans la formule 2A et au moins l'un des cycles A₂₁ et A₂₃ dans la formule 2B sont chacun indépendamment un groupe représenté par l'une des formules 2-1 à 2-3, 2-10 à 2-27, et 2- 33 à 2-36 dans lesquelles au moins l'un de X₂₂ et X₂₃ est N-[(L₂₂)ₐ₂₂-(R₂₂)b₂₂] : 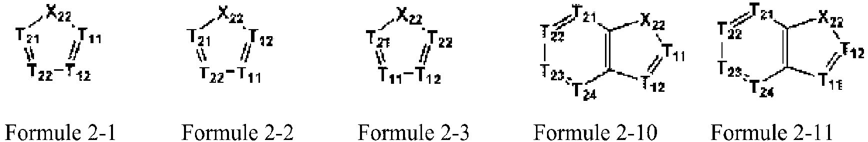 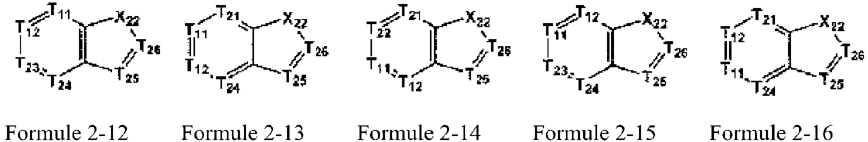 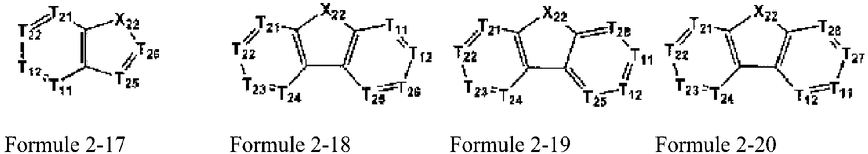 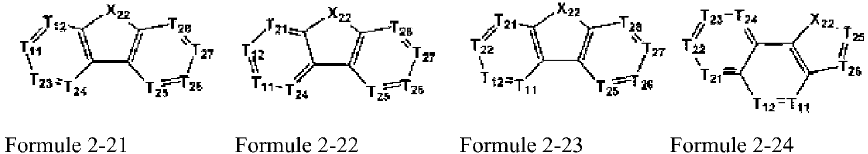 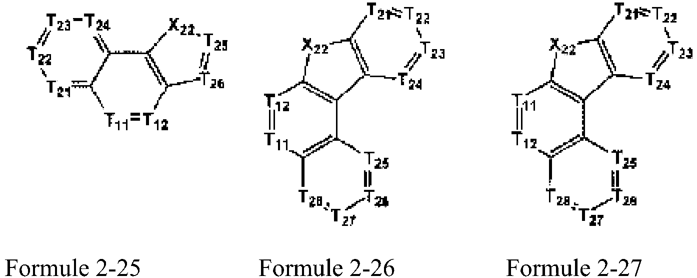 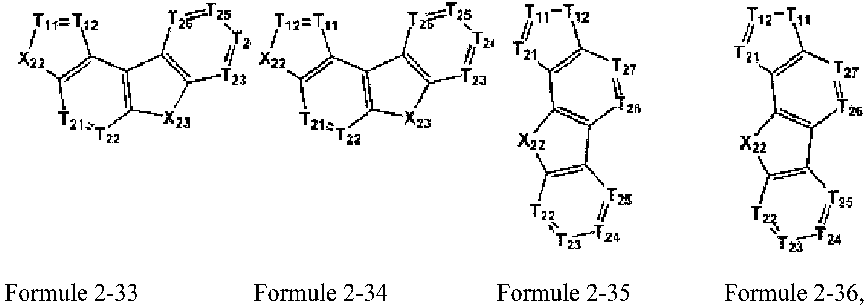
dans lequel, dans les Formules 2-1 à 2-3, 2-10 à 2-27 et 2-33 à 2-36,
X₂₂ et X₂₃ sont chacun indépendamment choisis parmi O, S, Se, un fragment contenant du carbone, un fragment contenant de l'azote et un fragment contenant du silicium, et
T₂₁ à T₂₈ sont chacun indépendamment choisis parmi N et un fragment contenant du carbone,
L₁ à L₄, L₁₁, L₁₂, et L₂₁ sont chacun indépendamment choisis parmi un groupe cycloalkylène en C₃ à C₁₀ substitué ou non substitué, un groupe hétérocycloalkylène en C₁ à C₁₀ substitué ou non substitué, un groupe cycloalcénylène en C₃ à C₁₀ substitué ou non substitué, un groupe hétérocycloalcénylène en C₁ à C₁₀ substitué ou non substitué, un groupe arylène en C₆ à C₆₀ substitué ou non substitué, un groupe hétéroarylène en C₁ à C₆₀ substitué ou non substitué, un groupe polycyclique condensé en C8 à C60 divalent non aromatique substitué ou non substitué et un groupe hétéropolycyclique condensé à 8 à 60 chaînons divalent non aromatique substitué ou non substitué,
dans lequel dans les Formules 2-1 à 2-3, 2-10 à 2-19, 2-21 à 2-27 et 2-33 à 2-36,
L₂₂ sont chacun indépendamment choisis parmi un groupe cycloalkylène en C₃ à C₁₀ substitué ou non substitué, un groupe hétérocycloalkylène en C₁ à C₁₀ substitué ou non substitué, un groupe cycloalcénylène en C₃ à C₁₀ substitué ou non substitué, un groupe hétérocycloalcénylène en C₁ à C₁₀ substitué ou non substitué, un groupe arylène en C₆ à C₆₀ substitué ou non substitué, un groupe hétéroarylène en C₁ à C₆₀ substitué ou non substitué, un groupe polycyclique condensé en C8 à C60 divalent non aromatique substitué ou non substitué et un groupe hétéropolyclique condensé à 8 à 60 chaînons divalent non aromatique substitué ou non substitué,
dans lequel, dans la Formule 2-20,
L₂₂ sont chacun indépendamment choisis parmi un groupe phénylène, un groupe pentalénylène, un groupe indénylène, un groupe naphtylène, un groupe azulénylène, un groupe indacénylène, un groupe acénaphtylène, un groupe fluorénylène, un groupe spiro-bifluorénylène, un groupe spiro-benzofluorène-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe pérylénylène, un groupe pentaphénylène, un groupe pyrrolylène, un groupe thiophénylène, un groupe furanylène, un groupe silolylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyridazinylène, un groupe indolylène, un groupe isoindolylène, un groupe indazolylène, un groupe purinylène, un groupe quinolinylène, un groupe isoquinolinylène, un groupe benzoquinolinylène, un groupe phtalazinylène, un groupe naphthyridinylène, un groupe quinoxalinylène, un groupe quinazolinylène, un groupe cinnolinylène, un groupe phénanthridinylène, un groupe acridinylène, un groupe phénanthrolinylène, un groupe phénazinylène, un groupe benzoimidazolylène, un groupe benzofuranylène, un groupe benzothiophénylène, un groupe benzosilolylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe dibenzosilolylène, un groupe carbazolylène, un groupe benzocarbazolylène, un groupe dibenzocarbazolylène, un groupe thiadiazolylène, un groupe imidazopyridinylène, un groupe imidazopyrimidinylène, un groupe oxazolopyridinylène, un groupe thiazolopyridinylène, un groupe benzonaphtyridinylène, un groupe azafluorénylène, un groupe azaspiro-bifluorénylène, un groupe azacarbazolylène, un groupe azadibenzofuranylène, un groupe azadibenzothiophénylène et un groupe azadibenzosilolylène ; et
un groupe phénylène, un groupe pentalénylène, un groupe indénylène, un groupe naphtylène, un groupe azulénylène, un groupe indacénylène, un groupe acénaphtylène, un groupe fluorénylène, un groupe spiro-bifluorénylène, un groupe spiro-benzofluorène-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe pérylénylène, un groupe pentaphénylène, un groupe pyrrolylène, un groupe thiophénylène, un groupe furanylène, un groupe silolylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyridazinylène, un groupe indolylène, un groupe isoindolylène, un groupe indazolylène, un groupe purinylène, un groupe quinolinylène, un groupe isoquinolinylène, un groupe benzoquinolinylène, un groupe phtalazinylène, un groupe naphthyridinylène, un groupe quinoxalinylène, un groupe quinazolinylène, un groupe cinnolinylène, un groupe phénanthridinylène, un groupe acridinylène, un groupe phénanthrolinylène, un groupe phénazinylène, un groupe benzoimidazolylène, un groupe benzofuranylène, un groupe benzothiophénylène, un groupe benzosilolylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe dibenzosilolylène, un groupe carbazolylène, un groupe benzocarbazolylène, un groupe dibenzocarbazolylène, un groupe thiadiazolylène, un groupe imidazopyridinylène, un groupe imidazopyrimidinylène, un groupe oxazolopyridinylène, un groupe thiazolopyridinylène, un groupe benzonaphtyridinylène, un groupe azafluorénylène, un groupe azaspiro-bifluorénylène, un groupe azacarbazolylène, un groupe azadibenzofuranylène, un groupe azadibenzothiophénylène et un groupe azadibenzosilolylène, chacun substitué par au moins un élément choisi parmi le deutérium, -F, - Cl, -Br, -I, un groupe hydroxyle, un groupe cyano, un groupe nitro, un groupe amidino, un groupe hydrazino, un groupe hydrazono, un groupe un groupe alkyle en C₁ à C₂₀, un groupe alcoxy en C₁ à C₂₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe hétéroaryle en C₁ à C₆₀, un groupe polycyclique condensé en C8 à C60 non aromatique monovalent, un groupe hétéropolycyclique condensé à 8 à 60 chaînons non aromatique monovalent, un groupe biphényle, un groupe terphényle, -Si(Q₃₁)(Q₃₂)(Q₃₃), -N(Q₃₁)(Q₃₂), - B(Q₃₁)(Q₃₂),-C(=O)(Q₃₁), -S(=O)₂(Q₃₁) et -P(=O)(Q₃₁)(Q₃₂), dans lequel Q₃₁ à Q₃₃ sont chacun indépendamment choisi parmi :
un groupe alkyle en C₁ à C₁₀, un groupe alcoxy en C₁ à C₁₀, un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle et un groupe quinazolinyle ; et
un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle et un groupe quinazolinyle, chacun substitué par au moins un élément choisi parmi un groupe alkyle en C₁ à C₁₀, un groupe alcoxy en C₁ à C₁₀ et un groupe phényle,
a1 à a4, a11, a12, a21 et a22 sont chacun indépendamment un nombre entier de 0 à 5,
R₁ à R₄, R₂₁, R₂₃, R₂₄, R₂₇, et R₂₈ sont chacun indépendamment choisis parmi l'hydrogène, le deutérium (-D), -F, -Cl, -Br, -I, un groupe hydroxyle, un groupe cyano, un groupe nitro, un groupe amidino, un groupe hydrazino, un groupe hydrazono, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alcoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe polycyclique condensé en C8 à C60 non aromatique monovalent substitué ou non substitué, un groupe hétéropolycyclique condensé à 8 à 60 chaînons non aromatique monovalent substitué ou non substitué, -Si(Q₁)(Q₂)(Q₃), -N(Q₁)(Q₂), -B(Q₁)(Q₂), -C(=O)(Q₁), - S(=O)₂(Q₁), et -P(=O)(Q₁)(Q₂),
dans lequel dans les Formules 2-1 à 2-3, 2-10 à 2-19, 2-21, 2-23 à 2-27 et 2-33 à 2-36,
R₂₂ est choisi parmi l'hydrogène, le deutérium (-D), -F, -Cl, -Br, -I, un groupe hydroxyle, un groupe cyano, un groupe nitro, un groupe amidino, un groupe hydrazino, un groupe hydrazono, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alcoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe polycyclique condensé en C8 à C60 non aromatique monovalent substitué ou non substitué, un groupe hétéropolycyclique condensé à 8 à 60 chaînons non aromatique monovalent substitué ou non substitué, -Si(Q₁)(Q₂)(Q₃), - N(Q₁)(Q₂), -B(Q₁)(Q₂), -C(=O)(Q₁), -S(=O)₂(Q₁), et -P(=O)(Q₁)(Q₂),
dans lequel, dans la Formule 2-20,
R₂₂ est choisi parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀ et un groupe alcoxy en C₁ à C₂₀ ;
un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe spiro-benzofluorène-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentaphényle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyridazinyle, un groupe indolyle, un groupe isoindolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzoimidazolyle, un groupe benzofuranyle, un groupe benzothiophényle, un groupe benzosilolyle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe carbazolyle, un groupe benzocarbazolyle, un groupe dibenzocarbazolyle, un groupe thiadiazolyle, un groupe imidazopyridinyle, un groupe imidazopyrimidinyle, un groupe oxazolopyridinyle, un groupe thiazolopyridinyle, un groupe benzonaphthyridinyle, un groupe azafluorényle, un groupe azaspiro-bifluorényle, un groupe azacarbazolyle, un groupe azadibenzofuranyle, un groupe azadibenzothiophényle, un groupe azadibenzosilolyle, - Si(Q₁)(Q₂)(Q₃), - N(Q₁)(Q₂), -B(Q₁)(Q₂), -C(=O)(Q₁), -S(=O)₂(Q₁), et -P(=O)(Q₁)(Q₂) ; et
un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe spiro-benzofluorène-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentaphényle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyridazinyle, un groupe indolyle, un groupe isoindolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzoimidazolyle, un groupe benzofuranyle, un groupe benzothiophényle, un groupe benzosilolyle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe carbazolyle, un groupe benzocarbazolyle, un groupe dibenzocarbazolyle, un groupe thiadiazolyle, un groupe imidazopyridinyle, un groupe imidazopyrimidinyle, un groupe oxazolopyridinyle, un groupe thiazolopyridinyle, un groupe benzonaphthyridinyle, un groupe azafluorényle, un groupe azaspirobifluorényle, un groupe azacarbazolyle, un groupe azadibenzofuranyle, un groupe azadibenzothiophényle et un groupe azibenzosilolyle, chacun substitué par au moins un élément choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alcoxy en C₁ à C₂₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe hétéroaryle en C₁ à C₆₀, un groupe polycyclique condensé en C8 à C60 non aromatique monovalent, un groupe hétéropolycyclique condensé à 8 à 60 chaînons non aromatique monovalent, un groupe biphényle, un groupe terphényle, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), et -P(=O)(Q₃₁)(Q₃₂), dans lequel Q₁ à Q₃ et Q₃₁ à Q₃₃ sont choisis indépendamment parmi :
un groupe alkyle en C₁ à C₁₀, un groupe alcoxy en C₁ à C₁₀, un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle et un groupe quinazolinyle ; et
un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle et un groupe quinazolinyle, chacun substitué par au moins un élément choisi parmi un groupe alkyle en C₁ à C₁₀, un groupe alcoxy en C₁ à C₁₀ et un groupe phényle,
dans lequel, dans les Formules 2-22,
R₂₂ est l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀ et un groupe alcoxy en C₁ à C₂₀ ;
un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe spiro-benzofluorène-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentaphényle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle un groupe pyridazinyle, un groupe indolyle, un groupe isoindolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzoimidazolyle, un groupe benzofuranyle, un groupe benzothiophényle, un groupe benzosilolyle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzothiophényle, un groupe dibenzosilolyle, un groupe carbazolyle, un groupe benzocarbazolyle, un groupe dibenzocarbazolyle, un groupe thiadiazolyle, un groupe imidazopyridinyle, un groupe imidazopyrimidinyle, un groupe oxazolopyridinyle, un groupe thiazolopyridinyle, un groupe benzonaphthyridinyle, un groupe azafluorényle, un groupe azaspiro-bifluorényle, un groupe azacarbazolyle, un groupe azadibenzofuranyle, un groupe azadibenzothiophényle, un groupe azadibenzosilolyle, -Si(Q₁)(Q₂)(Q₃), -N(Q₁)(Q₂), -B(Q₁)(Q₂), - C(=O)(Q₁), -S(=O)₂(Q₁), et -P(=O)(Q₁)(Q₂) ;
un groupe cyclopentyle, un groupe cyclohexyle, un groupe cycloheptyle, un groupe cyclopentényle, un groupe cyclohexényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe spiro-benzofluorène-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentaphényle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzoimidazolyle, un groupe benzothiophényle, un groupe benzosilolyle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe carbazolyle, un groupe benzocarbazolyle, un groupe dibenzocarbazolyle, un groupe thiadiazolyle, un groupe imidazopyridinyle, un groupe imidazopyrimidinyle, un groupe oxazolopyridinyle, un groupe thiazolopyridinyle, un groupe benzonaphthyridinyle, un groupe azafluorényle, un groupe azaspirobifluorényle, un groupe azacarbazolyle, un groupe azadibenzofuranyle, un groupe azadibenzothiophényle et un groupe azibenzosilolyle, chacun substitué par au moins un élément choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alcoxy en C₁ à C₂₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe hétéroaryle en C₁ à C₆₀, un groupe polycyclique condensé en C8 à C60 non aromatique monovalent, un groupe hétéropolycyclique condensé à 8 à 60 chaînons non aromatique monovalent, un groupe biphényle, un groupe terphényle, -Si(Q₃₁)(Q₃₂)(Q₃₃), - N(Q₃₁)(Q₃₂), -B(Q₃₁)(Q₃₂), -C(=O)(Q₃₁), -S(=O)₂(Q₃₁), et -P(=O)(Q₃₁)(Q₃₂), dans lequel Q₁ à Q₃ et Q₃₁ à Q₃₃ sont chacun choisis indépendamment parmi :
un groupe alkyle en C₁ à C₁₀, un groupe alcoxy en C₁ à C₁₀, un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle et un groupe quinazolinyle ; et
un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle et un groupe quinazolinyle, chacun substitué par au moins un élément choisi parmi un groupe alkyle en C₁ à C₁₀, un groupe alcoxy en C₁ à C₁₀ et un groupe phényle,
R₁₁ et R₁₃ sont chacun individuellement tels que définis pour R₁ ou, lorsque R₁₁ et R₁₃ sont tous deux présents, ils peuvent être connectés l'un à l'autre pour former un groupe carbocyclique en C₅ à C₆₀ ou un groupe hétérocyclique en C₁ à C₆₀ conjointement avec l'atome auquel ils sont attachés,
R₁₂ et R₁₄ sont chacun individuellement tels que définis pour R₁ ou, lorsque R₁₂ et R₁₄ sont tous deux présents, ils peuvent être connectés l'un à l'autre pour former un groupe carbocyclique en C₅ à C₆₀ ou un groupe hétérocyclique en C₁ à C₆₀ conjointement avec l'atome auquel ils sont attachés,
b1 à b4, b11, b12, b21 et b22 sont chacun indépendamment un nombre entier de 1 à 3,
c1 et c2 sont chacun indépendamment un nombre entier de 0 à 8, et c3 et c4 sont chacun indépendamment un nombre entier de 0 à 4, et
le groupe cycloalkylène en C₃ à C₁₀ substitué, le groupe hétérocycloalkylène en C₁ à C₁₀ substitué, le groupe cycloalkénylène en C₃ à C₁₀ substitué, le groupe hétérocycloalkénylène en C₁ à C₁₀ substitué, le groupe arylène en C₆ à C₆₀ substitué, le groupe hétéroarylène en C₁ à C₆₀ substitué, le groupe polycyclique condensé en C8 à C60 divalent non aromatique substitué, le groupe hétéropolycyclique non aromatique condensé à 8 à 60 chaînons divalent substitué, le groupe alkyle en C₁ à C₆₀ substitué, le groupe alcényle en C₂ à C₆₀ substitué, le groupe alkynyle en C₂ à C₆₀ substitué, le groupe alcoxy en C₁ à C₆₀ substitué, le groupe cycloalkyle en C₃ à C₁₀ substitué, le groupe hétérocycloalkyle en C₁ à C₁₀ substitué, le groupe cycloalcényle en C₃ à C₁₀ substitué, le groupe hétérocycloalcényle en C₁ à C₁₀ substitué, le groupe aryle en C₆ à C₆₀ substitué, le groupe aryloxy en C₆ à C₆₀ substitué, le groupe arylthio en C₆ à C₆₀ substitué, le groupe hétéroaryle en C₁ à C₆₀ substitué, le groupe polycyclique condensé en C8 à C60 non aromatique monovalent substitué et le groupe hétéropolycyclique condensé non aromatique monovalent substitué à 8 à 60 chaînons sont chacun indépendamment substitués par un ou plusieurs substituants sélectionnés parmi :
le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀, un groupe alcényle en C₂ à C₆₀, un groupe alcynyle en C₂ à C₆₀ et un groupe alcoxy en C₁ à C₆₀ ;
un groupe alkyle en C₁ à C₆₀, un groupe alcényle en C₂ à C₆₀, un groupe alcynyle en C₂ à C₆₀ et un groupe alcoxy en C₁ à C₆₀, chacun substitué par au moins l'un sélectionné parmi le deutérium, -F, -Cl, -Br, -I, un groupe hydroxyle, un groupe cyano, un groupe nitro, un groupe amidino, un groupe hydrazino, un groupe hydrazono, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé en C8 à C60 non aromatique monovalent, un groupe hétéropolycyclique condensé à 8 à 60 chaînons non aromatique monovalent substitué ou non substitué, -Si(Q₁₁)(Q₁₂)(Q₁₃), -N(Q₁₁)(Q₁₂), - B(Q₁₁)(Q₁₂), - C(=O)(Q₁₁), -S(=O)₂(Q₁₁), et -P(=O)(Q₁₁)(Q₁₂) ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé en C8 à C60 non aromatique monovalent, un groupe hétéropolycyclique condensé à 8 à 60 chaînons non aromatique monovalent, un groupe biphényle et un groupe terphényle ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé en C8 à C60 non aromatique monovalent et un groupe hétéropolycyclique condensé à 8 à 60 chaînons non aromatique monovalent, chacun substitué par au moins un élément sélectionné parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀, un groupe alcényle en C₂ à C₆₀, un groupe alcynyle en C₂ à C₆₀, un groupe alcoxy en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé en C8 à C60 non aromatique monovalent, un groupe hétéropolycyclique condensé à 8 à 60 chaînons non aromatique monovalent, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), et - P(=O)(Q₂₁)(Q₂₂) ; et
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), et - P(=O)(Q₃₁)(Q₃₂),
dans lequel Q₁ à Q₃, Q₁₁ à Q₁₃, Q₂₁ à Q₂₃, et Q₃₁ à Q₃₃ sont chacun indépendamment sélectionnés parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀, un groupe alcényle en C₂ à C₆₀, un groupe alcynyle en C₂ à C₆₀, un groupe alcoxy en C₁ à C₆₀, un groupe cycloalkyle en C₃ à C₁₀, un groupe hétérocycloalkyle en C₁-C₁₀, un groupe cycloalcényle en C₃ à C₁₀, un groupe hétérocycloalcényle en C₁ à C₁₀, un groupe aryle en C₆ à C₆₀, un groupe aryle en C₆ à C₆₀ substitué par un groupe alkyle en C₁ à C₆₀, un groupe aryle en C₆ à C₆₀ substitué par un groupe aryle en C₆ à C₆₀, un groupe terphényle, un groupe hétéroaryle en C₁ à C₆₀, un groupe hétéroaryle en C₁ à C₆₀ substitué par un groupe alkyle en C₁ à C₆₀, un groupe hétéroaryle en C₁ à C₆₀ substitué par un groupe aryle en C₆ à C₆₀, un groupe polycyclique condensé en C8 à C60 non aromatique monovalent, et un groupe hétéropolycyclique condensé à 8 à 60 chaînons non aromatique monovalent.

2. Dispositif électroluminescent organique selon la revendication 1, dans lequel les cycles A₁ à A₃ dans les formules 1A et 1B sont chacun indépendamment choisis parmi un groupe benzène, un groupe naphtalène, un groupe anthracène, un groupe phénanthrène, un groupe indène, un groupe indénopyridine, un groupe fluorène, un groupe pyridine, un groupe pyrimidine, un groupe pyrazine, un groupe pyrrole, un groupe imidazole, un groupe quinoline, un groupe isoquinoline, un groupe quinazoline, un groupe phénanthroline, un groupe phénanthridine, un groupe furane, un groupe thiophène, un groupe indole, un groupe indolocarbazole, un groupe benzofurane, un groupe benzofurocarbazole, un groupe benzofuropyrimidine, un groupe benzothiophène, un groupe benzoxazole, un groupe benzothiazole, un groupe benzoimidazole, un groupe carbazole, un groupe dibenzofurane, un groupe dibenzothiophène, un groupe pyridoindole, un groupe dipyridofurane, un groupe dipyridothiophène, un groupe pyrimidobenzofurane, un groupe dipyridopyrrole, et un groupe pyrimidobenzothiophène.

3. Dispositif électroluminescent organique selon la revendication 1 ou la revendication 2, dans lequel les cycles A₂₁, A₂₂ et A₂₃ dans les formules 2A et 2B sont chacun indépendamment choisis parmi un groupe benzène, un groupe naphtalène, un groupe anthracène, un groupe indène, un groupe fluorène, un groupe pyridine, un groupe pyrimidine, un groupe pyrazine, un groupe pyridazine, un groupe quinoline, un groupe isoquinoline, un groupe pyrrole, un groupe pyrazole, un groupe imidazole, un groupe oxazole, un groupe thiazole, un groupe cyclopentadiène, un groupe silole, un groupe sélénophène, un groupe furane, un groupe thiophène, un groupe indole, un groupe benzoimidazole, un groupe benzoxazole, un groupe benzothiazole, un groupe indène, un groupe benzosilole, un groupe benzosélénophène, un groupe benzofurane, un groupe benzothiophène, un groupe carbazole, un groupe fluorène, un groupe dibenzosilole, un groupe dibenzosélénophène, un groupe dibenzofurane, un groupe dibenzothiophène, un groupe pyrrolopyridine, un groupe cyclopentapyridine, un groupe silolopyridine, un groupe sélénophénopyridine, un groupe furopyridine, un groupe thiénopyridine, un groupe pyrrolopyrimidine, un groupe cyclopentapyrimidine, une silolopyrimidine un groupe sélénophénopyrimidine, un groupe furopyrimidine, un groupe thiénopyrimidine, un groupe pyrrolopyrazine, un groupe cyclopentapyrazine, un groupe silolopyrazine, un groupe sélénophénopyrazine, un groupe furopyrazine, un groupe thiénopyrazine, un groupe naphtopyrrole, un groupe cyclopentanaphtalène, un groupe naphtosilole, un groupe naphtosélénothiophène, un groupe naphtofurane, un groupe naphtothiophène, un groupe pyrroloquinoline, un groupe cyclopentaquinoléine, un groupe siloloquinoléine, un groupe sélénophénoquinoléine, un groupe furoquinoléine, un groupe thiénoquinoléine, un groupe pyrroloisoquinoléine, un groupe cyclopentaisoquinoléine, un groupe siloloisoquinoléine, un groupe sélénophénoisoquinoléine, un groupe furoisoquinoléine, un groupe thiénoisoquinoléine, un groupe azacarbazole, un groupe azafluorène, un groupe azadibenzosilole, un groupe azadibenzoselenophène, un groupe azadibenzofurane, un groupe azadibenzothiophène, un groupe indénoquinoline, un groupe indénoisoquinoline, un groupe indénoquinoxaline, un groupe phénanthroline, et un groupe naphthoindole, chacun substitué par au moins un *-[(L₂₂)ₐ₂₂-(R₂₂)_{b22}], dans lequel * est un site de liaison à un atome voisin.

4. Dispositif électroluminescent organique selon la revendication 1 ou la revendication 2, dans lequel :
les cycles A₂₁ A₂₂, et A₂₃ dans les formules 2A et 2B sont chacun indépendamment un groupe représenté par l'une des formules 2-1 à 2-36 suivantes, chacune substituée par au moins un *-[(L₂₂)ₐ₂₂-(R₂₂)_{b22})], dans lequel * est un site de liaison au cycle A₂₁, A₂₂, ou A₂₃, 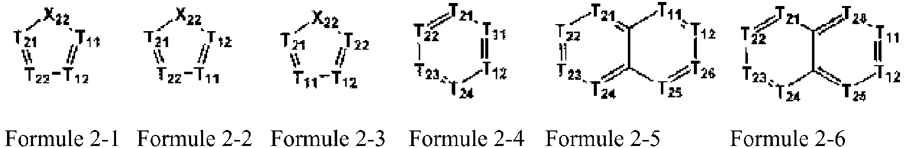 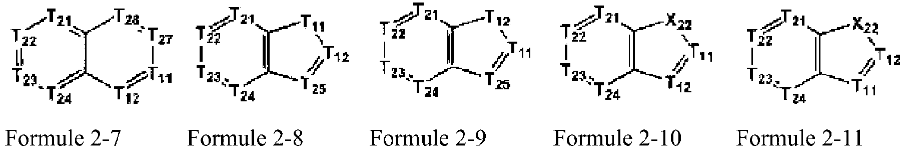 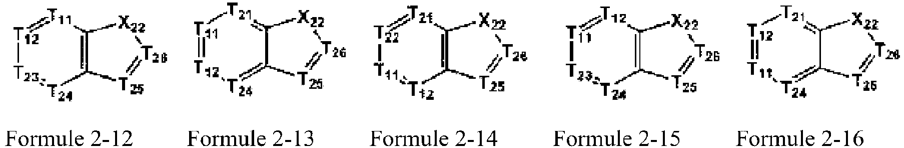 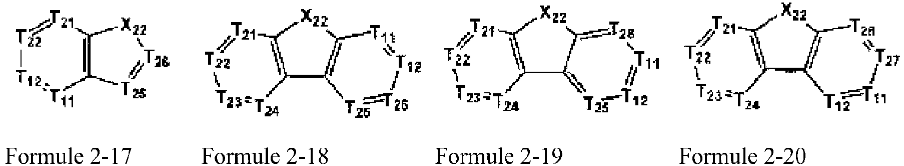 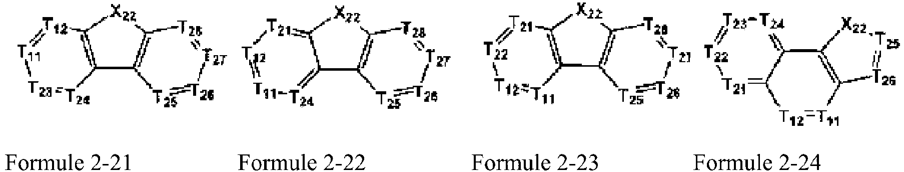 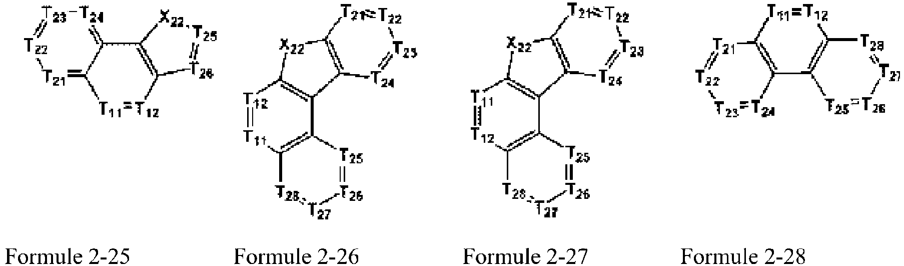 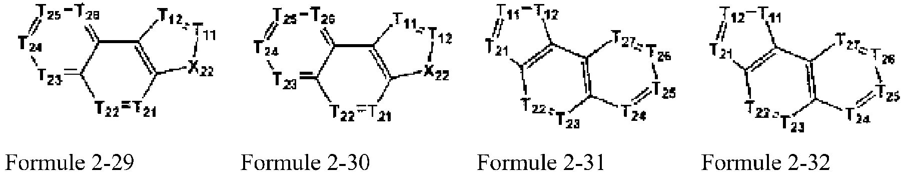 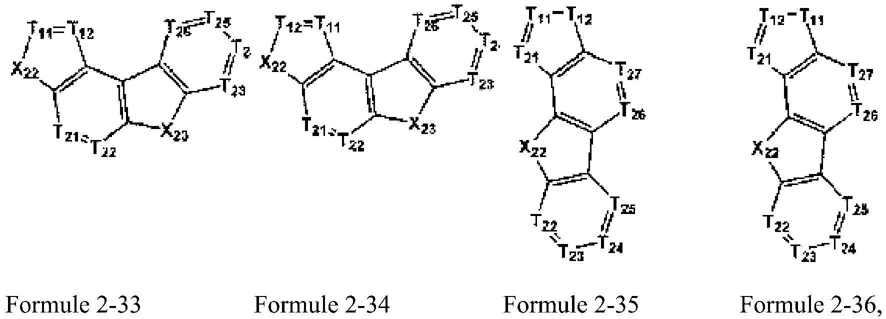
dans lequel, dans les formules 2-1 à 2-36,
T₁₁ et T₁₂ sont tels que définis dans la revendication 1,
X₂₂ et X₂₃ sont chacun indépendamment choisis parmi O, S, Se, un fragment contenant du carbone, un fragment contenant de l'azote et un fragment contenant du silicium, et
T₂₁ à T₂₈ sont chacun indépendamment choisis parmi N et un fragment contenant du carbone.

5. Dispositif électroluminescent organique selon l'une quelconque des revendications précédentes, dans lequel, dans les formules 1A et 1B :
Y₁ et Y₂ sont tous deux une liaison simple,
Y₁ est une liaison simple et Y₂ est choisi parmi N[(L₁₂)ₐ₁₂-(R₁₂)_{b12}], C(R₁₂)(R₁₄), Si(R₁₂)(R₁₄), O, S et Se, ou
Y₁ est choisi parmi N[(L₁₁)ₐ₁₁-(R₁₁)_{b11}], C(R₁₁)(R₁₃), Si(R₁₁)(R₁₃), O, S et Se, et Y₂ est une liaison simple.

6. Dispositif électroluminescent organique selon l'une quelconque des revendications précédentes, dans lequel, dans les Formules 1A, 1B, 2A, 2B, les Formules 2-1 à 2-3, 2-10 à 2-27 et 2-33 à 2-36, L₁ à L₄, L₁₁, L₁₂ et L₂₁ sont chacun indépendamment sélectionnés parmi :
un groupe phénylène, un groupe pentalénylène, un groupe indénylène, un groupe naphtylène, un groupe azulénylène, un groupe indacénylène, un groupe acénaphtylène, un groupe fluorénylène, un groupe spiro-bifluorénylène, un groupe spiro-benzofluorène-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe pérylénylène, un groupe pentaphénylène, un groupe pyrrolylène, un groupe thiophénylène, un groupe furanylène, un groupe silolylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe indolylène, un groupe isoindolylène, un groupe indazolylène, un groupe purinylène, un groupe quinolinylène, un groupe isoquinolinylène, un groupe benzoquinolinylène, un groupe phtalazinylène, un groupe naphthyridinylène, un groupe quinoxalinylène, un groupe quinazolinylène, un groupe cinnolinylène, un groupe phénanthridinylène, un groupe acridinylène, un groupe phénanthrolinylène, un groupe phénazinylène, un groupe benzoimidazolylène, un groupe benzofuranylène, un groupe benzothiophénylène, un groupe benzosilolylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe dibenzosilolylène, un groupe carbazolylène, un groupe benzocarbazolylène, un groupe dibenzocarbazolylène, un groupe thiadiazolylène, un groupe imidazopyridinylène, un groupe imidazopyrimidinylène, un groupe oxazolopyridinylène, un groupe thiazolopyridinylène, un groupe benzonaphtyridinylène, un groupe azafluorénylène, un groupe azaspiro-bifluorénylène, un groupe azacarbazolylène, un groupe azadibenzofuranylène, un groupe azadibenzothiophénylène et un groupe azadibenzosilolylène ; et
un groupe phénylène, un groupe pentalénylène, un groupe indénylène, un groupe naphtylène, un groupe azulénylène, un groupe indacénylène, un groupe acénaphtylène, un groupe fluorénylène, un groupe spiro-bifluorénylène, un groupe spiro-benzofluorène-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe pérylénylène, un groupe pentaphénylène, un groupe pyrrolylène, un groupe thiophénylène, un groupe furanylène, un groupe silolylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe indolylène, un groupe isoindolylène, un groupe indazolylène, un groupe purinylène, un groupe quinolinylène, un groupe isoquinolinylène, un groupe benzoquinolinylène, un groupe phtalazinylène, un groupe naphthyridinylène, un groupe quinoxalinylène, un groupe quinazolinylène, un groupe cinnolinylène, un groupe phénanthridinylène, un groupe acridinylène, un groupe phénanthrolinylène, un groupe phénazinylène, un groupe benzoimidazolylène, un groupe benzofuranylène, un groupe benzothiophénylène, un groupe benzosilolylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe dibenzosilolylène, un groupe carbazolylène, un groupe benzocarbazolylène, un groupe dibenzocarbazolylène, un groupe thiadiazolylène, un groupe imidazopyridinylène, un groupe imidazopyrimidinylène, un groupe oxazolopyridinylène, un groupe thiazolopyridinylène, un groupe benzonaphtyridinylène, un groupe azafluorénylène, un groupe azaspiro-bifluorénylène, un groupe azacarbazolylène, un groupe azadibenzofuranylène, un groupe azadibenzothiophénylène et un groupe azadibenzosilolylène, chacun substitué par au moins un élément choisi parmi le deutérium, -F, - Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alcoxy en C₁ à C₂₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe hétéroaryle en C₁ à C₆₀, un groupe polycyclique condensé en C8 à C60 non aromatique monovalent, un groupe hétéropolycyclique condensé à 8 à 60 chaînons non aromatique monovalent, un groupe biphényle, un groupe terphényle, -Si(Q₃₁)(Q₃₂)(Q₃₃), -N(Q₃₁)(Q₃₂), - B(Q₃₁)(Q₃₂),-C(=O)(Q₃₁), - S(=O)₂(Q₃₁), et -P(=O)(Q₃₁)(Q₃₂),
dans lequel dans les Formules 2-1 à 2-3, 2-10 à 2-19, 2-21 à 2-27 et 2-33 à 2-36, L₂₂ est choisi parmi :
un groupe phénylène, un groupe pentalénylène, un groupe indénylène, un groupe naphtylène, un groupe azulénylène, un groupe indacénylène, un groupe acénaphtylène, un groupe fluorénylène, un groupe spiro-bifluorénylène, un groupe spiro-benzofluorène-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe pérylénylène, un groupe pentaphénylène, un groupe pyrrolylène, un groupe thiophénylène, un groupe furanylène, un groupe silolylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe indolylène, un groupe isoindolylène, un groupe indazolylène, un groupe purinylène, un groupe quinolinylène, un groupe isoquinolinylène, un groupe benzoquinolinylène, un groupe phtalazinylène, un groupe naphthyridinylène, un groupe quinoxalinylène, un groupe quinazolinylène, un groupe cinnolinylène, un groupe phénanthridinylène, un groupe acridinylène, un groupe phénanthrolinylène, un groupe phénazinylène, un groupe benzoimidazolylène, un groupe benzofuranylène, un groupe benzothiophénylène, un groupe benzosilolylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe dibenzosilolylène, un groupe carbazolylène, un groupe benzocarbazolylène, un groupe dibenzocarbazolylène, un groupe thiadiazolylène, un groupe imidazopyridinylène, un groupe imidazopyrimidinylène, un groupe oxazolopyridinylène, un groupe thiazolopyridinylène, un groupe benzonaphtyridinylène, un groupe azafluorénylène, un groupe azaspiro-bifluorénylène, un groupe azacarbazolylène, un groupe azadibenzofuranylène, un groupe azadibenzothiophénylène et un groupe azadibenzosilolylène ; et
un groupe phénylène, un groupe pentalénylène, un groupe indénylène, un groupe naphtylène, un groupe azulénylène, un groupe indacénylène, un groupe acénaphtylène, un groupe fluorénylène, un groupe spiro-bifluorénylène, un groupe spiro-benzofluorène-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe pérylénylène, un groupe pentaphénylène, un groupe pyrrolylène, un groupe thiophénylène, un groupe furanylène, un groupe silolylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe indolylène, un groupe isoindolylène, un groupe indazolylène, un groupe purinylène, un groupe quinolinylène, un groupe isoquinolinylène, un groupe benzoquinolinylène, un groupe phtalazinylène, un groupe naphthyridinylène, un groupe quinoxalinylène, un groupe quinazolinylène, un groupe cinnolinylène, un groupe phénanthridinylène, un groupe acridinylène, un groupe phénanthrolinylène, un groupe phénazinylène, un groupe benzoimidazolylène, un groupe benzofuranylène, un groupe benzothiophénylène, un groupe benzosilolylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe dibenzosilolylène, un groupe carbazolylène, un groupe benzocarbazolylène, un groupe dibenzocarbazolylène, un groupe thiadiazolylène, un groupe imidazopyridinylène, un groupe imidazopyrimidinylène, un groupe oxazolopyridinylène, un groupe thiazolopyridinylène, un groupe benzonaphtyridinylène, un groupe azafluorénylène, un groupe azaspiro-bifluorénylène, un groupe azacarbazolylène, un groupe azadibenzofuranylène, un groupe azadibenzothiophénylène et un groupe azadibenzosilolylène, chacun substitué par au moins un élément choisi parmi le deutérium, -F, - Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alcoxy en C₁ à C₂₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe hétéroaryle en C₁ à C₆₀, un groupe polycyclique condensé en C8 à C60 non aromatique monovalent, un groupe hétéropolycyclique condensé à 8 à 60 chaînons non aromatique monovalent, un groupe biphényle, un groupe terphényle, -Si(Q₃₁)(Q₃₂)(Q₃₃), -N(Q₃₁)(Q₃₂), - B(Q₃₁)(Q₃₂),-C(=O)(Q₃₁), - S(=O)₂(Q₃₁), et -P(=O)(Q₃₁)(Q₃₂).

7. Dispositif électroluminescent organique selon l'une quelconque des revendications précédentes, dans lequel, dans les Formules 1A, 1B, 2A et 2B, R₁ à R₄, R₁₁ à R₁₄, R₂₁, R₂₃, R₂₄, R₂₇ et R₂₈ sont chacun indépendamment sélectionnés parmi :
l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀ et un groupe alcoxy en C₁ à C₂₀ ;
un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe spiro-benzofluorène-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentaphényle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzoimidazolyle, un groupe benzofuranyle, un groupe benzothiophényle, un groupe benzosilolyle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe carbazolyle, un groupe benzocarbazolyle, un groupe dibenzocarbazolyle, un groupe thiadiazolyle, un groupe imidazopyridinyle, un groupe imidazopyrimidinyle, un groupe oxazolopyridinyle, un groupe thiazolopyridinyle, un groupe benzonaphthyridinyle, un groupe azafluorényle, un groupe azaspiro-bifluorényle, un groupe azacarbazolyle, un groupe azadibenzofuranyle, un groupe azadibenzothiophényle, un groupe azadibenzosilolyle, - Si(Q₁)(Q₂)(Q₃), - N(Q₁)(Q₂), -B(Q₁)(Q₂), -C(=O)(Q₁), -S(=O)₂(Q₁), et -P(=O)(Q₁)(Q₂) ; et
un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe spiro-benzofluorène-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentaphényle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzoimidazolyle, un groupe benzofuranyle, un groupe benzothiophényle, un groupe benzosilolyle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe carbazolyle, un groupe benzocarbazolyle, un groupe dibenzocarbazolyle, un groupe thiadiazolyle, un groupe imidazopyridinyle, un groupe imidazopyrimidinyle, un groupe oxazolopyridinyle, un groupe thiazolopyridinyle, un groupe benzonaphthyridinyle, un groupe azafluorényle, un groupe azaspiro-bifluorényle, un groupe azacarbazolyle, un groupe azadibenzofuranyle, un groupe azadibenzothiophényle et un groupe azibenzosilolyle, chacun substitué par au moins l'un des éléments parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alcoxy en C₁ à C₂₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe hétéroaryle en C₁ à C₆₀, un groupe polycyclique condensé en C8 à C60 non aromatique monovalent, un groupe hétéropolycyclique condensé à 8 à 60 chaînons non aromatique monovalent, un groupe biphényle, un groupe terphényle, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), et -P(=O)(Q₃₁)(Q₃₂), dans lequel Q₁ à Q₃ et Q₃₁ à Q₃₃ sont chacun sélectionnés parmi :
un groupe alkyle en C₁ à C₁₀, un groupe alcoxy en C₁ à C₁₀, un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle et un groupe quinazolinyle ; et
un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle et un groupe quinazolinyle, chacun substitué par au moins un élément sélectionné parmi un groupe alkyle en C₁ à C₁₀, un groupe alcoxy en C₁ à C₁₀ et un groupe phényle.

8. Dispositif électroluminescent organique selon l'une quelconque des revendications précédentes, dans lequel le premier composé est représenté par l'une des Formules 1-1 à 1-3 suivantes : 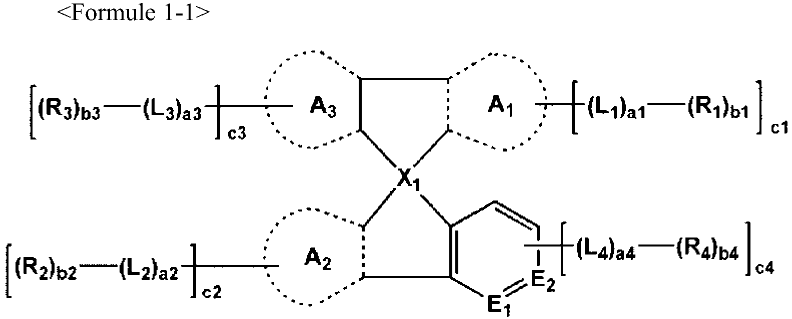 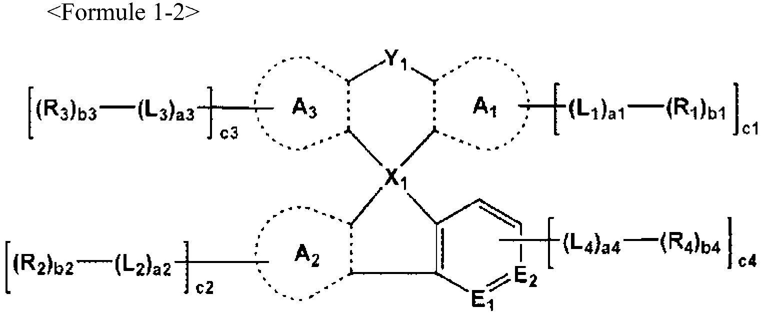 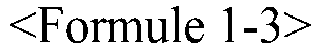 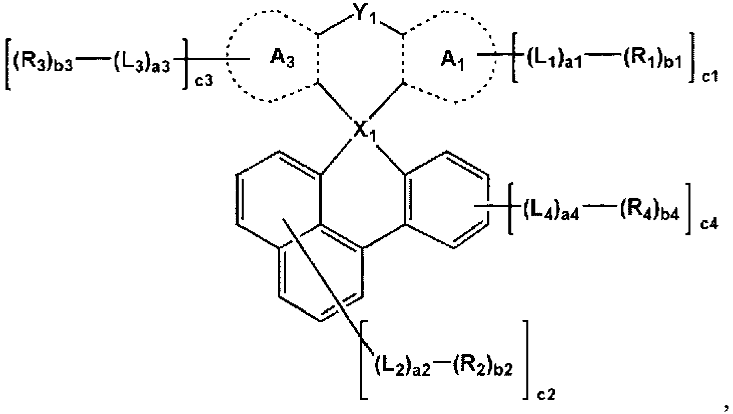 dans lequel, dans les formules 1-1 à 1-3,
c2 est un nombre entier de 0 à 6,
Y₁ est choisi parmi N[(L₁₁)ₐ₁₁-(R₁₁)_{b11}], C(R₁₁)(R₁₃), Si(R₁₁)(R₁₃), O, S et Se, et
les cycles A₁ à A₃, X₁, E₁, E₂, L₁ à L₄, a1 à a4, R₁ à R₄, b1 à b4, c1, c3, c4, L₁₁, a11, R₁₁, R₁₃ et b11 sont tels que définis dans l'une quelconque des revendications 1, 2, 8 et 9,
de préférence dans lequel :
le cycle A₁ est choisi parmi un groupe benzène, un groupe naphtalène, un groupe pyridine, un groupe dibenzofurane et un groupe pyrimidine,
les cycles A₂ et A₃ sont chacun indépendamment choisis parmi un groupe benzène, un groupe naphtalène, un groupe anthracène, un groupe phénanthrène, un groupe indène, un groupe indénopyridine, un groupe fluorène, un groupe pyridine, un groupe pyrimidine, un groupe pyrazine, un groupe pyrrole, un groupe imidazole, un groupe quinoléine, un groupe isoquinoléine, un groupe quinazoline, un groupe phénanthroline, un groupe phénanthridine, un groupe furane, un groupe thiophène, un groupe indole, un groupe indolocarbazole, un groupe benzofurane, un groupe benzofurocarbazole, un groupe benzofuropyrimidine, un groupe benzothiophène, un groupe benzoxazole, un groupe benzothiazole, un groupe benzoimidazole, un groupe carbazole, un groupe dibenzofurane, un groupe dibenzothiophène, un groupe pyridoindole, un groupe dipyridofurane, un groupe dipyridothiophène, un groupe pyrimidobenzofurane, un groupe dipyridopyrrole, et un groupe pyrimidobenzothiophène, et
R₁ à R₄ sont chacun indépendamment sélectionnés parmi l'hydrogène, le deutérium, -F, - Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alcoxy en C₁ à C₂₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe hétéroaryle en C₁ à C₆₀, un groupe polycyclique condensé en C8 à C60 non aromatique monovalent, un groupe hétéropolycyclique condensé à 8 à 60 chaînons non aromatique monovalent, un groupe biphényle, un groupe terphényle, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁) et -P(=O)(Q₃₁)(Q₃₂).

9. Dispositif électroluminescent organique selon l'une quelconque des revendications précédentes, dans lequel
(a) une énergie triplet du deuxième composé est d'environ 2,2 eV ou plus ; et/ou
(b) la couche d'émission comprend un premier hôte et un second hôte, le premier hôte comprenant le premier composé ; et/ou
(c) la région de transport d'électrons comprend une couche tampon, la couche tampon est directement en contact avec la couche d'émission, et la couche tampon comprend le deuxième composé.

10. Dispositif électroluminescent organique selon l'une quelconque des revendications précédentes, dans lequel :
la couche d'émission comprend un dopant, et
le dopant comprend un complexe organométallique ;
de préférence dans lequel le complexe organométallique est représenté par la Formule 401, dans laquelle L₄₀₁ est choisi parmi un ligand représenté par la Formule 402,
<Formule 401> M(L₄₀₁)_{xc1}(L₄₀₂)_{xc2} 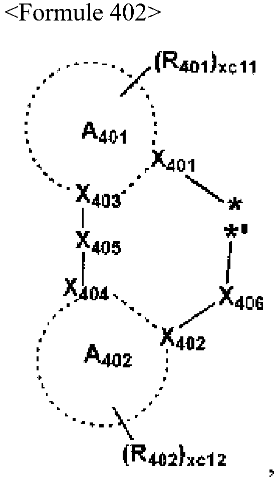
dans lequel, dans les Formules 401 et 402,
M est choisi parmi l'iridium (Ir), le platine (Pt), le palladium (Pd), l'osmium (Os), le titane (Ti), le zirconium (Zr), le hafnium (Hf), l'europium (Eu), le terbium (Tb), le rhodium (Rh) et le thulium (Tm),
xc1 vaut 1, 2 ou 3, dans lequel lorsque xc1 vaut 2 ou 3, 2 ou 3, L₄₀₁ sont identiques ou différents les uns des autres,
L₄₀₂ est un ligand organique, et xc2 est un nombre entier de 0 à 4, dans lequel lorsque xc2 vaut 2, 3 ou 4, 2, 3 ou 4 L₄₀₂ sont identiques ou différents les uns des autres,
X₄₀₁ à X₄₀₄ sont chacun indépendamment de l'azote ou du carbone,
X₄₀₁ et X₄₀₃ sont reliés l'un à l'autre via une liaison simple ou une liaison double, et X₄₀₂ et X₄₀₄ sont reliés l'un à l'autre via une liaison simple ou une liaison double,
A₄₀₁ et A₄₀₂ sont chacun indépendamment un groupe carbocyclique en C₅ à C₆₀ ou un groupe hétérocyclique en C₁ à C₆₀,
X₄₀₅ est une liaison simple, -O-, -S-, -C(=O)-, -N(Q₄₁₁)-, -C(Q₄₁₁)(Q₄₁₂)-, - C(Q₄₁₁)=C(Q₄₁₂)-, -C(Q₄₁₁)=, ou =C(Q₄₁₁)=, dans lequel Q₄₁₁ et Q₄₁₂ sont chacun indépendamment l'hydrogène, le deutérium, un groupe alkyle en C₁ à C₂₀, un groupe alcoxy en C₁ à C₂₀, un groupe phényle, un groupe biphényle, un groupe terphényle ou un groupe naphtyle,
X₄₀₆ est une liaison simple, O ou S,
R₄₀₁ et R₄₀₂ sont chacun indépendamment sélectionnés parmi l'hydrogène, le deutérium, - F, -Cl, -Br, -I, -CD₃, -CF₃, un groupe hydroxyle, un groupe cyano, un groupe nitro, un groupe amidino, un groupe hydrazino, un groupe hydrazono, un groupe alkyle en C₁ à C₂₀ substitué ou non substitué, un groupe alcoxy en C₁ à C₂₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en en C₆ à C₆₀ substitué ou non substitué, un groupe aryloxy en C₆ à C₆₀ substitué ou non substitué, un groupe arylthio en en C₆ à C₆₀ substitué ou non substitué, un groupe hétéroaryle en C₁ à C₆₀ substitué ou non substitué, un groupe polycyclique condensé en C8 à C60 non aromatique monovalent substitué ou non substitué, un groupe hétéropolycyclique condensé à 8 à 60 chaînons non aromatique monovalent substitué ou non substitué -Si(Q₄₀₁)(Q₄₀₂)(Q₄₀₃), -N(Q₄₀₁)(Q₄₀₂), -B (Q₄₀₁)(Q₄₀₂), -C(=O)(Q₄₀₁), - S(=O)₂(Q₄₀₁) et -P (=O)(Q₄₀₁)(Q₄₀₂), dans lequel Q₄₀₁ à Q₄₀₃ sont chacun indépendamment sélectionnés parmi un groupe alkyle en C₁ à C₁₀, un groupe alcoxy en C₁ à C₁₀, un groupe aryle en C₆ à C₂₀, et un groupe hétéroaryle en C₁ à C₂₀,
xc11 et xc12 sont chacun indépendamment un nombre entier de 0 à 10, et
* et *' dans la Formule 402 indiquent un site de liaison à M dans la Formule 401.

11. Dispositif électroluminescent organique selon l'une quelconque des revendications précédentes, dans lequel :
la région de transport d'électrons comprend une couche tampon, une couche de transport d'électrons et une couche d'injection d'électrons, et
au moins une couche de la couche de transport d'électrons et de la couche d'injection d'électrons comprend un métal alcalin, un métal alcalino-terreux, un métal de terres rares, un composé de métal alcalin, un composé de métal alcalino-terreux, un composé de métal de terres rares, un complexe de métal alcalin, un complexe de métal alcalino-terreux, un complexe de métal de terres rares ou une combinaison de ceux-ci.

12. Dispositif électroluminescent organique selon l'une quelconque des revendications précédentes, dans lequel :
la région de transport de trou comprend un dopant de type P, et
une orbitale moléculaire inoccupée la plus basse (LUMO) du dopant de type P est d'environ -3,5 eV ou moins ;
de préférence dans lequel le dopant de type P comprend un composé contenant un groupe cyano.

13. Dispositif électroluminescent organique selon l'une quelconque des revendications précédentes, dans lequel
la couche d'émission est une couche d'émission de lumière de première couleur,
le dispositif électroluminescent organique comprend en outre au moins une couche d'émission de lumière de deuxième couleur ou au moins une couche d'émission de lumière de deuxième couleur et au moins une couche d'émission de lumière de troisième couleur, entre la première électrode et la seconde électrode,
une longueur d'onde d'émission maximale de la couche d'émission de lumière de première couleur, une longueur d'onde d'émission maximale de la couche d'émission de lumière de deuxième couleur et une longueur d'onde d'émission maximale de la couche d'émission de lumière de troisième couleur sont identiques ou différentes les unes des autres , et
une lumière mixte comprenant une lumière de première couleur et une lumière de deuxième couleur, ou une lumière mixte comprenant une lumière de première couleur, une lumière de deuxième couleur, et une lumière de troisième couleur est émise.
